(19) Europäisches Patentamt
European Patent Office
Office européen des brevets

(11) EP 4 462 978 A2

(12) # EUROPEAN PATENT APPLICATION

(43) Date of publication:
**13.11.2024 Bulletin 2024/46**

(21) Application number: **24172579.5**

(22) Date of filing: **25.04.2024**

(51) International Patent Classification (IPC):
***H10K 50/12*** *(2023.01)* ***C07C 13/00*** *(2006.01)*
***C07D 209/00*** *(2006.01)* ***C07F 5/02*** *(2006.01)*
***C07F 7/02*** *(2006.01)* ***C07F 15/00*** *(2006.01)*
*H10K 85/30 (2023.01)* *H10K 85/40 (2023.01)*
*H10K 85/60 (2023.01)*

(52) Cooperative Patent Classification (CPC):
**H10K 50/12; C07C 13/00; C07D 209/00; C07F 5/02; C07F 7/02; C07F 15/0006;**
H10K 85/342; H10K 85/346; H10K 85/40; H10K 85/622; H10K 85/654; H10K 85/6572; H10K 85/6574; H10K 85/658; H10K 2101/20;

(Cont.)

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **09.05.2023 US 202363500964 P**
**16.04.2024 US 202418636527**

(71) Applicant: **Universal Display Corporation**
**Ewing, NJ 08618 (US)**

(72) Inventors:
- **HERBOL, Henry Carl**
**Ewing, NJ 08618 (US)**
- **MARGULIES, Eric A.**
**Ewing, NJ 08618 (US)**
- **MILAS, Ivan**
**Ewing, NJ 08618 (US)**
- **THOMPSON, Nicholas J.**
**Ewing, NJ 08618 (US)**
- **FUSELLA, Michael**
**Ewing, NJ 08618 (US)**
- **SZIGETHY, Geza**
**Ewing, NJ 08618 (US)**
- **FLEETHAM, Tyler**
**Ewing, NJ 08618 (US)**
- **RYNO, Sean Michael**
**Ewing, NJ 08618 (US)**

(74) Representative: **Maiwald GmbH**
**Elisenhof**
**Elisenstraße 3**
**80335 München (DE)**

(54) **ORGANIC ELECTROLUMINESCENT MATERIALS AND DEVICES**

(57) Provided is a composition A that includes: a first dopant; and a first host; where the first dopant has a HOMO energy HOMODopant and a LUMO energy LUMODopant; the first host has a HOMO energy HOMOHost and a LUMO energy LUMOHost; |LUMOHost - HOMODopant| = X1; ILUMODopant - HOMOHost| = X2; the first dopant has an optical bandgap energy, Y; at least one of XI and X2 is less than or equal to Y + 0.026 eV; the composition A has a vertical dipole ratio VDR(A); composition B is a reference composition comprising the first dopant and a second host, wherein the second host is

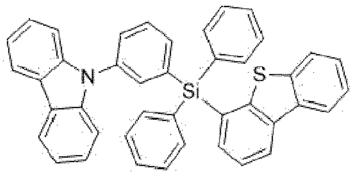

;

the composition B having a vertical dipole ratio VDR(B); the ratio of the first dopant and the first host in the composition A is identical to the ratio of the first dopant and second host in the composition B; and VDR(A) - VDR(B) is ≥ 0.05.

EP 4 462 978 A2

(52) Cooperative Patent Classification (CPC): (Cont.)
H10K 2101/30; H10K 2101/90

## Description

## CROSS-REFERENCE TO RELATED APPLICATIONS

This application claims priority under 35 U.S.C. § 119(e) to United States Provisional Application No. 63/500,964, filed on May 9, 2023, the entire contents of which are incorporated herein by reference.

## FIELD

The present disclosure generally relates to organic or metal coordination compounds and formulations and their various uses including as emitters, sensitizers, charge transporters, or exciton transporters in devices such as organic light emitting diodes and related electronic devices and consumer products.

## BACKGROUND

Opto-electronic devices that make use of organic materials are becoming increasingly desirable for various reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting diodes/devices (OLEDs), organic phototransistors, organic photovoltaic cells, organic scintillators, and organic photodetectors. For OLEDs, the organic materials may have performance advantages over conventional materials.

OLEDs make use of thin organic films that emit light when voltage is applied across the device. OLEDs are becoming an increasingly interesting technology for use in applications such as displays, illumination, and backlighting.

One application for emissive molecules is a full color display. Industry standards for such a display call for pixels adapted to emit particular colors, referred to as "saturated" colors. In particular, these standards call for saturated red, green, and blue pixels. Alternatively, the OLED can be designed to emit white light. In conventional liquid crystal displays emission from a white backlight is filtered using absorption filters to produce red, green and blue emission. The same technique can also be used with OLEDs. The white OLED can be either a single emissive layer (EML) device or a stack structure. Color may be measured using CIE coordinates, which are well known to the art.

## SUMMARY

Disclosed is the use of an exciplex state between a dopant and host in the emission layer (EML) of an OLED to deliberately increase the vertical dipole ratio (VDR) of the overall device. Using exciplex states, we can engineer a net-vertical exciplex emissive state that can subsequently increase the VDR of the EML.

In one aspect, the present disclosure provides a composition A comprising: a first dopant; and a first host;

wherein: the first dopant has a HOMO energy $HOMO_{Dopant}$ and a LUMO energy $LUMO_{Dopant}$;
the first host has a HOMO energy $HOMO_{Host}$ and a LUMO energy $LUMO_{Host}$;
$|LUMO_{Host} - HOMO_{Dopant}| = X1$;
$|LUMO_{Dopant} - HOMO_{Host}| = X2$;
the first dopant has an optical bandgap energy, Y;
at least one of X1 and X2 is less than or equal to Y + 0.026 eV;
the composition A has a vertical dipole ratio VDR(A);
composition B is a reference composition comprising the first dopant and a second host, wherein the second host is

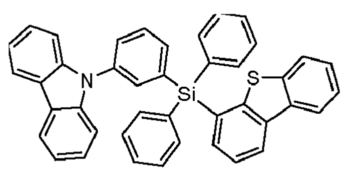
;

the composition B having a vertical dipole ratio VDR(B);
the ratio of the first dopant and the first host in the composition A is identical to the ratio of the first dopant and second host in the composition B; and

$$VDR(A) - VDR(B) \text{ is} \geq 0.05.$$

In another aspect, the present disclosure provides a formulation of comprising the composition A described herein.

In yet another aspect, the present disclosure provides an OLED having an organic layer comprising the composition A described herein.

In yet another aspect, the present disclosure provides a consumer product comprising an OLED with an organic layer comprising the composition A described herein.

## BRIEF DESCRIPTION OF THE DRAWINGS

FIG. 1 shows an organic light emitting device.

FIG. 2 shows an inverted organic light emitting device that does not have a separate electron transport layer.

FIG. 3 shows a graph of modeled P-polarized photoluminescence as a function of angle for emitters with different vertical dipole ratio (VDR) values.

FIG. 4A shows the PL spectra comparison between comparative host compound CH-1 and inventive host compound IH-1 for emitter E-1.

FIG. 4B shows the PL spectra comparison between comparative host compound CH-1 and inventive host compound IH-2 for emitter E-2.

FIG. 4C shows the PL spectra comparison between comparative host compounds CH-1 and inventive host compound IH-3 for emitter E-3.

## DETAILED DESCRIPTION

### A. Terminology

Unless otherwise specified, the below terms used herein are defined as follows:
As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processable" means capable of being dissolved, dispersed, or transported in and/or deposited from a liquid medium, either in solution or suspension form.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

Layers, materials, regions, and devices may be described herein in reference to the color of light they emit. In general, as used herein, an emissive region that is described as producing a specific color of light may include one or more emissive layers disposed over each other in a stack.

As used herein, a "NIR", "red", "green", "blue", "yellow" layer, material, region, or device refers to a layer, a material, a region, or a device that emits light in the wavelength range of about 700-1500 nm, 580-700 nm, 500-600 nm, 400-500 nm, 540-600 nm, respectively, or a layer, a material, a region, or a device that has a highest peak in its emission

spectrum in the respective wavelength region. In some arrangements, separate regions, layers, materials, or devices may provide separate "deep blue" and "light blue" emissions. As used herein, the "deep blue" emission component refers to an emission having a peak emission wavelength that is at least about 4 nm less than the peak emission wavelength of the "light blue" emission component. Typically, a "light blue" emission component has a peak emission wavelength in the range of about 465-500 nm, and a "deep blue" emission component has a peak emission wavelength in the range of about 400-470 nm, though these ranges may vary for some configurations.

In some arrangements, a color altering layer that converts, modifies, or shifts the color of the light emitted by another layer to an emission having a different wavelength is provided. Such a color altering layer can be formulated to shift wavelength of the light emitted by the other layer by a defined amount, as measured by the difference in the wavelength of the emitted light and the wavelength of the resulting light. In general, there are two classes of color altering layers: color filters that modify a spectrum by removing light of unwanted wavelengths, and color changing layers that convert photons of higher energy to lower energy. For example, a "red" color filter can be present in order to filter an input light to remove light having a wavelength outside the range of about 580-700 nm. A component "of a color" refers to a component that, when activated or used, produces or otherwise emits light having a particular color as previously described. For example, a "first emissive region of a first color" and a "second emissive region of a second color different than the first color" describes two emissive regions that, when activated within a device, emit two different colors as previously described.

As used herein, emissive materials, layers, and regions may be distinguished from one another and from other structures based upon light initially generated by the material, layer or region, as opposed to light eventually emitted by the same or a different structure. The initial light generation typically is the result of an energy level change resulting in emission of a photon. For example, an organic emissive material may initially generate blue light, which may be converted by a color filter, quantum dot or other structure to red or green light, such that a complete emissive stack or sub-pixel emits the red or green light. In this case the initial emissive material, region, or layer may be referred to as a "blue" component, even though the sub-pixel is a "red" or "green" component.

In some cases, it may be preferable to describe the color of a component such as an emissive region, sub-pixel, color altering layer, or the like, in terms of 1931 CIE coordinates. For example, a yellow emissive material may have multiple peak emission wavelengths, one in or near an edge of the "green" region, and one within or near an edge of the "red" region as previously described. Accordingly, as used herein, each color term also corresponds to a shape in the 1931 CIE coordinate color space. The shape in 1931 CIE color space is constructed by following the locus between two color points and any additional interior points. For example, interior shape parameters for red, green, blue, and yellow may be defined as shown below:

| Color | CIE Shape Parameters |
|---|---|
| Central Red | Locus: [0.6270,0.3725];[0.7347,0.2653]; Interior: [0.5086,0.2657] |
| Central Green | Locus: [0.0326,0.3530];[0.3731,0.6245]; Interior: [0.2268,0.3321 |
| Central Blue | Locus: [0.1746,0.0052];[0.0326,0.3530]; Interior: [0.2268,0.3321] |
| Central Yellow | Locus: [0.3731,0.6245];[0.6270,0.3725]; Interior: [0.3700,0.4087];[0.2886,0.4572] |

The terms "halo," "halogen," and "halide" are used interchangeably and refer to fluorine, chlorine, bromine, and iodine.

The term "acyl" refers to a substituted carbonyl group ($-C(O)-R_s$).

The term "ester" refers to a substituted oxycarbonyl ($-O-C(O)-R_s$ or $-C(O)-O-R_s$) group.

The term "ether" refers to an $-OR_s$ group.

The terms "sulfanyl" or "thio-ether" are used interchangeably and refer to a $-SR_s$ group.

The term "selenyl" refers to a $-SeR_s$ group.

The term "sulfinyl" refers to a $-S(O)-R_s$ group.

The term "sulfonyl" refers to a $-SO_2-R_s$ group.

The term "phosphino" refers to a group containing at least one phosphorus atom bonded to the relevant structure. Common examples of phosphino groups include, but are not limited to, groups such as a $-P(R_s)_2$ group or a - $PO(R_s)_2$ group, wherein each $R_s$ can be same or different.

The term "silyl" refers to a group containing at least one silicon atom bonded to the relevant structure. Common

examples of silyl groups include, but are not limited to, groups such as a -Si($R_s$)$_3$ group, wherein each $R_s$ can be same or different.

The term "germyl" refers to a group containing at least one germanium atom bonded to the relevant structure. Common examples of germyl groups include, but are not limited to, groups such as a -Ge($R_s$)$_3$ group, wherein each $R_s$ can be same or different.

The term "boryl" refers to a group containing at least one boron atom bonded to the relevant structure. Common examples of boryl groups include, but are not limited to, groups such as a -B($R_s$)$_2$ group or its Lewis adduct - B($R_s$)$_3$ group, wherein $R_s$ can be same or different.

In each of the above, $R_s$ can be hydrogen, or a substituent selected from the group consisting of the General Substituents as defined in this application. Preferred $R_s$ is selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, and combination thereof. More preferably $R_s$ is selected from the group consisting of alkyl, cycloalkyl, aryl, heteroaryl, and combination thereof.

The term "alkyl" refers to and includes both straight and branched chain alkyl groups having an alkyl carbon atom bonded to the relevant structure. Preferred alkyl groups are those containing from one to fifteen carbon atoms, preferably one to nine carbon atoms, and includes methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, and the like. Additionally, the alkyl group can be further substituted.

The term "cycloalkyl" refers to and includes monocyclic, polycyclic, and spiro alkyl groups having a ring alkyl carbon atom bonded to the relevant structure. Preferred cycloalkyl groups are those containing 3 to 12 ring carbon atoms and includes cyclopropyl, cyclopentyl, cyclohexyl, bicyclo[3.1.1]heptyl, spiro[4.5]decyl, spiro[5.5]undecyl, adamantyl, and the like. Additionally, the cycloalkyl group can be further substituted.

The terms "heteroalkyl" or "heterocycloalkyl" refer to an alkyl or a cycloalkyl group, respectively, having at least one carbon atom replaced by a heteroatom. Optionally the at least one heteroatom is selected from O, S, N, P, B, Si, Ge and Se, preferably, O, S or N. Additionally, the heteroalkyl or heterocycloalkyl group can be further substituted.

The term "alkenyl" refers to and includes both straight and branched chain alkene groups. Alkenyl groups are essentially alkyl groups that include at least one carbon-carbon double bond in the alkyl chain with one carbon atom from the carbon-carbon double bond that is bonded to the relevant structure. Cycloalkenyl groups are essentially cycloalkyl groups that include at least one carbon-carbon double bond in the cycloalkyl ring. The term "heteroalkenyl" as used herein refers to an alkenyl group having at least one carbon atom replaced by a heteroatom. Optionally the at least one heteroatom is selected from O, S, N, P, B, Si, Ge, and Se, preferably, O, S, or N. Preferred alkenyl, cycloalkenyl, or heteroalkenyl groups are those containing two to fifteen carbon atoms. Additionally, the alkenyl, cycloalkenyl, or heteroalkenyl group can be further substituted.

The term "alkynyl" refers to and includes both straight and branched chain alkyne groups. Alkynyl groups are essentially alkyl groups that include at least one carbon-carbon triple bond in the alkyl chain with one carbon atom from the carbon-carbon triple bond that is bonded to the relevant structure. Preferred alkynyl groups are those containing two to fifteen carbon atoms. Additionally, the alkynyl group can be further substituted.

The terms "aralkyl" or "arylalkyl" are used interchangeably and refer to an aryl-substituted alkyl group having an alkyl carbon atom bonded to the relevant structure. Additionally, the aralkyl group can be further substituted.

The term "heterocyclic group" refers to and includes aromatic and non-aromatic cyclic groups containing at least one heteroatom. Optionally the at least one heteroatom is selected from O, S, Se, N, P, B, Si, Ge, and Se, preferably, O, S, N, or B. Hetero-aromatic cyclic groups may be used interchangeably with heteroaryl. Preferred hetero-non-aromatic cyclic groups are those containing 3 to 10 ring atoms, preferably those containing 3 to 7 ring atoms, which includes at least one hetero atom, and includes cyclic amines such as morpholino, piperidino, pyrrolidino, and the like, and cyclic ethers/thio-ethers, such as tetrahydrofuran, tetrahydropyran, tetrahydrothiophene, and the like. Additionally, the heterocyclic group can be further substituted or fused.

The term "aryl" refers to and includes both single-ring and polycyclic aromatic hydrocarbyl groups. The polycyclic rings may have two or more rings in which two carbons are common to two adjoining rings (the rings are "fused"). Preferred aryl groups are those containing six to thirty carbon atoms, preferably six to twenty-four carbon atoms, six to eighteen carbon atoms, and more preferably six to twelve carbon atoms. Especially preferred is an aryl group having six carbons, ten carbons, twelve carbons, fourteen carbons, or eighteen carbons. Suitable aryl groups include phenyl, biphenyl, triphenyl, triphenylene, tetraphenylene, naphthalene, anthracene, phenalene, phenanthrene, pyrene, chrysene, perylene, and azulene, preferably phenyl, biphenyl, triphenyl, triphenylene, and naphthalene. Additionally, the aryl group can be further substituted or fused, such as, without limitation, fluorene.

The term "heteroaryl" refers to and includes both single-ring aromatic groups and polycyclic aromatic ring systems that include at least one heteroatom. The heteroatoms include, but are not limited to O, S, Se, N, P, B, Si, Ge, and Se. In many instances, O, S, N, or B are the preferred heteroatoms. Hetero-single ring aromatic systems are preferably single rings with 5 or 6 ring atoms, and the ring can have from one to six heteroatoms. The hetero-polycyclic

ring systems can have two or more aromatic rings in which two atoms are common to two adjoining rings (the rings are "fused") wherein at least one of the rings is a heteroaryl. The hetero-polycyclic aromatic ring systems can have from one to six heteroatoms per ring of the polycyclic aromatic ring system. Preferred heteroaryl groups are those containing three to thirty carbon atoms, preferably three to twenty-four carbon atoms, three to eighteen carbon atoms, and more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, selenophenodipyridine, azaborine, borazine, $5\lambda^2,9\lambda^2$-diaza-13b-boranaphtho[2,3,4-*de*]anthracene, $5\lambda^2$-benzo[*d*]benzo[4,5]imidazo[3,2-*a*]imidazole, and 5,9-dioxa-13b-boranaphtho[3,2,1-*de*]anthracene; preferably dibenzothiophene, dibenzofuran, dibenzoselenophene, carbazole, indolocarbazole, imidazole, pyridine, triazine, benzimidazole, $5\lambda^2,9\lambda^2$-diaza-13b-boranaphtho[2,3,4-*de*]anthracene, $5\lambda^2$-benzo[*d*]benzo[4,5]imidazo[3,2-*a*]imidazole, and 5,9-dioxa-13b-boranaphtho[3,2,1-*de*]anthracene. Additionally, the heteroaryl group can be further substituted or fused.

Of the aryl and heteroaryl groups listed above, the groups of triphenylene, naphthalene, anthracene, dibenzothiophene, dibenzofuran, dibenzoselenophene, carbazole, indolocarbazole, imidazole, pyridine, pyrazine, pyrimidine, triazine, benzimidazole, $5\lambda^2,9\lambda^2$-diaza-13b-boranaphtho[2,3,4-*de*]anthracene, $5\lambda^2$-benzo[*d*]benzo[4,5]imidazo[3,2-*a*]imidazole, 5,9-dioxa-13b-boranaphtho[3,2,1-*de*]anthracene, and the respective aza-analogs of each thereof are of particular interest.

In many instances, the General Substituents are selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, selenyl, sulfinyl, sulfonyl, phosphino, and combinations thereof.

In some instances, the Preferred General Substituents are selected from the group consisting of deuterium, fluorine, alkyl, cycloalkyl, heteroalkyl, alkoxy, aryloxy, amino, silyl, germyl, boryl, alkenyl, cycloalkenyl, heteroalkenyl, aryl, heteroaryl, nitrile, isonitrile, sulfanyl, and combinations thereof.

In some instances, the More Preferred General Substituents are selected from the group consisting of deuterium, fluorine, alkyl, cycloalkyl, alkoxy, aryloxy, amino, silyl, germyl, boryl, aryl, heteroaryl, nitrile, sulfanyl, and combinations thereof.

In some instances, the Even More Preferred General Substituents are selected from the group consisting of deuterium, fluorine, alkyl, cycloalkyl, silyl, aryl, heteroaryl, nitrile, and combinations thereof.

In yet other instances, the Most Preferred General Substituents are selected from the group consisting of deuterium, alkyl, cycloalkyl, aryl, heteroaryl, and combinations thereof.

The terms "substituted", and "substitution" refer to a substituent other than H that is bonded to the relevant position, e.g., a carbon or nitrogen. For example, when $R^1$ represents mono-substitution, then one $R^1$ must be other than H (i.e., a substitution). Similarly, when $R^1$ represents di-substitution, then two of $R^1$ must be other than H. Similarly, when $R^1$ represents zero or no substitution, $R^1$, for example, can be a hydrogen for all available valencies of ring atoms, as in carbon atoms for benzene and the nitrogen atom in pyrrole, or simply represents nothing for ring atoms with fully filled valencies, e.g., the nitrogen atom in pyridine. The maximum number of substitutions possible in a ring structure will depend on the total number of available valencies in the ring atoms.

As used herein, "combinations thereof' indicates that one or more members of the applicable list are combined to form a known or chemically stable arrangement that one of ordinary skill in the art can envision from the applicable list. For example, an alkyl and deuterium can be combined to form a partial or fully deuterated alkyl group; a halogen and alkyl can be combined to form a halogenated alkyl substituent; and a halogen, alkyl, and aryl can be combined to form a halogenated arylalkyl. In one instance, the term substitution includes a combination of two to four of the listed groups. In another instance, the term substitution includes a combination of two to three groups. In yet another instance, the term substitution includes a combination of two groups. Preferred combinations of substituent groups are those that contain up to fifty atoms that are not hydrogen or deuterium, or those which include up to forty atoms that are not hydrogen or deuterium, or those that include up to thirty atoms that are not hydrogen or deuterium. In many instances, a preferred combination of substituent groups will include up to twenty atoms that are not hydrogen or deuterium.

The "aza" designation in the fragments described herein, i.e. aza-dibenzofuran, aza-dibenzothiophene, etc. means that one or more of the C-H groups in the respective aromatic ring can be replaced by a nitrogen atom, for example, and without any limitation, azatriphenylene encompasses both dibenzo[*f*,*h*]quinoxaline and dibenzo[*f,h*]quinoline. One of ordinary skill in the art can readily envision other nitrogen analogs of the aza-derivatives described above, and all such analogs are intended to be encompassed by the terms as set forth herein.

As used herein, "deuterium" refers to an isotope of hydrogen. Deuterated compounds can be readily prepared

using methods known in the art. For example, U.S. Pat. No. 8,557,400, Patent Pub. No. WO 2006/095951, and U.S. Pat. Application Pub. No. US 2011/0037057, which are hereby incorporated by reference in their entireties, describe the making of deuterium-substituted organometallic complexes. Further reference is made to Ming Yan, et al., Tetrahedron 2015, 71, 1425-30 and Atzrodt et al., Angew. Chem. Int. Ed. (Reviews) 2007, 46, 7744-65, which are incorporated by reference in their entireties, describe the deuteration of the methylene hydrogens in benzyl amines and efficient pathways to replace aromatic ring hydrogens with deuterium, respectively.

As used herein, any specifically listed substituent, such as, without limitation, methyl, phenyl, pyridyl, etc. includes undeuterated, partially deuterated, and fully deuterated versions thereof. Similarly, classes of substituents such as, without limitation, alkyl, aryl, cycloalkyl, heteroaryl, etc. also include undeuterated, partially deuterated, and fully deuterated versions thereof. Unless otherwise specified, atoms in chemical structures without valences fully filled by H or D should be considered to include undeuterated, partially deuterated, and fully deuterated versions thereof. For example, the chemical structure of

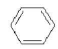

implies to include $C_6H_6$, $C_6D_6$, $C_6H_3D_3$, and any other partially deuterated variants thereof. Some common basic partially or fully deuterated group include, without limitation, $CD_3$, $CD_2C(CH_3)_3$, $C(CD_3)_3$, and $C_6D_5$.

It is to be understood that when a molecular fragment is described as being a substituent or otherwise attached to another moiety, its name may be written as if it were a fragment (e.g. phenyl, phenylene, naphthyl, dibenzofuryl) or as if it were the whole molecule (e.g. benzene, naphthalene, dibenzofuran). As used herein, these different ways of designating a substituent or attached fragment are considered to be equivalent.

In some instances, a pair of substituents in the molecule can be optionally joined or fused into a ring. The preferred ring is a five to nine-membered carbocyclic or heterocyclic ring, includes both instances where the portion of the ring formed by the pair of substituents is saturated and where the portion of the ring formed by the pair of substituents is unsaturated. In yet other instances, a pair of adjacent substituents can be optionally joined or fused into a ring. As used herein, "adjacent" means that the two substituents involved can be on the same ring next to each other, or on two neighboring rings having the two closest available substitutable positions, such as 2, 2' positions in a biphenyl, or 1, 8 position in a naphthalene.

## B. The OLEDs and the Devices of the Present Disclosure

Disclosed is the use of an exciplex state between a dopant and host in the emission layer (EML) of an OLED to deliberately increase the vertical dipole ratio (VDR) of the overall device. Using exciplex states, one can engineer a net-vertical exciplex emissive state that can subsequently increase the VDR of the EML.

In one aspect, the present disclosure provides an OLED device that comprises: an anode; a cathode; and an organic layer disposed between the anode and the cathode, where the organic layer comprises the composition A disclosed in the Compounds section of the present disclosure.

In yet another aspect, the OLED of the present disclosure may also comprise an emissive region containing the composition A disclosed in the above compounds section of the present disclosure.

### Plasmonic Devices:

In some embodiments, at least one of the anode, the cathode, or a new layer disposed over the organic emissive layer functions as an enhancement layer. The enhancement layer comprises a plasmonic material exhibiting surface plasmon resonance that non-radiatively couples to the emitter material and transfers excited state energy from the emitter material to non-radiative mode of surface plasmon polariton. The enhancement layer is provided no more than a threshold distance away from the organic emissive layer, wherein the emitter material has a total non-radiative decay rate constant and a total radiative decay rate constant due to the presence of the enhancement layer and the threshold distance is where the total non-radiative decay rate constant is equal to the total radiative decay rate constant. In some embodiments, the OLED further comprises an outcoupling layer. In some embodiments, the outcoupling layer is disposed over the enhancement layer on the opposite side of the organic emissive layer. In some embodiments, the outcoupling layer is disposed on the opposite side of the emissive layer from the enhancement layer but still outcouples energy from the surface plasmon mode of the enhancement layer. This may include nanoparticles being located on the same side of the enhancement layer as the organic emissive layer, with the organic emissive layer being located between the nanoparticles and the enhancement layer. The outcoupling layer scatters the energy from the surface plasmon polaritons. In some embodiments this energy is scattered as photons to free space. In other embodiments, the energy is scattered from the surface plasmon mode into other modes of the device such as but not limited to the organic waveguide mode,

the substrate mode, or another waveguiding mode. If energy is scattered to the non-free space mode of the OLED, other outcoupling schemes could be incorporated to extract that energy to free space. In some embodiments, one or more intervening layer can be disposed between the enhancement layer and the outcoupling layer. The examples for intervening layer(s) can be dielectric materials, including organic, inorganic, perovskites, oxides, and may include stacks and/or mixtures of these materials.

The enhancement layer modifies the effective properties of the medium in which the emitter material resides resulting in any or all of the following: a decreased rate of emission, a modification of emission line-shape, a change in emission intensity with angle, a change in the stability of the emitter material, a change in the efficiency of the OLED, and reduced efficiency roll-off of the OLED device. Placement of the enhancement layer on the cathode side, anode side, or on both sides results in OLED devices which take advantage of any of the above-mentioned effects. In addition to the specific functional layers mentioned herein and illustrated in the various OLED examples shown in the figures, the OLEDs according to the present disclosure may include any of the other functional layers often found in OLEDs.

The enhancement layer can be comprised of plasmonic materials, optically active metamaterials, or hyperbolic metamaterials. As used herein, a plasmonic material is a material in which the real part of the dielectric constant crosses zero in the visible or ultraviolet region of the electromagnetic spectrum. In some embodiments, the plasmonic material includes at least one metal. In such embodiments the metal may include at least one of Ag, Al, Au, Ir, Pt, Ni, Cu, W, Ta, Fe, Cr, Mg, Ga, Rh, Ti, Ru, Pd, In, Bi, Ca alloys or mixtures of these materials, and stacks of these materials. In general, a metamaterial is a medium composed of different materials where the medium as a whole acts differently than the sum of its material parts. In particular, we define optically active metamaterials as materials which have both negative permittivity and negative permeability. Hyperbolic metamaterials, on the other hand, are anisotropic media in which the permittivity or permeability are of different sign for different spatial directions. Optically active metamaterials and hyperbolic metamaterials are strictly distinguished from many other photonic structures such as Distributed Bragg Reflectors ("DBRs") in that the medium should appear uniform in the direction of propagation on the length scale of the wavelength of light. Using terminology that one skilled in the art can understand: the dielectric constant of the metamaterials in the direction of propagation can be described with the effective medium approximation. Plasmonic materials and metamaterials provide methods for controlling the propagation of light that can enhance OLED performance in a number of ways.

In some embodiments, the enhancement layer is provided as a planar layer. In other embodiments, the enhancement layer has wavelength-sized features that are arranged periodically, quasi-periodically, or randomly, or sub-wavelength-sized features that are arranged periodically, quasi-periodically, or randomly. In some embodiments, the wavelength-sized features and the sub-wavelength-sized features have sharp edges.

In some embodiments, the outcoupling layer has wavelength-sized features that are arranged periodically, quasi-periodically, or randomly, or sub-wavelength-sized features that are arranged periodically, quasi-periodically, or randomly. In some embodiments, the outcoupling layer may be composed of a plurality of nanoparticles and in other embodiments the outcoupling layer is composed of a plurality of nanoparticles disposed over a material. In these embodiments the outcoupling may be tunable by at least one of varying a size of the plurality of nanoparticles, varying a shape of the plurality of nanoparticles, changing a material of the plurality of nanoparticles, adjusting a thickness of the material, changing the refractive index of the material or an additional layer disposed on the plurality of nanoparticles, varying a thickness of the enhancement layer, and/or varying the material of the enhancement layer. The plurality of nanoparticles of the device may be formed from at least one of metal, dielectric material, semiconductor materials, an alloy of metal, a mixture of dielectric materials, a stack or layering of one or more materials, and/or a core of one type of material and that is coated with a shell of a different type of material. In some embodiments, the outcoupling layer is composed of at least metal nanoparticles wherein the metal is selected from the group consisting of Ag, Al, Au, Ir, Pt, Ni, Cu, W, Ta, Fe, Cr, Mg, Ga, Rh, Ti, Ru, Pd, In, Bi, Ca, alloys or mixtures of these materials, and stacks of these materials. The plurality of nanoparticles may have additional layer disposed over them. In some embodiments, the polarization of the emission can be tuned using the outcoupling layer. Varying the dimensionality and periodicity of the outcoupling layer can select a type of polarization that is preferentially outcoupled to air. In some embodiments the outcoupling layer also acts as an electrode of the device.

In some embodiments, the organic layer may be an emissive layer and the composition A as described herein may be an emissive dopant or a non-emissive dopant.

In some embodiments, the emissive dopant can be a phosphorescent or fluorescent material.

In some embodiments, the non-emissive dopant can also be a phosphorescent or fluorescent material.

Phosphorescence generally refers to emission of a photon with a change in electron spin, i.e., the initial and final states of the emission have different multiplicity, such as from $T_1$ to $S_0$ state. Ir and Pt complexes currently widely used in the OLED belong to phosphorescent material. In some embodiments, if an exciplex formation involves a triplet emitter, such exciplex can also emit phosphorescent light. On the other hand, fluorescent emitters generally refer to emission of a photon without a change in electron spin, such as from $S_1$ to $S_0$ state. Fluorescent emitters can be delayed fluorescent or non-delayed fluorescent emitters. Depending on the spin state, fluorescent emitter can be a singlet emitter or a doublet emitter, or other multiplet emitter. It is believed that the internal quantum efficiency (IQE) of fluorescent

OLEDs can exceed the 25% spin statistics limit through delayed fluorescence. There are two types of delayed fluorescence, i.e. P-type and E-type delayed fluorescence. P-type delayed fluorescence is generated from triplet-triplet annihilation (TTA). On the other hand, E-type delayed fluorescence does not rely on the collision of two triplets, but rather on the thermal population between the triplet states and the singlet excited states. Thermal energy can activate the transition from the triplet state back to the singlet state. This type of delayed fluorescence is also known as thermally activated delayed fluorescence (TADF). E-type delayed fluorescence characteristics can be found in an exciplex system or in a single compound. Without being bound by theory, it is believed that TADF requires a compound or an exciplex having a small singlet-triplet energy gap ($\Delta E_{S-T}$) less than or equal to 300, 250, 200, 150, 100, or 50 meV There are two major types of TADF emitters, one is called donor-acceptor type TADF, the other one is called multiple resonance (MR) TADF. Often, donor-acceptor single compounds are constructed by connecting an electron donor moiety such as amino- or carbazole-derivatives and an electron acceptor moiety such as N-containing six-membered aromatic ring. Donor-acceptor exciplex can be formed between a hole transporting compound and an electron transporting compound. The examples for MR-TADF include a highly conjugated boron-containing compounds. In some embodiments, the reverse intersystem crossing time from T1 to S1 of the delayed fluorescent emission at 293K is less than or equal to 10 microseconds. In some embodiments, such time can be greater than 10 microseconds and less than 100 microseconds.

In some embodiments, the OLED may comprise an additional compound selected from the group consisting of a fluorescence material, a delayed fluorescence material, a phosphorescent material, and combination thereof.

In some embodiments, the phosphorescent material is an emitter which emits light within the OLED. In some embodiments, the phosphorescent material does not emit light within the OLED. In some embodiments, the phosphorescent material energy transfers its excited state to another material within the OLED. In some embodiments, the phosphorescent material participates in charge transport within the OLED. In some embodiments, the phosphorescent material is a sensitizer, and the OLED further comprises an acceptor.

In some embodiments, the fluorescence material or the delayed fluorescence material is an emitter which emits light within the OLED. In some embodiments, the fluorescence material or the delayed fluorescence material does not emit light within the OLED. In some embodiments, the fluorescence material or the delayed fluorescence material energy transfers its excited state to another material within the OLED. In some embodiments, the fluorescence material or the delayed fluorescence material participates in charge transport within the OLED. In some embodiments, the fluorescence material or the delayed fluorescence material is a sensitizer, and the OLED further comprises an acceptor.

In some embodiments, the composition A described herein may be an acceptor, and the OLED may further comprise a sensitizer selected from the group consisting of a delayed fluorescence material, a phosphorescent material, and combination thereof.

In some embodiments, the composition A described herein may be a fluorescent material, a delayed fluorescence material, or a component of an exciplex that is a fluorescent material or a delayed fluorescence material. It should be understood that a fluorescent material or a delayed fluorescence material may be emissive or non-emissive.

In some embodiments, the emissive layer comprises one or more quantum dots.

In some embodiments, the organic layer may further comprise a host, wherein the host comprises a triphenylene containing benzo-fused thiophene or benzo-fused furan, wherein any substituent in the host is an unfused substituent independently selected from the group consisting of $C_nH_{2n+1}$, $OC_nH_{2n+1}$, $OAr_1$, $N(C_nH_{2n+1})_2$, $N(Ar_1)(Ar_2)$, $CH=CH-C_nH_{2n+1}$, $C\equiv CC_nH_{2n+1}$, $Ar_1$, $Ar_1-Ar_2$, $C_nH_{2n}-Ar_1$, or no substitution, wherein n is an integer from 1 to 10; and wherein $Ar_1$ and $Ar_2$ are independently selected from the group consisting of benzene, biphenyl, naphthalene, triphenylene, carbazole, and heteroaromatic analogs thereof.

In some embodiments, the organic layer may further comprise a host, wherein host comprises at least one chemical group selected from the group consisting of triphenylene, carbazole, indolocarbazole, dibenzothiophene, dibenzofuran, dibenzoselenophene, 5$\lambda^2$-benzo[d]benzo[4,5]imidazo[3,2-a]imidazole, 5,9-dioxa-13b-boranaphtho[3,2,1-de]anthracene, azaborinine, oxaborinine, dihydroacridine, xanthene, dihydrobenzoazasiline, dibenzooxasiline, phenoxazine, phenoxathiine, phenothiazine, dihydrophenazine, fluorene, naphthalene, anthracene, phenanthrene, phenanthroline, benzoquinoline, quinoline, isoquinoline, quinazoline, pyrimidine, pyrazine, pyridine, triazine, boryl, silyl, aza-triphenylene, aza-carbazole, aza-indolocarbazole, aza-dibenzothiophene, aza-dibenzofuran, aza-dibenzoselenophene, aza-5$\lambda^2$-benzo[d]benzo[4,5]imidazo[3,2-a]imidazole, and aza-(5,9-dioxa-13b-boranaphtho[3,2,1-de]anthracene).

In some embodiments, the host can be selected from the group consisting of the structures of the following HOST Group 1:

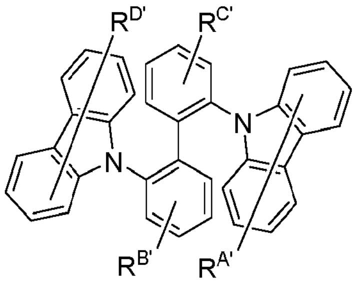 , 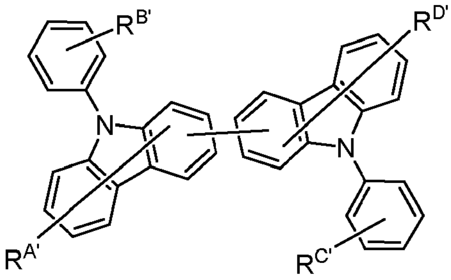 , 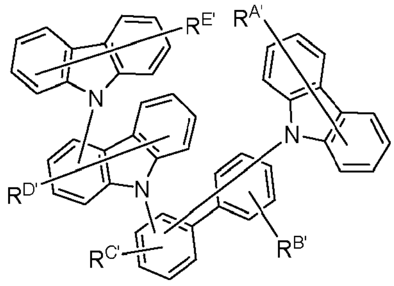 ,

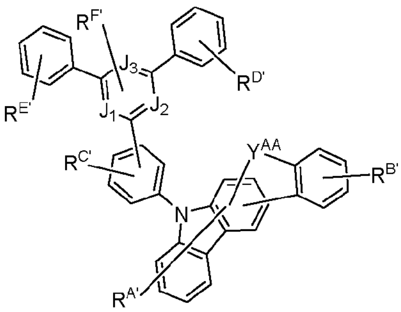 , 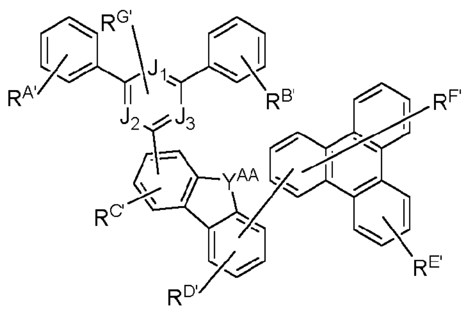 , 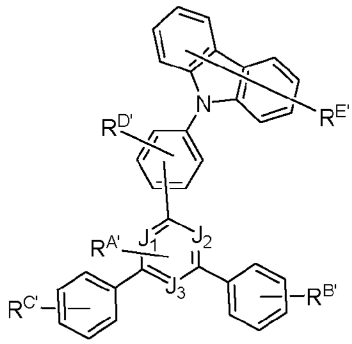

, 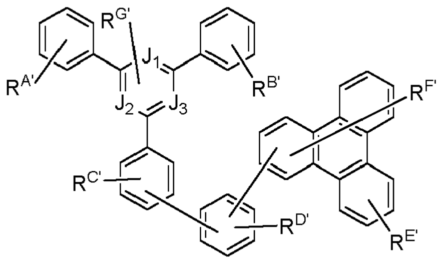 , 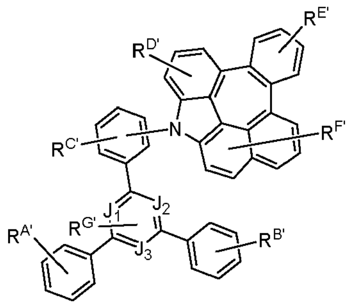 ,

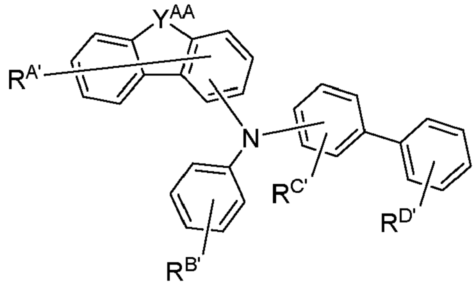 , 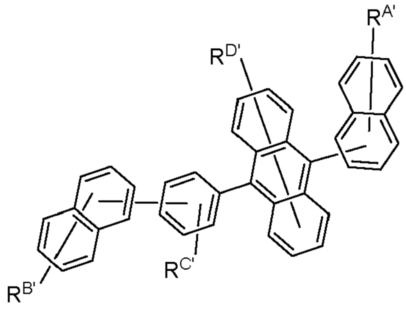 ,

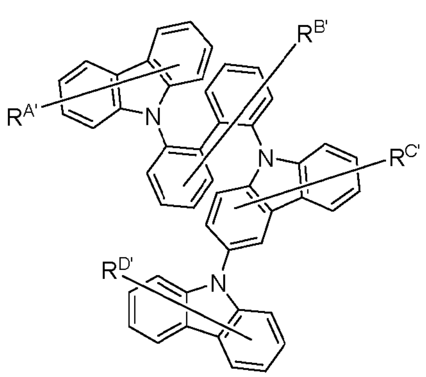,
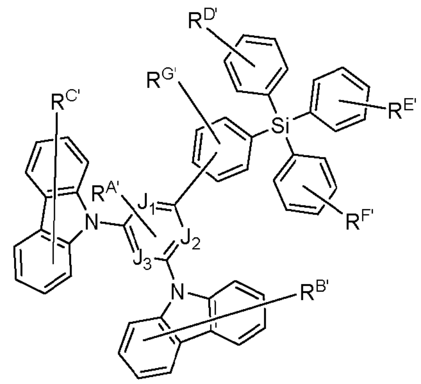,
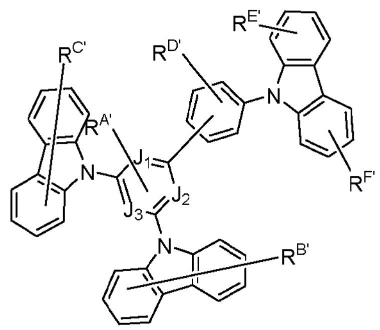,

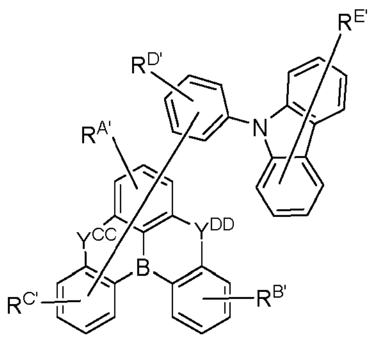,
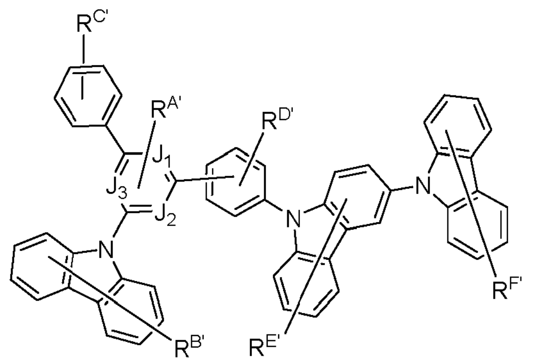,
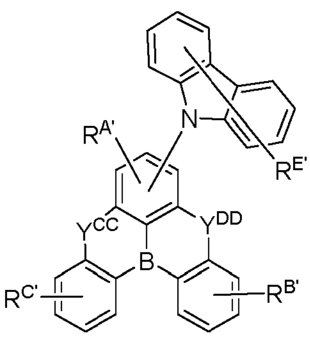,

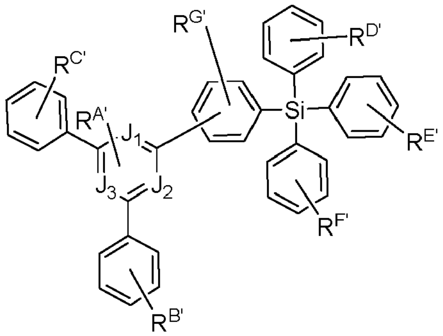,
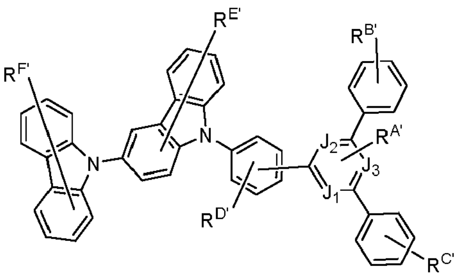,

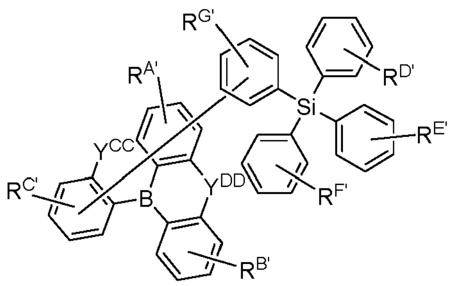,
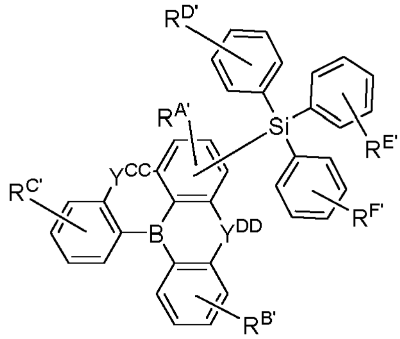,

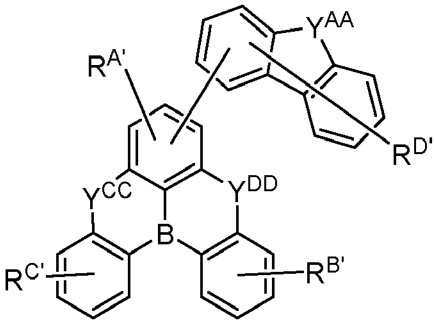

,

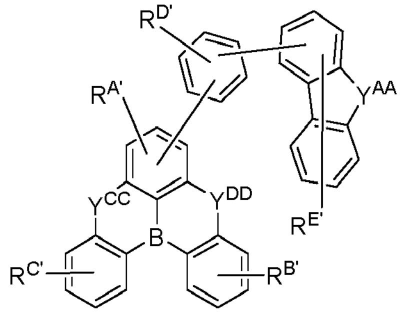

,

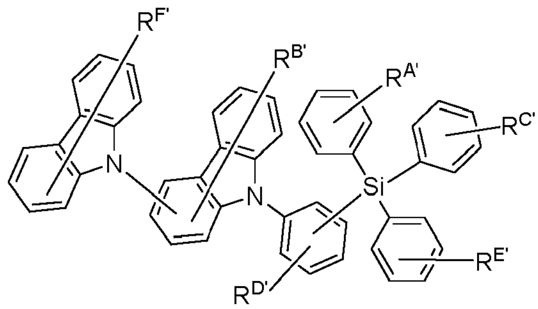

,

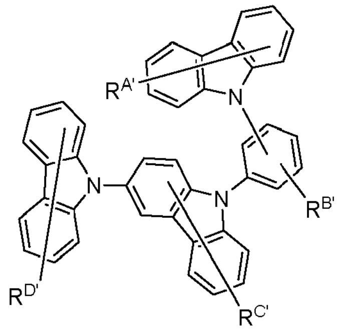

,

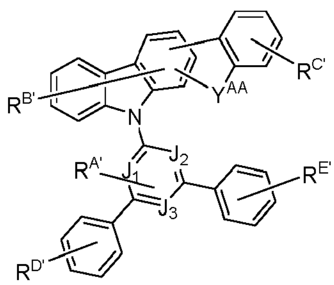

,

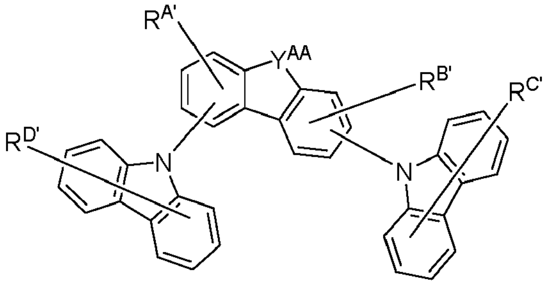

,

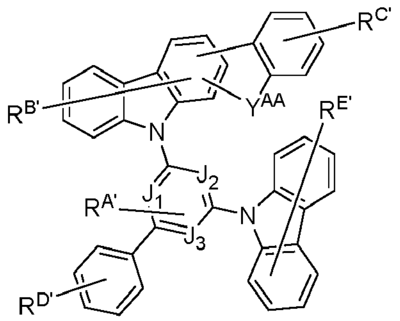

,

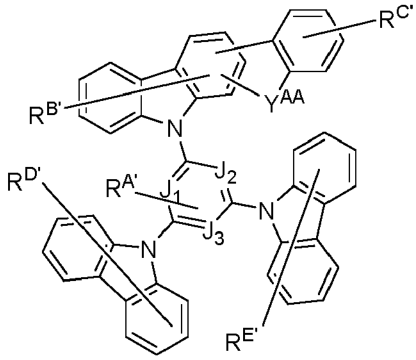

,

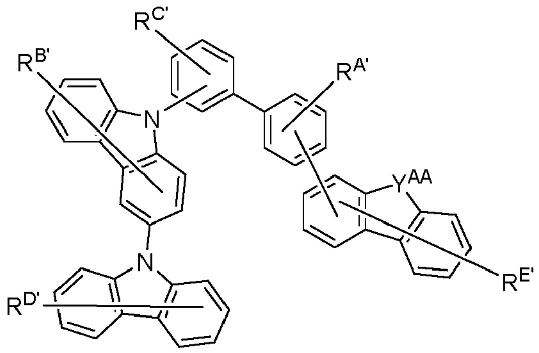

,

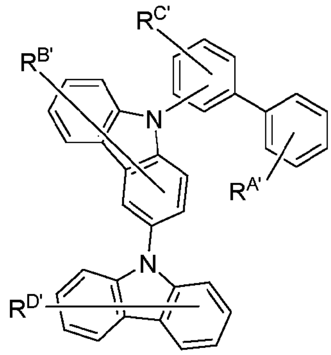,
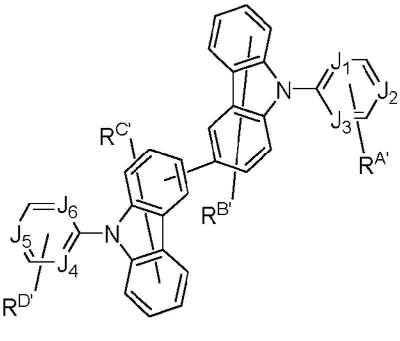,
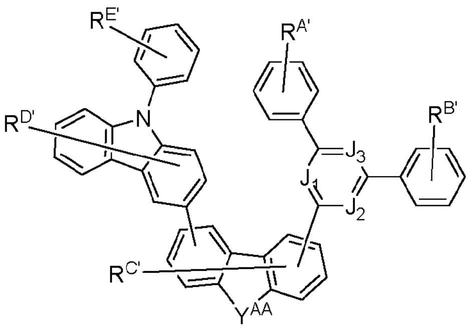,

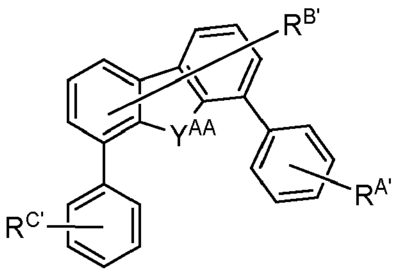,
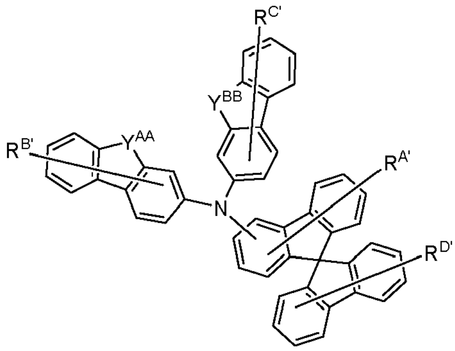,
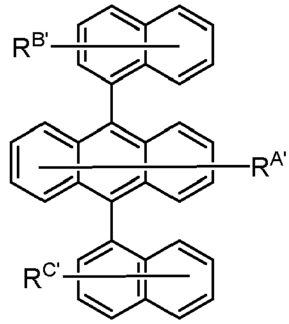,

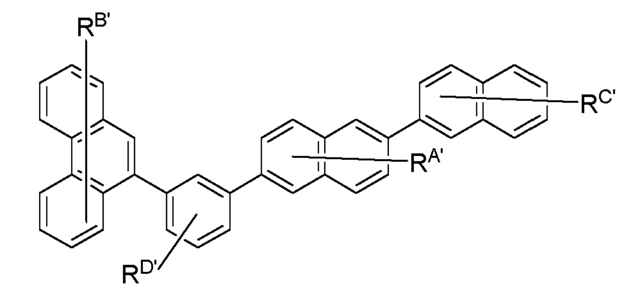,
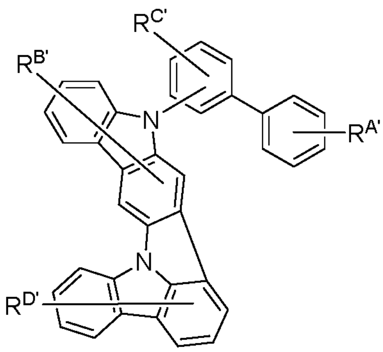,

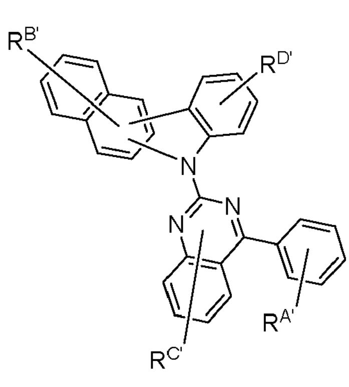,
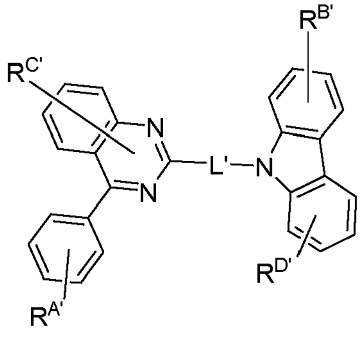,
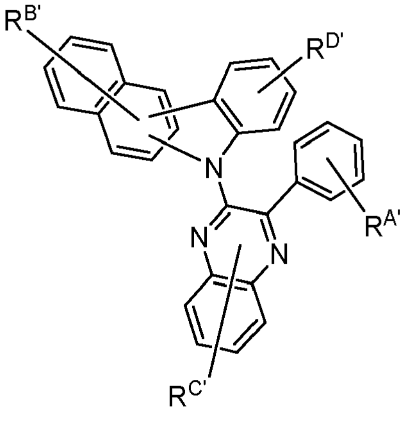,

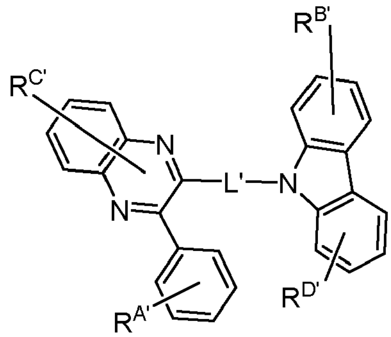,
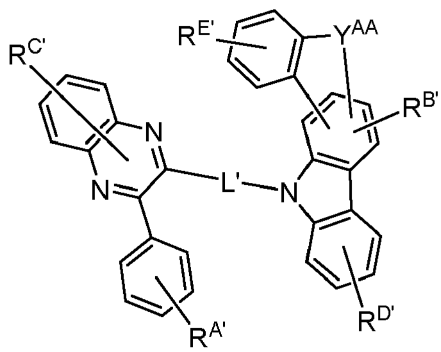,
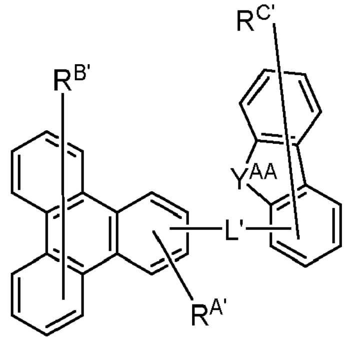,

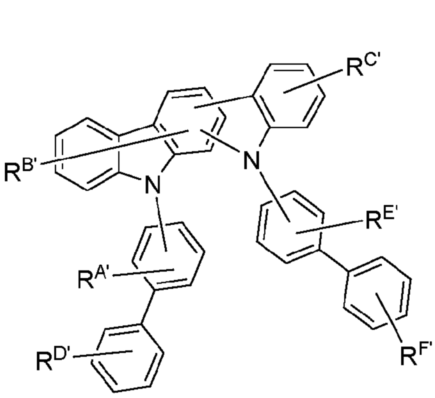,
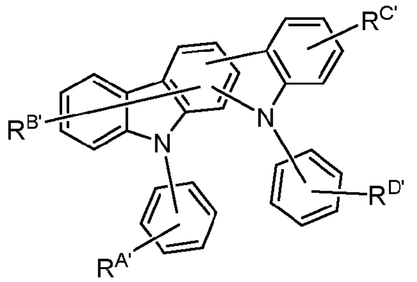,
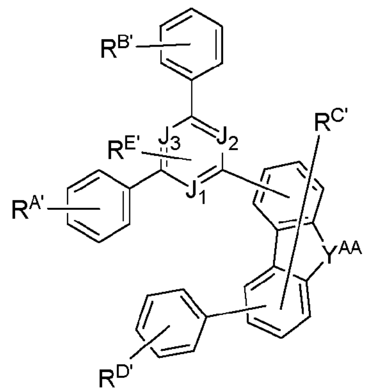,

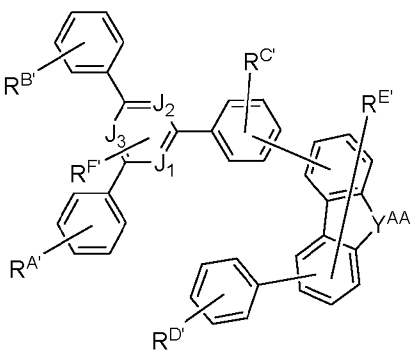,
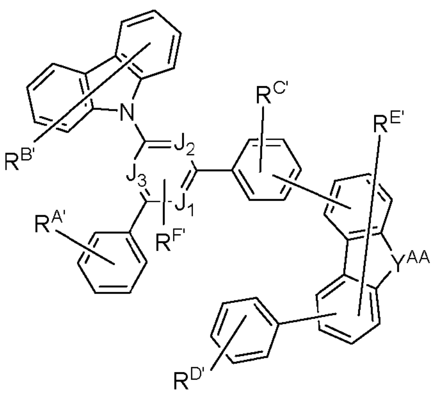,
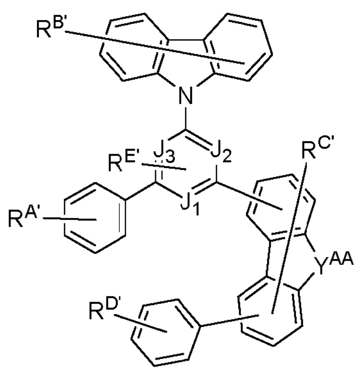,

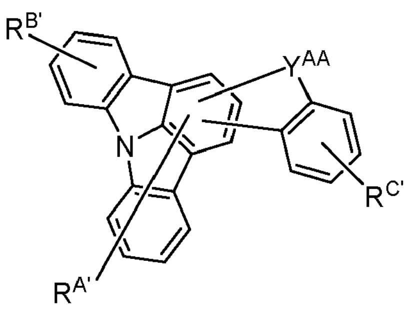,
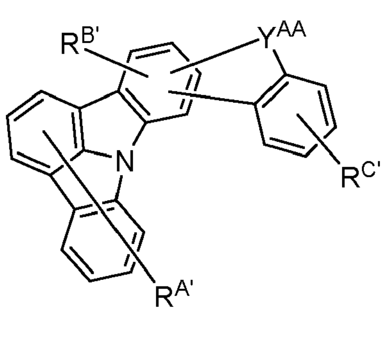,
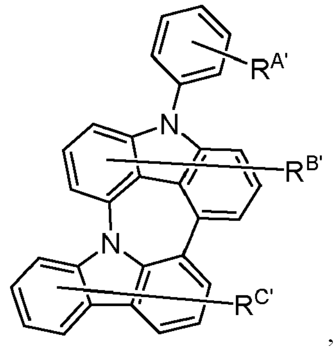,

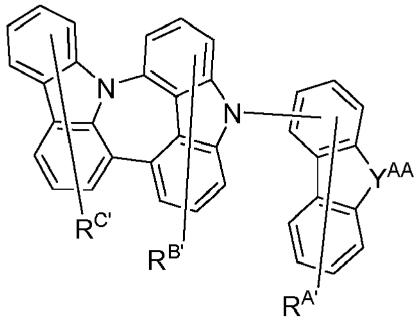
,
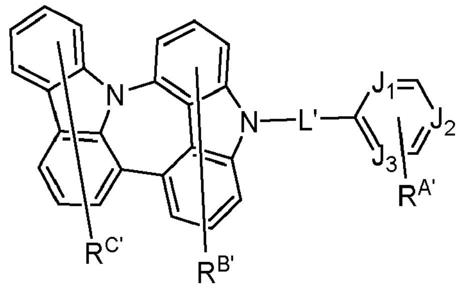
,
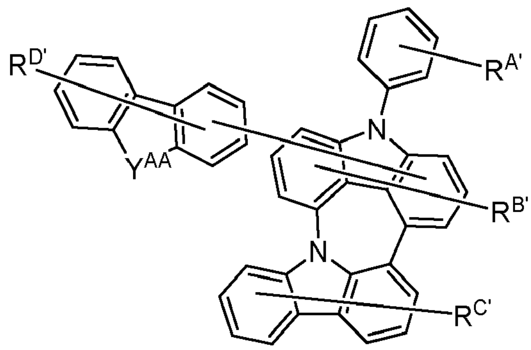
,
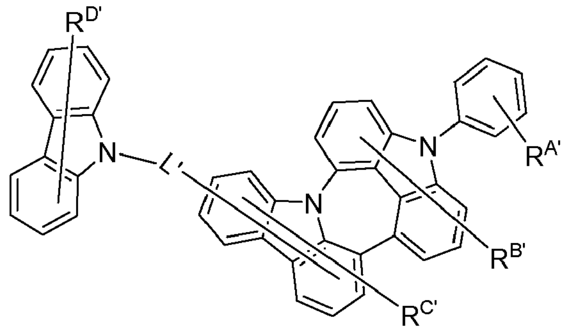
,
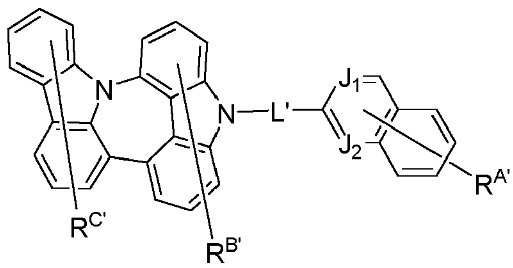
,
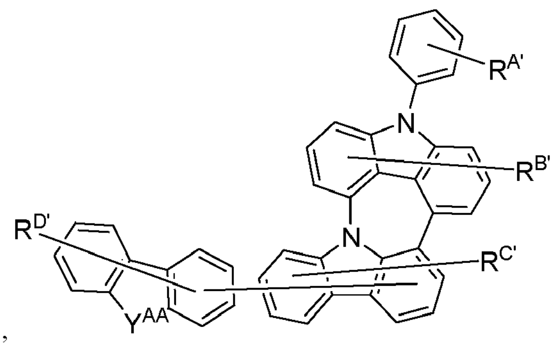
,
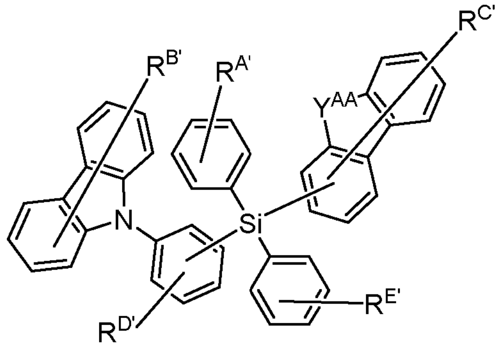
,
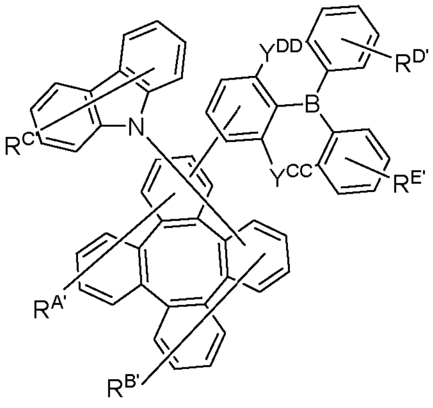
,
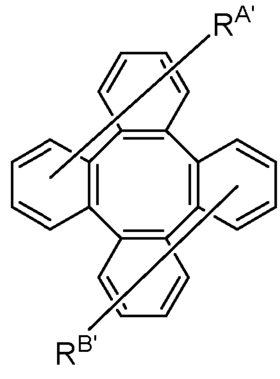
,

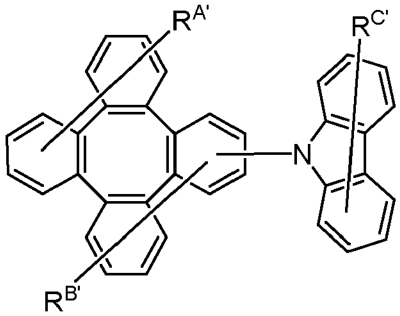,

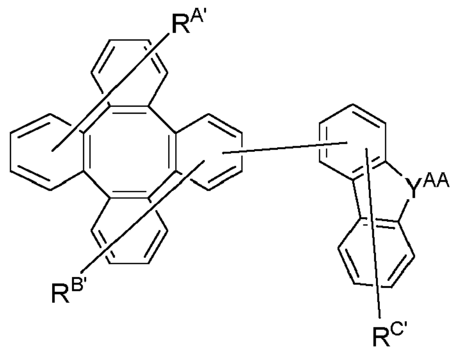,

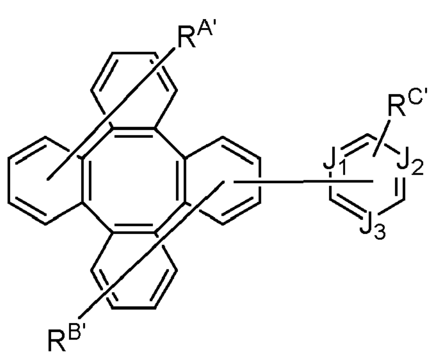,

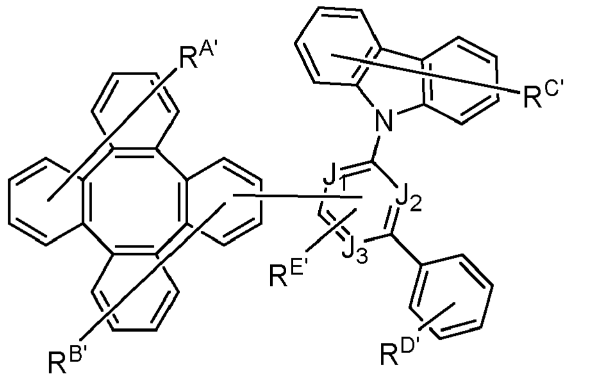,

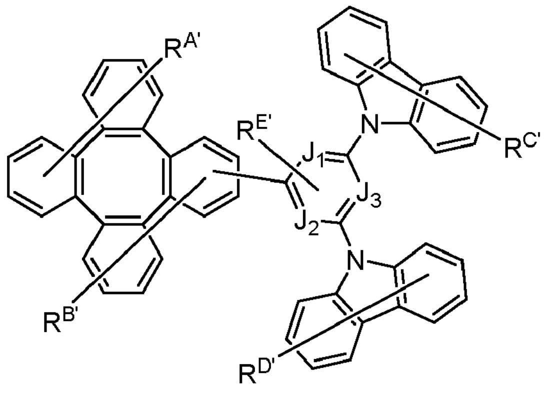,

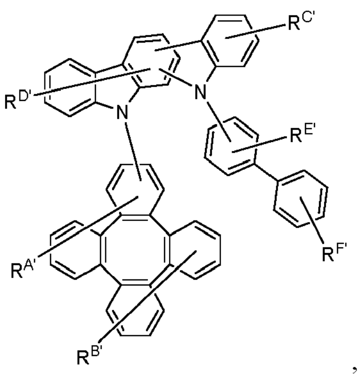,

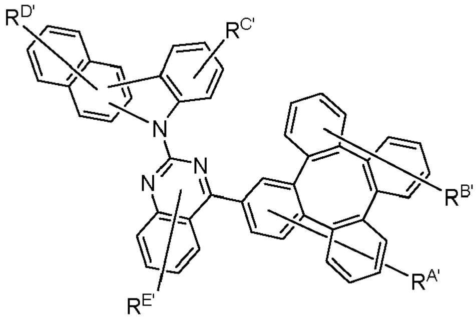,

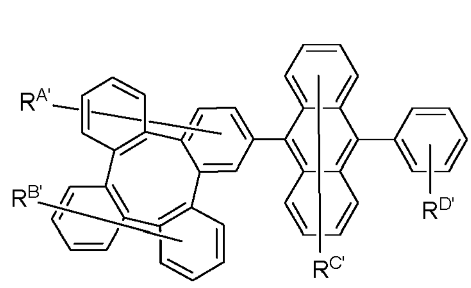,

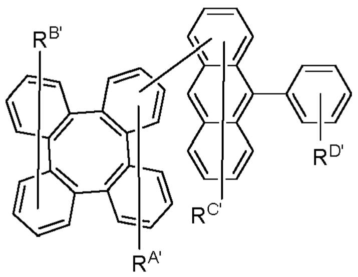
,
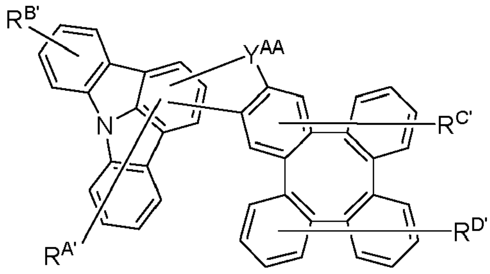
, and

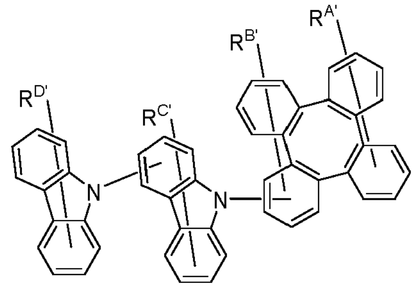
,

wherein:

each of $J_1$ to $J_6$ is independently C or N;
L' is a direct bond or an organic linker;
each $Y^{AA}$, $Y^{BB}$, $Y^{CC}$, and $Y^{DD}$ is independently selected from the group consisting of absent a bond, direct bond, O, S, Se, CRR', SiRR', GeRR', NR, BR, BRR';
each of $R^{A'}$, $R^{B'}$, $R^{C'}$, $R^{D'}$, $R^{E'}$, $R^{F'}$, and $R^{G'}$ independently represents mono, up to the maximum substitutions, or no substitutions;
each R, R', $R^{A'}$, $R^{B'}$, $R^{C'}$, $R^{D'}$, $R^{E'}$, $R^{F'}$, and $R^{G'}$ is independently a hydrogen or a substituent selected from the group consisting of the General Substituents as defined herein; any two substituents can be joined or fused to form a ring; and where possible, each unsubstituted aromatic carbon atom is optionally replaced with N to form an aza-substituted ring.

In some embodiments at least one of $J_1$ to $J_3$ is N. In some embodiments at least two of $J_1$ to $J_3$ are N. In some embodiments, all three of $J_1$ to $J_3$ are N. In some embodiments, each $Y^{CC}$ and $Y^{DD}$ is independently O, S, or SiRR', or more preferably O or S. In some embodiments, at least one unsubstituted aromatic carbon atom is replaced with N to form an aza-ring.

In some embodiments, the host is selected from the group consisting of EG*1*-MG*1*-EG*1* to EG*53*-MG*27*-EG*53* with a formula of EG*a*-MG*b*-EG*c*, or EG*1*-EG*1* to EG*53*-EG*53* with a formula of EG*a*-EG*c* when MG*b* is absent, wherein $\alpha$ is an integer from 1 to 53, *b* is an integer from 1 to 27, *c* is an integer from 1 to 53. The structure of EG1 to EG53 is shown below:

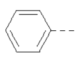
EG1 ,
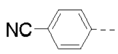
EG2 ,
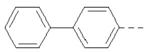
EG3 ,
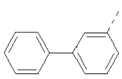
EG4 ,
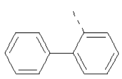
EG5 ,
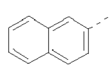
EG6 ,
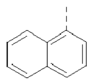
EG7 ,
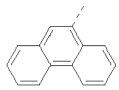
EG8 ,
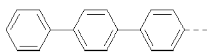
EG9 ,

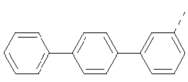
EG10 ,
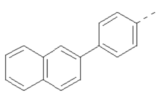
EG11 ,
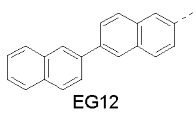
EG12 ,
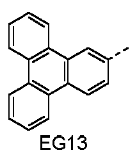
EG13 ,
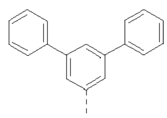
EG14 ,
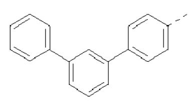
EG15 ,
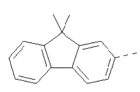
EG16 ,

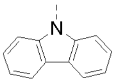 EG17, 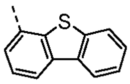 EG18, 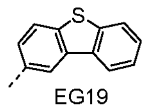 EG19, 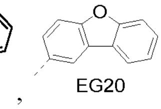 EG20, 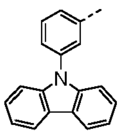 EG21, 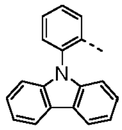 EG22, 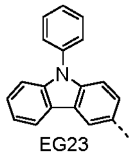 EG23, 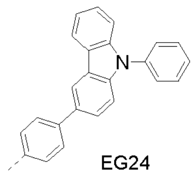 EG24,

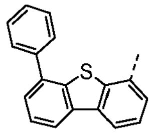 EG25, 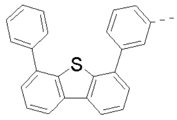 EG26, 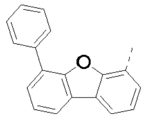 EG27, 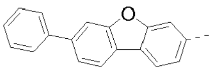 EG28, 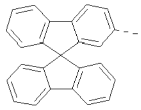 EG29, 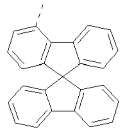 EG30, 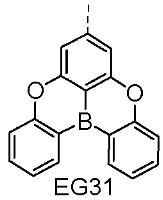 EG31,

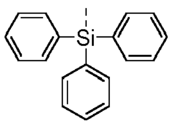 EG32, 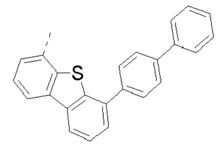 EG33, 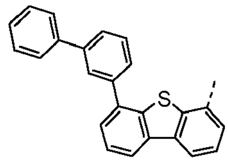 EG34, 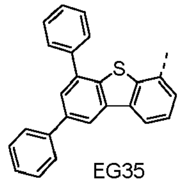 EG35, 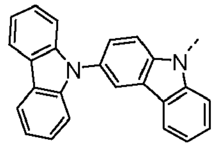 EG36, 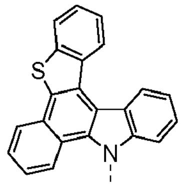 EG37,

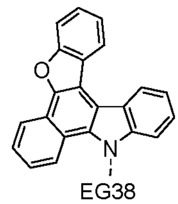 EG38, 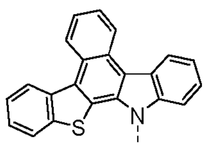 EG39, 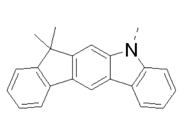 EG40, 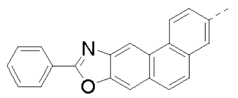 EG41, 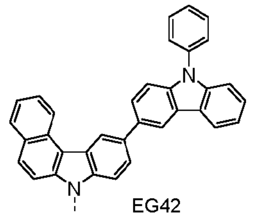 EG42, 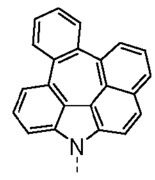 EG43,

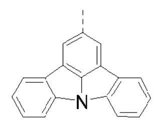 EG44, 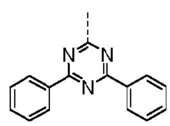 EG45, 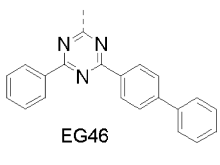 EG46, 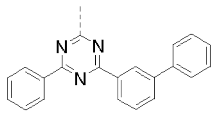 EG47, 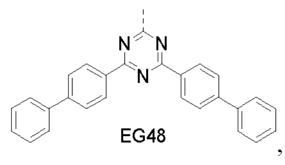 EG48, 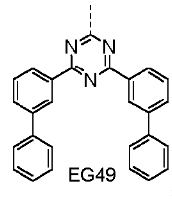 EG49,

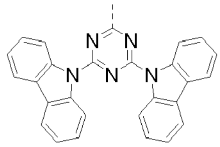 EG50, 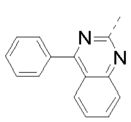 EG51, 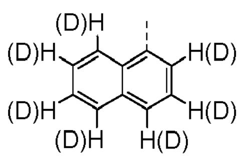 E52, 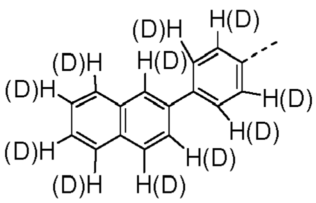 EG53.

The structure of MG1 to MG27 is shown below:

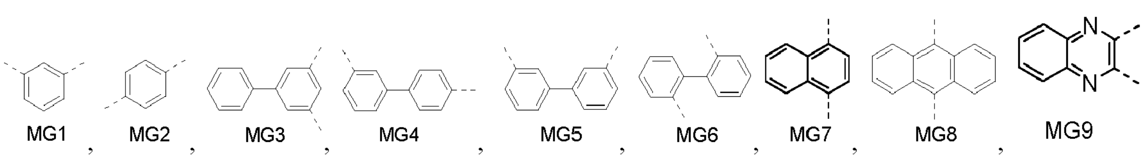
MG1, MG2, MG3, MG4, MG5, MG6, MG7, MG8, MG9,

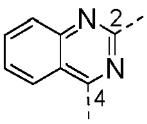
MG10 ,
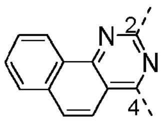
MG11 ,
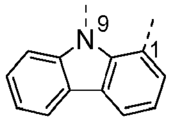
MG12 ,
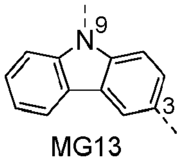
MG13 ,
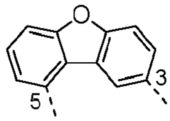
MG14 ,
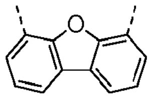
MG15 ,
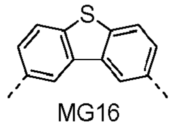
MG16 ,

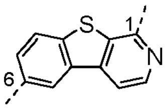
MG17 ,
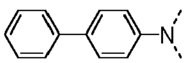
MG18 ,
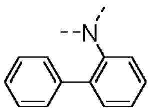
MG19 ,
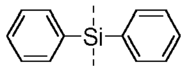
MG20 ,
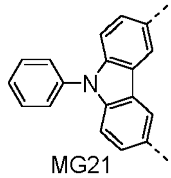
MG21 ,
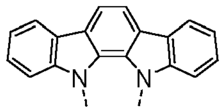
MG22 ,

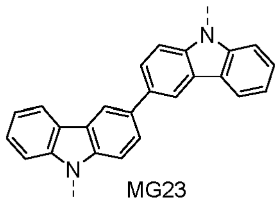
MG23 ,
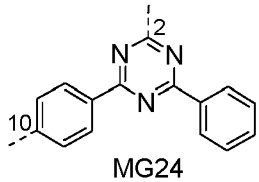
MG24 ,
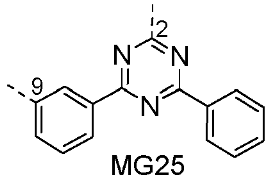
MG25 ,
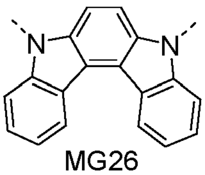
MG26 ,

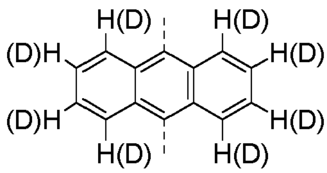
MG27 .

In the MG*b* structures shown above, the two bonding positions in the asymmetric structures MG10, MG11, MG12, MG13, MG14, MG17, MG24, and MG25 are labeled with numbers for identification purposes.

In some embodiments, the host can be any of the aza-substituted variants thereof, fully or partially deuterated variants thereof, and combinations thereof. In some embodiments, the host has formula EG*a*-MG*b*-Eg*c* and is selected from the group consisting of *h1* to *h112* defined in the following HOST Group 2 list, where each of MG*b*, EG*a*, and EG*c* are defined as follows:

| ***h*** | **MG*b*** | **EG*a*** | **EG*c*** | ***A*** | **MG*b*** | **EG*a*** | **EG*c*** | ***h*** | **MG*b*** | **EG*a*** | **EG*c*** |
|---|---|---|---|---|---|---|---|---|---|---|---|
| ***h1*** | MG1 | EG3 | EG36 | ***h39*** | MG13 | *3*-EG17 | 9-EG4 | ***h77*** | MG23 | EG3 | EG4 |
| ***h2*** | MG1 | EG8 | EG12 | ***h40*** | MG13 | *3*-EG17 | 9-EG13 | ***h78*** | MG23 | EG3 | EG5 |
| ***h3*** | MG1 | EG13 | EG14 | ***h41*** | MG13 | *3*-EG17 | *9*-EG31 | ***h79*** | MG23 | EG4 | EG4 |
| ***h4*** | MG1 | EG13 | EG18 | ***h42*** | MG13 | *3*-EG17 | *9*-EG45 | ***h80*** | MG23 | EG4 | EG5 |
| ***h5*** | MG1 | EG13 | EG25 | ***h43*** | MG13 | *3*-EG17 | *9*-EG46 | ***h81*** | MG24 | 2-EG1 | *10*-EG33 |
| ***h6*** | MG1 | EG13 | EG36 | ***h44*** | MG13 | *3*-EG17 | *9*-EG48 | ***h82*** | MG24 | 2-EG4 | *10*-EG36 |
| ***h7*** | MG1 | EG22 | EG36 | ***h45*** | MG13 | *3*-EG17 | *9*-EG49 | ***h83*** | MG24 | 2-EG21 | *10*-EG36 |
| ***h8*** | MG1 | EG25 | EG46 | ***h46*** | MG13 | *3*-EG32 | *9*-EG31 | ***h84*** | MG24 | 2-EG23 | *10*-EG36 |
| ***h9*** | MG1 | EG27 | EG46 | ***h47*** | MG13 | *3*-EG44 | *9*-EG3 | ***h85*** | MG25 | 2-EG1 | *9*-EG33 |

(continued)

| ***h*** | **MG*b*** | **EG*a*** | **EG*c*** | ***A*** | **MG*b*** | **EG*a*** | **EG*c*** | ***h*** | **MG*b*** | **EG*a*** | **EG*c*** |
|---|---|---|---|---|---|---|---|---|---|---|---|
| ***h10*** | MG1 | EG27 | EG48 | ***h48*** | MG14 | *3*-EG13 | *5*-EG45 | ***h86*** | MG25 | 2-EG3 | *9*-EG36 |
| ***h11*** | MG1 | EG32 | EG50 | ***h49*** | MG14 | *3*-EG23 | *5*-EG45 | ***h87*** | MG25 | 2-EG4 | *9*-EG36 |
| ***h12*** | MG1 | EG35 | EG46 | ***h50*** | MG15 | EG3 | EG48 | ***h88*** | MG25 | 2-EG17 | *9*-EG27 |
| ***h13*** | MG1 | EG36 | EG45 | ***h51*** | MG15 | EG17 | EG31 | ***h89*** | MG25 | 2-EG17 | *9*-EG36 |
| ***h14*** | MG1 | EG36 | EG49 | ***h52*** | MG15 | EG31 | EG36 | ***h90*** | MG25 | 2-EG21 | *9*-EG36 |
| ***h15*** | MG1 | EG40 | EG45 | ***h53*** | MG 16 | EG17 | EG17 | ***h91*** | MG25 | 2-EG23 | *9*-EG27 |
| ***h16*** | MG2 | EG3 | EG36 | ***h54*** | MG17 | EG17 | EG17 | ***h92*** | MG25 | 2-EG23 | *9*-EG36 |
| ***h17*** | MG2 | EG25 | EG31 | ***h55*** | MG18 | EG16 | EG24 | ***h93*** | MG26 | EG1 | EG9 |
| ***h18*** | MG2 | EG31 | EG33 | ***h56*** | MG18 | EG16 | EG30 | ***h94*** | MG26 | EG1 | EG10 |
| ***h19*** | MG2 | EG36 | EG45 | ***h57*** | MG18 | EG20 | EG41 | ***h95*** | MG26 | EG1 | EG21 |
| ***h20*** | MG2 | EG36 | EG46 | ***h58*** | MG19 | EG16 | EG29 | ***h96*** | MG26 | EG1 | EG23 |
| ***h21*** | MG3 | EG4 | EG36 | ***h59*** | MG20 | EG1 | EG31 | ***h97*** | MG26 | EG1 | EG26 |
| ***h22*** | MG3 | EG34 | EG45 | ***h60*** | MG20 | EG17 | EG18 | ***h98*** | MG26 | EG3 | EG3 |
| ***h23*** | MG4 | EG13 | EG17 | ***h61*** | MG21 | EG23 | EG23 | ***h99*** | MG26 | EG3 | EG9 |
| ***h24*** | MG5 | EG13 | EG45 | ***h62*** | MG22 | EG1 | EG45 | ***h100*** | MG26 | EG3 | EG23 |
| ***h25*** | MG5 | EG17 | EG36 | ***h63*** | MG22 | EG1 | EG46 | ***h101*** | MG26 | EG3 | EG26 |
| ***h26*** | MG5 | EG18 | EG36 | ***h64*** | MG22 | EG3 | EG46 | ***h102*** | MG26 | EG4 | EG10 |
| ***h27*** | MG6 | EG17 | EG17 | ***h65*** | MG22 | EG4 | EG46 | ***h103*** | MG26 | EG5 | EG10 |
| ***h28*** | MG7 | EG43 | EG45 | ***h66*** | MG22 | EG4 | EG47 | ***h104*** | MG26 | EG6 | EG10 |
| ***h29*** | MG8 | EG1 | EG28 | ***h67*** | MG22 | EG9 | EG45 | ***h105*** | MG26 | EG10 | EG10 |
| ***h30*** | MG8 | EG6 | EG7 | ***h68*** | MG23 | EG1 | EG3 | ***h106*** | MG26 | EG10 | EG14 |
| ***h31*** | MG8 | EG7 | EG7 | ***h69*** | MG23 | EG1 | EG6 | ***h107*** | MG26 | EG10 | EG15 |
| ***h32*** | MG8 | EG7 | EG11 | ***h70*** | MG23 | EG1 | EG14 | ***h108*** | MG27 | EG52 | EG53 |
| ***h33*** | MG9 | EG1 | EG43 | ***h71*** | MG23 | EG1 | EG18 | ***h109*** | - | EG13 | EG18 |
| ***h34*** | MG10 | *4*-EG1 | 2-EG37 | ***h72*** | MG23 | EG1 | EG19 | ***h110*** | - | EG17 | EG31 |
| ***h35*** | MG10 | *4*-EG1 | 2-EG38 | ***h73*** | MG23 | EG1 | EG23 | ***h111*** | - | EG17 | EG50 |
| ***h36*** | MG10 | EG1 | EG42 | ***h74*** | MG23 | EG1 | EG51 | ***h112*** | - | EG40 | EG45 |
| ***h37*** | MG11 | *4*-EG1 | 2-EG39 | ***h75*** | MG23 | EG2 | EG18 | | | | |
| ***h38*** | MG12 | *1*-EG17 | *9*-EG31 | ***h76*** | MG23 | EG3 | EG3 | | | | |

In the table above, the EG*a* and EG*c* structures that are bonded to one of the asymmetric structures MG10, MG11, MG12, MG13, MG14, MG17, MG24, and MG25, are noted with a numeric prefix identifying their bonding position in the MG*b* structure.

In some embodiments, the host can be selected from the group consisting of the structures of the following HOST Group 1a:

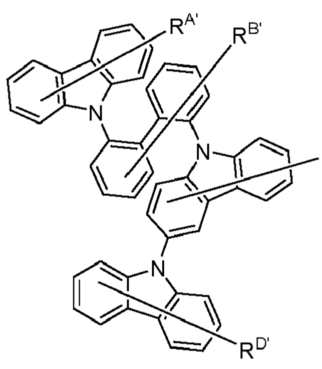 , 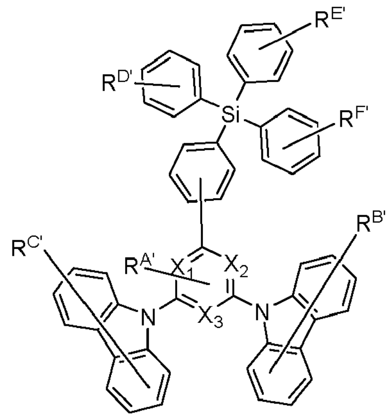 ,

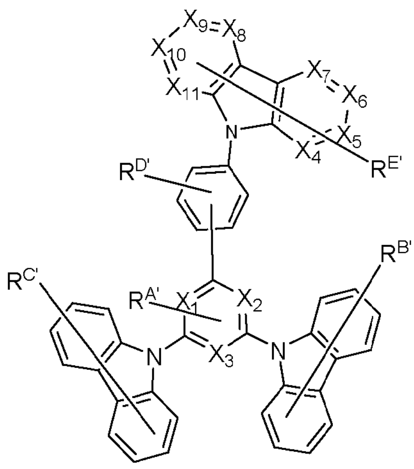 , 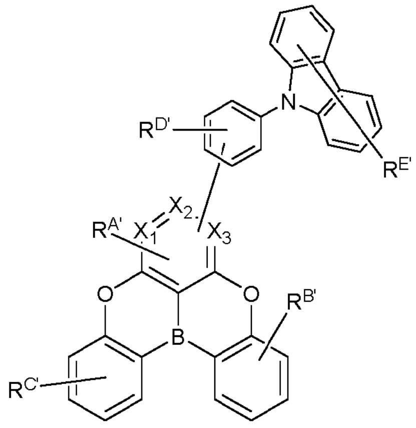 , 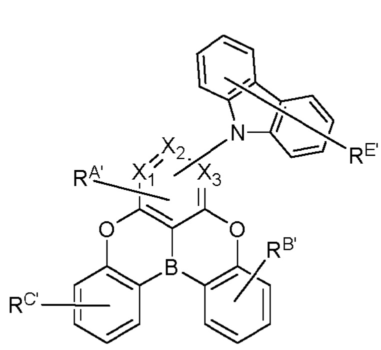 ,

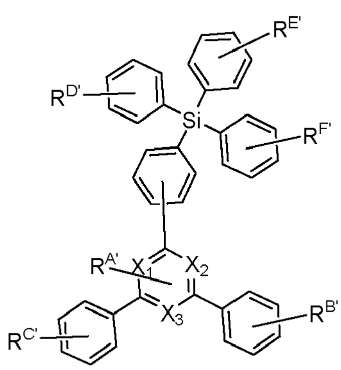 , 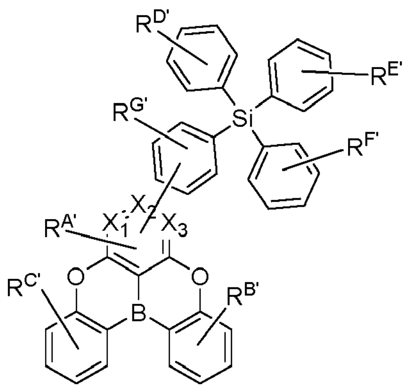 , 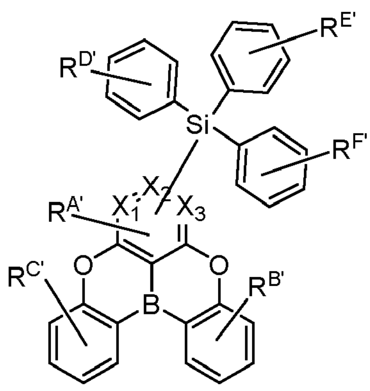 ,

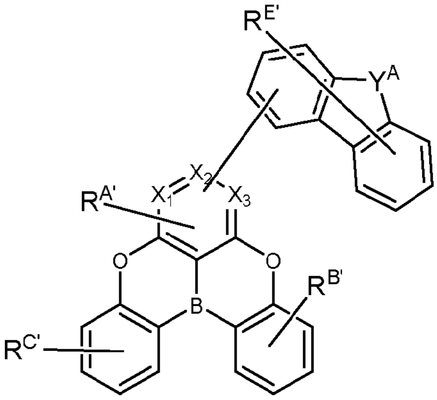,

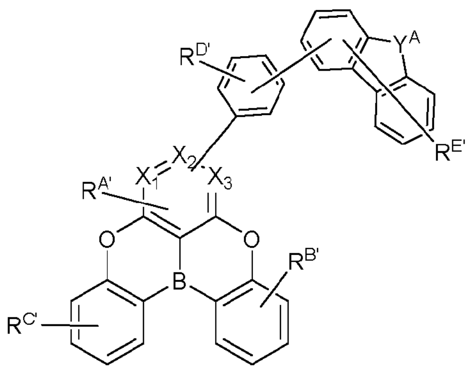,

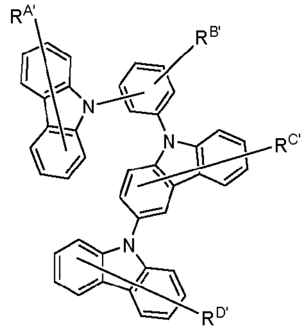,

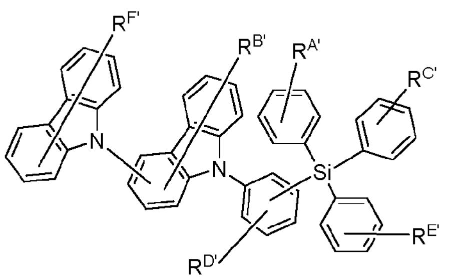,

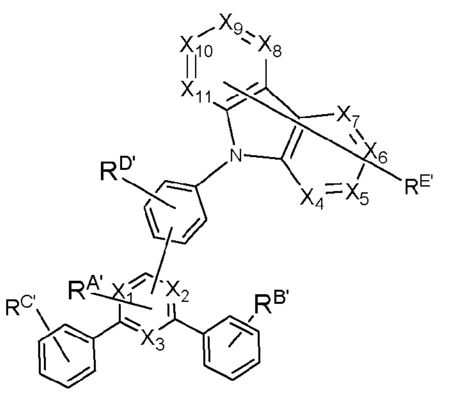,

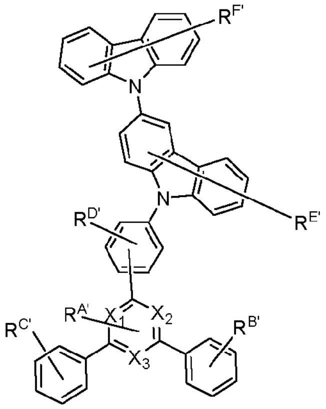,

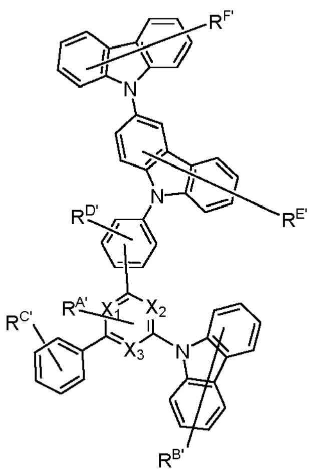,

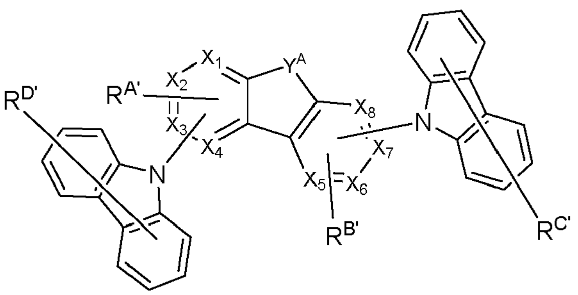,

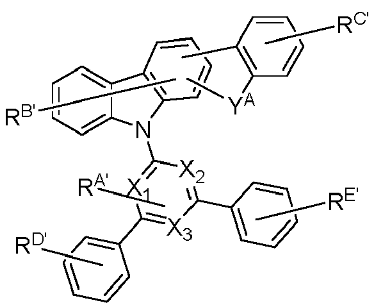,
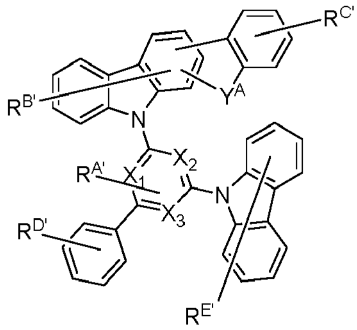,
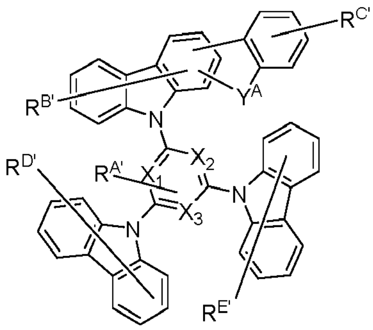,

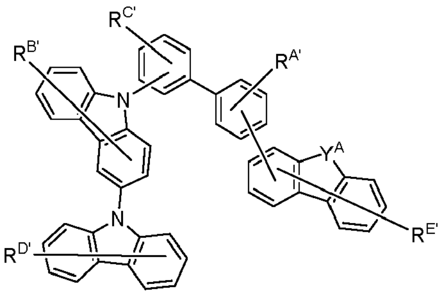,
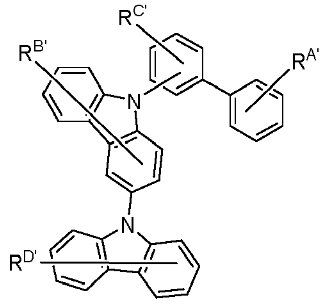,
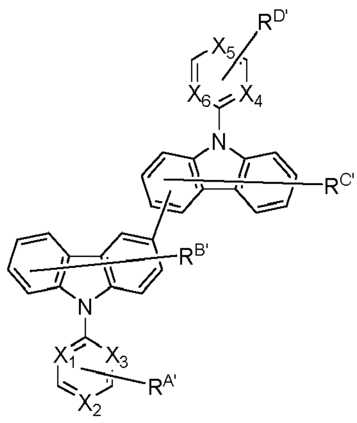,

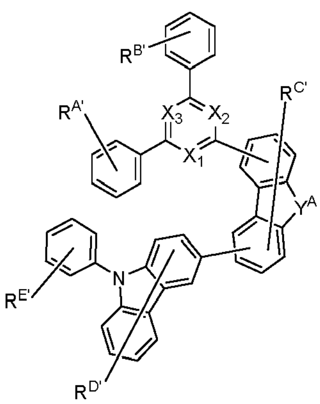,
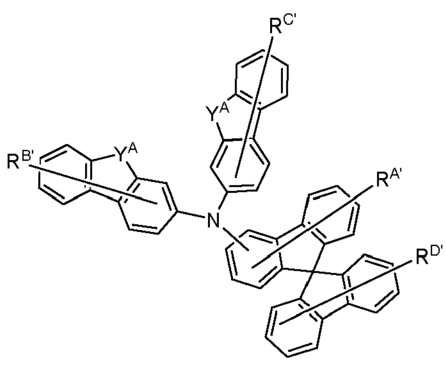,
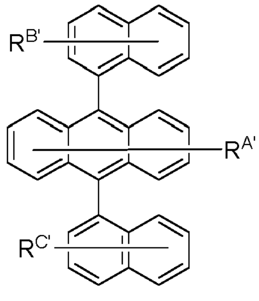,

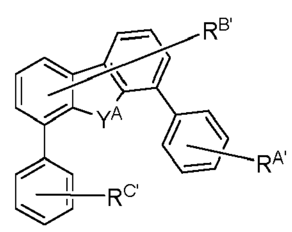,
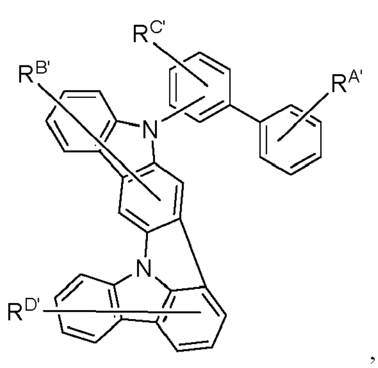,
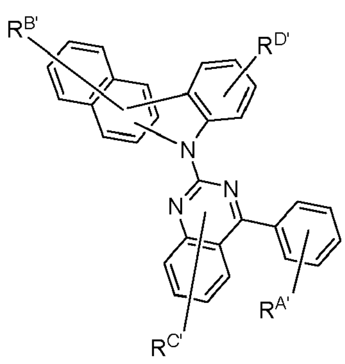,

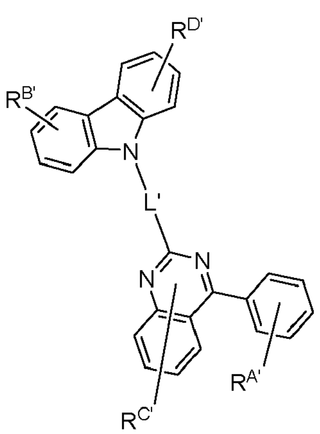,
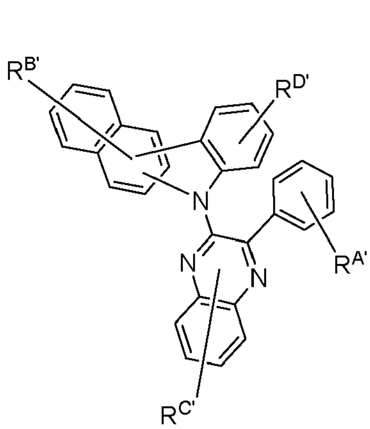,
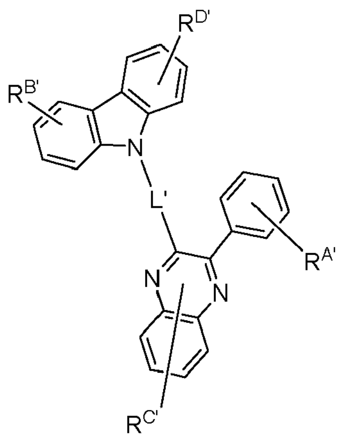,

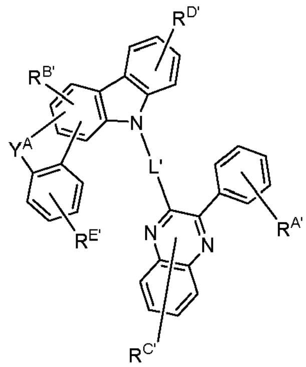,
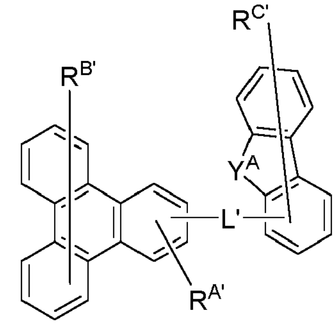,
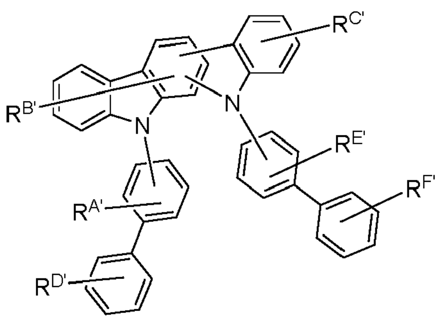,

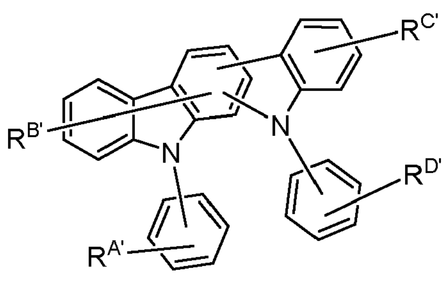,
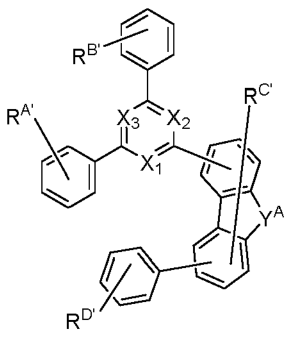,
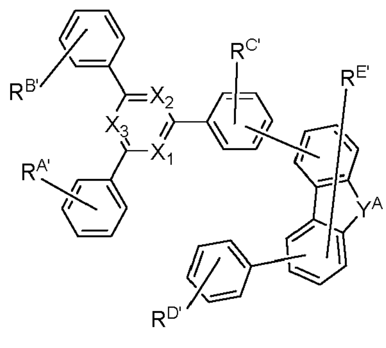,

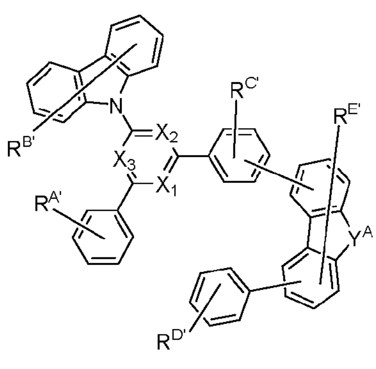,
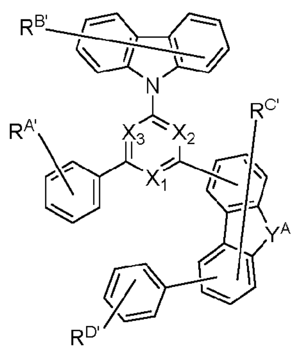,
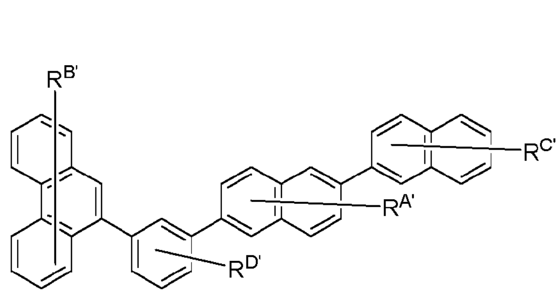

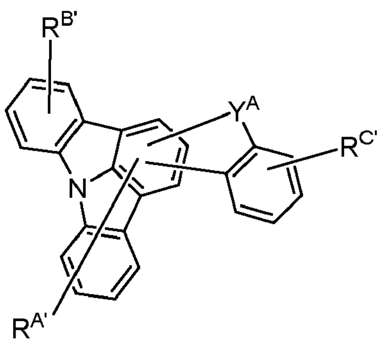

,

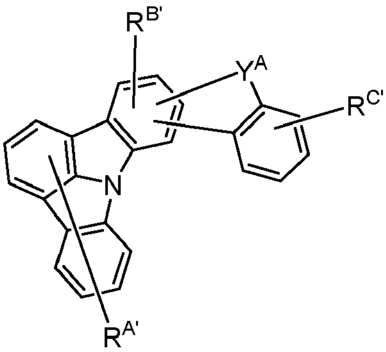

,

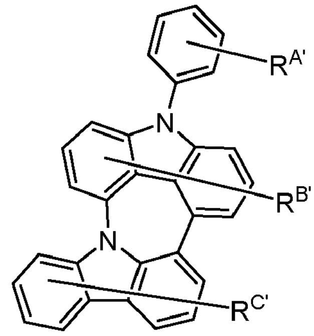

,

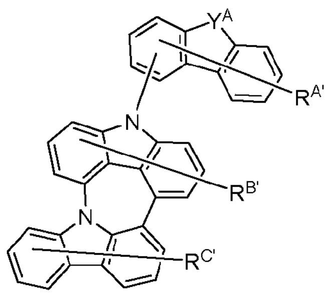

,

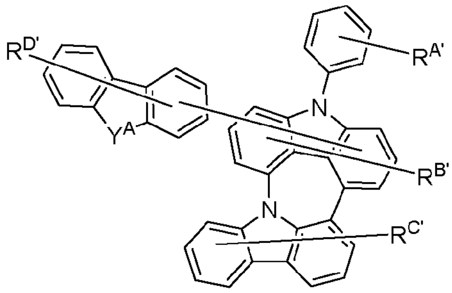

,

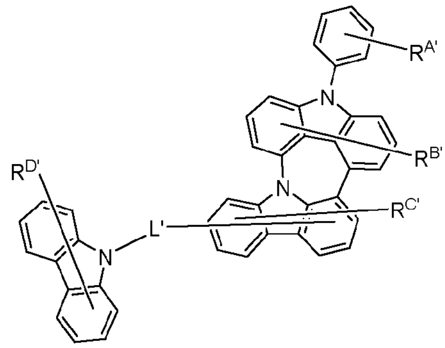

,

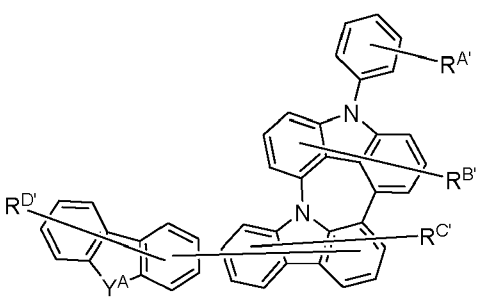

,

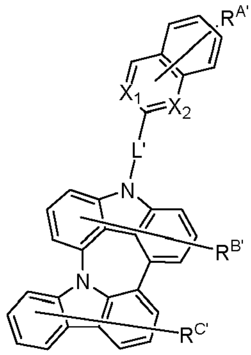

,

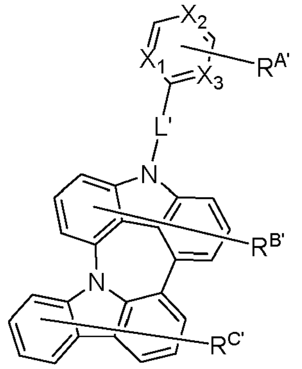

,

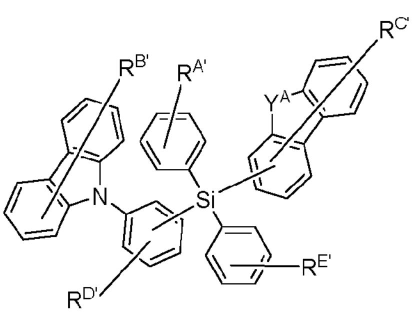

,

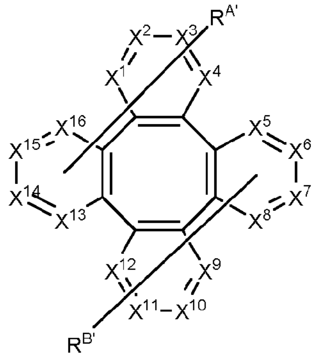

,

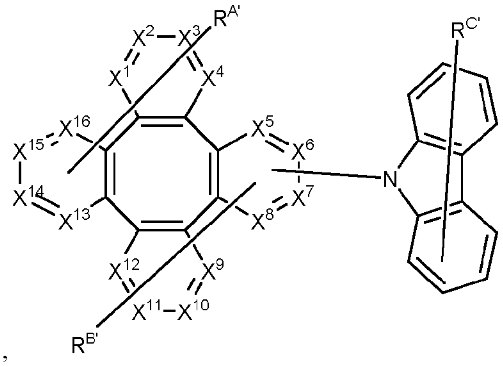

, 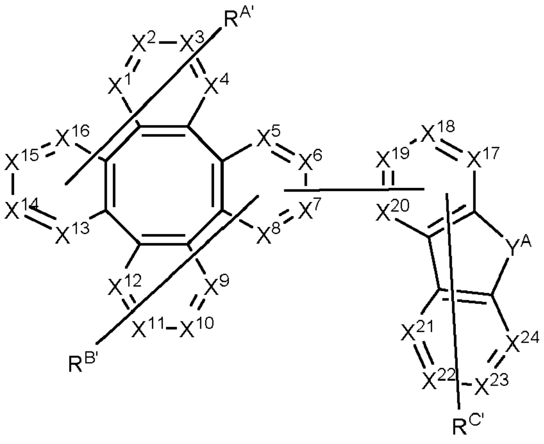 , 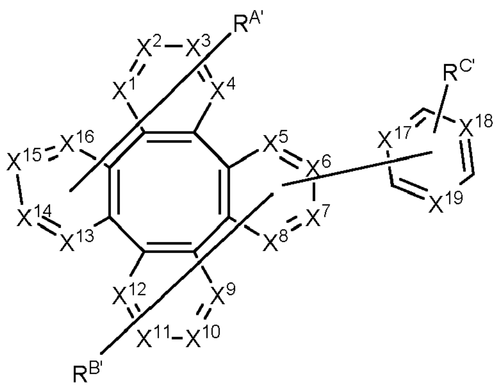 ,

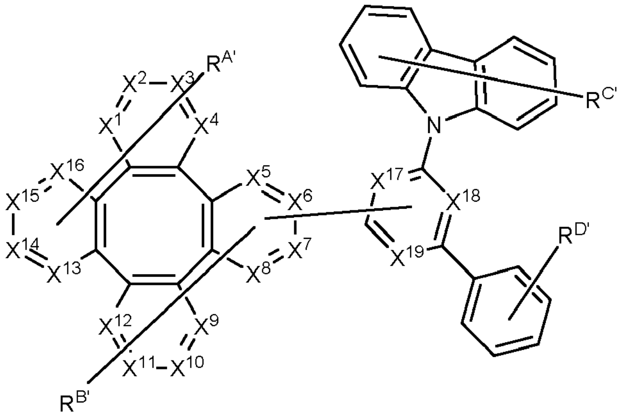 , 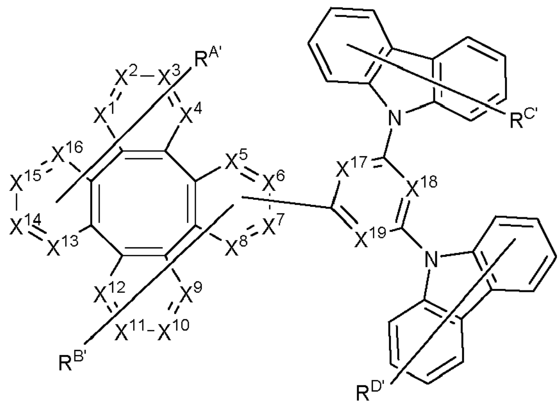 ,

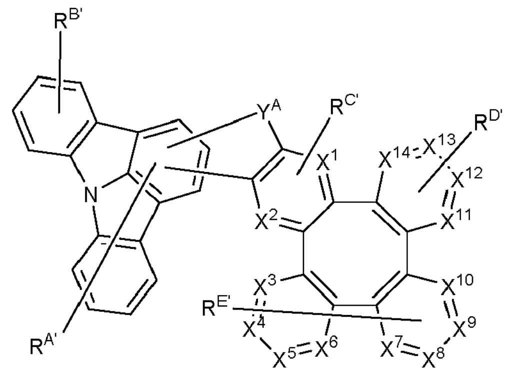 , 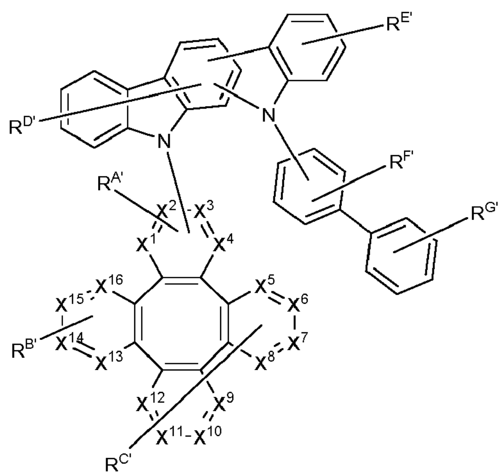 ,

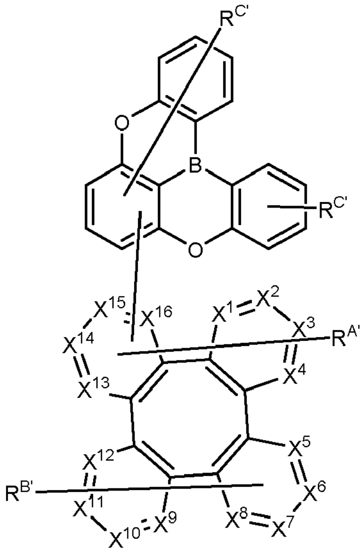 , 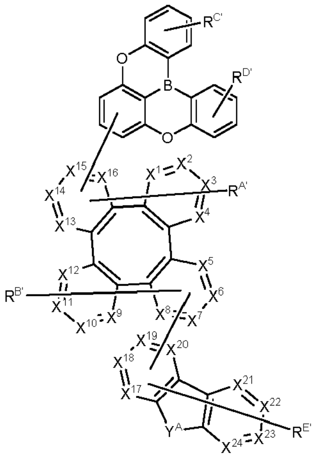 , 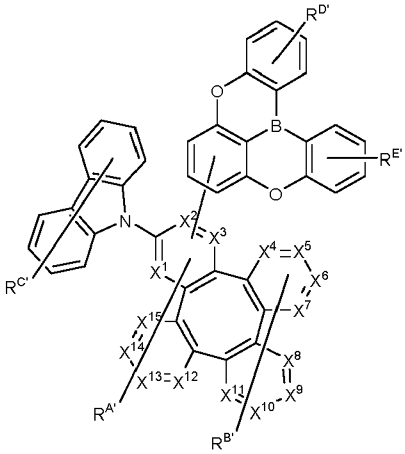 ,

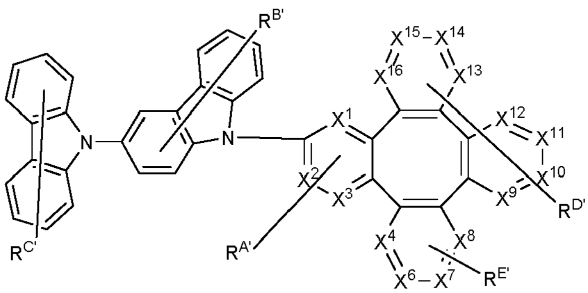 , 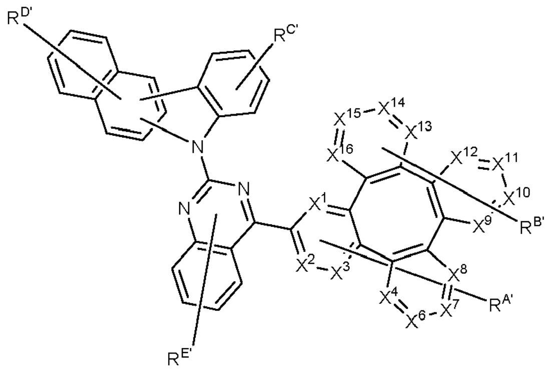 ,

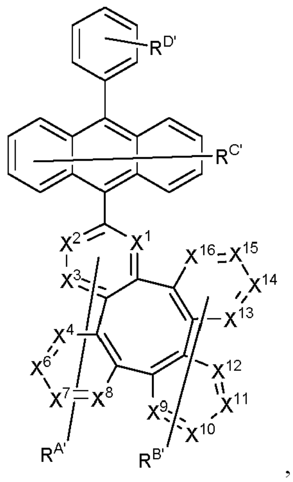 , and 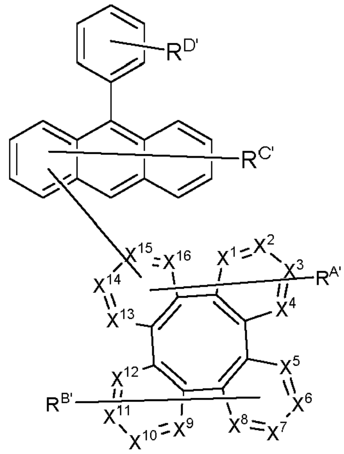 ;

wherein:

each of $X^1$ to $X^{24}$ is independently C or N;
L' is a direct bond or an organic linker;
each $Y^A$ is independently selected from the group consisting of absent a bond, O, S, Se, CRR', SiRR', GeRR', NR, BR, BRR';
each of $R^{A'}$, $R^{B'}$, $R^{C'}$, $R^{D'}$, $R^{E'}$, $R^{F'}$, and $R^{G'}$ independently represents mono, up to the maximum substitutions, or no substitutions;

each R, R', $R^{A'}$, $R^{B'}$, $R^{C'}$, $R^{D'}$, $R^{E'}$, $R^{F'}$, and $R^{G'}$ is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, selenyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, boryl, and combinations thereof, and two adjacent of $R^{A'}$, $R^{B'}$, $R^{C'}$, $R^{D'}$, $R^{E'}$, $R^{F'}$, and $R^{G'}$ are optionally joined or fused to form a ring.

In some embodiments, the host may be selected from the HOST Group 1b consisting of:

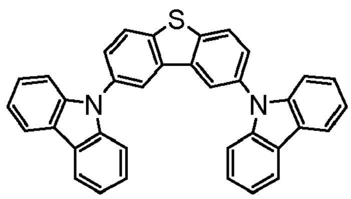, 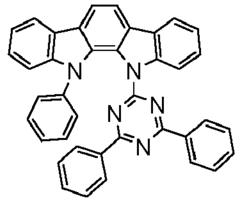, 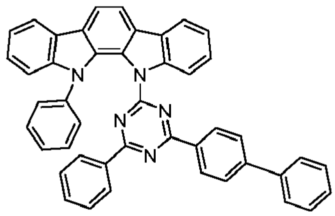, 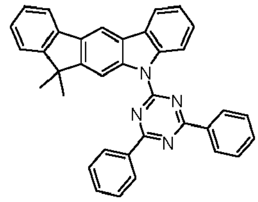,

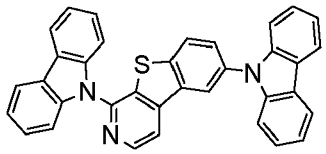, 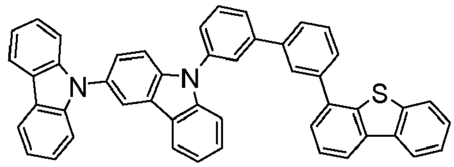, 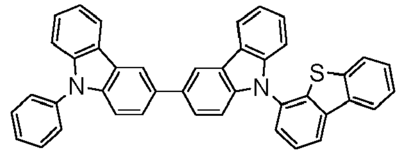,

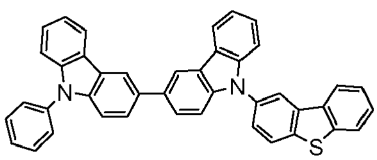, 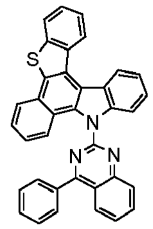, 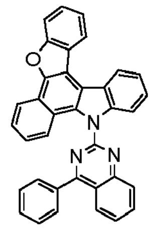, 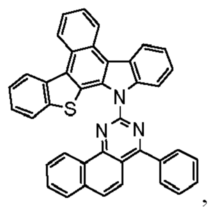, 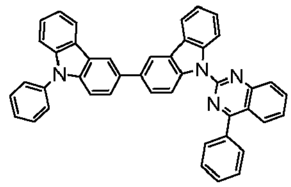,

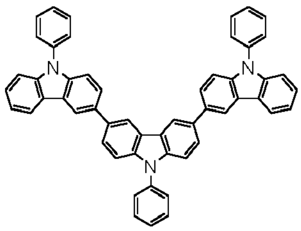, 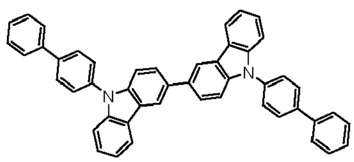, 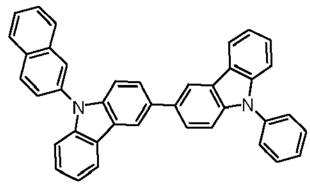,

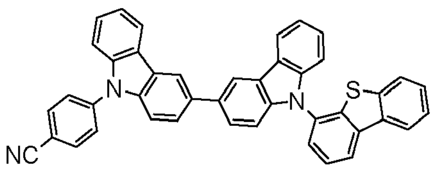, 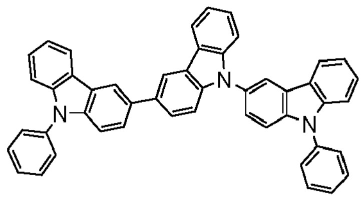, 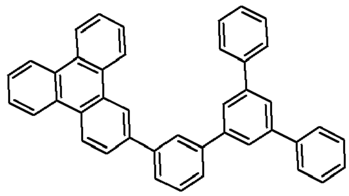,

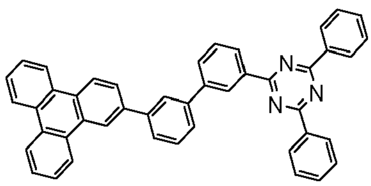, 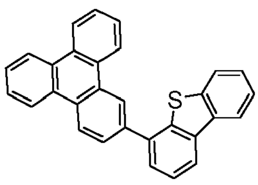, 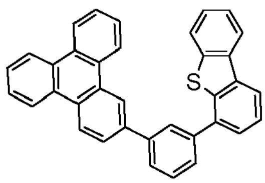, 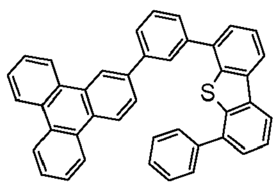,

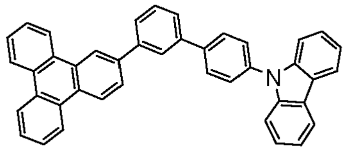, 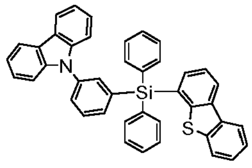, 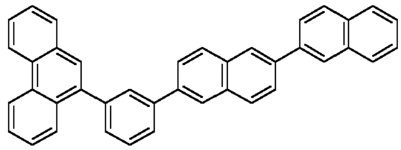, 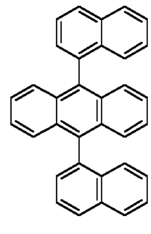,

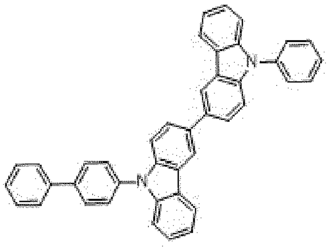, 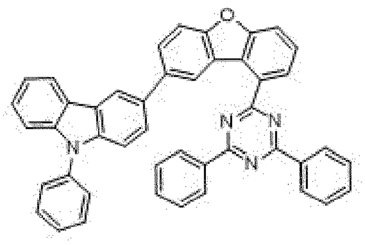, 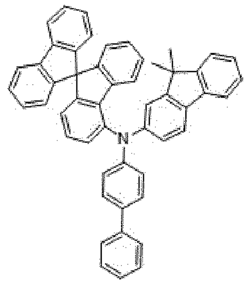, 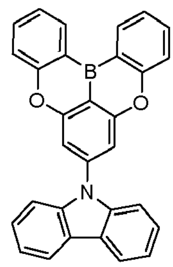,

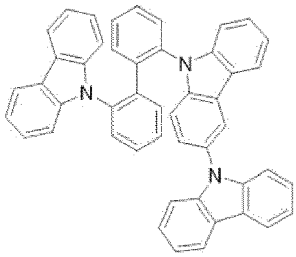, 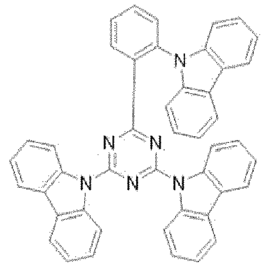, 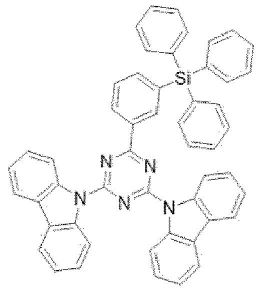,

and combinations thereof.

In some embodiments, the organic layer may further comprise a host, wherein the host comprises a metal complex.

In some embodiments, the emissive layer can comprise two hosts, a first host and a second host. In some embodiments, the first host is a hole transporting host, and the second host is an electron transporting host. In some embodiments, the first host is a hole transporting host, and the second host is a bipolar host. In some embodiments, the first host is an electron transporting host, and the second host is a bipolar host. In some embodiments, the first host and the second host can form an exciplex.

In some embodiments, the emissive layer can comprise a third host. In some embodiments, the third host is selected from the group consisting of an insulating host (wide band gap host), a hole transporting host, and an electron transporting host. In some embodiments, the third host forms an exciplex with one of the first host and the second host, or with both the first host and the second host. In some embodiments, the emissive layer can comprise a fourth host. In some embodiments, the fourth host is selected from the group consisting of an insulating host (wide band gap host), a hole transporting host, and an electron transporting host. In some embodiments, the fourth host forms an exciplex with one of the first host, the second host, and the third host, with two of the first host, the second host, and the third host, or with each of the first host, the second host, and the third host. In some embodiments, the electron transporting host has a LUMO less than -2.4 eV, less than -2.5 eV, less than -2.6 eV, or less than -2.7 eV In some embodiments, the hole transporting host has a HOMO higher than -5.6 eV, higher than -5.5 eV, higher than -5.4 eV, or higher than -5.35 eV The HOMO and LUMO values can be determined using solution electrochemistry. Solution cyclic voltammetry and differential pulsed voltammetry can be performed using a CH Instruments model 6201B potentiostat using anhydrous dimethylformamide (DMF) solvent and tetrabutylammonium hexafluorophosphate as the supporting electrolyte. Glassy carbon, platinum wire, and silver wire were used as the working, counter and reference electrodes, respectively. Electrochemical potentials can be referenced to an internal ferrocene-ferrocenium redox couple (Fc/Fc+) by measuring the peak potential differences from differential pulsed voltammetry. The corresponding highest occupied molecular orbital (HOMO) and lowest unoccupied molecular orbital (LUMO) energies can be determined by referencing the cationic and anionic redox potentials to ferrocene (4.8 eV vs. vacuum) according to literature ((a) Fink, R.; Heischkel, Y; Thelakkat, M.; Schmidt, H.-W. Chem. Mater. 1998, 10, 3620-3625. (b) Pommerehne, J.; Vestweber, H.; Guss, W.; Mahrt, R. F.;

Bassler, H.; Porsch, M.; Daub, J. Adv. Mater. 1995, 7, 551).

In some embodiments, the composition A as described herein may be a sensitizer or a component of a sensitizer; wherein the device may further comprise an acceptor that receives the energy from the sensitizer. In some embodiments, the acceptor is an emitter in the device. In some embodiments, the acceptor may be a fluorescent material. In some embodiments, the composition A described herein can be used as a phosphorescent sensitizer in an OLED where one or multiple layers in the OLED contain an acceptor in the form of one or more non-delayed fluorescent and/or delayed fluorescence material. In some embodiments, the composition A described herein can be used as one component of an exciplex to be used as a sensitizer. As a phosphorescent sensitizer, the composition must be capable of energy transfer to the acceptor and the acceptor will emit the energy or further transfer energy to a final emitter. The acceptor concentrations can range from 0.001% to 99.9%. The acceptor could be in either the same layer as the phosphorescent sensitizer or in one or more different layers. In some embodiments, the acceptor is a thermally activated delayed fluorescence (TADF) material. In some embodiments, the acceptor is a non-delayed fluorescent material. In some embodiments, the emission can arise from any or all of the sensitizer, acceptor, and final emitter. In some embodiments, the acceptor has an emission at room temperature with a full width at half maximum (FWHM) of equal to or less than 50, 45, 40, 35, 30, 25, 20, 15, 10, or 5 nm. Narrower FWHM means better color purity for the OLED display application.

In some embodiments of the OLED, the delayed fluorescence material comprises at least one donor group and at least one acceptor group. In some embodiments, the delayed fluorescence material is a metal complex. In some embodiments, the delayed fluorescence material is a non-metal complex. In some embodiments, the delayed fluorescence material is a Pt, Pd, Zn, Cu, Ag, or Au complex (some of them are also called metal-assisted (MA) TADF). In some embodiments, the metal-assisted delayed fluorescence material comprises a metal-carbene bond. In some embodiments, the non-delayed fluorescence material or delayed fluorescence material comprises at least one chemical group selected from the group consisting of aryl-amine, aryloxy, arylthio, triphenylene, carbazole, indolocarbazole, dibenzothiophene, dibenzofuran, dibenzoselenophene, 5$\lambda^2$-benzo[d]benzo[4,5]imidazo[3,2-a]imidazole, 5,9-dioxa-13b-bomnaphtho[3,2,1-de]anthracene, 5$\lambda^2$, 9$\lambda^2$-aza-13b-boranaphtho[3,2,1-de]anthracene, azaborinine, oxaborinine, dihydroacridine, xanthene, dihydrobenzoazasiline, dibenzooxasiline, phenoxazine, phenoxathiine, phenothiazine, dihydrophenazine, fluorene, naphthalene, anthracene, phenanthrene, phenanthroline, benzoquinoline, quinoline, isoquinoline, quinazoline, pyrimidine, pyrazine, pyridine, triazine, boryl, amino, silyl, aza-variants thereof, and combinations thereof. In some embodiments, non-delayed the fluorescence material or delayed fluorescence material comprises a tri(aryl/heteroaryl)borane with one or more pairs of the substituents from the aryl/heteroaryl being joined to form a ring. In some embodiments, the fluorescence material comprises at least one chemical group selected from the group consisting of naphthalene, anthracene, phenalene, phenanthrene, fluorene, pyrene, chrysene, perylene, and azulene.

In yet another aspect, the OLED of the present disclosure may also comprise an emissive region containing a compound, or a formulation of the compound as disclosed in the above compounds section of the present disclosure. In some embodiments, the emissive region can comprise a composition A as described herein. In some embodiments, the emissive region consists of one or more organic layers, wherein at least one of the one or more organic layers has a minimum thickness selected from the group consisting of 350, 400, 450, 500, 550, 600, 650 and 700 Å. In some embodiments, the at least one of the one or more organic layers are formed from an Emissive System that has a figure of merit (FOM) value equal to or larger than the number selected from the group consisting of 2.50, 2.55, 2.60, 2.65, 2.70, 2.75, 2.80, 2.85, 2.90, 2.95, 3.00, 5.00, 10.0, 15.0, and 20.0. The definition of FOM is available in U.S. patent Application Publication No. 2023/0292605, and its entire contents are incorporated herein by reference. In some embodiments, the at least one of the one or more organic layers comprises a compound or a formulation of the compound as disclosed in Sections A and D of the present disclosure.

In some embodiments, the OLED or the emissive region comprising the inventive composition A disclosed herein can be incorporated into a full-color pixel arrangement of a device. The full-color pixel arrangement of such device comprises at least one pixel, wherein the at least one pixel comprises a first subpixel and a second subpixel. The first subpixel includes a first OLED comprising a first emissive region. The second subpixel includes a second OLED comprising a second emissive region. In some embodiments, the first and/or second OLED, the first and/or second emissive region can be the same or different and each can independently have the various device characteristics and the various embodiments of the inventive compounds included therein, and various combinations and subcombinations of the various device characteristics and the various embodiments of the inventive compounds included therein, as disclosed herein.

In some embodiments, the first emissive region is configured to emit a light having a peak wavelength $\lambda_{max1}$; the second emissive region is configured to emit a light having a peak wavelength $\lambda_{max2}$. In some embodiments, the difference between the peak wavelengths $\lambda_{max1}$ and $\lambda_{max2}$ is at least 4 nm but within the same color. For example, a light blue and a deep blue light as described above. In some embodiments, a first emissive region is configured to emit a light having a peak wavelength $\lambda_{max1}$ in one region of the visible spectrum of 400-500 nm, 500-600 nm, 600-700 nm; and a second emissive region is configured to emit light having a peak wavelength $\lambda_{max2}$ in one of the remaining regions of the visible spectrum of 400-500 nm, 500-600 nm, 600-700 nm. In some embodiments, the first emissive region comprises a first number of emissive layers that are deposited one over the other if more than one; and the second

emissive region comprises a second number of emissive layers that is deposited one over the other if more than one; and the first number is different from the second number. In some embodiments, both the first emissive region and the second emissive region comprise a phosphorescent material, which may be the same or different. In some embodiments, the first emissive region comprises a phosphorescent material, while the second emissive region comprises a fluorescent material. In some embodiments, both the first emissive region and the second emissive region comprise a fluorescent material, which may be the same or different.

In some embodiments, the at least one pixel of the OLED or emissive regions includes a total of *N* subpixels; wherein the *N* subpixels comprises the first subpixel and the second subpixel; wherein each of the *N* subpixels comprises an emissive region; wherein the total number of the emissive regions within the at least one pixel is equal to or less than *N-1*. In some embodiments, the second emissive region is exactly the same as the first emissive region; and each subpixel of the at least one pixel comprises the same one emissive region as the first emissive region. In some embodiments, the full-color pixel arrangements can have a plurality of pixels comprising a first pixel region and a second pixel region; wherein at least one display characteristic in the first pixel region is different from the corresponding display characteristic of the second pixel region, and wherein the at least one display characteristic is selected from the group consisting of resolution, cavity mode, color, outcoupling, and color filter.

In some embodiments, the OLED is a stacked OLED comprising one or more charge generation layers (CGLs). In some embodiments, the OLED comprises a first electrode, a first emissive region disposed over the first electrode, a first CGL disposed over the first emissive region, a second emissive region disposed over the first CGL, and a second electrode disposed over the second emissive region. In some embodiments, the first and/or the second emissive regions can have the various device characteristics as described above for the pixelated device. In some embodiments, the stacked OLED is configured to emit white color. In some embodiments, one or more of the emissive regions in a pixelated or in a stacked OLED comprises a sensitizer and an acceptor with the various sensitizing device characteristics and the various embodiments of the inventive compounds disclosed herein. For example, the first emissive region is comprised in a sensitizing device, while the second emissive region is not comprised in a sensitizing device; in some instances, both the first and the second emissive regions are comprised in sensitizing devices.

In some embodiments, the OLED can emit light having at least 1%, 5%, 10, 30%, 50%, 70%, 80%, 90%, 95%, 99%, or 100% from the plasmonic mode. In some embodiments, at least one of the anode, the cathode, or a new layer disposed over the organic emissive layer functions as an enhancement layer. The enhancement layer comprises a plasmonic material exhibiting surface plasmon resonance that non-radiatively couples to the emitter material and transfers excited state energy from the emitter material to non-radiative mode of surface plasmon polariton. In some embodiments, the enhancement layer is provided no more than a threshold distance away from the organic emissive layer, wherein the emitter material has a total non-radiative decay rate constant and a total radiative decay rate constant due to the presence of the enhancement layer. A threshold distance is where the total non-radiative decay rate constant is equal to the total radiative decay rate constant. Another threshold distance is the distance at which the total radiative decay rate constant divided by the sum of the total non-radiative decay rate constant and total radiative decay rate constant is equal to the photoluminescent yield of the emissive material without the enhancement layer present.

### C. The Compounds of the Present Disclosure

In one aspect, the present disclosure provides a composition A comprising: a first dopant; and a first host;

wherein: the first dopant has a HOMO energy $HOMO_{Dopant}$ and a LUMO energy $LUMO_{Dopant}$;
the first host has a HOMO energy $HOMO_{Host}$ and a LUMO energy $LUMO_{Host}$;
$|LUMO_{Host} - HOMO_{Dopant}| = X1$;
$|LUMO_{Dopant} - HOMO_{Host}| = X2$;
the first dopant has an optical bandgap energy, Y;
at least one of X1 and X2 is less than or equal to Y + 0.026 eV;
the composition A has a vertical dipole ratio VDR(A);
composition B is a reference composition comprising the first dopant and a second host, wherein the second host is

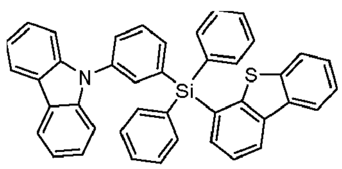
;

the composition B having a vertical dipole ratio VDR(B);

the ratio of the first dopant and the first host in the composition A is identical to the ratio of the first dopant and second host in the composition B; and

$$\mathrm{VDR(A) - VDR(B)\ is} \geq 0.05.$$

In some embodiments, the first dopant and the first host form an exciplex when the composition A is used as an emissive layer in an OLED.

As used herein, a compound's optical bandgap is the Optical LUMO energy (in eV) - the HOMO energy (in eV). This can be either an experimentally obtained value, where the HOMO and Optical LUMO are obtained experimentally, or by computational means using a DFT software. Unless otherwise stated, the Optical Bandgap is measured experimentally in this disclosure.

The calculations obtained with the above-identified DFT functional set and basis set are theoretical. Computational composite protocols, such as Gaussian with the CEP-31G basis set used herein, rely on the assumption that electronic effects are additive and, therefore, larger basis sets can be used to extrapolate to the complete basis set (CBS) limit. However, when the goal of a study is to understand variations in HOMO, LUMO, Si, $T_1$, bond dissociation energies, etc. over a series of structurally-related compounds, the additive effects are expected to be similar. Accordingly, while absolute errors from using the B3LYP may be significant compared to other computational methods, the relative differences between the HOMO, LUMO, Si, $T_1$, and bond dissociation energy values calculated with B3LYP protocol are expected to reproduce experiment quite well. *See, e.g.,* Hong et al., Chem. Mater. 2016, 28, 5791-98, 5792-93 and Supplemental Information (discussing the reliability of DFT calculations in the context of OLED materials). Moreover, with respect to iridium or platinum complexes that are useful in the OLED art, the data obtained from DFT calculations correlates very well to actual experimental data. *See* Tavasli et al., J. Mater. Chem. 2012, 22, 6419-29, 6422 (Table 3) (showing DFT calculations closely correlating with actual data for a variety of emissive complexes); Morello, G.R., J. Mol. Model. 2017, 23:174 (studying of a variety of DFT functional sets and basis sets and concluding the combination of B3LYP and CEP-31G is particularly accurate for emissive complexes).

As used herein, exciplex is defined between a first molecule D and a second molecule A, wherein the first molecule D has a HOMO energy of $HOMO_D$, a LUMO energy of $LUMO_D$, and a lowest triplet energy of $T1_D$; the second molecule A has a HOMO energy of $HOMO_A$, a LUMO energy of $LUMO_A$, and a lowest triplet energy of $T1_A$; wherein $|HOMO_D| < |HOMO_A|$, $|LUMO_D| < |LUMO_A|$, $|HOMO_D - LUMO_A| < T1_D$, and $|HOMO_D - LUMO_A| < T1_A$. The HOMO and LUMO energies are measured by solution electrochemistry as described herein. The lowest triplet energy T1 can be obtained from the short-wavelength band of a phosphorescence spectrum by determining the wavelength at which the onset of the shortest-wavelength peak of the phosphorescence spectrum achieves 10% of the intensity of the peak of the gated emission of a frozen sample in 2-MeTHF at 77 K.

In some embodiments, $|HOMO_D|$ is less than $|HOMO_A|$ by at least 10, 20, 50, 100, 150, 200, 250, or 300 meV In some embodiments, $|LUMO_D|$ is less than $|LUMO_A|$ by at least 10, 20, 50, 100, 150, 200, 250, or 300 meV In some embodiments, $|HOMO_D - LUMO_A|$ is less than $T1_D$ and/or $T1_A$ by at least 10, 20, 50, 100, 150, 200, 250, or 300 meV When the exciplex is placed in a matrix system, such as in an EML, the emission from the exciplex may be observable or may not be observable.

In some embodiments, the first dopant is capable of fluorescence at room temperature in an OLED. In some embodiments, the first dopant is capable of TADF emission at room temperature in an OLED. In some embodiments, the first dopant is capable of phosphorescence at room temperature in an OLED.

In some embodiments, the first dopant comprises a metal M selected from the group consisting of Ir, Pt, Pd, Au, Ag, Cu, Zn, Zr, Ru, Re, Co, Ti, Os, Ga, Al, Rh, Be, Mn, Mg, In, Bi, Sn, Ni, and Fe.

In some embodiments, VDR(A) - VDR(B) is ≥ 0.08. In some embodiments, VDR(A) - VDR(B) is ≥ 0.1. In some embodiments, VDR(A) - VDR(B) is ≥ 0.15. In some embodiments, VDR(A) - VDR(B) is ≥ 0.20.

In some embodiments, VDR(A) > 0.33. In some embodiments, VDR(A) > 0.35. In some embodiments, VDR(A) > 0.40. In some embodiments, VDR(A) > 0.45.

In some embodiments, VDR(B) < 0.5. In some embodiments, VDR(B) < 0.4. In some embodiments, VDR(B) < 0.33. In some embodiments, VDR(B) < 0.25. In some embodiments, VDR(B) < 0.20. In some embodiments, VDR(B) < 0.15.

In one embodiment, when the composition A is used as an emissive layer in an OLED, at least the first dopant or the first host of the composition A has an orientation order parameter (S) > 0, and this embodiment will be referred to herein as Embodiment A. In some embodiments, the first host of the composition A has an orientation order parameter (S) > 0. In some embodiments, the first host of the composition A has an orientation order parameter (S) < 1.

In one embodiment, when the composition A is used as an emissive layer in an OLED, at least the first dopant or the first host of the composition A has an orientation order parameter (S) < 0 in the composition A, and this embodiment will be referred to herein as Embodiment B. In some embodiments, at least the first dopant or the first host of the

composition A has an orientation order parameter (S) < 0.1 in the composition A. In some embodiments, at least the first dopant or the first host of the composition A has an orientation order parameter (S) < 0.2 in the composition A. In some embodiments, at least the first dopant or the first host of the composition A has an orientation order parameter (S) < 0.3 in the composition A.

In some embodiments, when the composition A is used as an emissive layer in an OLED, the first host of the composition A has an orientation order parameter (S) < 0. In some embodiments, the first host of the composition A has an orientation order parameter (S) < 0.1. In some embodiments, the first host of the composition A has an orientation order parameter (S) < 0.2. In some embodiments, the first host of the composition A has an orientation order parameter (S) < 0.3.

The electrochemical HOMO and LUMO values can be determined using solution electrochemistry. Solution cyclic voltammetry and differential pulsed voltammetry were performed using a CH Instruments model 6201B potentiostat using anhydrous dimethylformamide solvent and tetrabutylammonium hexafluorophosphate as the supporting electrolyte. Glassy carbon, and platinum and silver wires were used as the working, counter and reference electrodes, respectively. Electrochemical potentials were referenced to an internal ferrocene-ferrocenium redox couple (Fc/Fc+) by measuring the peak potential differences from differential pulsed voltammetry. The corresponding highest occupied molecular orbital (HOMO) and lowest unoccupied molecular orbital (LUMO) energies were determined by referencing the cationic and anionic redox potentials to ferrocene (4.8 eV vs. vacuum) according to literature ((a) Fink, R.; Heischkel, Y; Thelakkat, M.; Schmidt, H.-W. Chem. Mater. 1998, 10, 3620-3625. (b) Pommerehne, J.; Vestweber, H.; Guss, W.; Mahrt, R. F.; Bassler, H.; Porsch, M.; Daub, J. Adv. Mater. 1995, 7, 551).

In either the Embodiment A or the Embodiment B, the first dopant's optical LUMO is within ± 0.026 eV of the electrochemical LUMO of at least the first dopant or the first host of the composition A.

In either the Embodiment A or the Embodiment B, the first dopant's optical LUMO is within ± 0.05 eV of the electrochemical LUMO of at least the first dopant or the first host of the composition A.

In either the Embodiment A or the Embodiment B, the first dopant's optical LUMO is at least 0.026 eV greater than electrochemical LUMO of at least the first dopant or the first host of the composition A.

In either the Embodiment A or the Embodiment B, the first dopant's optical LUMO is at least 0.05 eV greater than electrochemical LUMO of at least the first dopant or the first host of the composition A.

In either the Embodiment A or the Embodiment B, the first dopant's optical LUMO is at least 0.10 eV greater than electrochemical LUMO of at least the first dopant or the first host of the composition A.

In either the Embodiment A or the Embodiment B, the first dopant's optical LUMO is at least 0.20 eV greater than electrochemical LUMO of at least the first dopant or the first host of the composition A.

In either the Embodiment A or the Embodiment B, the first dopant's optical LUMO is within ± 0.05 eV of the electrochemical LUMO of at least the first dopant or the first host of the composition A.

In the composition B, the second host does not form an exciplex with the first dopant. In the composition B, the first dopant's optical LUMO is at least 0.2 eV less than the electrochemical LUMO of the second host.

In the Embodiment A, at least the first dopant or the first host of the composition A has rod-like metric R > 0.3. In the Embodiment A, at least the first dopant or the first host of the composition A can have a rod-like metric R > 0.35. In the Embodiment A, at least the first dopant or the first host of the composition A can have a rod-like metric 0.40. In the Embodiment A, at least the first dopant or the first host of the composition A can have a rod-like metric 0.45. In the Embodiment A, at least the first dopant or the first host of the composition A can have a rod-like metric 0.50.

In the Embodiment A, where at least the first dopant or the first host of the composition A has rod-like metric R > 0.3, the first dopant and the first host of the composition A form an exciplex.

In the Embodiment A, both the first host and the first dopant of the composition A have a rod-like metric R > 0.3. In the Embodiment A, both the first host and the first dopant of the composition A can have a rod-like metric R > 0.35. In the Embodiment A, both the first host and the first dopant of the composition A can have a rod-like metric R > 0.40. In the Embodiment A, both the first host and the first dopant of the composition A can have a rod-like metric R > 0.45. In the Embodiment A, both the first host and the first dopant of the composition A can have a rod-like metric R > 0.50.

In the Embodiment A, where both the first host and the first dopant of the composition A have a rod-like metric R > 0.3, the first host forms an exciplex with the first dopant.

In the Embodiment A, where both the first host and the first dopant of the composition A have a rod-like metric R > 0.3, the first dopant forms an excimer.

In the Embodiment A, where both the first host and the first dopant of the composition A have a rod-like metric R > 0.3, the first host can form an excimer.

In the Embodiment A, at least the first dopant or the first host of the composition A has a disk-like metric D > 0.3. In the Embodiment A, both the first host and the first dopant of the composition A can have a disk-like metric D > 0.35. In the Embodiment A, both the first host and the first dopant of the composition A can have a disk-like metric D > 0.40. In the Embodiment A, both the first host and the first dopant of the composition A can have a disk-like metric D > 0.45. In the Embodiment A, both the first host and the first dopant of the composition A can have a disk-like metric D > 0.50.

In the Embodiment A, where at least the first dopant or the first host of the composition A has a disk-like metric D > 0.3, the first dopant and the first host of the composition A can form an exciplex.

In the Embodiment A, both the first host and the first dopant in the composition A have a disk-like metric D > 0.3. In the Embodiment A, both the first host and the first dopant in the composition A can have a disk-like metric D > 0.35. In the Embodiment A, both the first host and the first dopant in the composition A can have a disk-like metric D > 0.40. In the Embodiment A, both the first host and the first dopant in the composition A can have a disk-like metric D > 0.45. In the Embodiment A, both the first host and the first dopant in the composition A can have a disk-like metric D > 0.50.

In the Embodiment A, where both the first host and the first dopant in the composition A have a disk-like metric D > 0.3, the first host can form an exciplex with the fist dopant.

In the Embodiment A, where both the first host and the first dopant in the composition A have a disk-like metric D > 0.3, the first dopant can form an excimer.

In the Embodiment A, where both the first host and the first dopant in the composition A have a disk-like metric D > 0.3, the first host can form an excimer.

In the Embodiment A, at least the first dopant or the first host of the composition A has a sphericity < 0.5. In the Embodiment A, at least the first dopant or the first host of the composition A can have a sphericity < 0.45. In the Embodiment A, at least the first dopant or the first host of the composition A can have a sphericity < 0.40. In the Embodiment A, at least the first dopant or the first host of the composition A can have a sphericity < 0.35. In the Embodiment A, at least the first dopant or the first host of the composition A can have a sphericity < 0.30.

In the Embodiment A, where at least the first dopant or the first host of the composition A has a sphericity < 0.5, the first dopant and the first host of the composition A forms an exciplex.

In the Embodiment A, both the first host and the first dopant in the composition A have a sphericity < 0.5. In the Embodiment A, both the first host and the first dopant in the composition A can have a sphericity < 0.45. In the Embodiment A, both the first host and the first dopant in the composition A can have a sphericity < 0.40. In the Embodiment A, both the first host and the first dopant in the composition A can have a sphericity < 0.35. In the Embodiment A, both the first host and the first dopant in the composition A can have a sphericity < 0.30.

In the Embodiment A, where both the first host and the first dopant in the composition A have a sphericity < 0.5, the first host forms an exciplex with the first dopant.

In the Embodiment A, where both the first host and the first dopant in the composition A have a sphericity < 0.5, the first dopant can form an excimer.

In the Embodiment A, where both the first host and the first dopant in the composition A have a sphericity < 0.5, the first host can form an excimer.

In the Embodiment A, where both the first host and the first dopant in the composition A have a sphericity < 0.5, the first dopant has D > 0.3 and the first host has sphericity < 0.5.

In the Embodiment A, the first dopant can have a sphericity < 0.5 and the first host has D > 0.3.

In some embodiments of the composition A, when the first dopant contains a metal center, a part of the Van Der Walls surface of the first dopant lies within 15 angstroms of the metal center.

The van der Waals surface is comprised of the spheres centered at atomic coordinates with radii equal to the respective van der Waals radii of the atom species, and can be determined utilizing a variety of software. One such example is the python package pyvdwsurface. To determine distances to the projected surface from the metal center, one can uniformly sample points on the van der Waals surface and calculate the Euclidian distance to the metal center.

**Orientation Order Parameter (S):** As used in this disclosure, the orientation order parameter (S) is defined as: $S = \frac{k_e^{max} - k_o^{max}}{k_e^{max} + 2k_o^{max}}$, where $k_o^{max}$ and $k_e^{max}$ are the ordinary and extraordinary extinction coefficients, respectively, at the peak wavelength corresponding to the transition dipole moment, as determined by ellipsometry.

**Optical LUMO:** As used in this disclosure, a compound's optical LUMO is the HOMO energy (in eV) + 1240 nm * eV / (peak absorption wavelength in nm). This can be either an experimentally obtained value, where the HOMO energy is determined using CV measurements and the absorption spectra from PL measurements, or by computational means using a DFT software. Unless otherwise stated, the Optical LUMO is measured experimentally in this disclosure.

**Sphericity:** Sphericity is a metric that defines how spherical a molecule is, and is defined as: $Sphericity = \frac{3*PMI_1}{PMI_1+PMI_2+PMI_3}$, where $PMI_1$, $PMI_2$, and $PMI_3$ are the principal moments of inertia of a compound from smallest to largest. $NPR_1$=$PMI_1$ / $PMI_3$ and $NPR_2$= $PMI_2$ / $PMI_3$.

**Rod-like metric, R:** Rod-like metric, R, can be defined for a compound as:

$$R = 1 - \sqrt{NPR_1^2 + 3(1 - NPR_2)^2}$$

**Disk-like metric, D:** Disk-like metric, D, can be defined for a compound as:

$$D = 1 - \sqrt{\left(\frac{1}{2} - NPR_1\right)^2 + 3\left(NPR_2 - \frac{1}{2}\right)^2}$$

**Steric factor, *SF*:** Steric factor, ***SF***, is defined as:

- For a given molecule, calculate the solvent-excluded surface (***ses***) using a probe with radius 4 Angstroms.
- For a given molecule, calculate the triplet surface (***ts***) at an isovalue of 2.0E-04 as the absolute value of the difference between the $S_0$ ground state electron density and the $T_1$ excited state electron density.
- Calculate the surface integral (*I*) of $e^{-\frac{d}{2.0}}$ along the *ses* where *d* is the distance between the ***ses*** and ***ts***.
- A sign convention of positive when the *ses* is outside the ***ts*** and negative when the ***ts*** is outside the *ses* with respect to the center of the molecule should be used.
- Determine the surface area of the ms (*A*).
- ***SF*** = 1 - *I*/*A*

In the Embodiment A, the first host can have a steric factor ***SF*** > 0.5.
In the Embodiment A, the first dopant can have a steric factor ***SF*** > 0.5.
In the Embodiment A, the first host and the first dopant each can have a steric factor ***SF*** > 0.5.
In some embodiments of the composition A, where the first dopant is capable of fluorescence at room temperature in an OLED, the first dopant comprises at least one of the chemical moieties selected from the group consisting of:

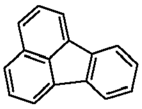 , 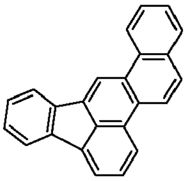 , 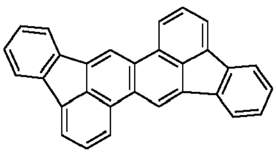 , 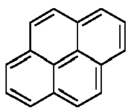 , 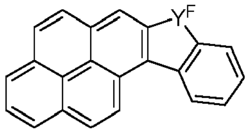 , 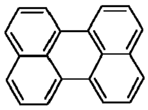 ,

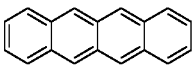 , 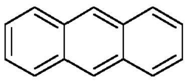 , 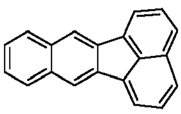 , 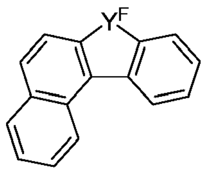 , 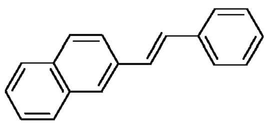 ,

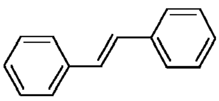 , 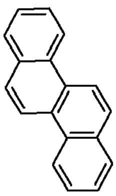 , 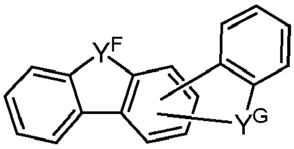 , 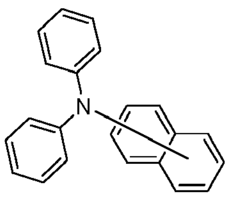 , 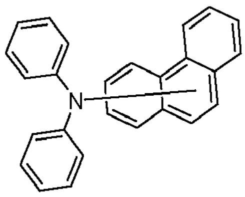 ,

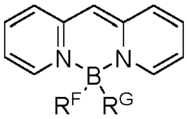 , 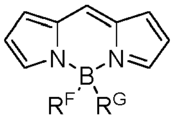 , 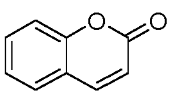 , 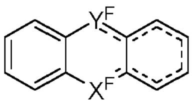 , 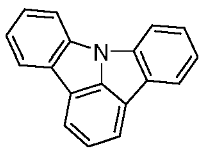 ,

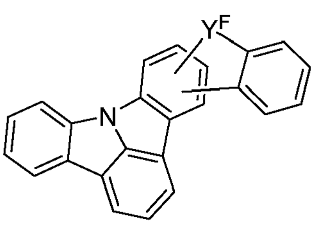,
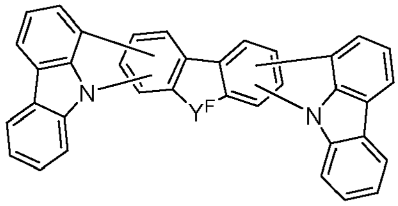,
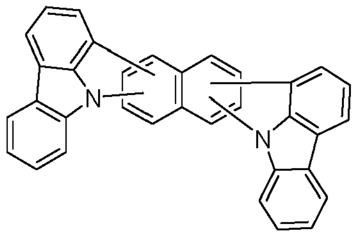,

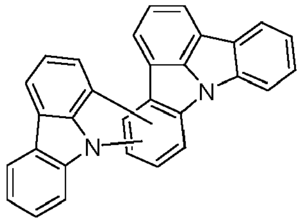,
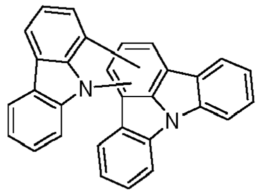,
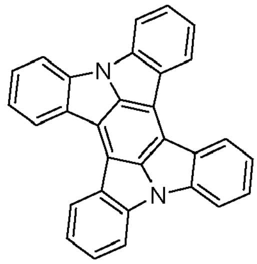,
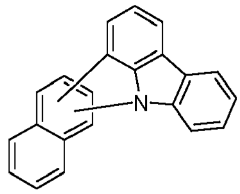,

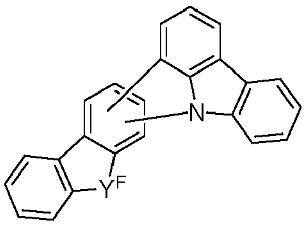,
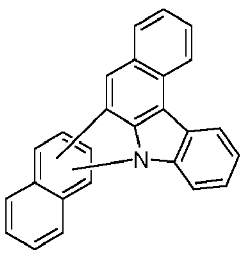,
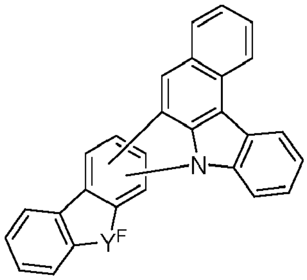,
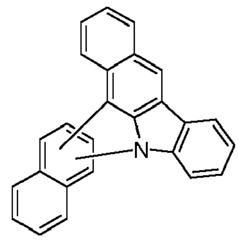,

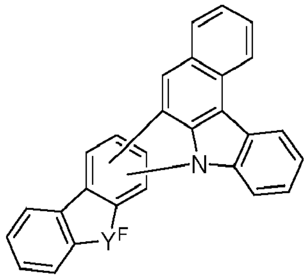,
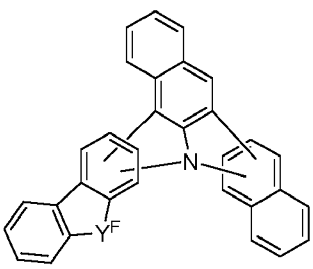,
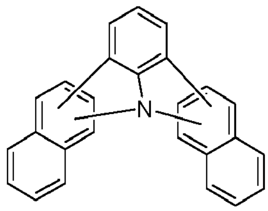,

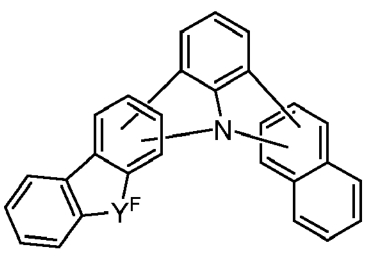,
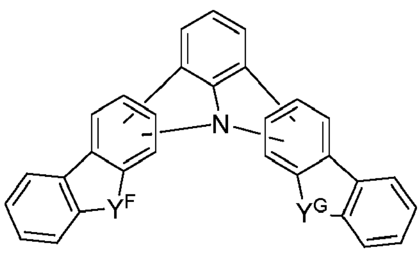,
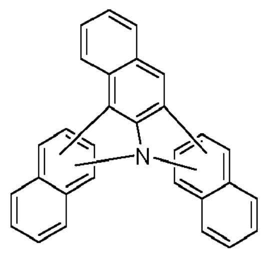,

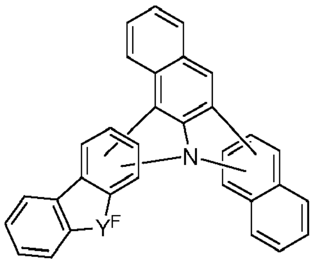,
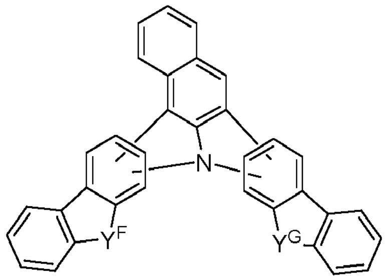,
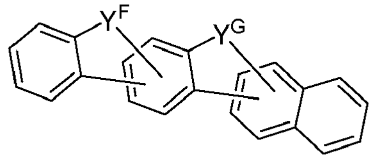,
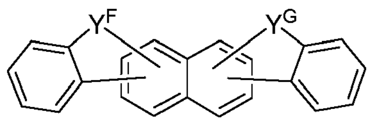,
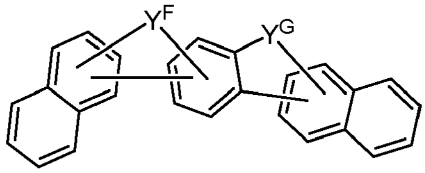,
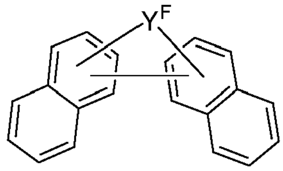,
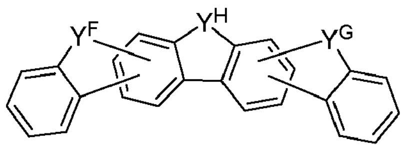,
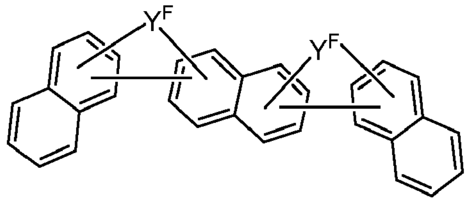,
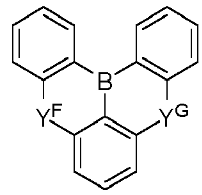,
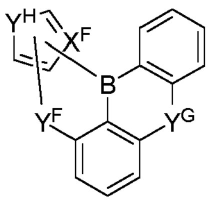
and
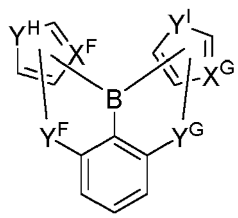

wherein $Y^F$, $Y^G$, $Y^H$, and $Y^I$ are each independently selected from the group consisting of BR, NR, PR, O, S, Se, C=O, S=O, $SO_2$, BRR', CRR', SiRR', and GeRR'; wherein $X^F$ and $Y^G$ are each independently selected from the group consisting of C and N; and

wherein $R^F$, $R^G$, R, and R' are each independently a hydrogen or a substituent selected from the group consisting of the General Substituents as defined herein.

In some of the above embodiments, any carbon ring atoms up to maximum of a total number of three, together with their substituents, in each phenyl ring of any of above structures can be replaced with N.

In some embodiments of the composition A, where the first dopant is capable of fluorescence at room temperature in an OLED, the first dopant capable of fluorescence at room temperature in an OLED can be selected from the group consisting of the structures in the following LIST A:

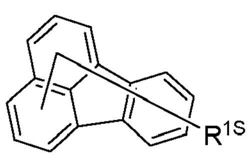,
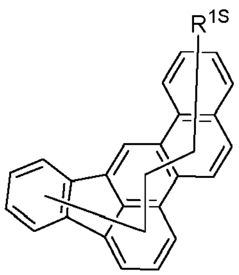,
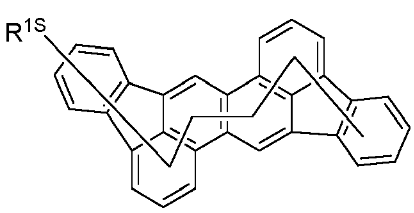,
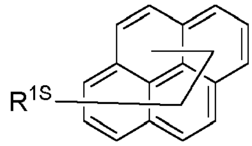,

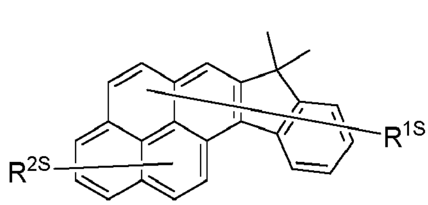
,
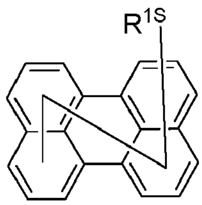
,
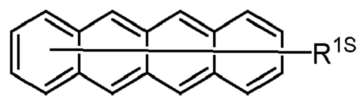
,

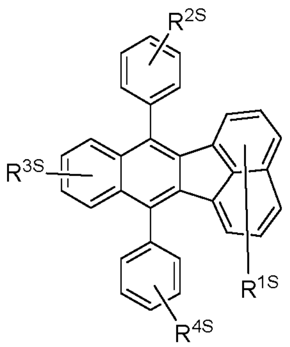
,
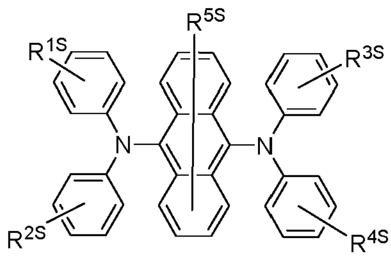
,
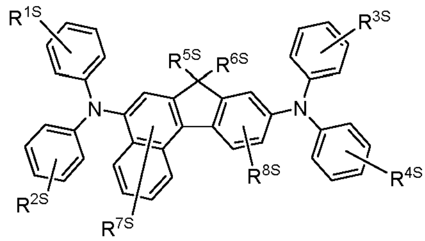
,

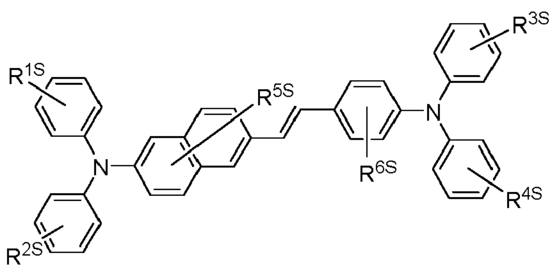
,
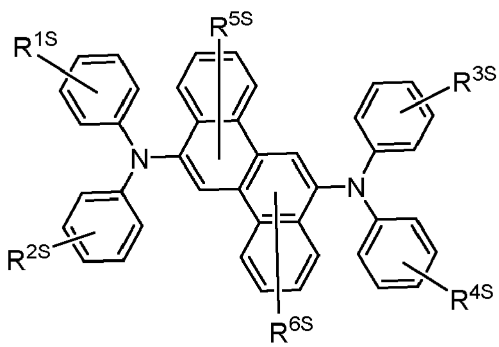
,

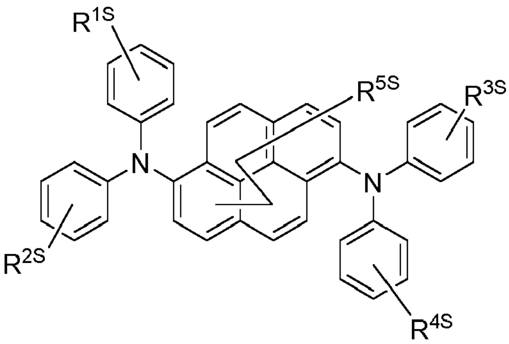
,
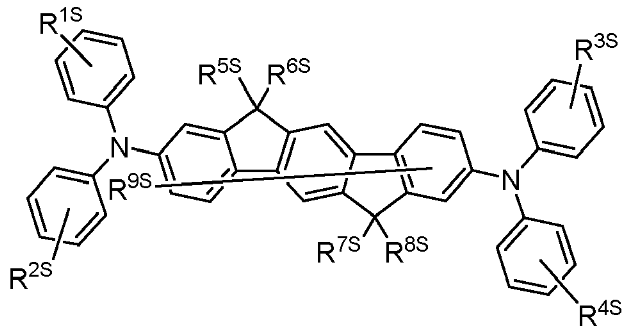
,

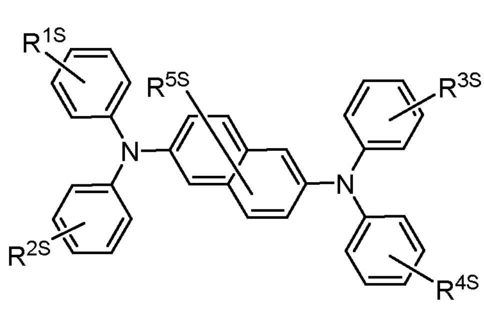
,
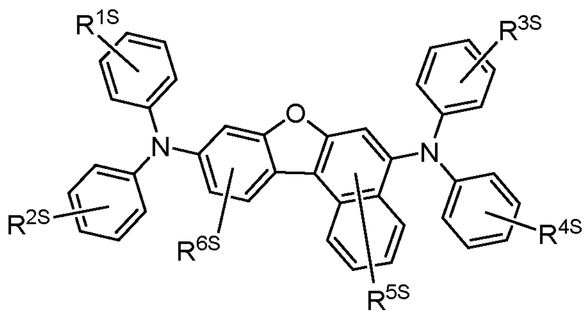
,

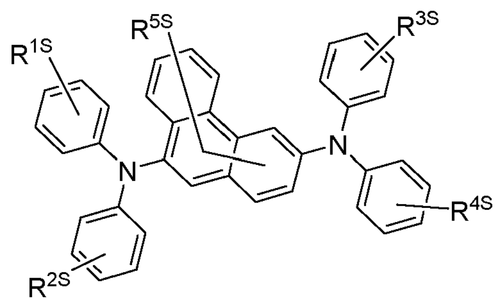
,
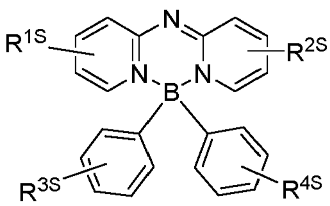
,
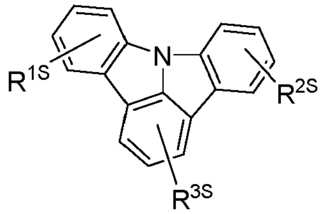
,

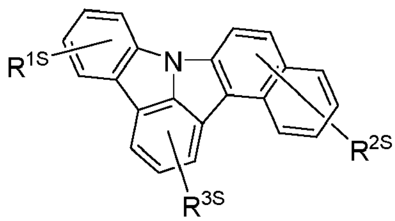
,
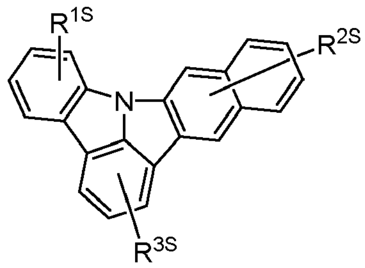
,
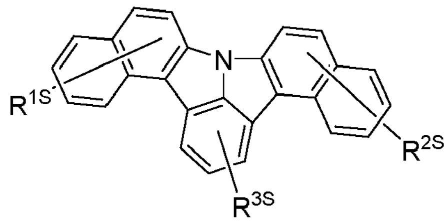
,

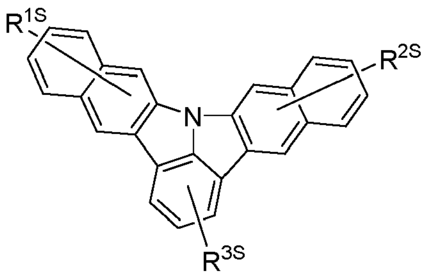
,
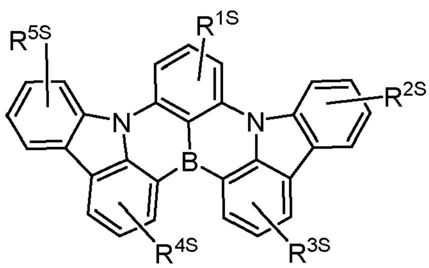
,
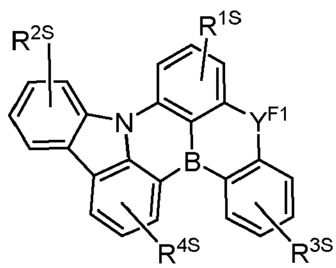
,

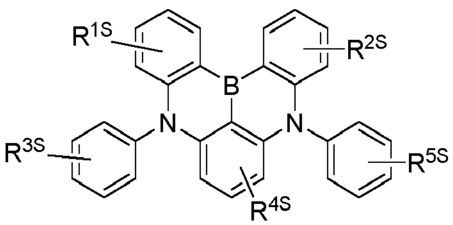
,
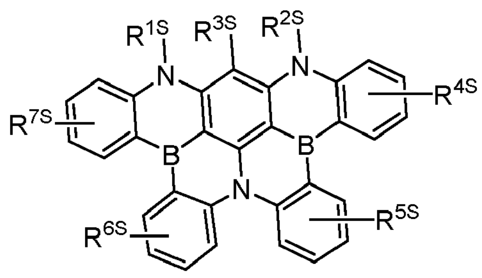
,

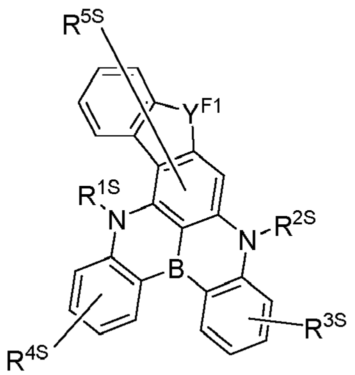
,
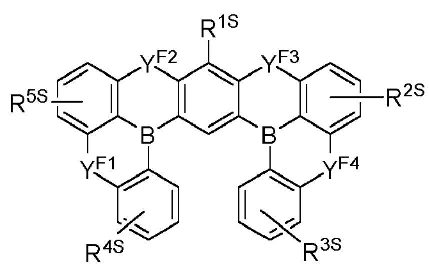
,
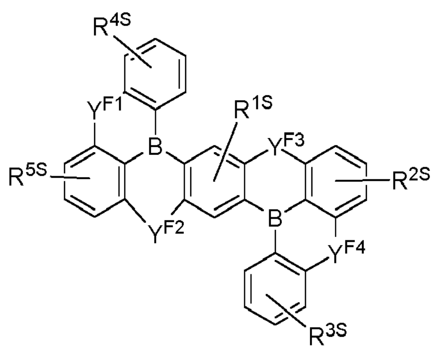
,

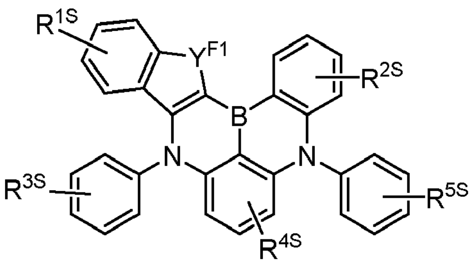

,

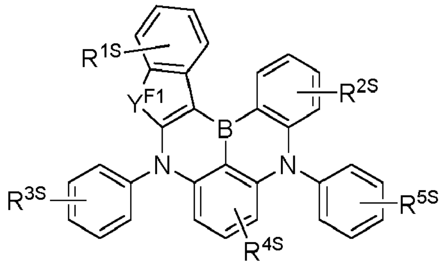

,

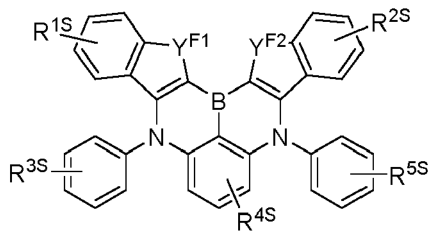

,

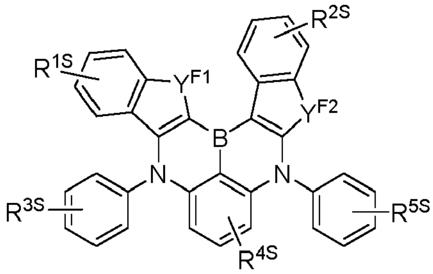

,

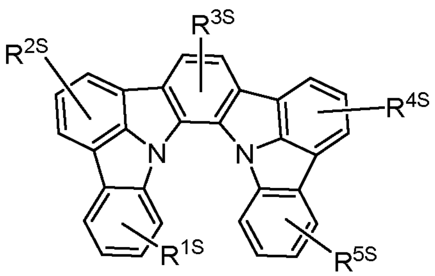

,

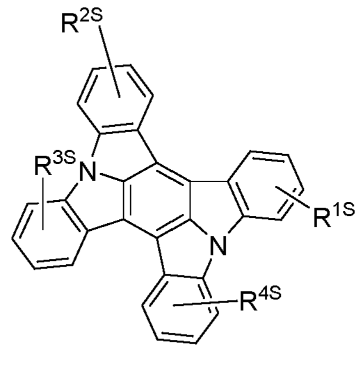

,

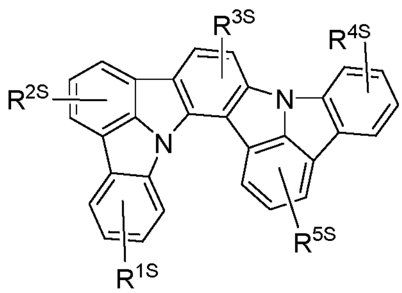

,

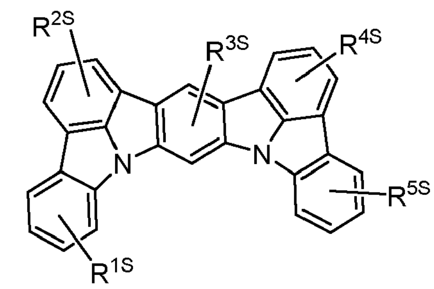

,

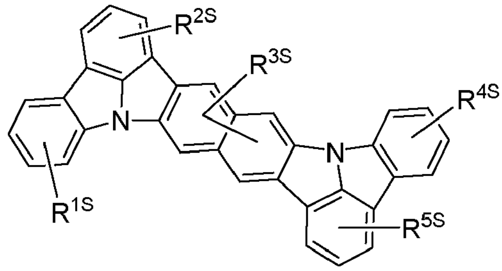

,

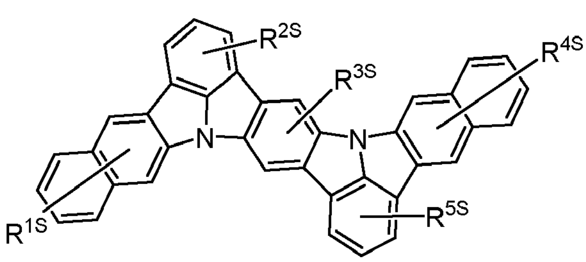

, and

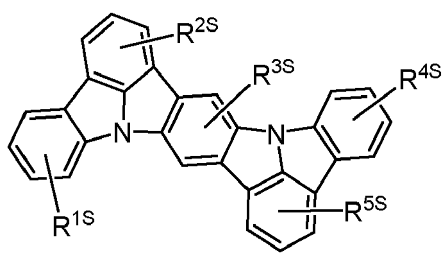

;

wherein $Y^{F1}$ to $Y^{F4}$ are each independently selected from O, S, and $NR^{F1}$;

wherein $R^{F1}$ and $R^{1S}$ to $R^{9S}$ each independently represents from mono to maximum possible number of substitutions, or no substitution; and

wherein $R^{F1}$ and $R^{1S}$ to $R^{9S}$ are each independently a hydrogen or a substituent selected from the group consisting of the General Substituents as defined herein, and any two substituents can be joined or fused to form a ring.

In some embodiments of the composition A, the first dopant capable of TADF emission at room temperature in an OLED comprises at least one of the chemical moieties selected from the group consisting of

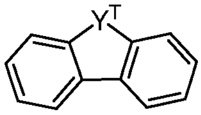, 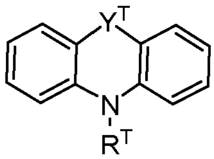, 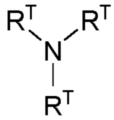, 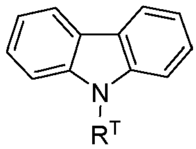, 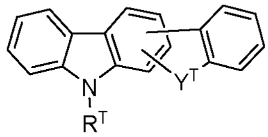,

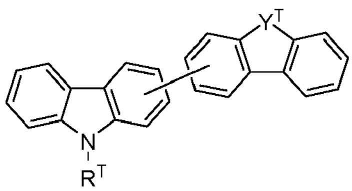, 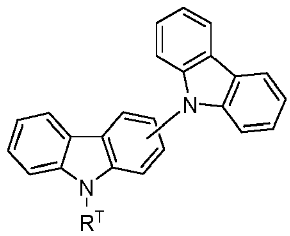, 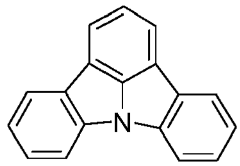, 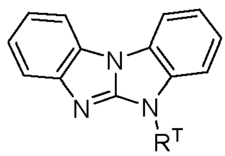,

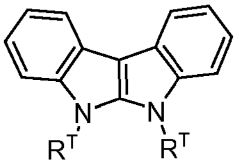, 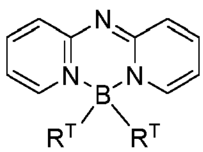, 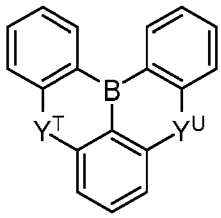, 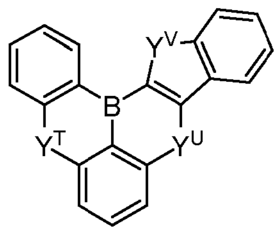, 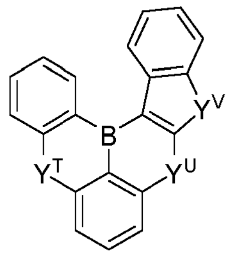,

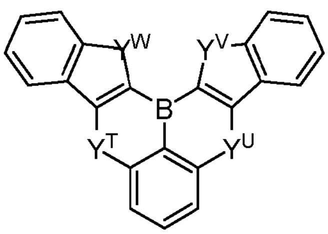, 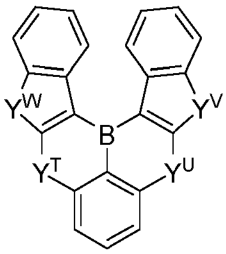, 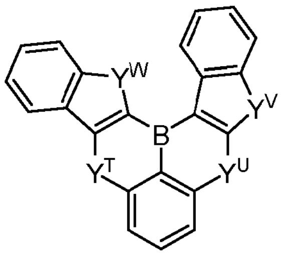, 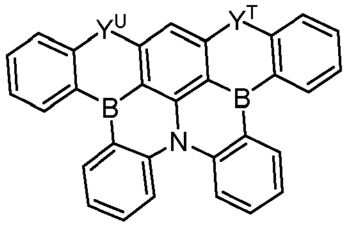,

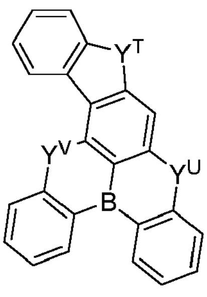, 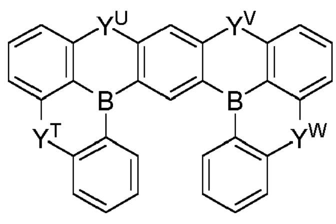, and 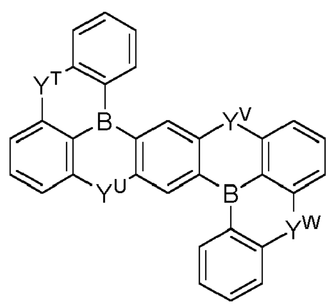;

wherein $Y^T$, $Y^U$, $Y^V$, and $Y^W$ are each independently selected from the group consisting of BR, NR, PR, O, S, Se, C=O, S=O, $SO_2$, BRR', CRR', SiRR', and GeRR';

wherein each $R^T$ can be the same or different and each $R^T$ is independently a donor, an acceptor group, an organic linker bonded to a donor, an organic linker bonded to an acceptor group, or a terminal group selected from the group

consisting of alkyl, cycloalkyl, heteroalkyl, heterocycloalkyl, arylalkyl, aryl, heteroaryl, and combinations thereof; and R, and R' are each independently a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof.

In embodiments of the composition A where the first dopant is capable of TADF emission at room temperature in an OLED, the first dopant comprises at least one of the chemical moieties selected from the group consisting of nitrile, isonitrile, borane, fluoride, pyridine, pyrimidine, pyrazine, triazine, aza-carbazole, aza-dibenzothiophene, aza-dibenzofuran, aza-dibenzoselenophene, aza-triphenylene, imidazole, pyrazole, oxazole, thiazole, isoxazole, isothiazole, triazole, thiadiazole, and oxadiazole.

In embodiments of the composition A where the first dopant is capable of TADF emission at room temperature in an OLED, the first dopant has the formula of $M(L^5)(L^6)$, wherein M is Cu, Ag, or Au, $L^5$ and $L^6$ are different, and $L^5$ and $L^6$ are independently selected from the group consisting of:

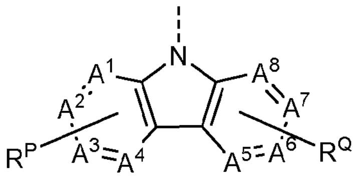 , 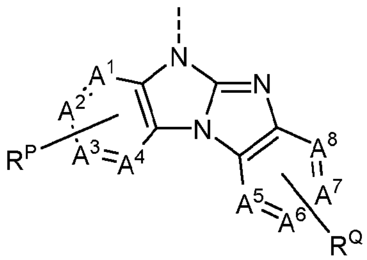 , 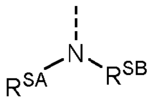 , 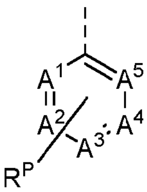 , 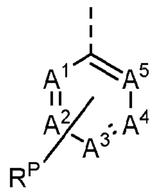 ,

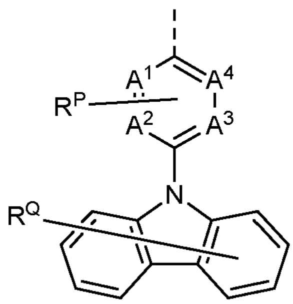 , 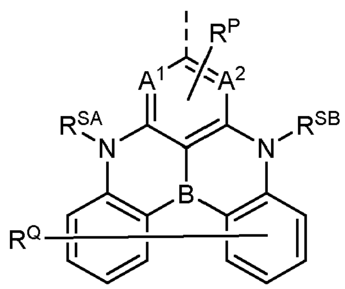 , 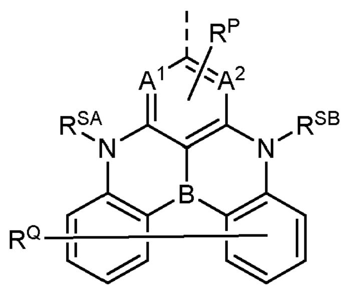 ,

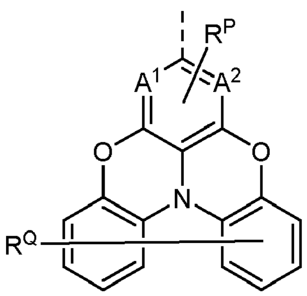 , 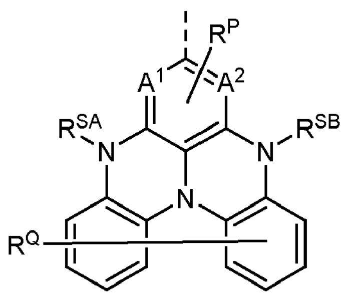 , 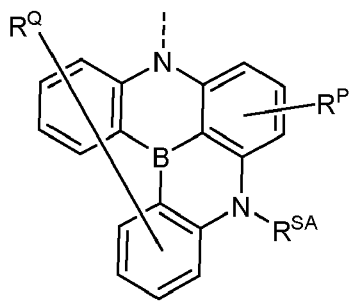 ,

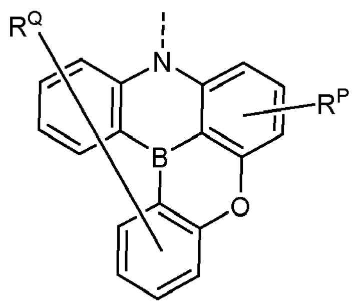
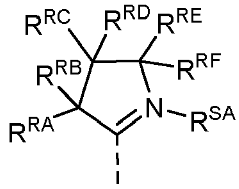
,
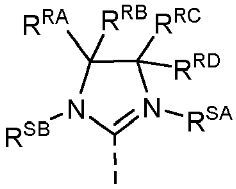
,
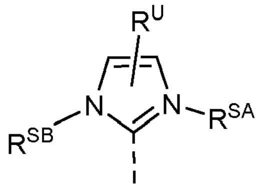
,

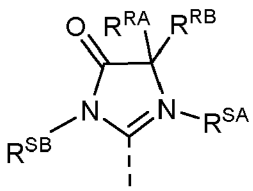
,
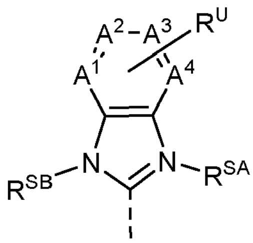
,
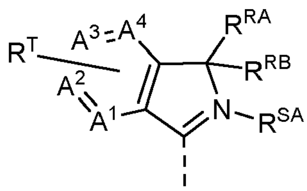
,
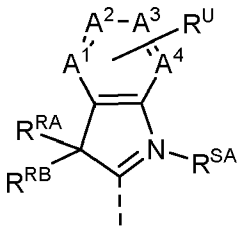
,

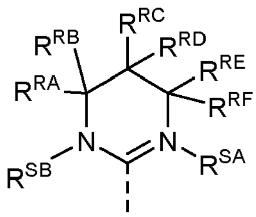
,
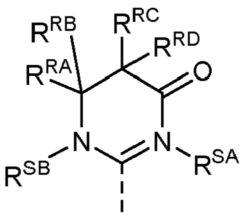
,
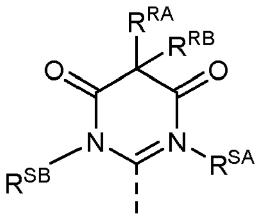
,
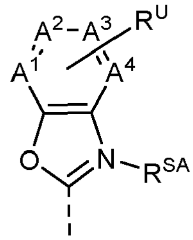
,
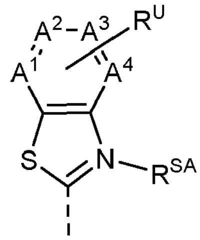
,

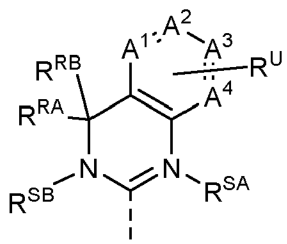
,
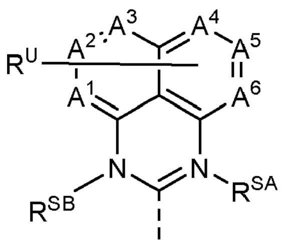
, and
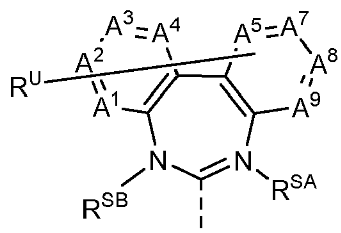
;

wherein $A^1$ - $A^9$ are each independently selected from C or N;

wherein each $R^P$, $R^P$, $R^U$, $R^{SA}$, $R^{SB}$, $R^{RA}$, $R^{RB}$, $R^{RC}$, $R^{RD}$, $R^{RE}$, and $R^{RF}$ is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof.

In embodiments of the composition A where the first dopant is capable of TADF emission at room temperature in an OLED, the first dopant can be selected from the group consisting of:

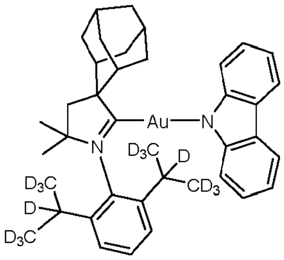,
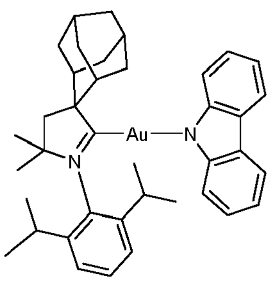,
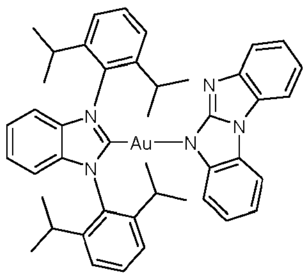,
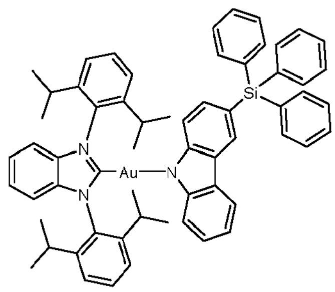,

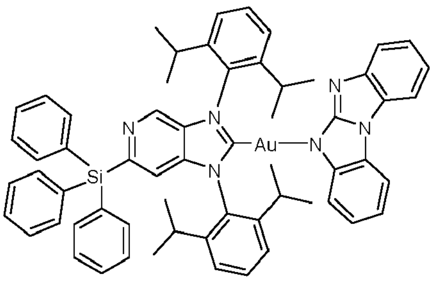,
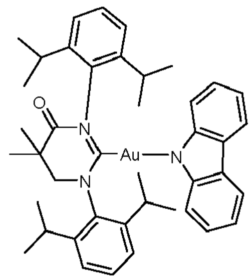,
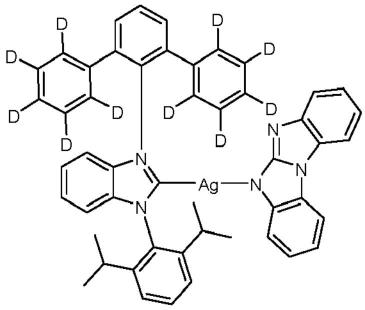,

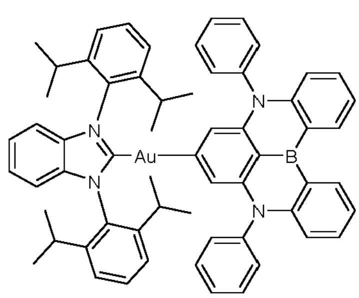,
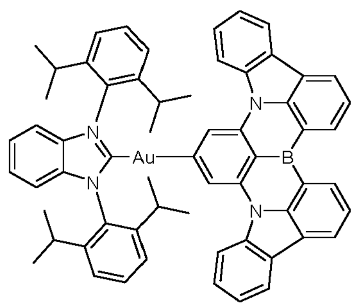,
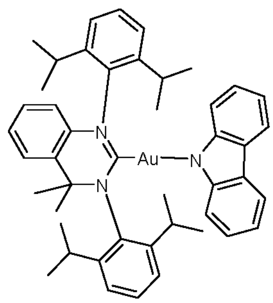,

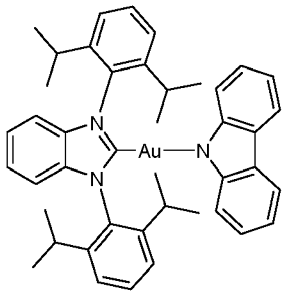,
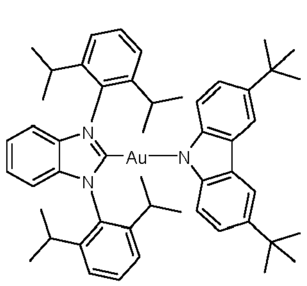,
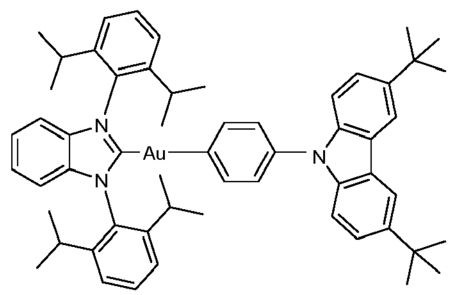,

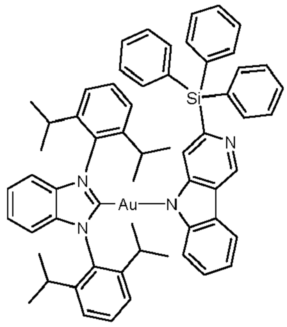,
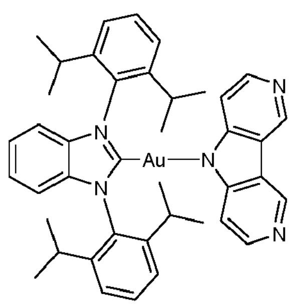, and
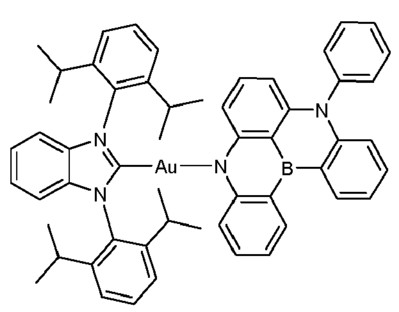.

In embodiments of the composition A, the first dopant can be selected from the group consisting of

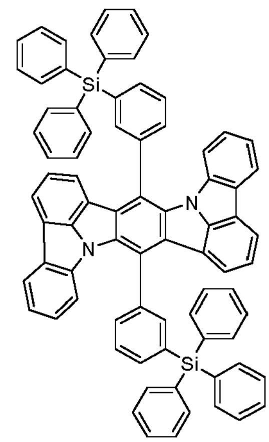

,

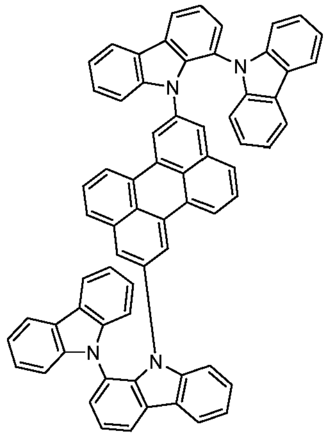

,

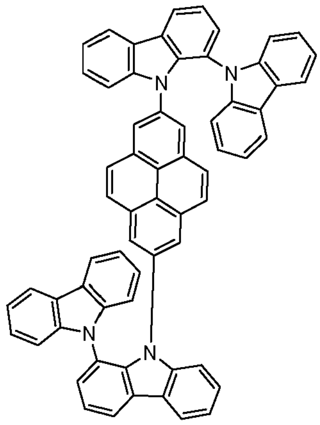

,

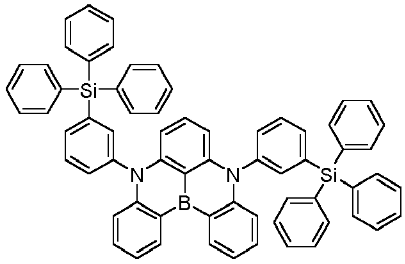

,

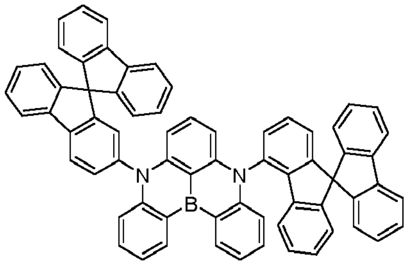

,

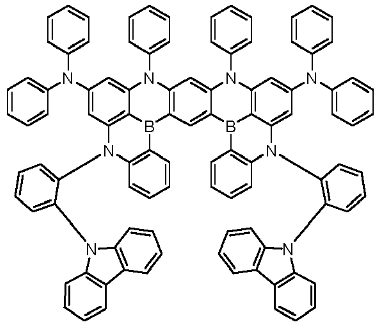

,

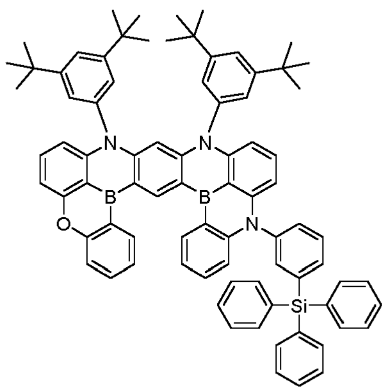

,

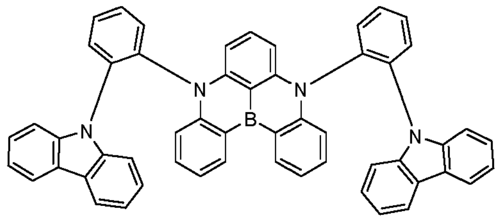

,

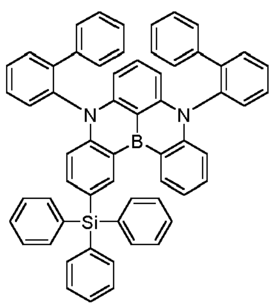

,

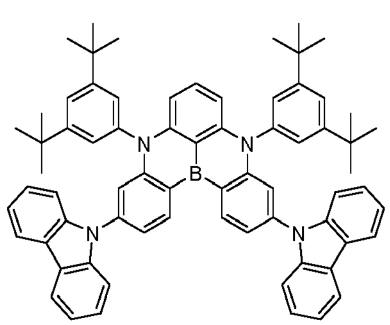

,

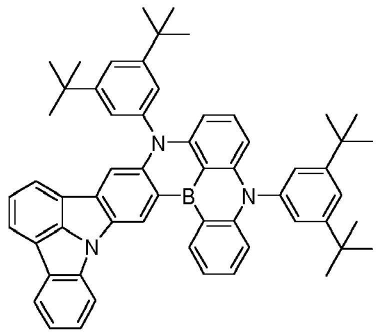

,

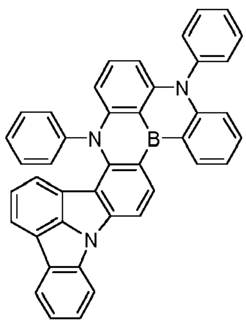

,

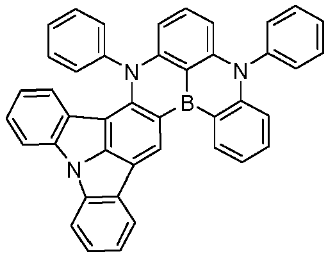 , 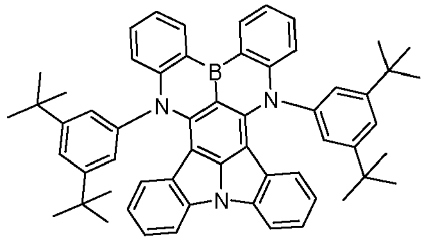 , 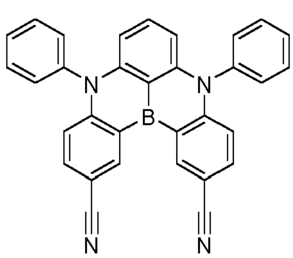 ,

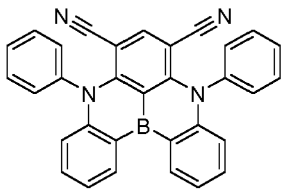 , 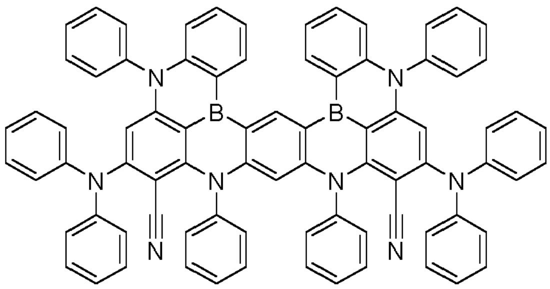 ,

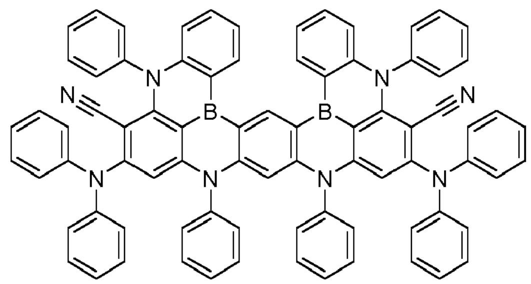 , 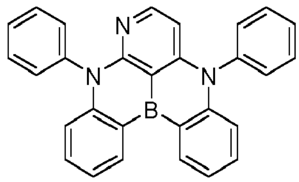 , 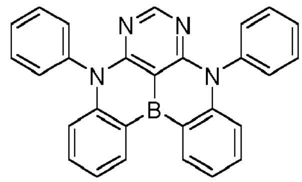 ,

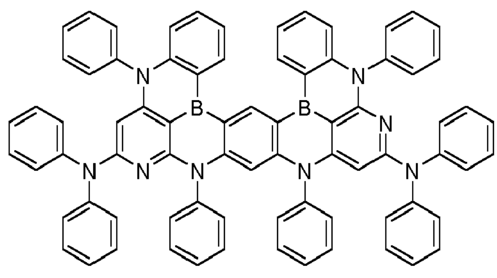 , 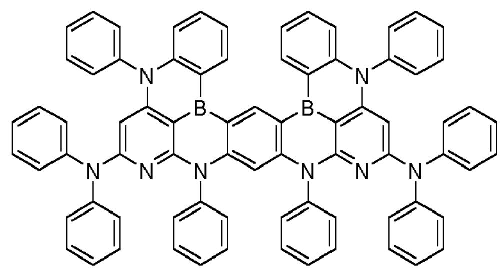 ,

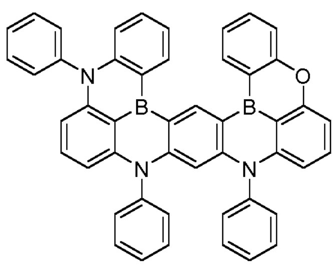 , 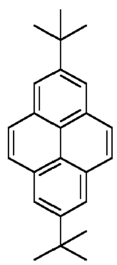 , 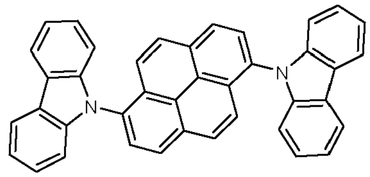 , 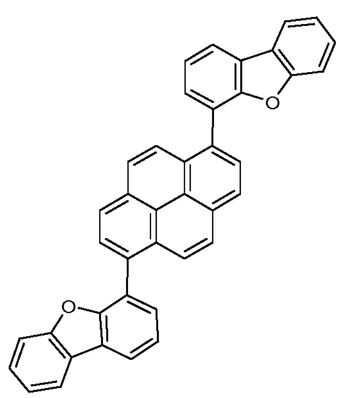 ,

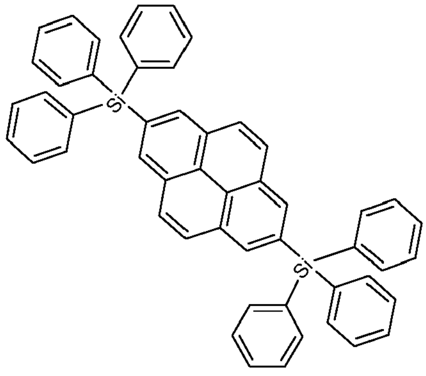, 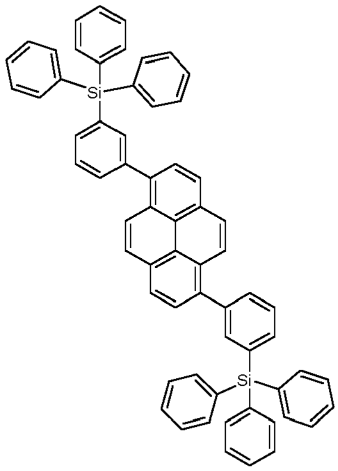, 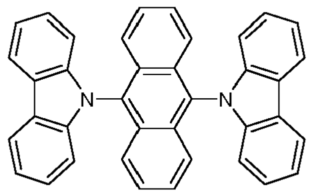,

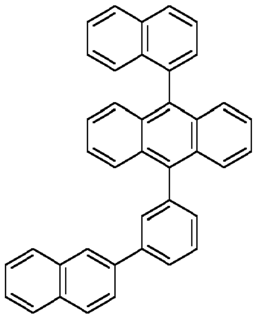, 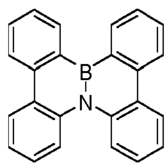, 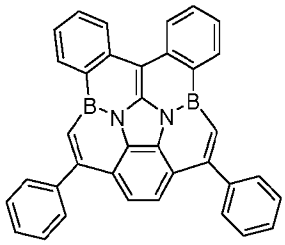, 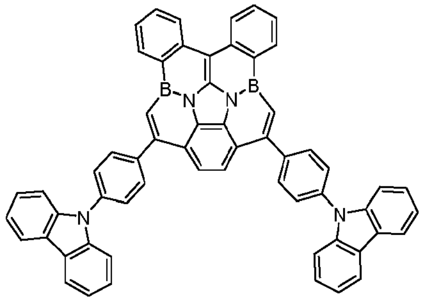,

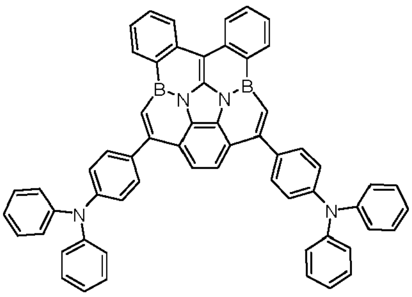, 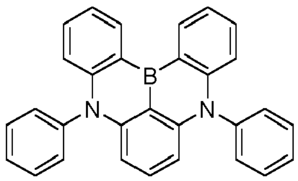, 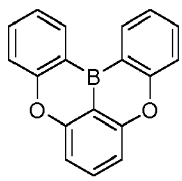, 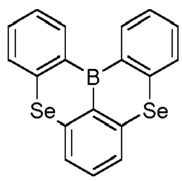,

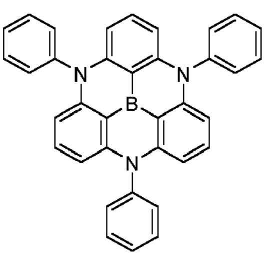, 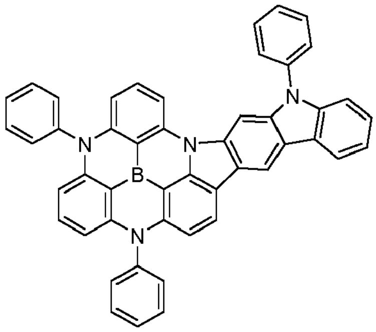, 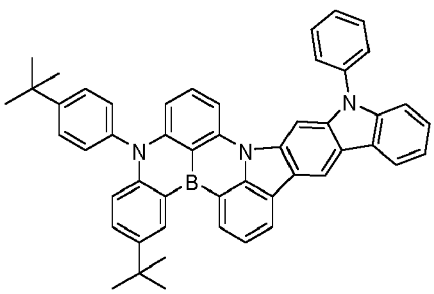,

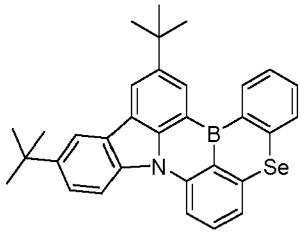,
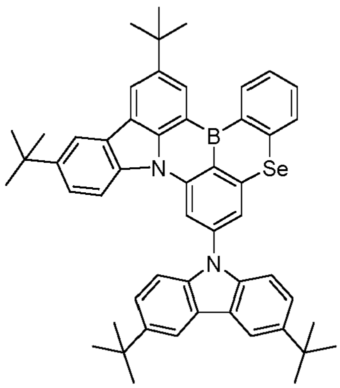,
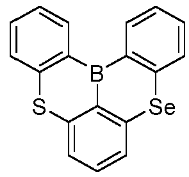,
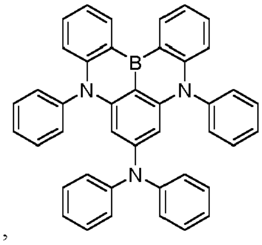,

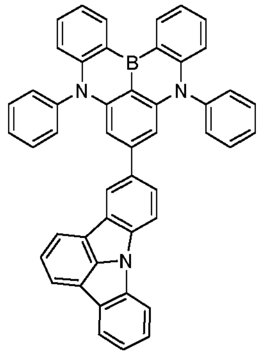,
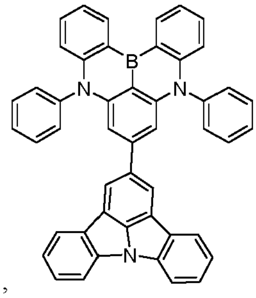,
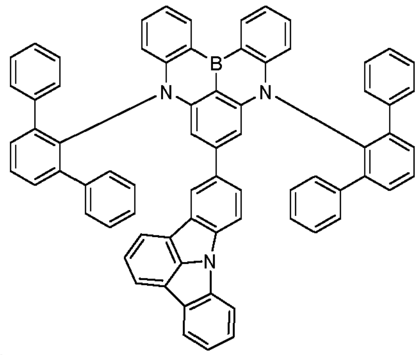,

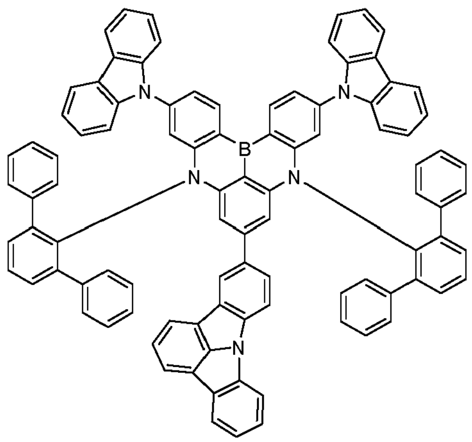,
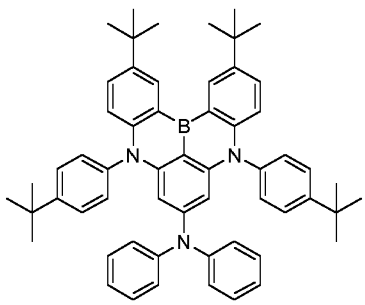,
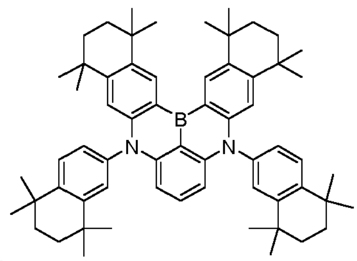,

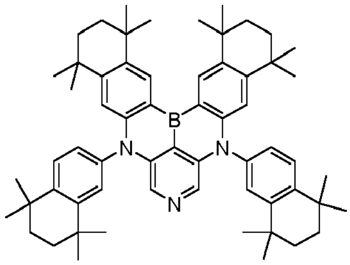,
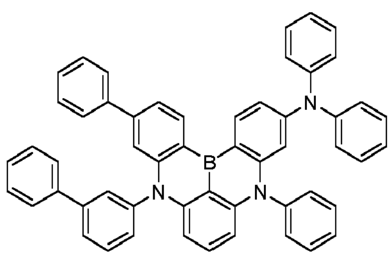,
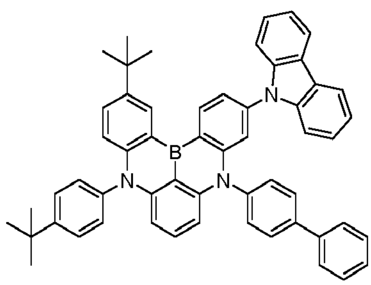,

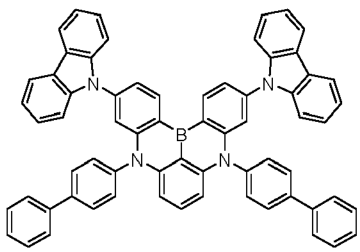, 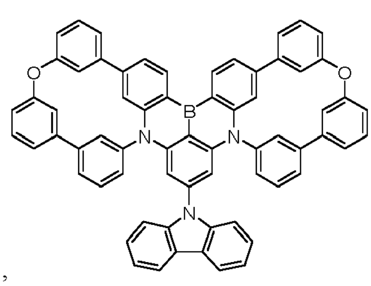, 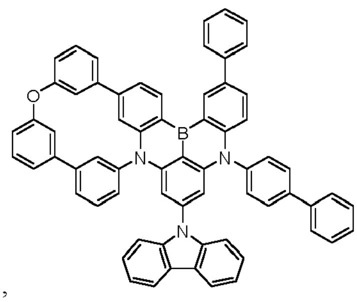,

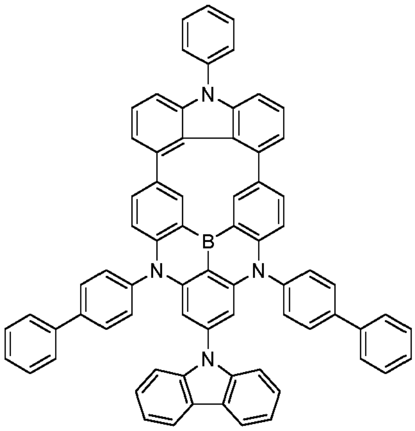, 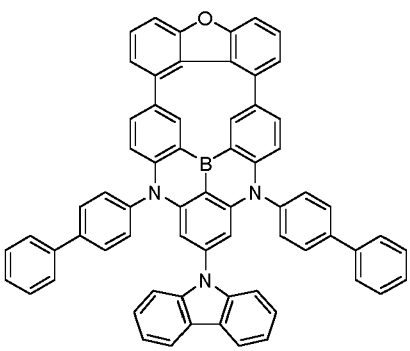, 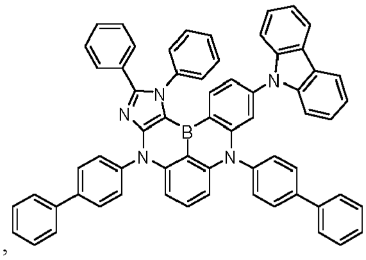,

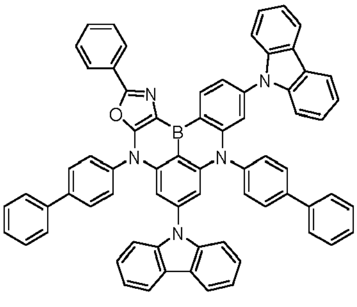, 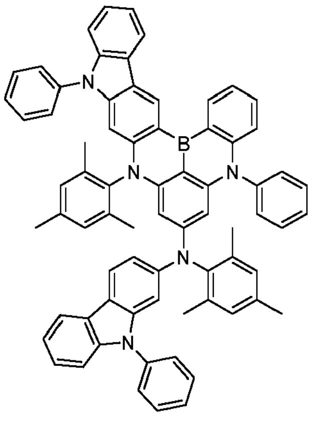, 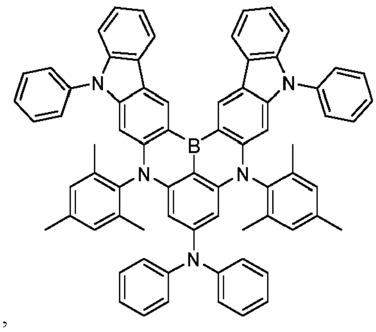,

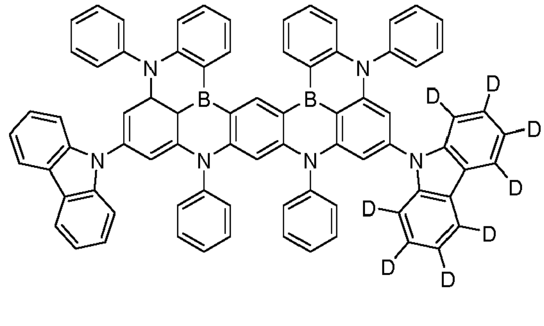, 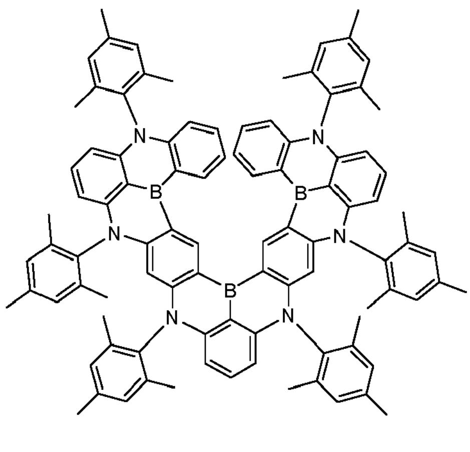,

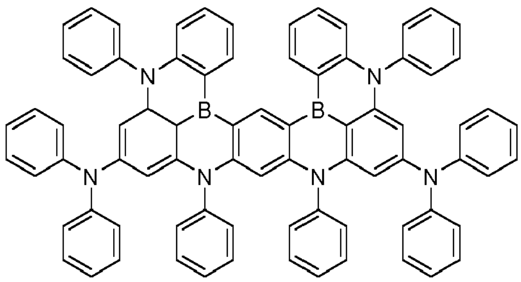,
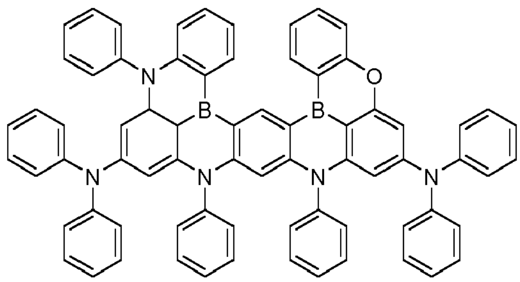,

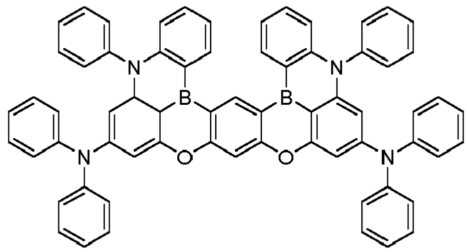,
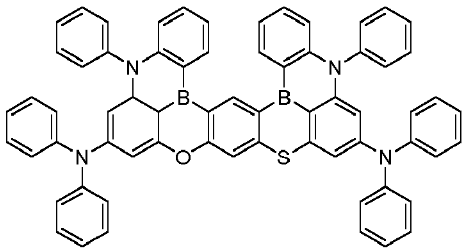,

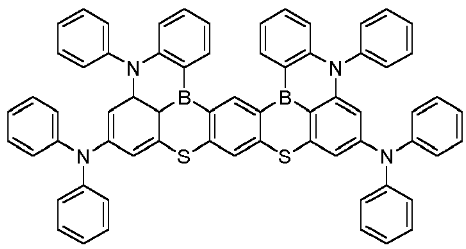,
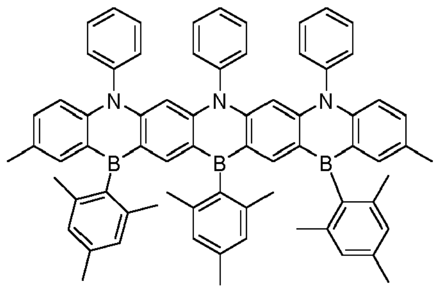,

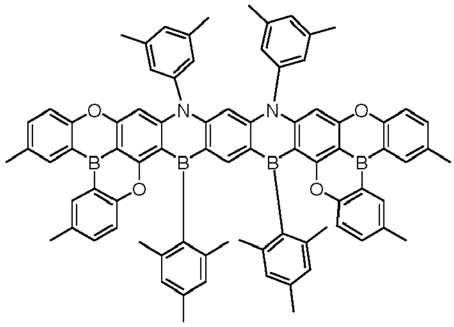,
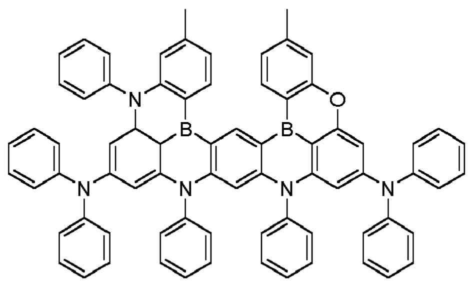,
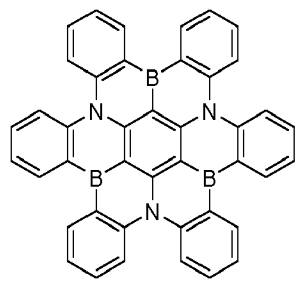,

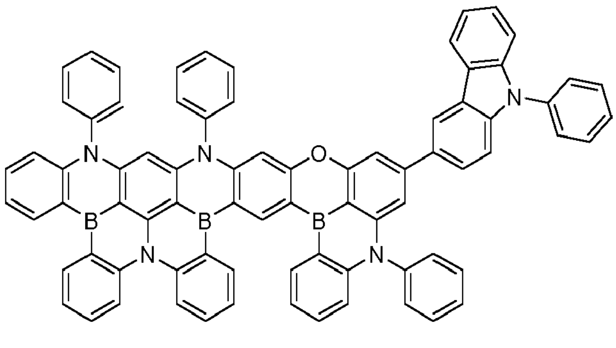,
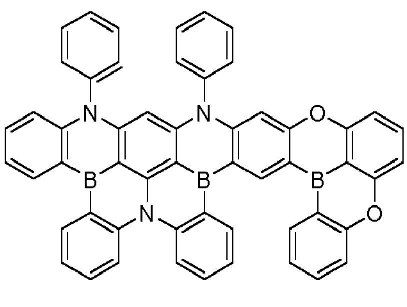,

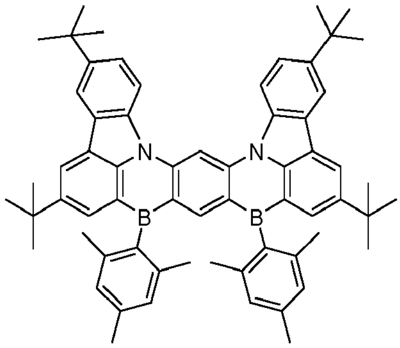
,
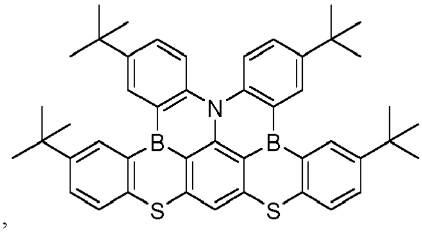
,
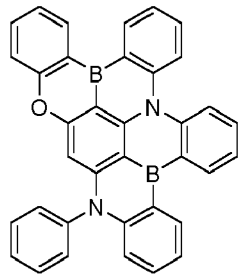
,

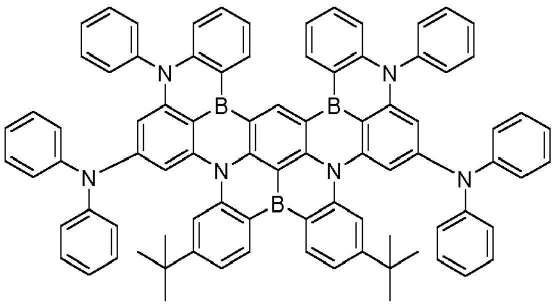
,
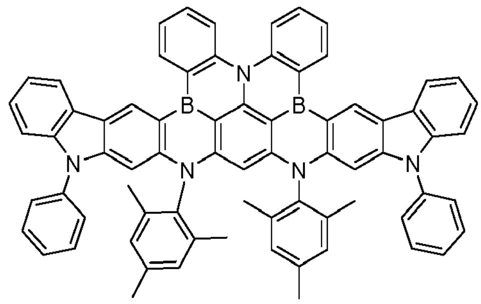
,

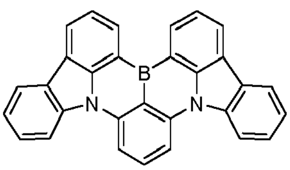
,
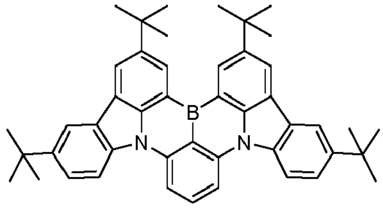
,
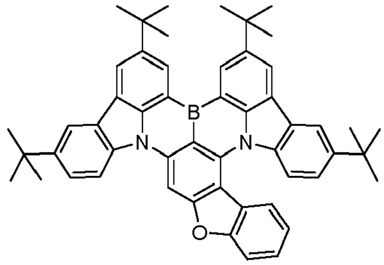
,

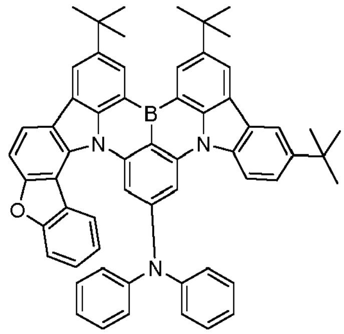
,
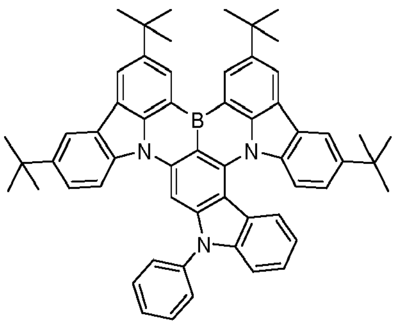
,
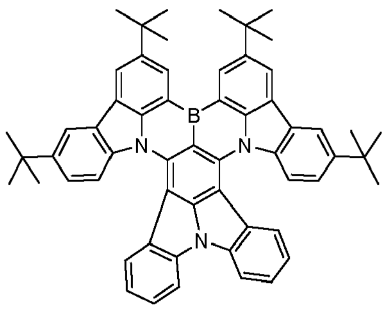
,

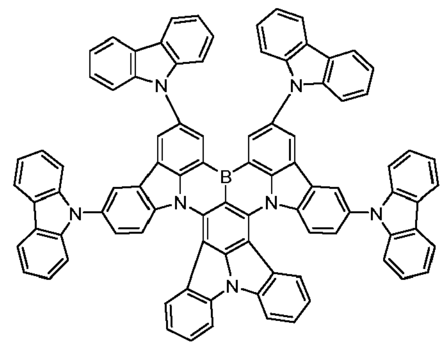,
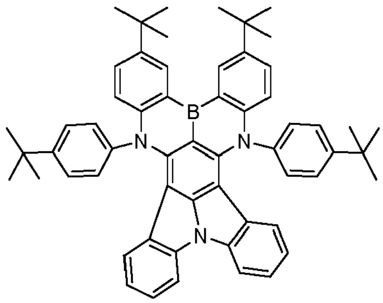,
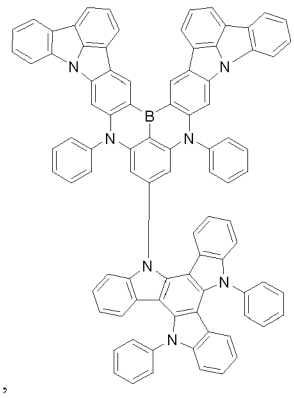,

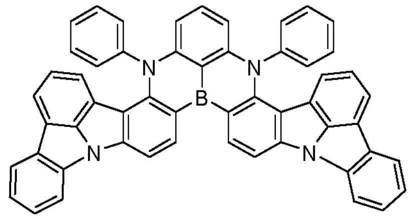,
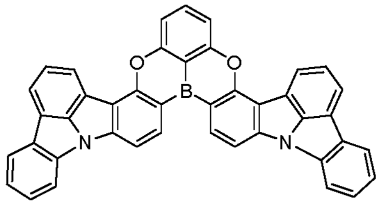,
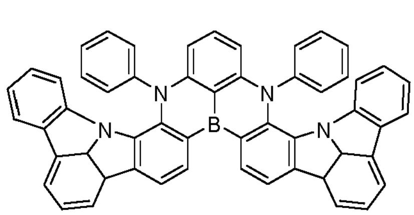,

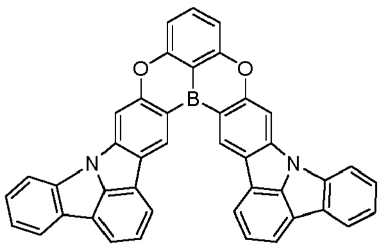,
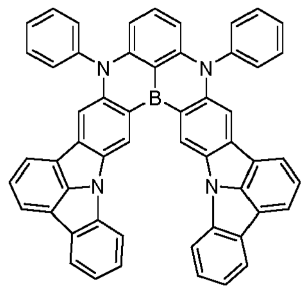,
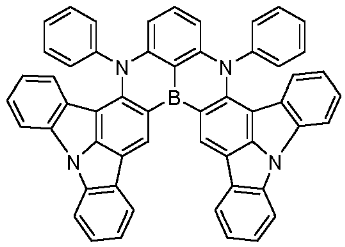,

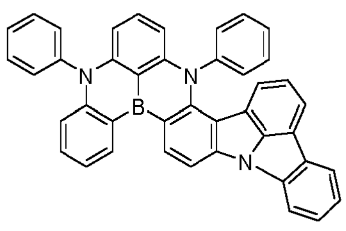,
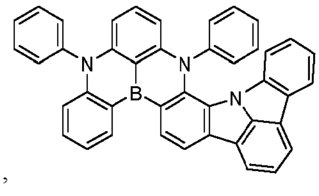,
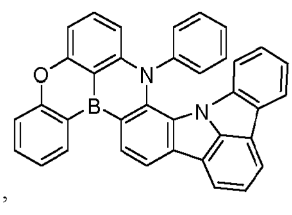,
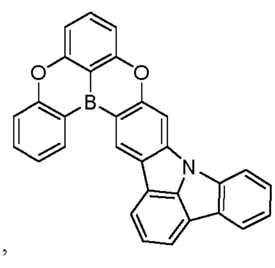,

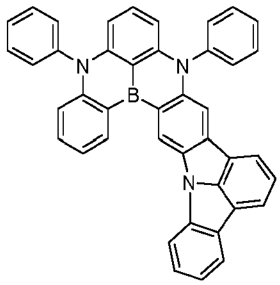,
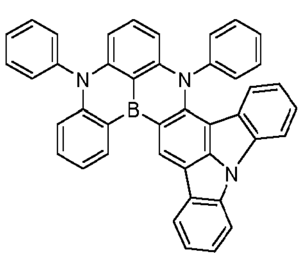,
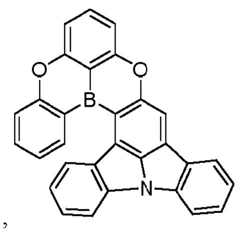,
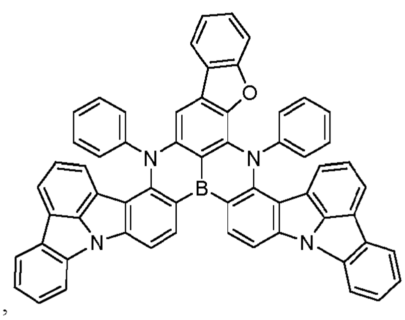,

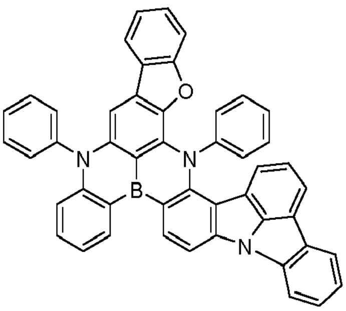,
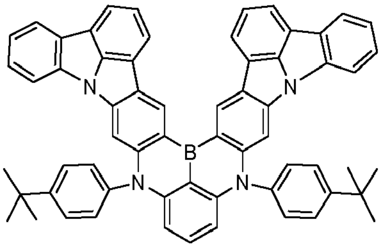,
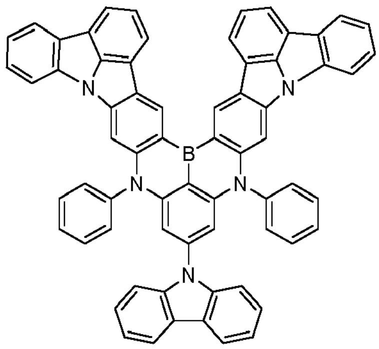,

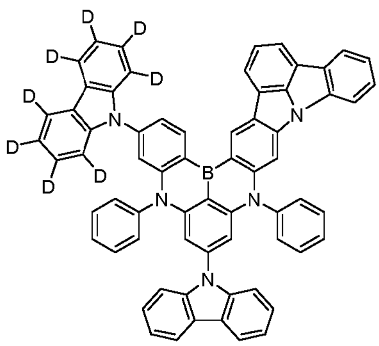,
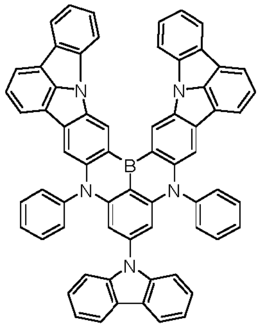,
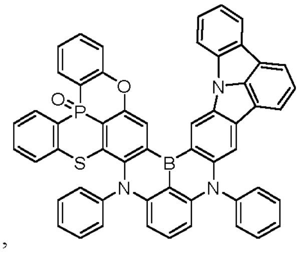,
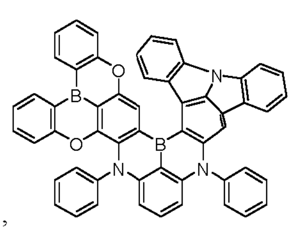,

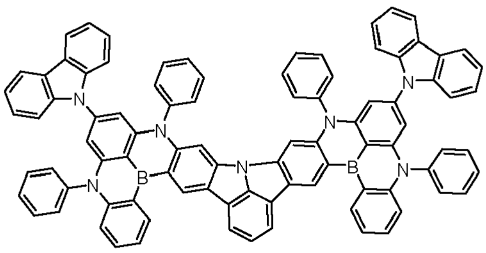,
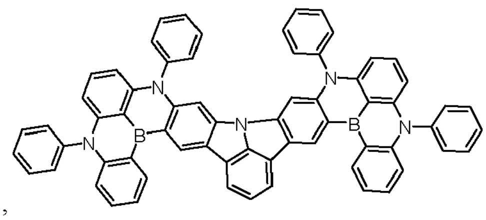,

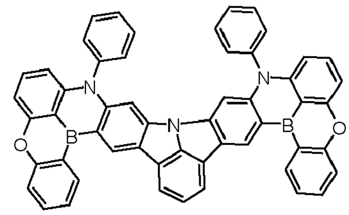,
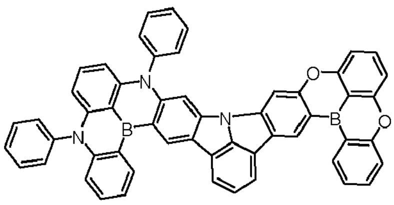,

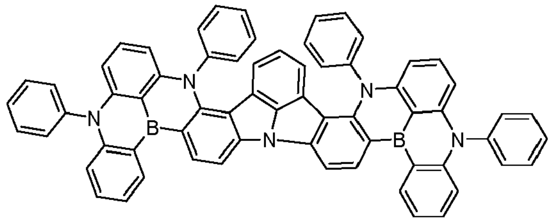,

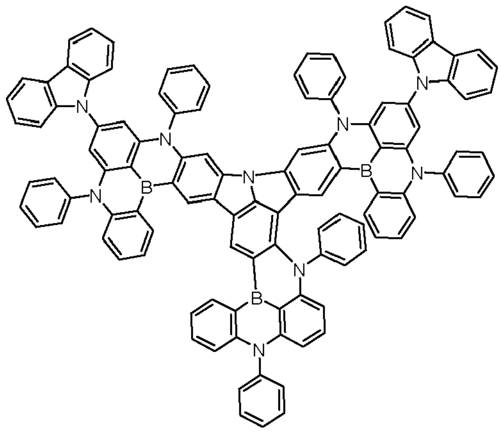,

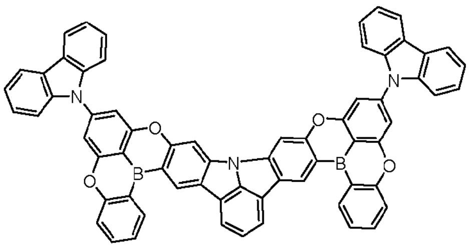,

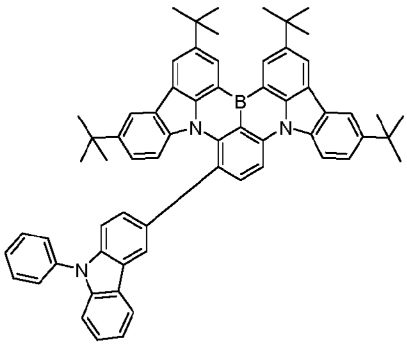,

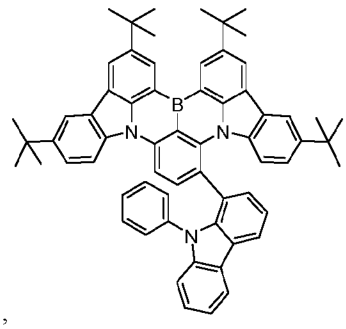,

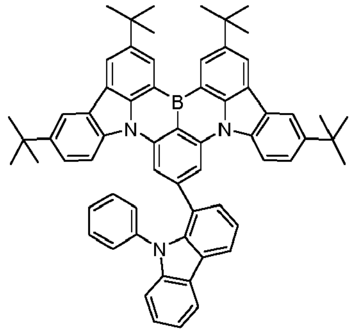,

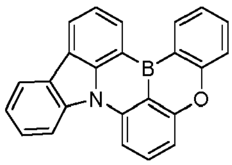,

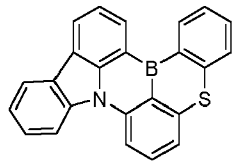,

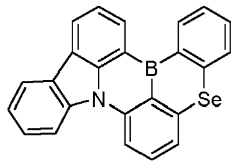,

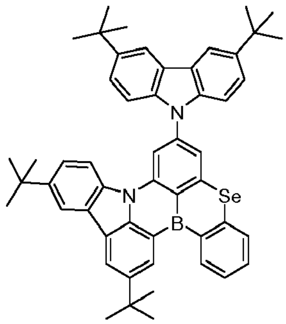,

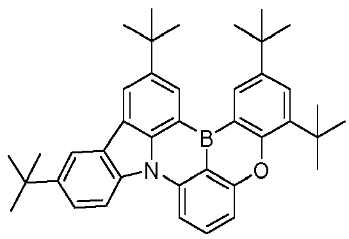,

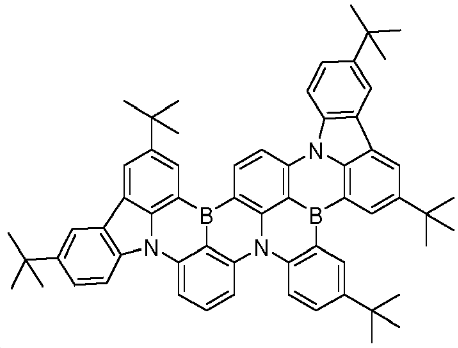,

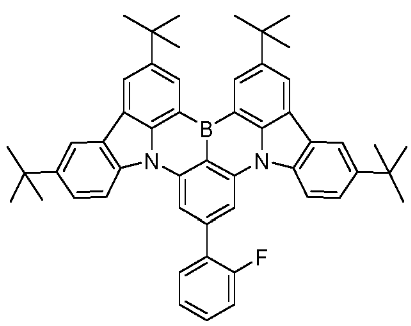
,
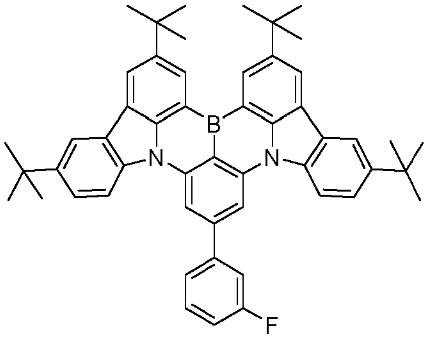
,
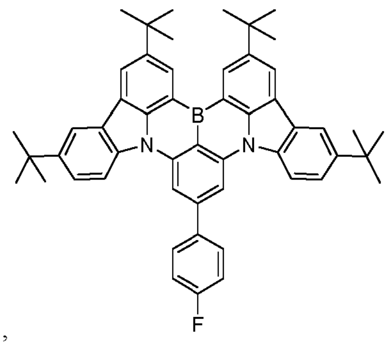
,

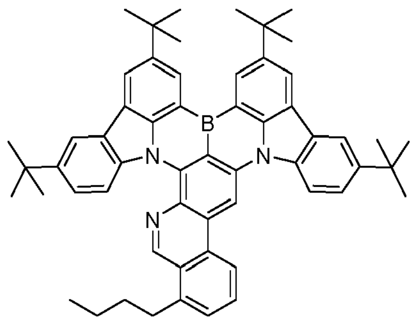
,
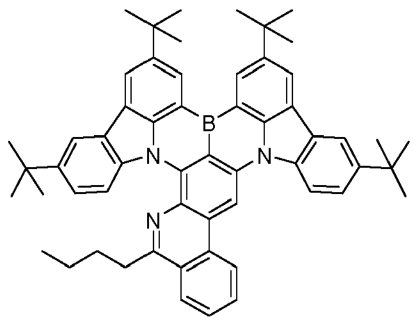
,

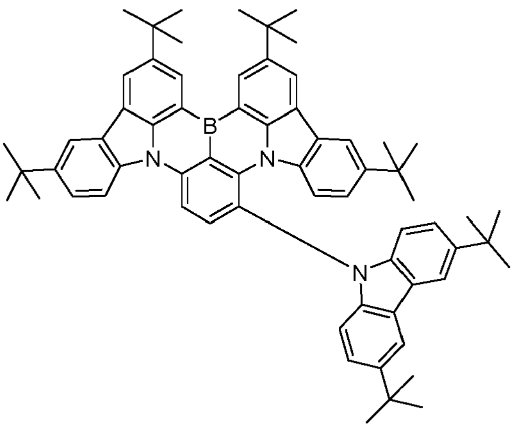
,
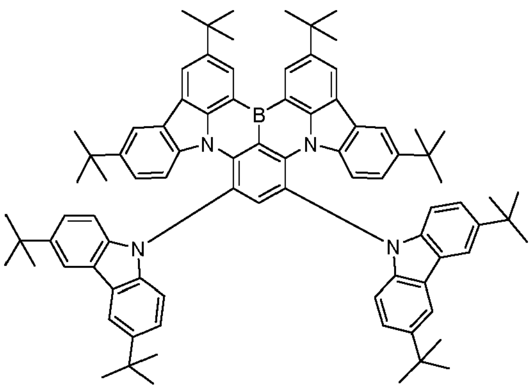
,

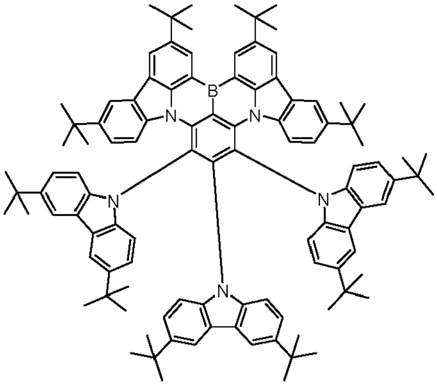
,
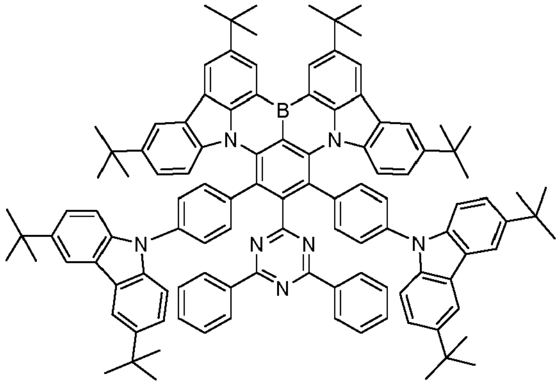
,

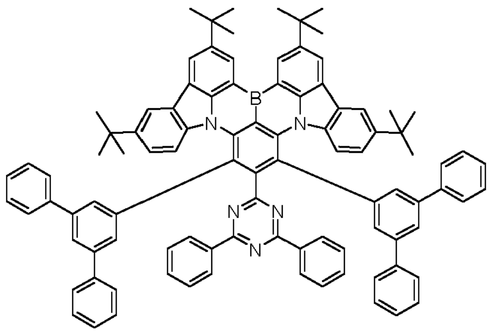,
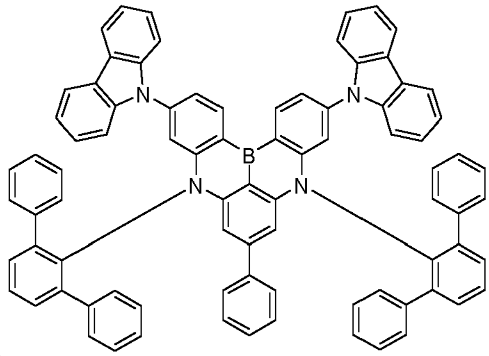,

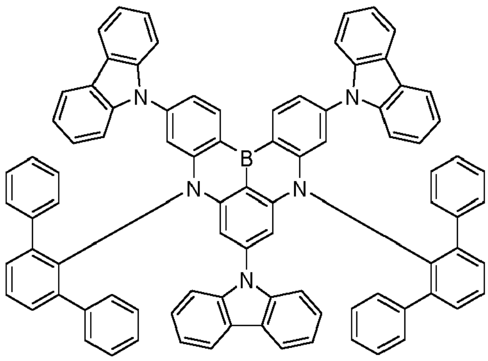,
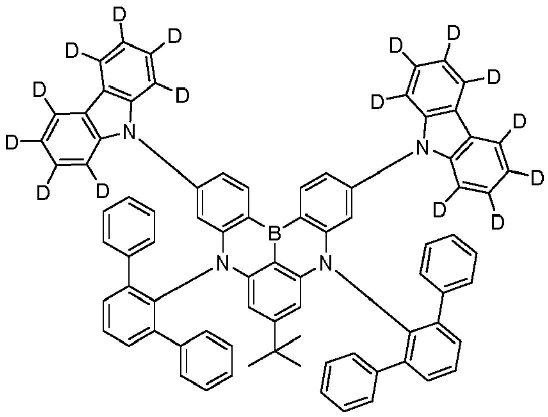,

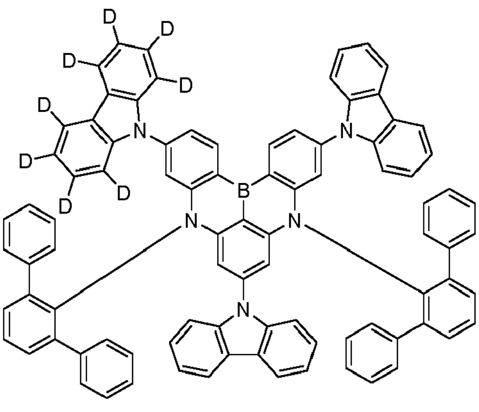,
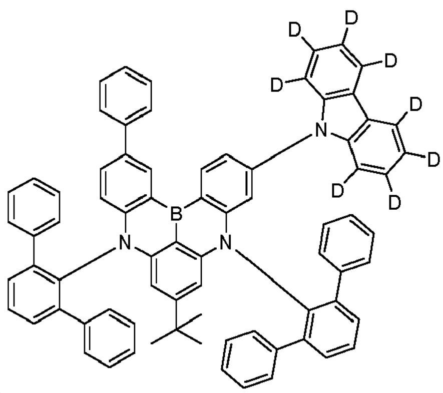,

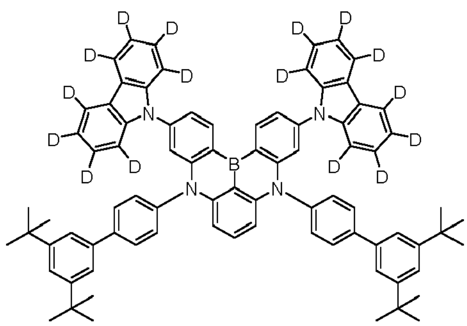,
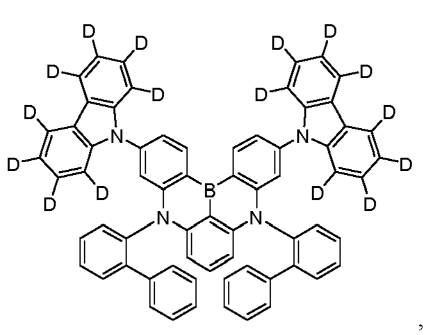,

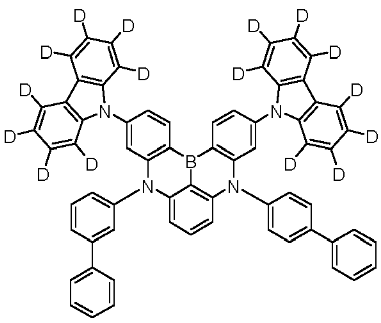,
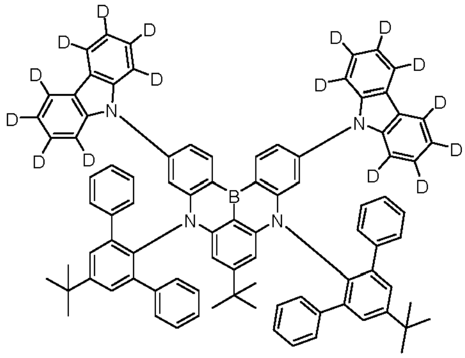,
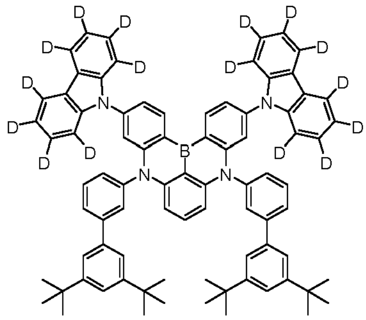,

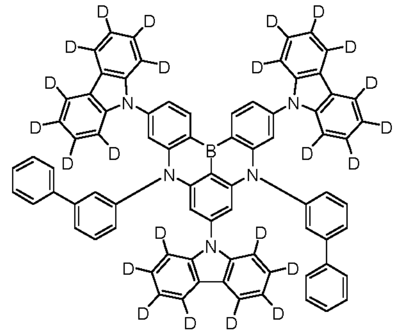,
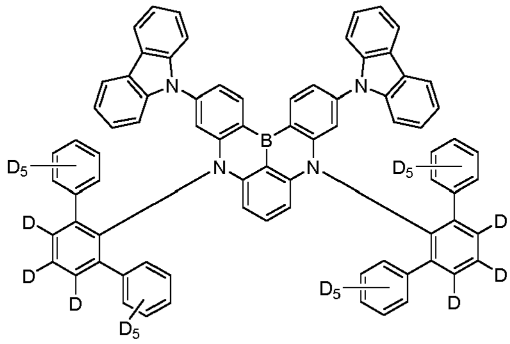,

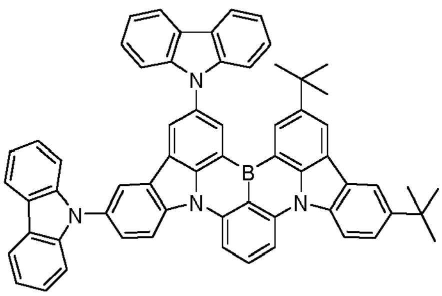,
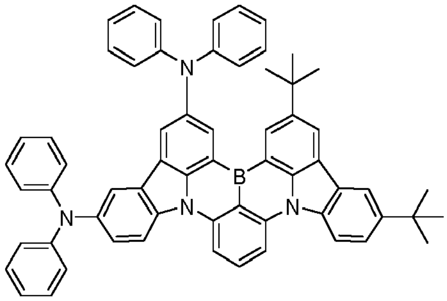,

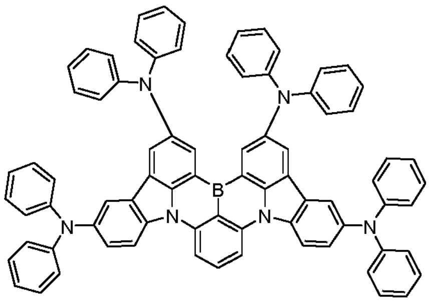,
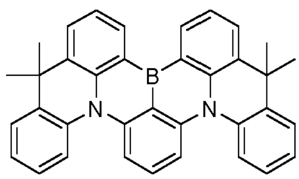
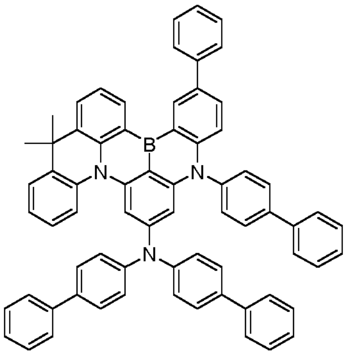,

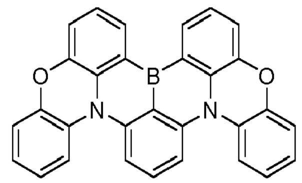 , 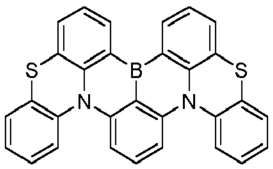 , 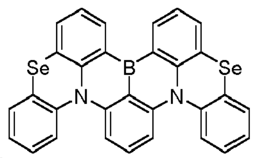 , 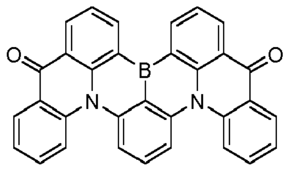 ,

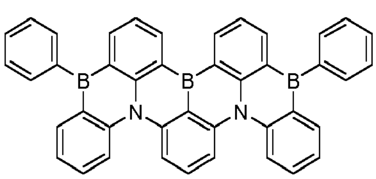 , 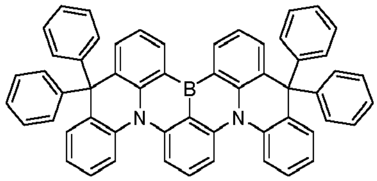 , 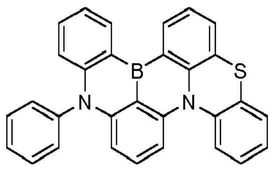 ,

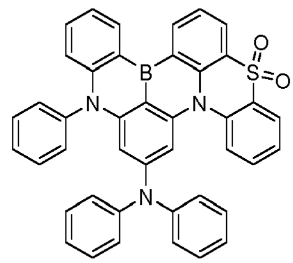 , 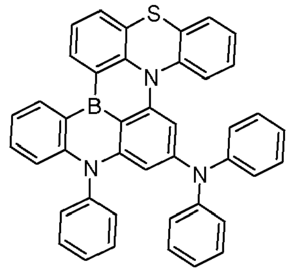 , 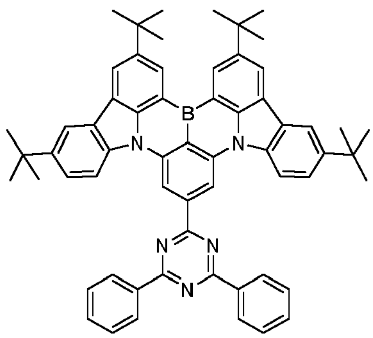 ,

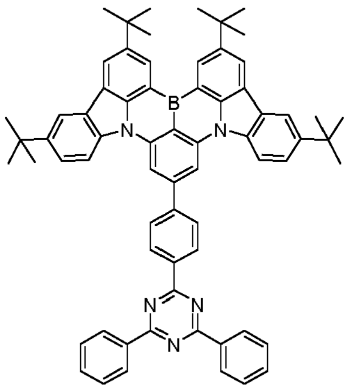 , 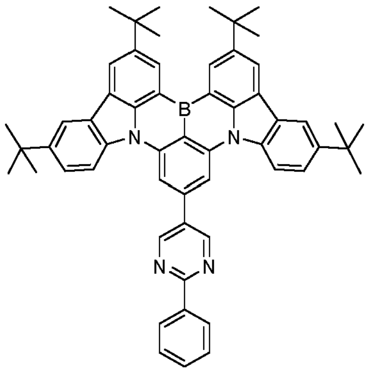 , 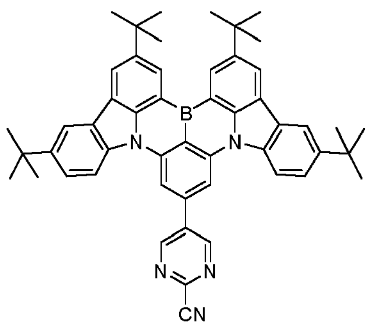 ,

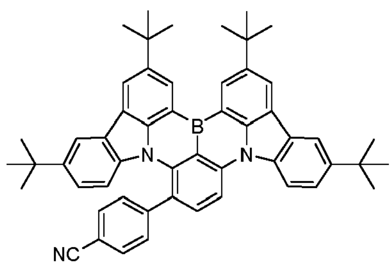 , 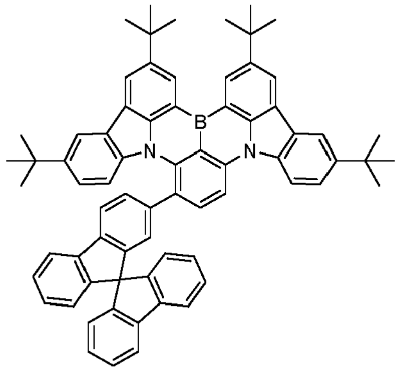 , 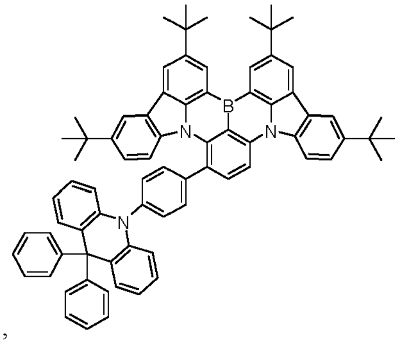 ,

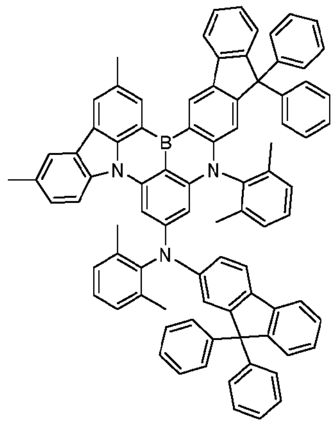,
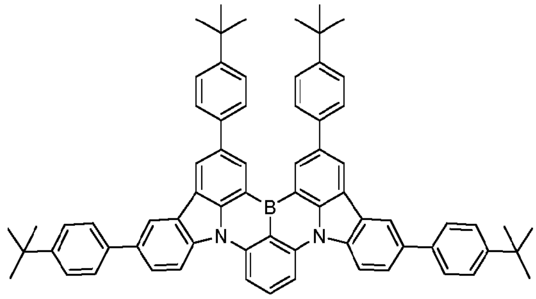,
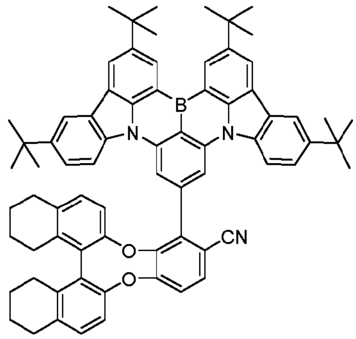,

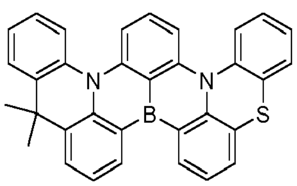,
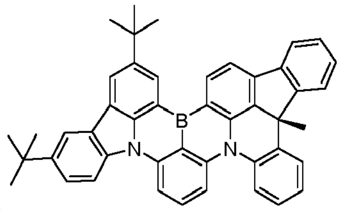,
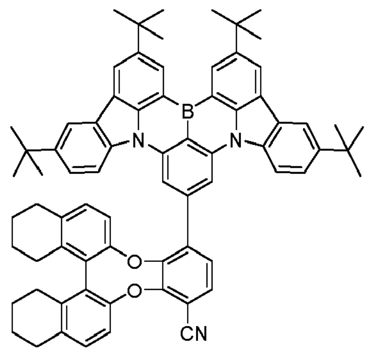,

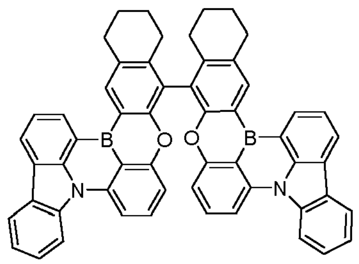,
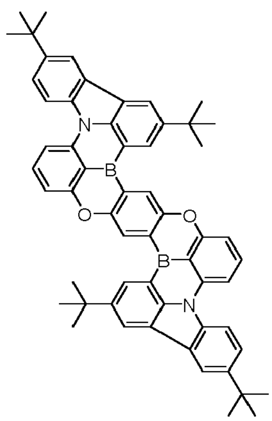,
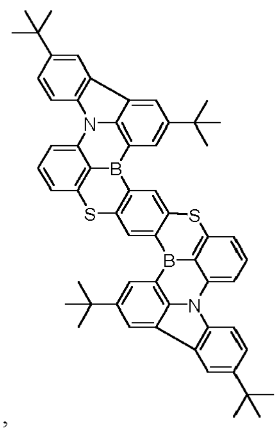,
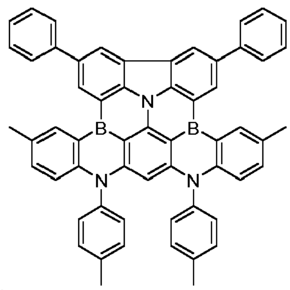,

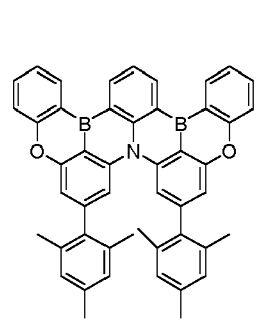,
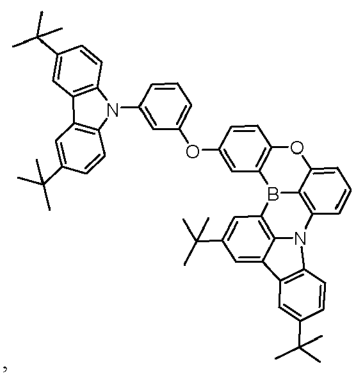,
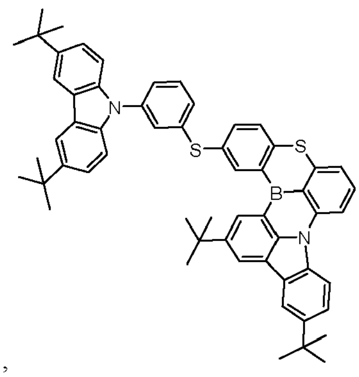,

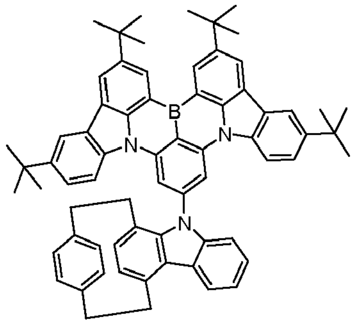, 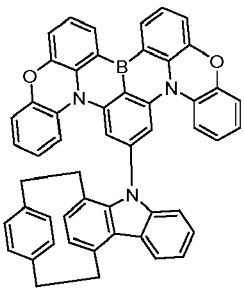, 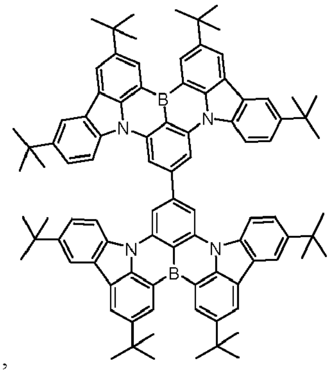,

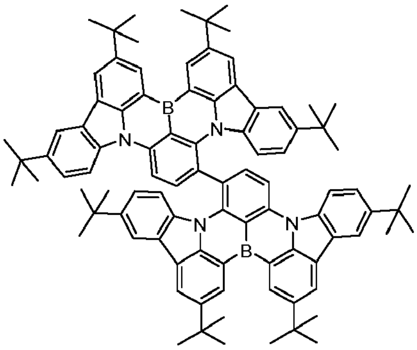, 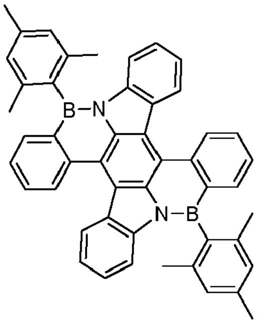, 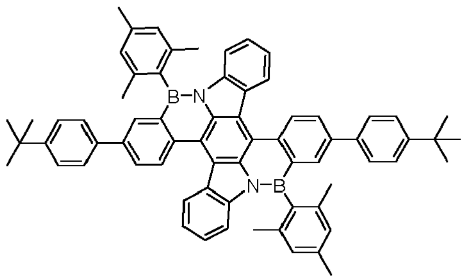,

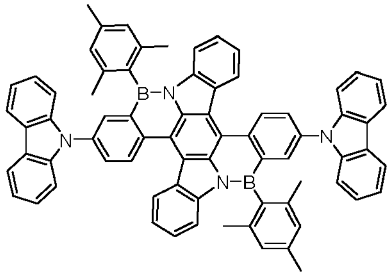, 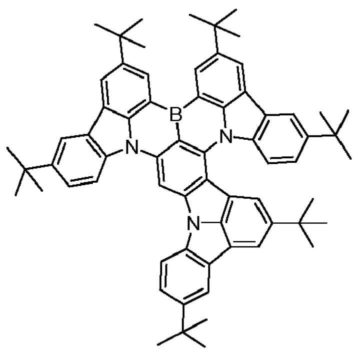, 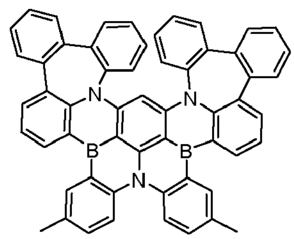,

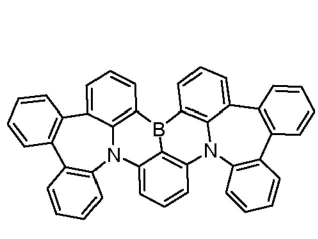, 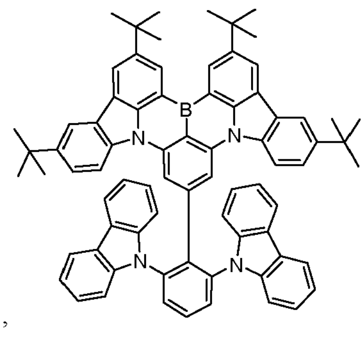, 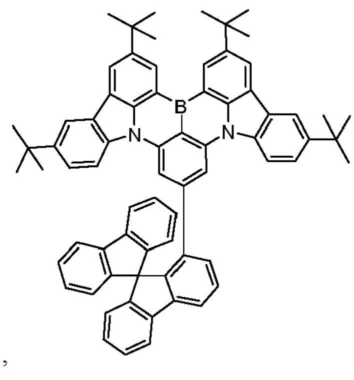,

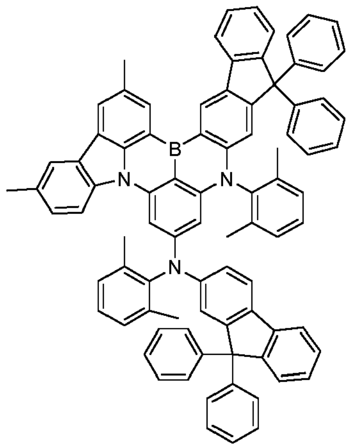

,

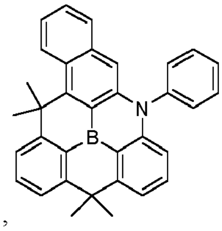

,

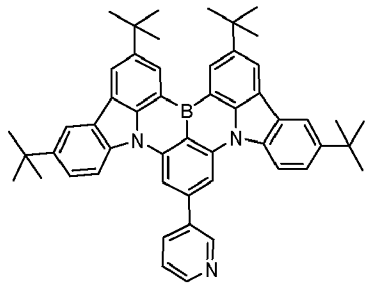

,

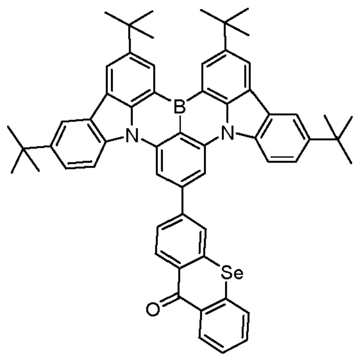

,

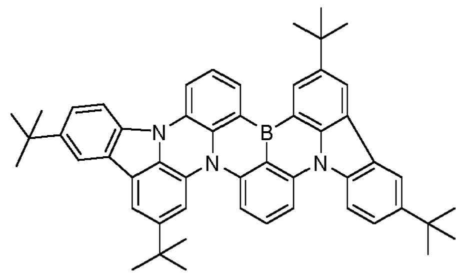

,

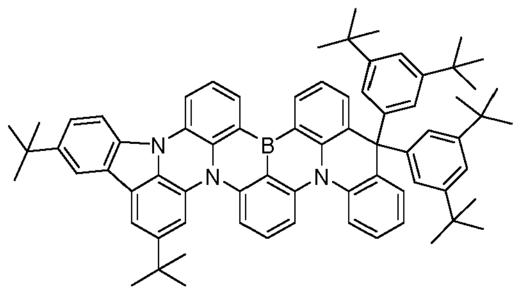

,

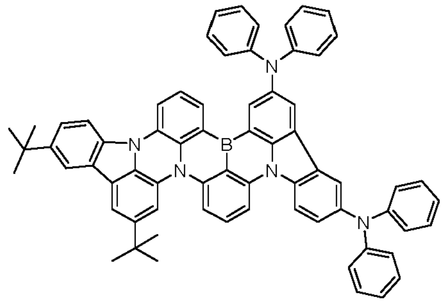

,

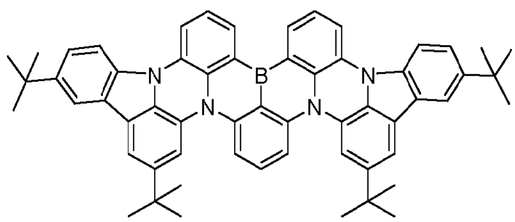

,

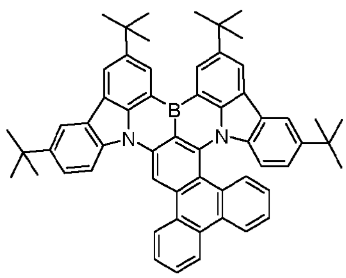

,

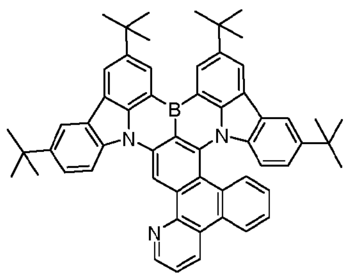

,

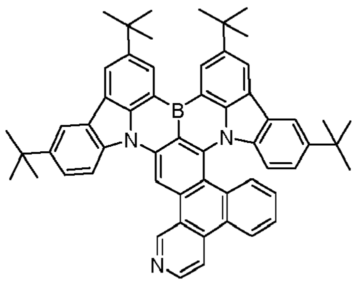
,
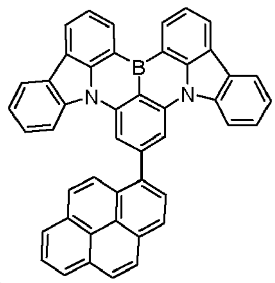
,
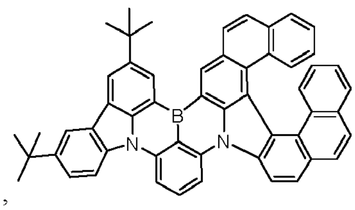
,

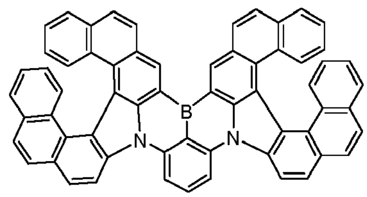
,
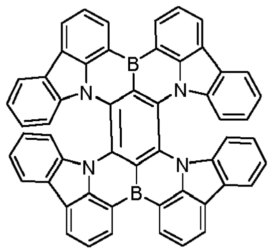
,
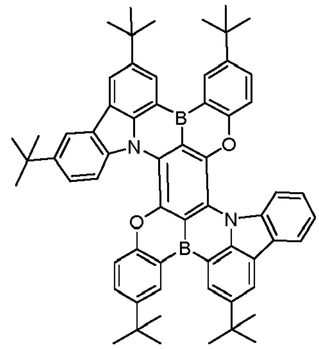
,

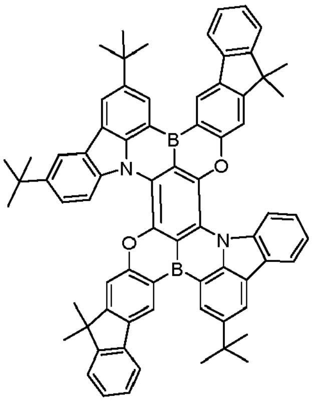
,
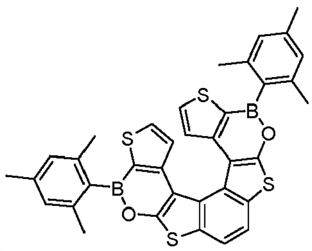
,
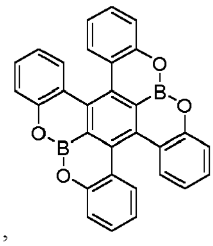
,
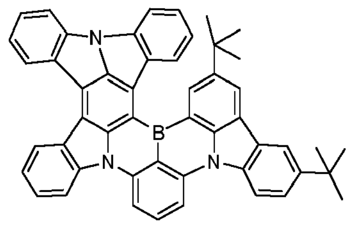
,

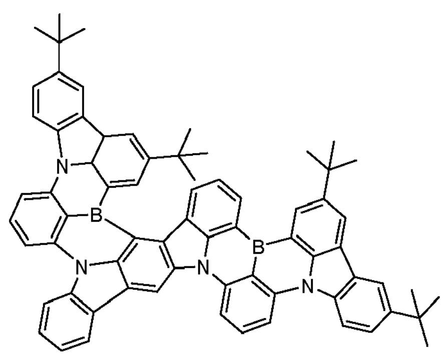
,
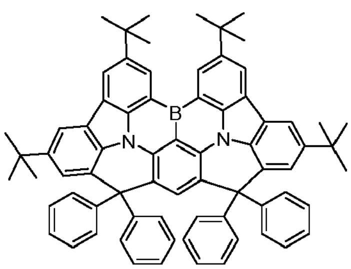
,
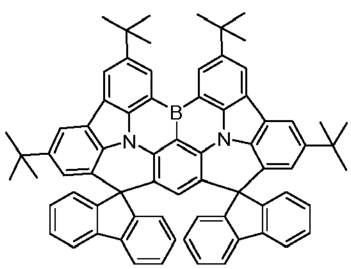
,

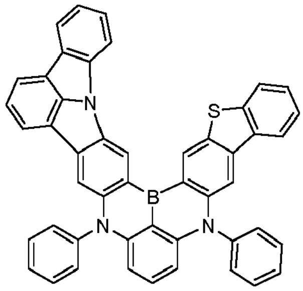
,
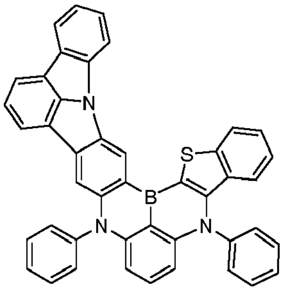
,
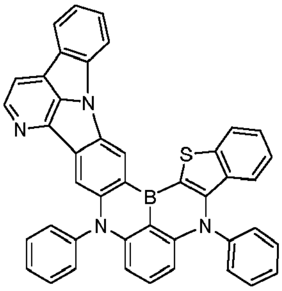
,
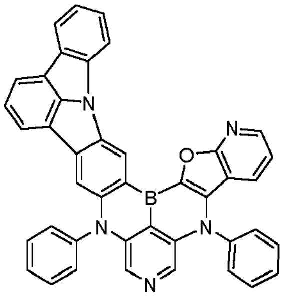
,

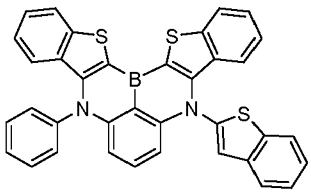
,
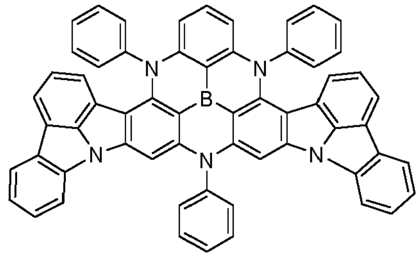
,
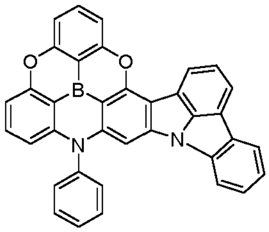

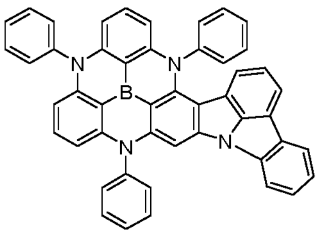
,
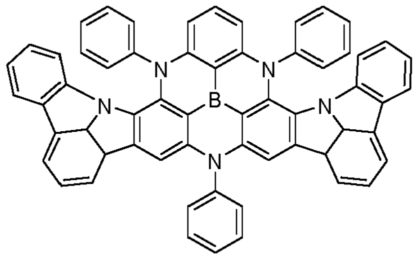
,
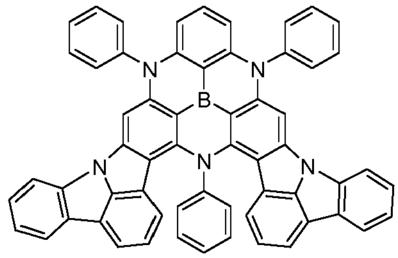
,

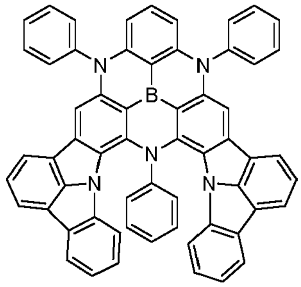
,
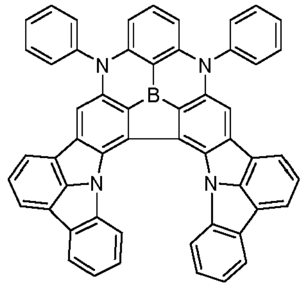
,
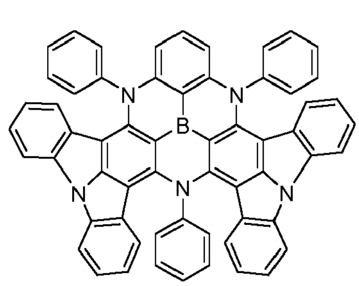
,

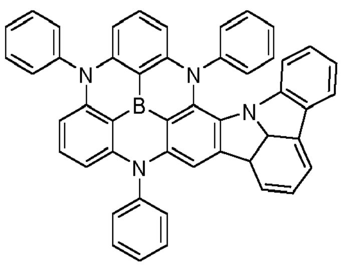
,
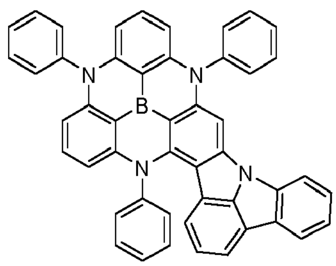
,
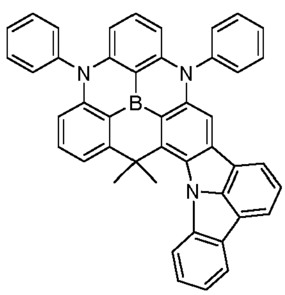
,

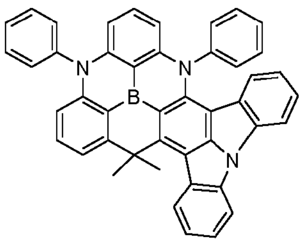 , 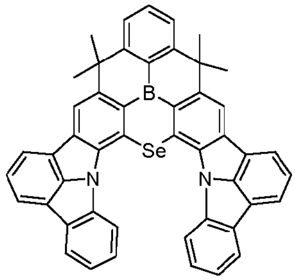 , 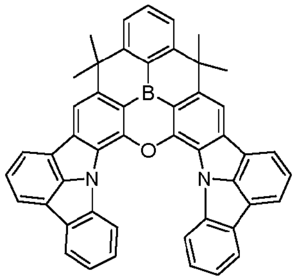 , 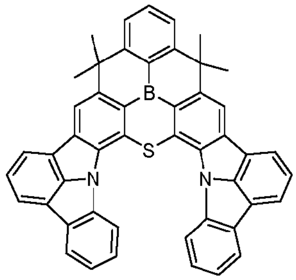 ,

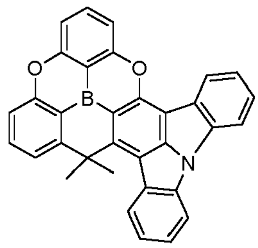 , 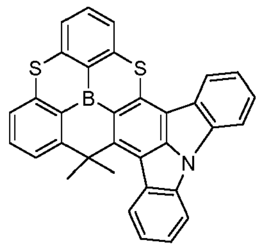 , 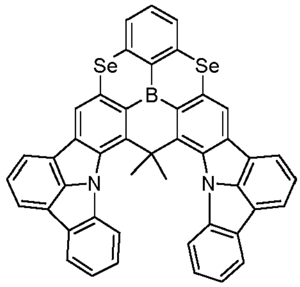 , 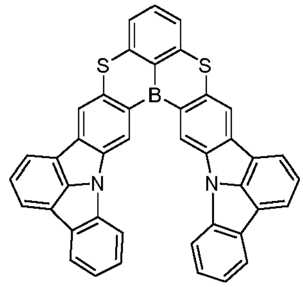 ,

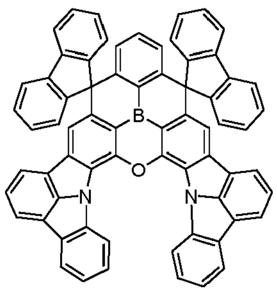 , 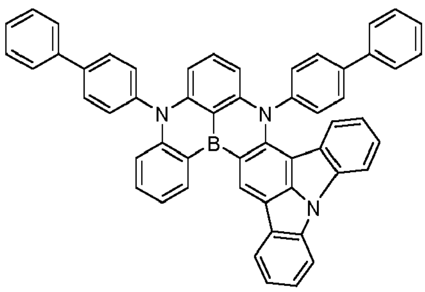 ,

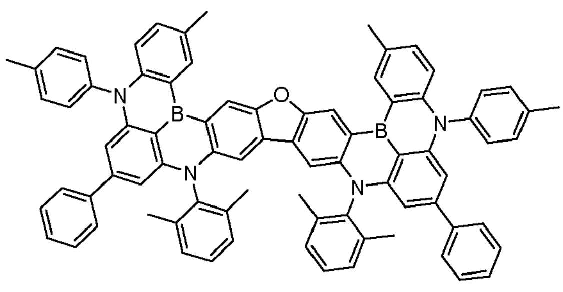 , 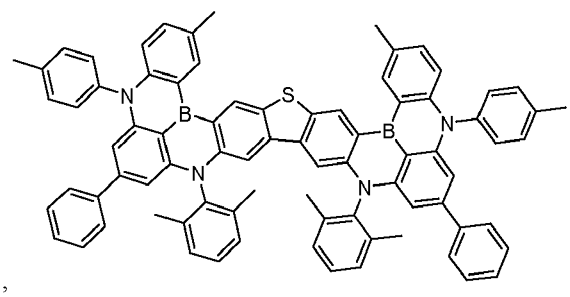 ,

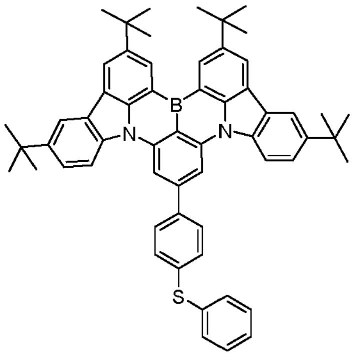 , 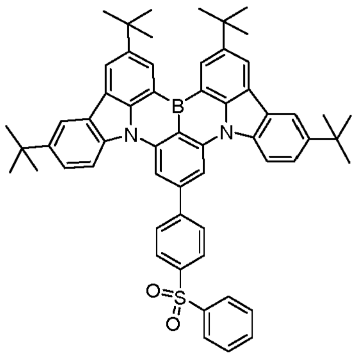 , 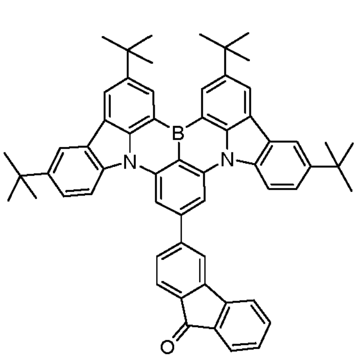 ,

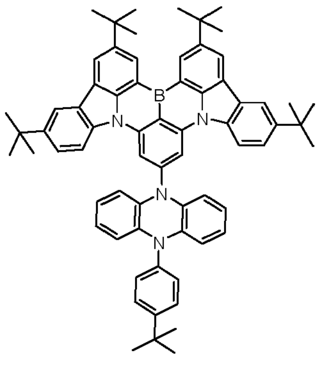,
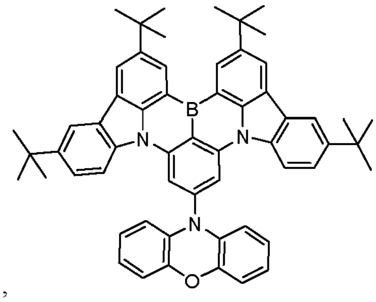,
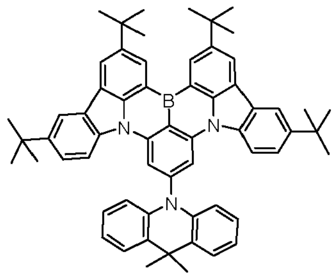,

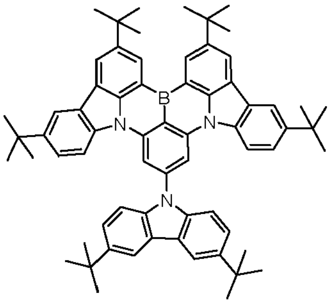,
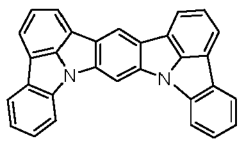,
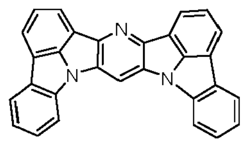,
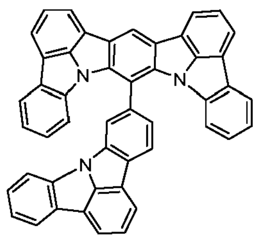,

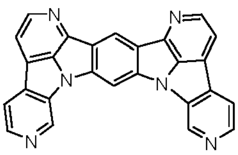,
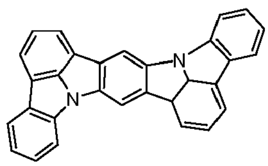,
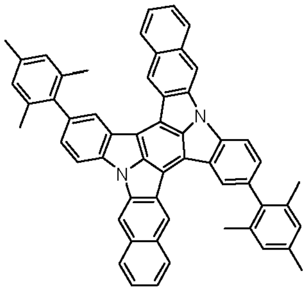,
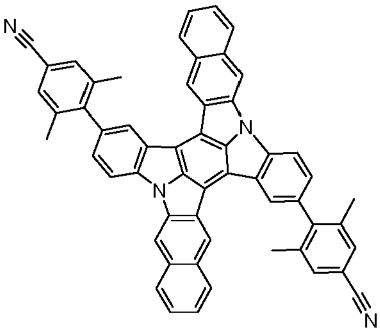,

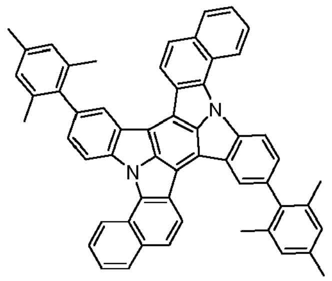,
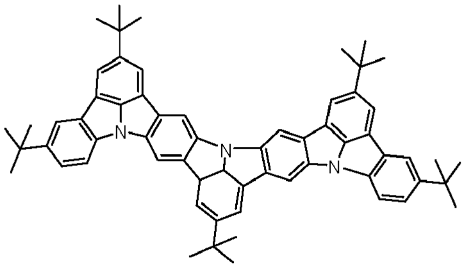,

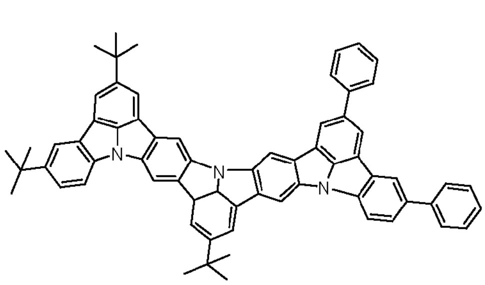 , 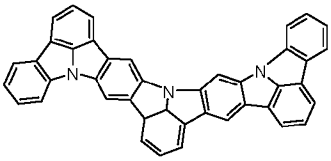 , 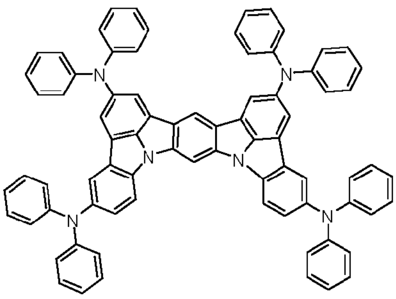 ,

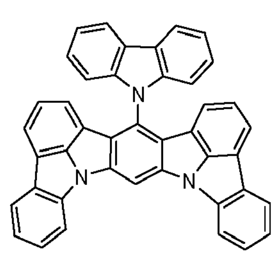 , 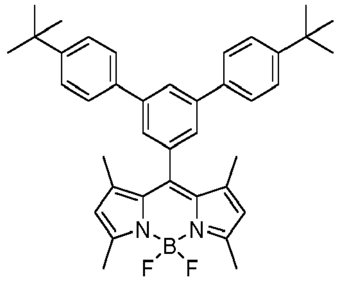 , 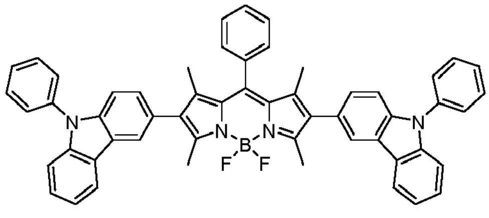 ,

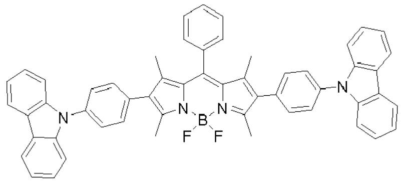 , 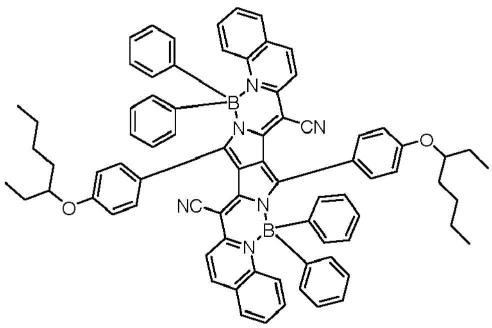 ,

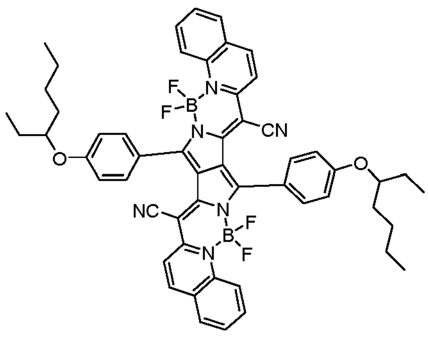 , 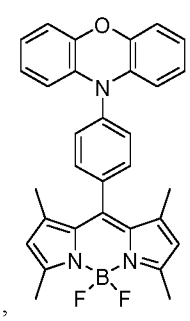 , 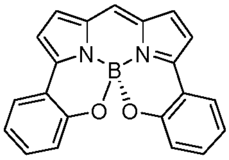 , 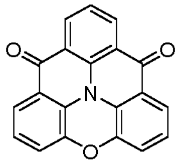 , 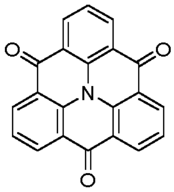 ,

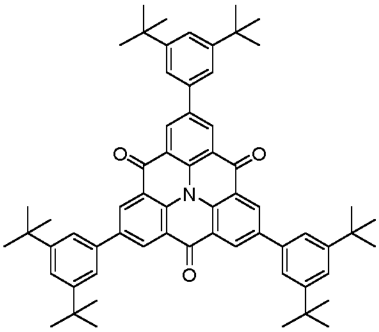,
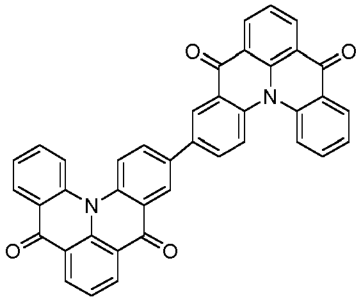,
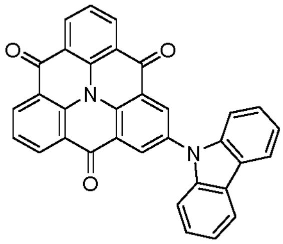,
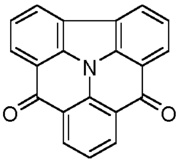,

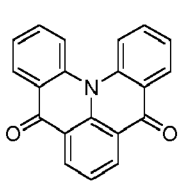,
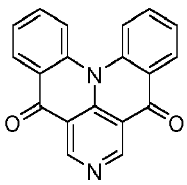,
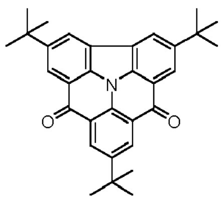,
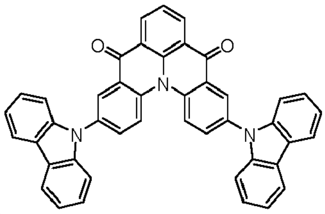,

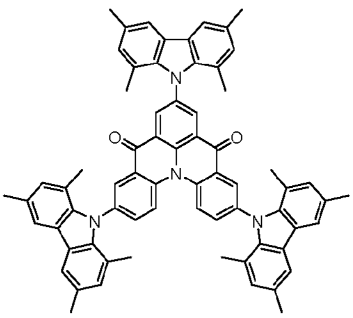,
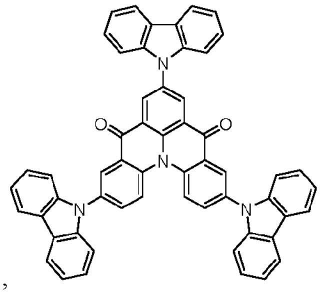,
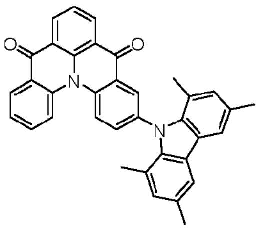,
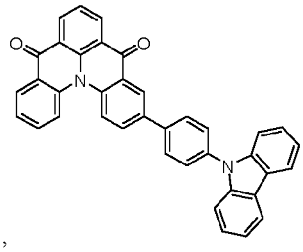

,
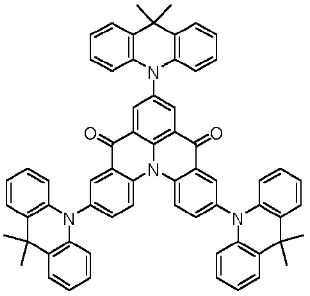,
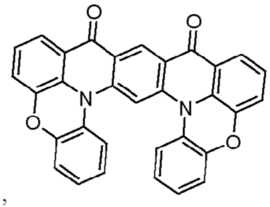,
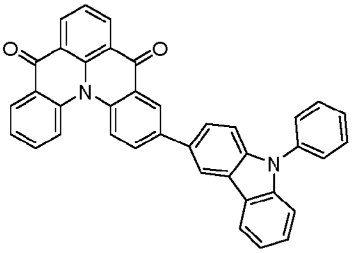,
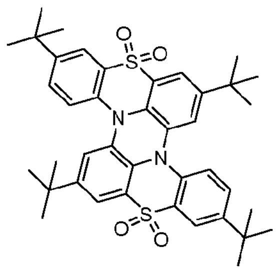,

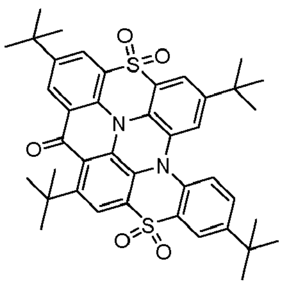,
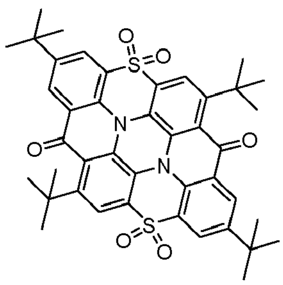,
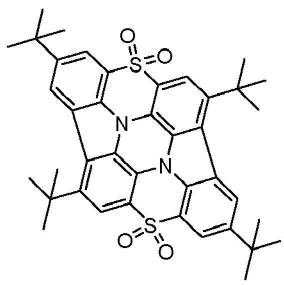,
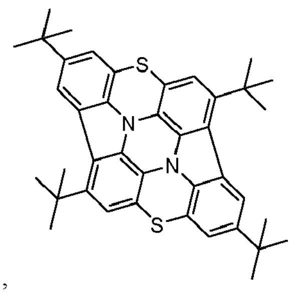,

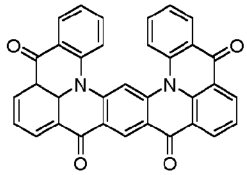
,
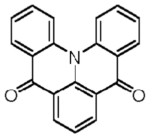
,
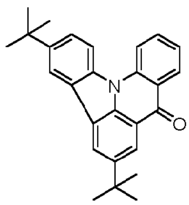
,
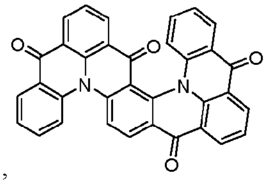
,
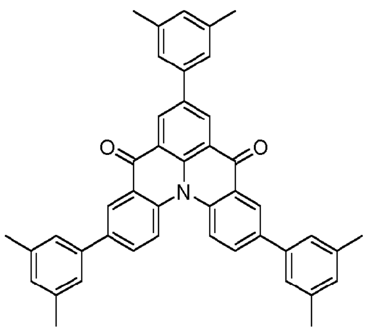
,

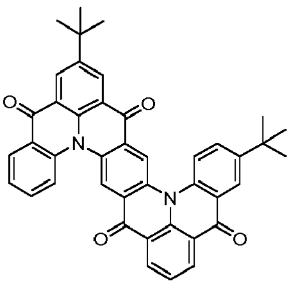
,
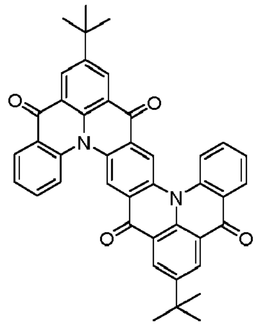
,
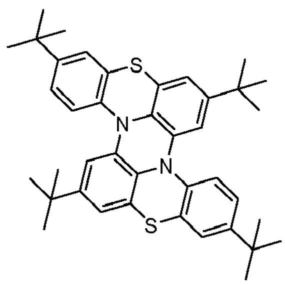
,
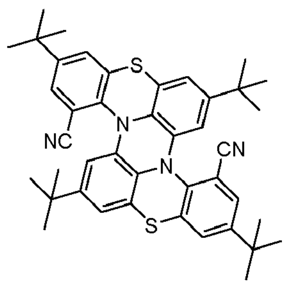
,

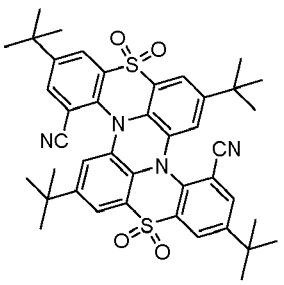
,
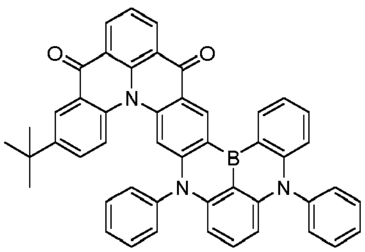
,
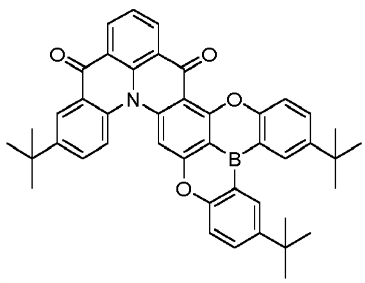
,

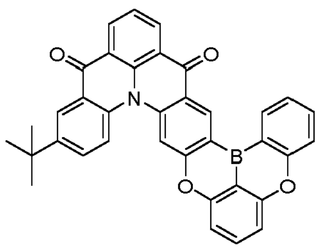
,
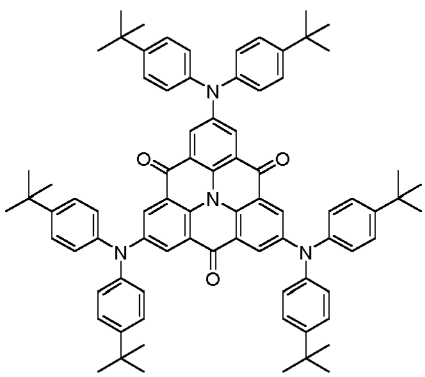
,
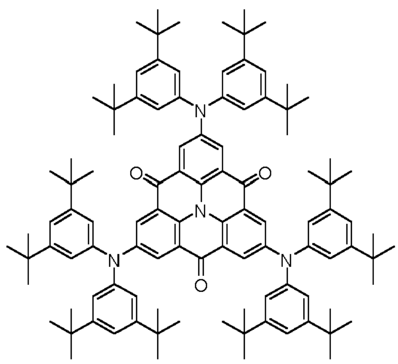
,

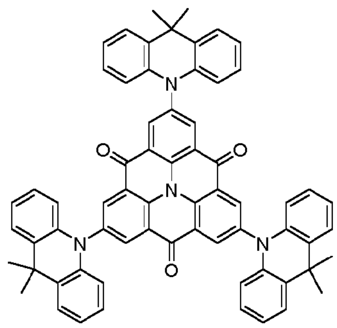,
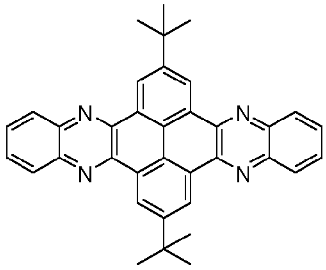,
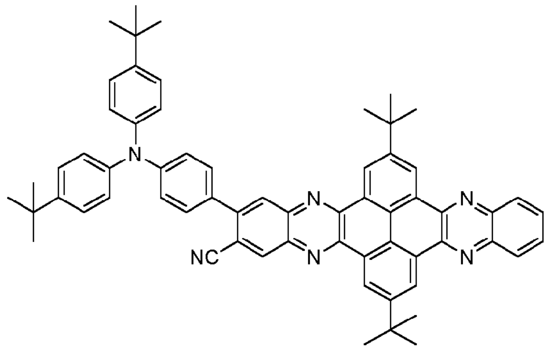,

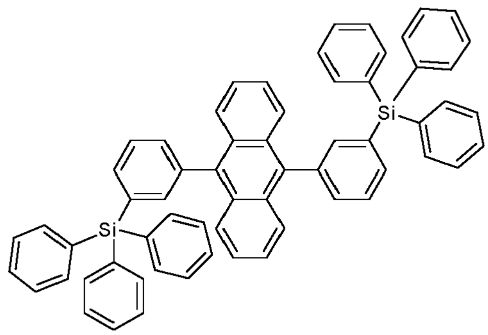,

aza-substituted variants thereof, fully or partially deuterated variants thereof, and combinations thereof.

In some of the above embodiments, any carbon ring atoms up to maximum of a total number of three, together with their substituents, in each phenyl ring of any of above structures can be replaced with N.

In some embodiments of the composition A, where the first dopant is capable of phosphorescence at room temperature in an OLED, the first dopant has the formula of $M(L^1)_x(L^2)_y(L^3)_z$;

wherein M is selected from the group consisting of Ir, Rh, Re, Ru, Os, Pt, Pd, Au, and Cu;
wherein L’, $L^2$, and $L^3$ can be the same or different;
wherein x is 1, 2, or 3;
wherein y is 0, 1, or 2;
wherein z is 0, 1, or 2;
wherein x+y+z is the oxidation state of the metal M;
wherein L’ is selected from the group consisting of the ligands in the following LIGAND LIST B:

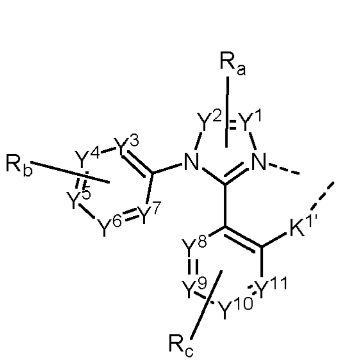,
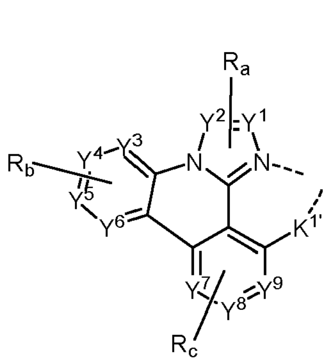,
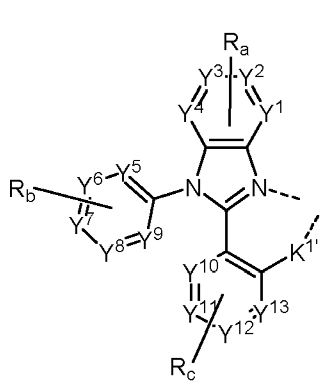,
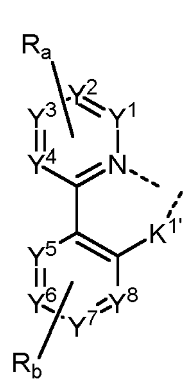,

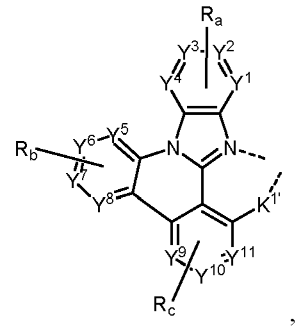 , 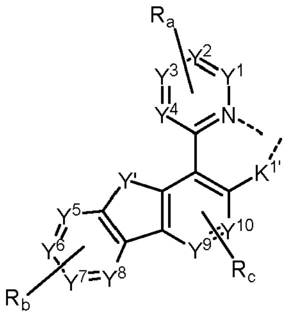 , 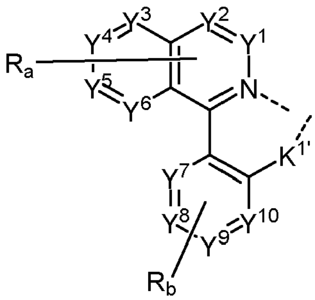 , 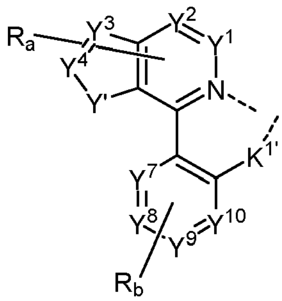 ,

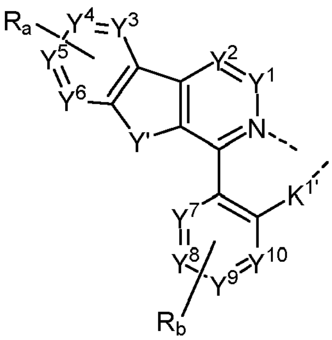 , 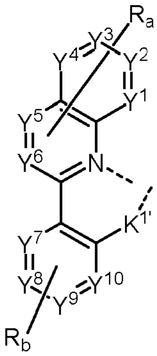 , 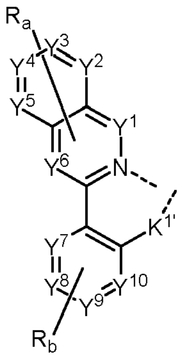 , 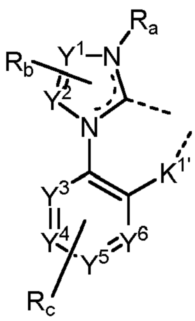 , 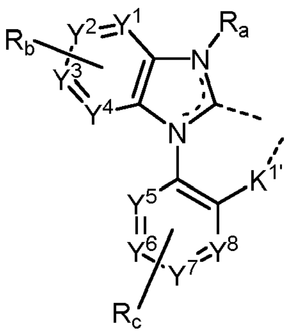 ,

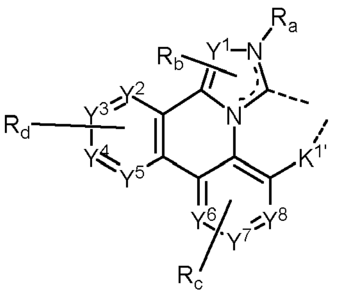 , 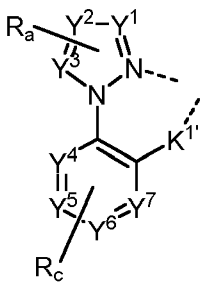 , 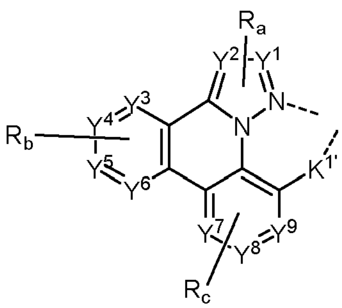 , 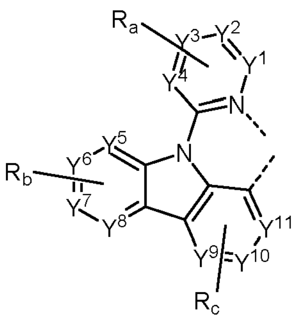 ,

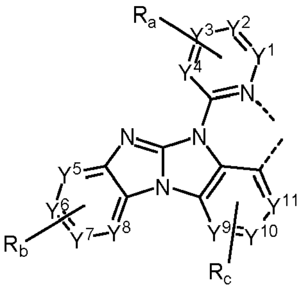 , 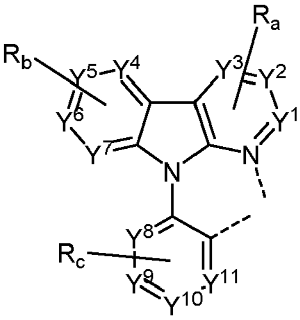 , 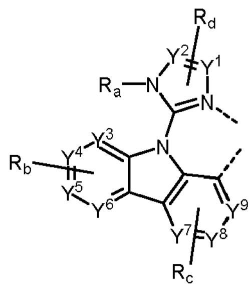 , 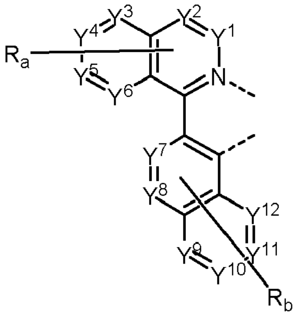 ,

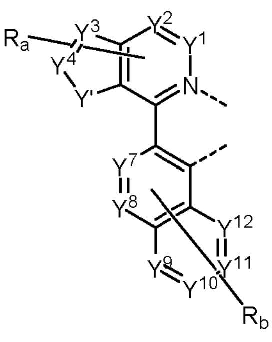, 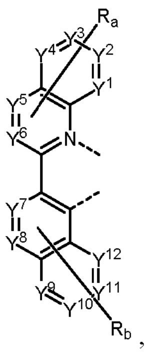, 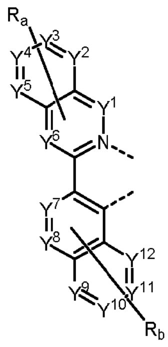, 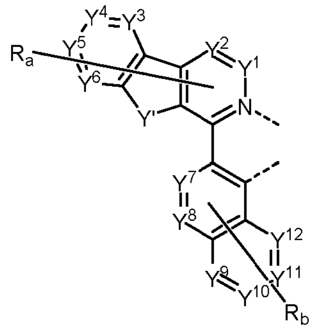, 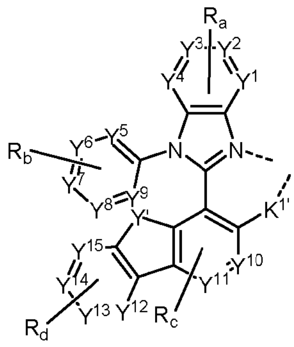,

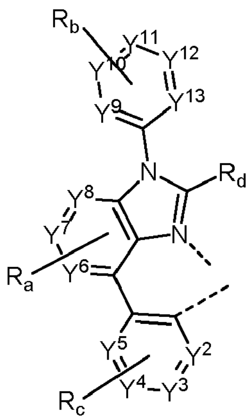, 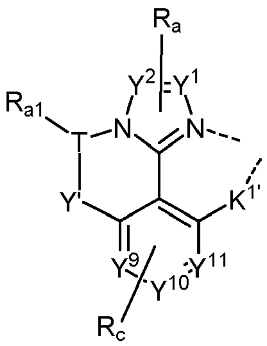, 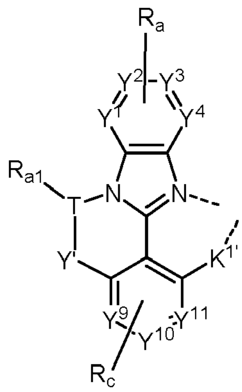, 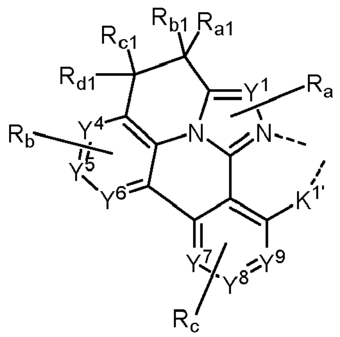,

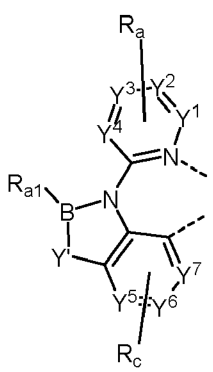, 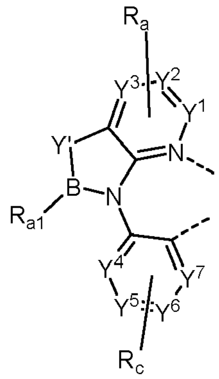, 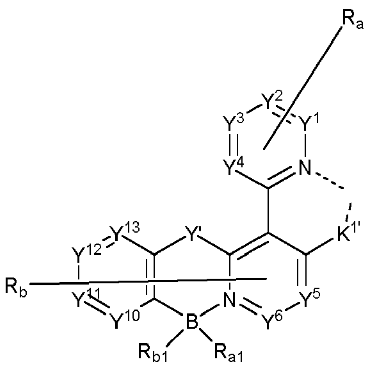, and 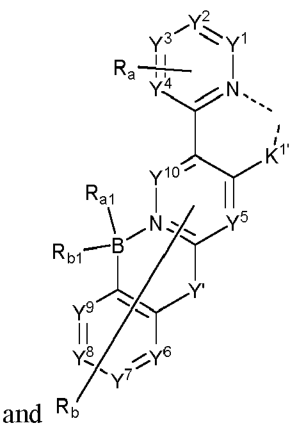;

wherein $L^2$ and $L^3$ are independently selected from the group consisting of

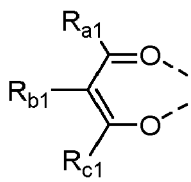,

and the structures of LIGAND LIST B; wherein:

T is selected from the group consisting of B, Al, Ga, and In;

$K^{1'}$ is a direct bond or is selected from the group consisting of $NR_e$, $PR_e$, O, S, and Se;

each Y' to $Y^{13}$ are independently selected from the group consisting of carbon and nitrogen;

Y' is selected from the group consisting of $BR_e$, $NR_e$, $PR_e$, O, S, Se, C=O, S=O, $SO_2$, $CR_eR_f$, $SiR_eR_f$, and $GeR_eR_f$;

$R_e$ and $R_f$ can be fused or joined to form a ring;
each $R_a$, $R_b$, $R_c$, and $R_d$ can independently represent from mono to the maximum possible number of substitutions, or no substitution;
each $R_{a1}$ $R_{b1}$, $R_{c1}$, $R_{d1}$, $R_a$, $R_b$, $R_c$, $R_d$, $R_e$, and $R_f$ is independently a hydrogen or a substituent selected from the group consisting of the General Substituents as defined herein; and

wherein any two of $R_{a1}$, $R_{b1}$, $R_{c1}$, $R_{d1}$, $R_a$, $R_b$, $R_c$, and $R_d$ can be fused or joined to form a ring or form a multidentate ligand.

In some embodiments of the composition A, where first dopant has the formula of $M(L^1)_x(L^2)_y(L^3)_z$, M is Ir or Pt.

In some embodiments of the composition A, where the first dopant is capable of phosphorescence at room temperature in an OLED, the first dopant has the formula selected from the group consisting of the structures of the following LIST C:

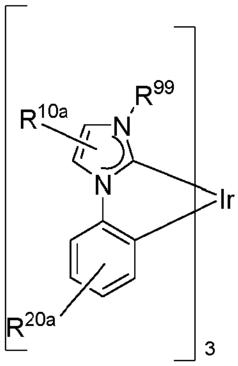
,
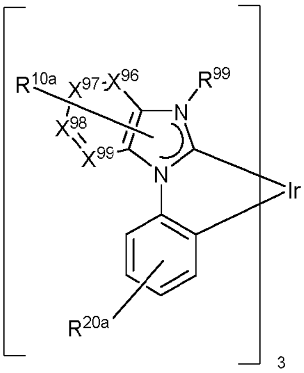
,
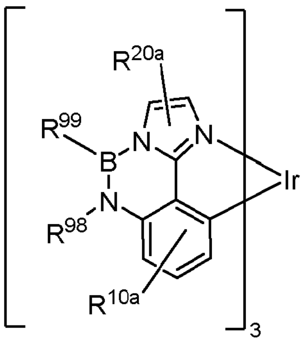
,
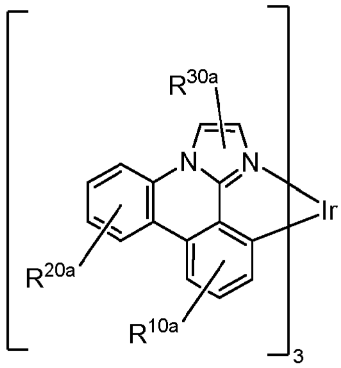
,

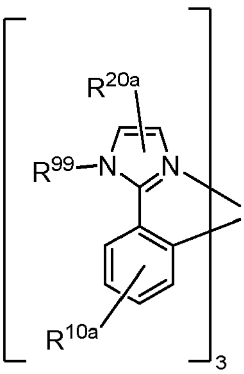
,
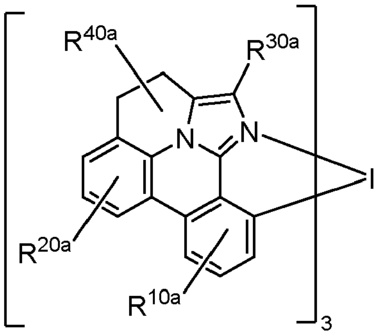
,
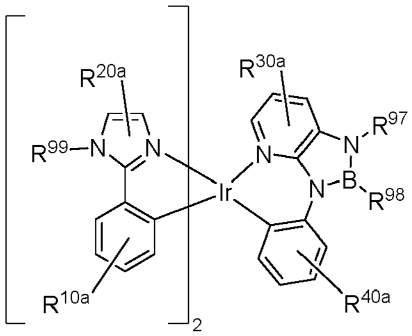
,

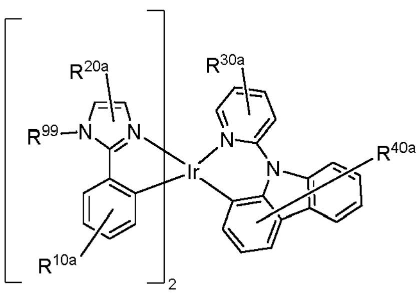
,
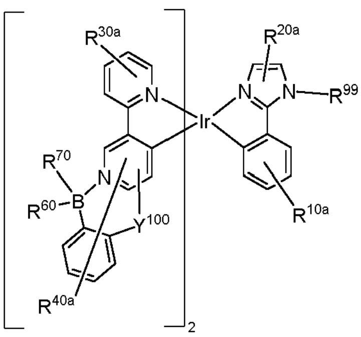
,
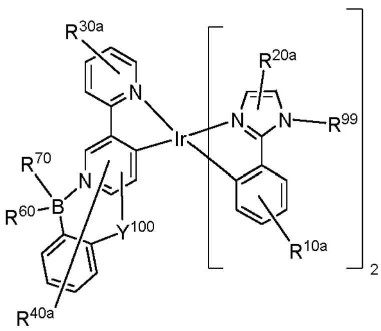
,

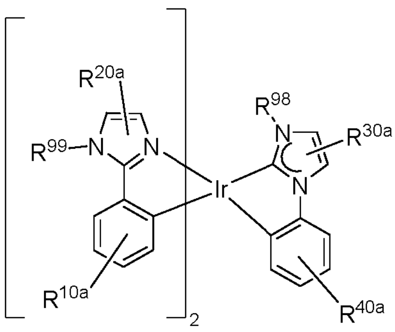,
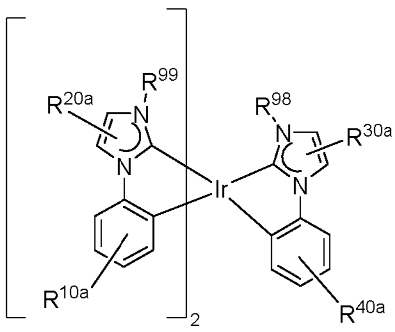,
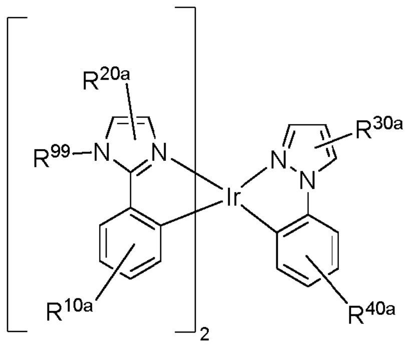,

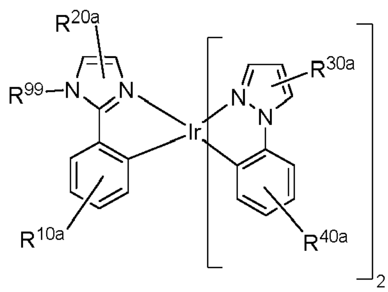,
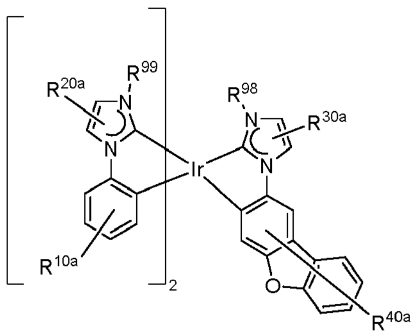,
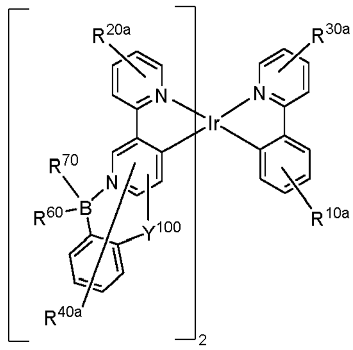,

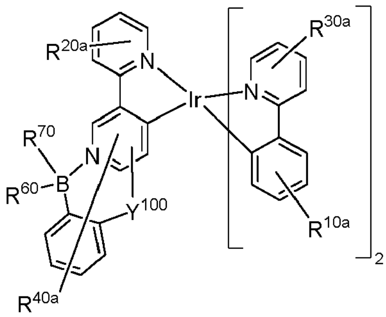,
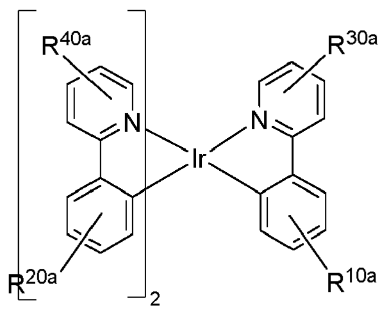,
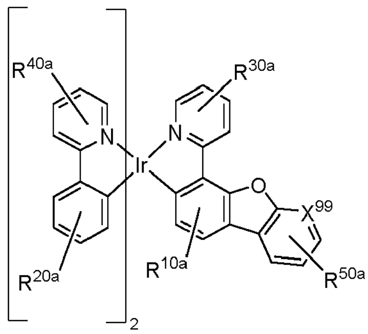,

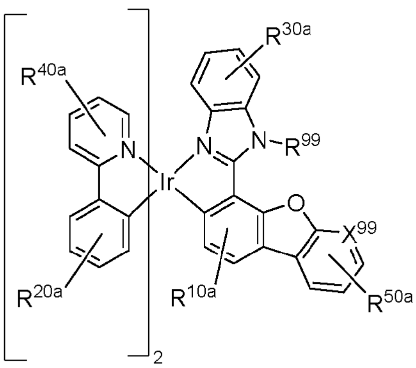,
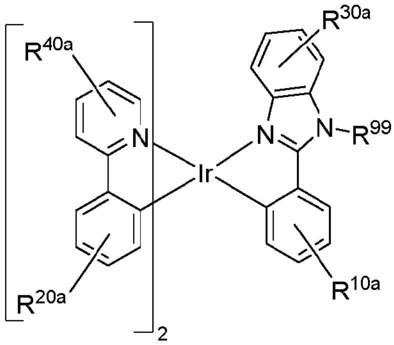,
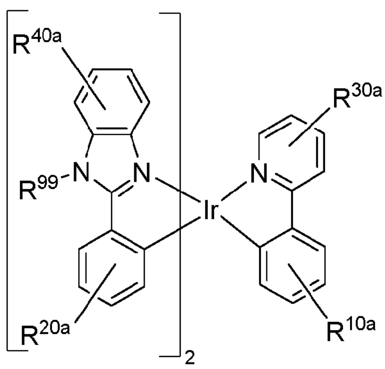,

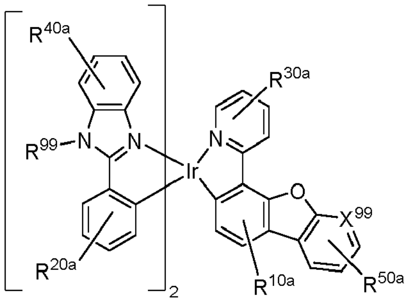,
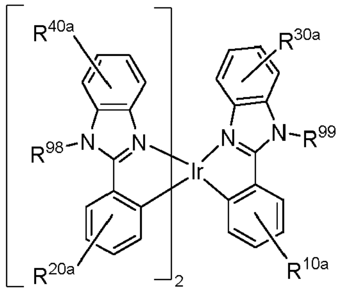,
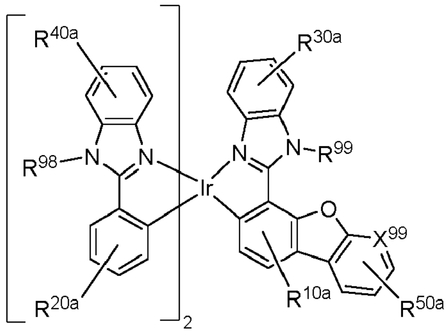,

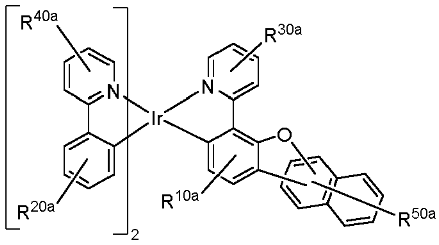,
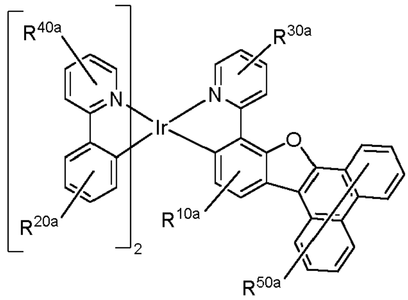,

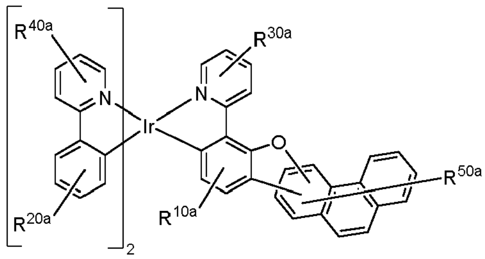,
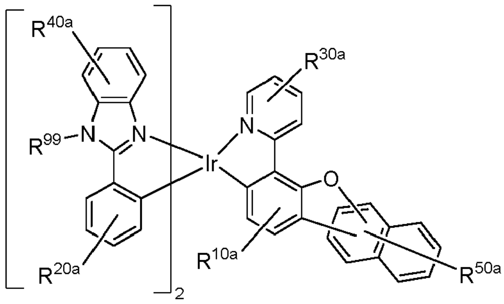,

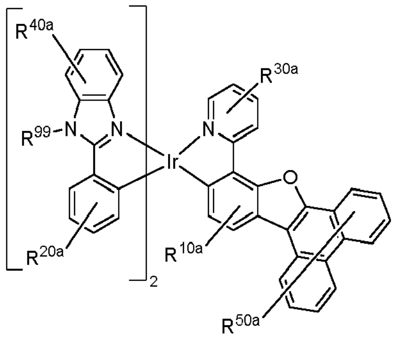,
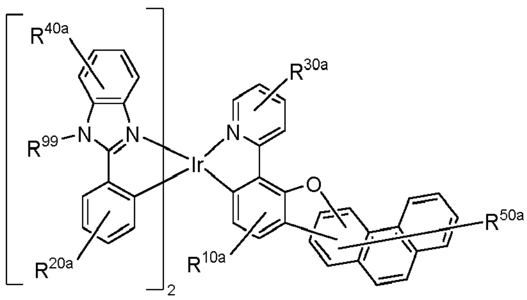,

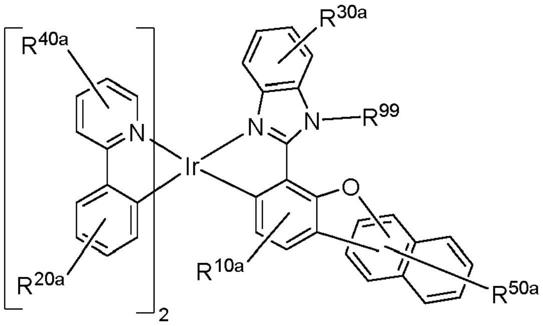

,

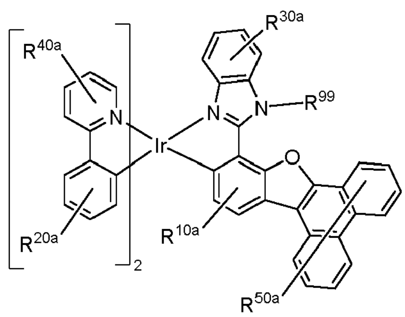

,

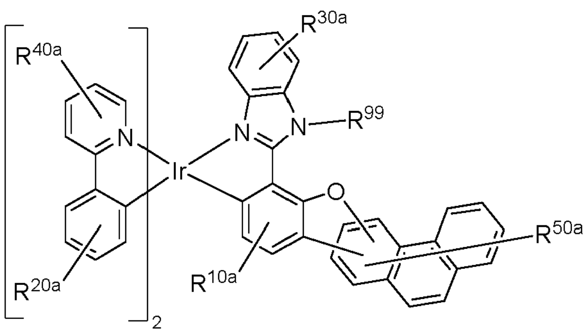

,

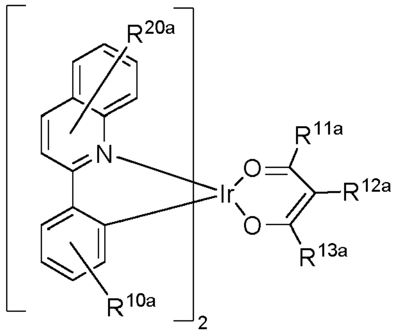

,

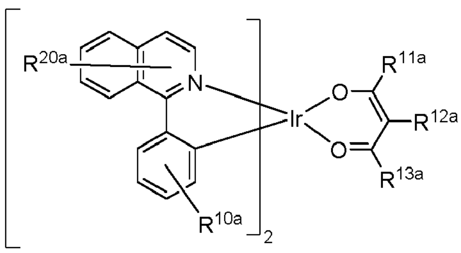

,

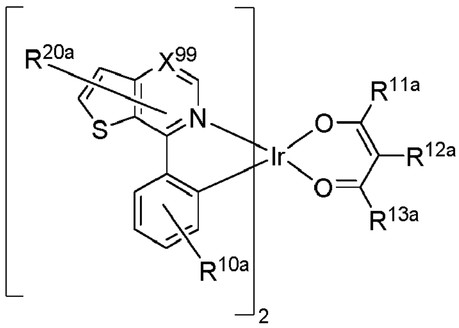

,

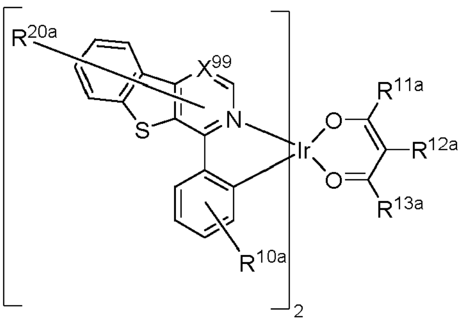

,

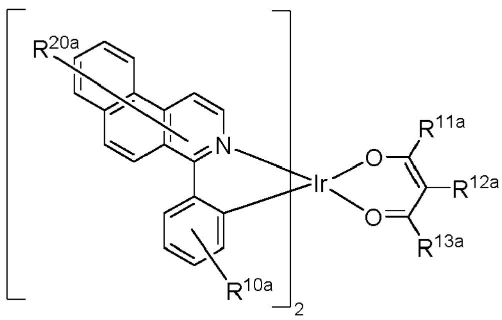

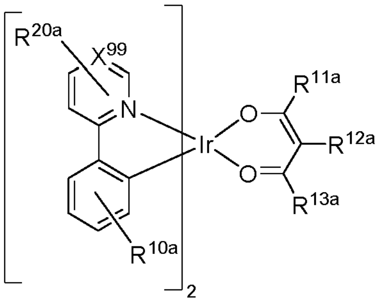

,

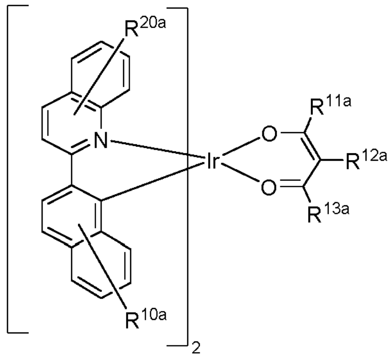

,

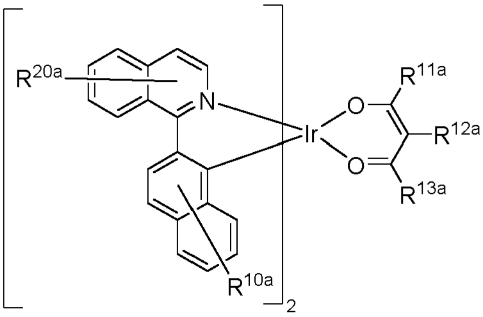

,

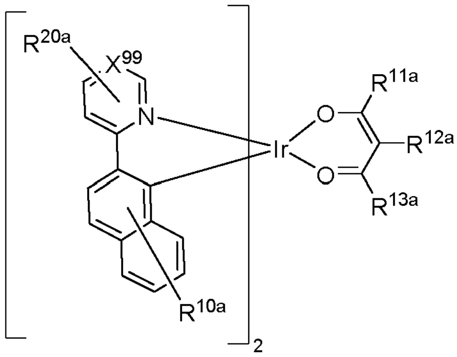

,

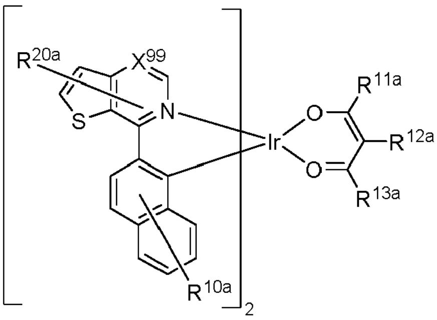

,

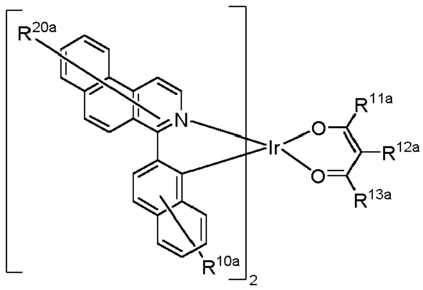

,

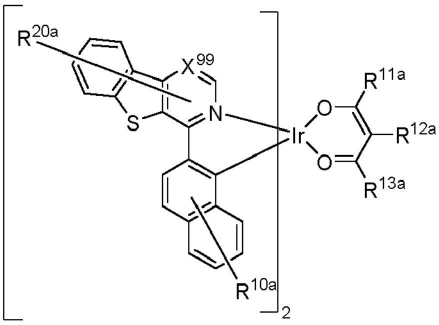

,

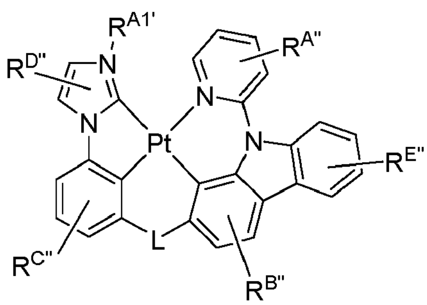

,

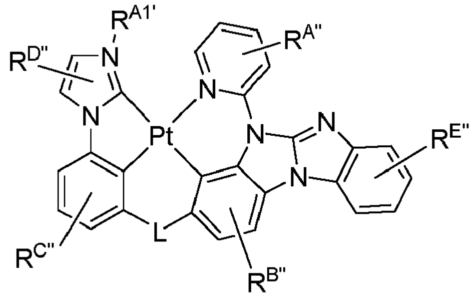,
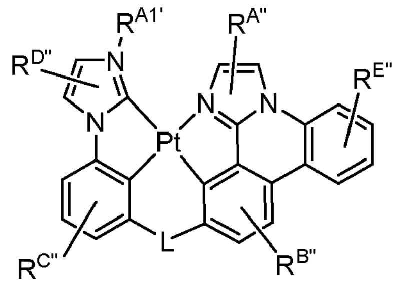,

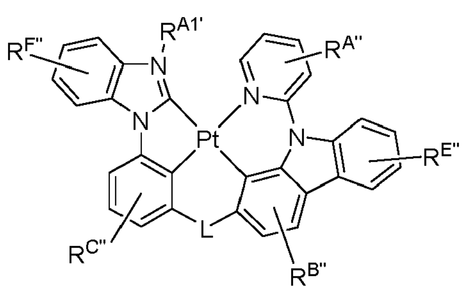,
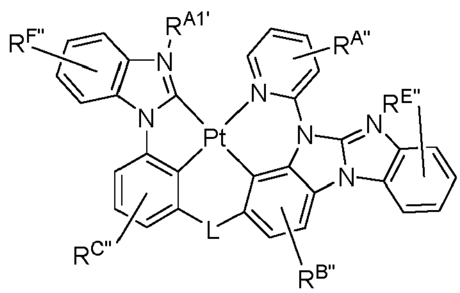,

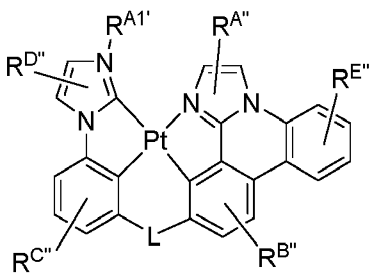,
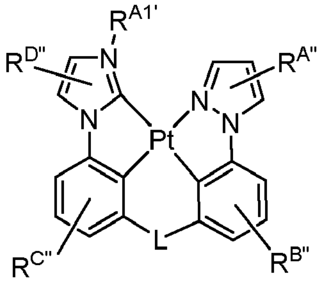,
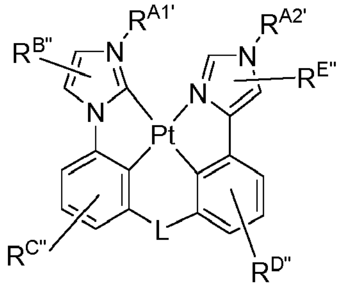,

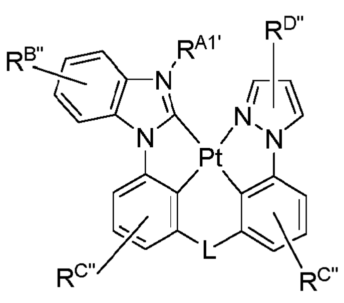,
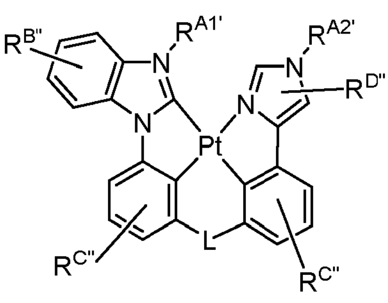,
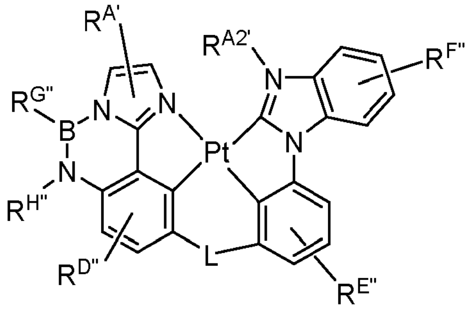,

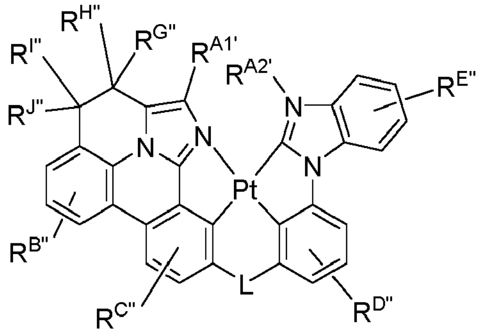,
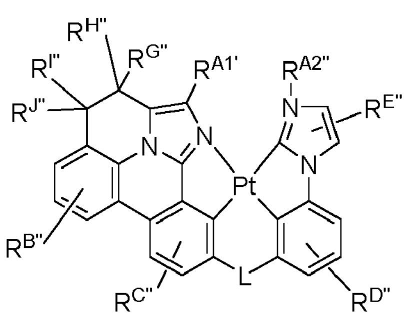,

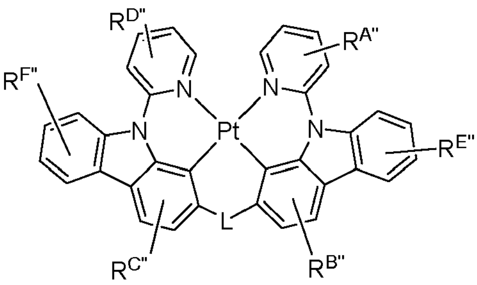

,

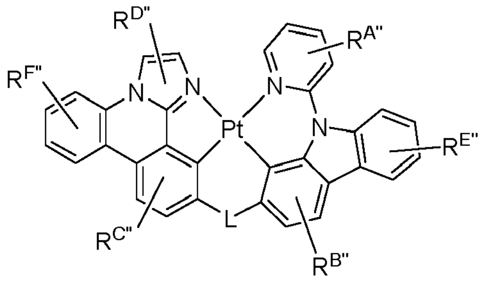

,

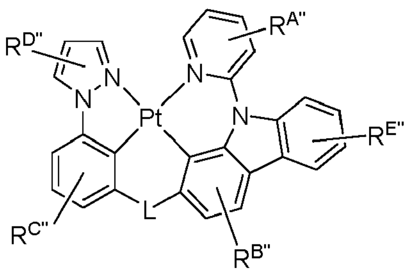

,

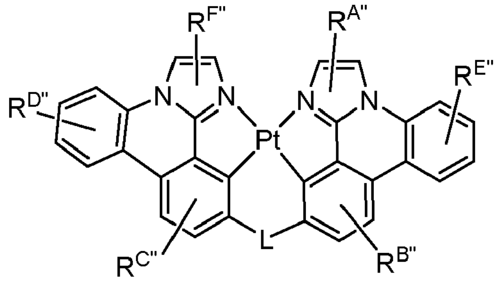

,

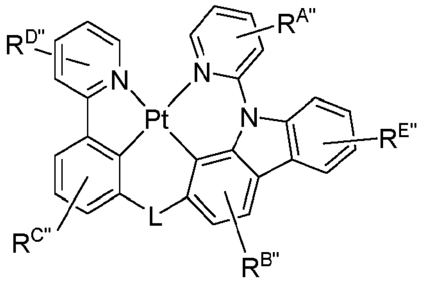

,

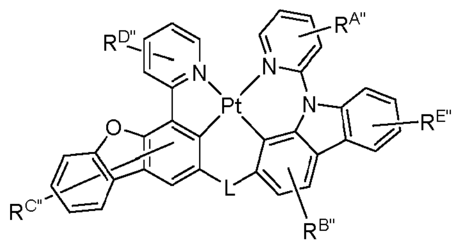

,

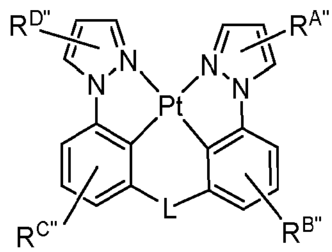

,

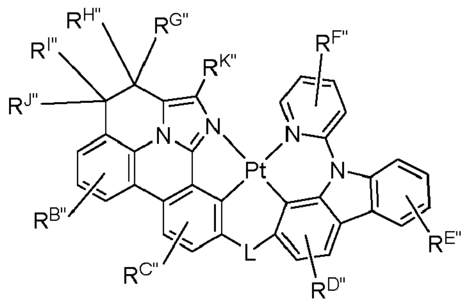

,

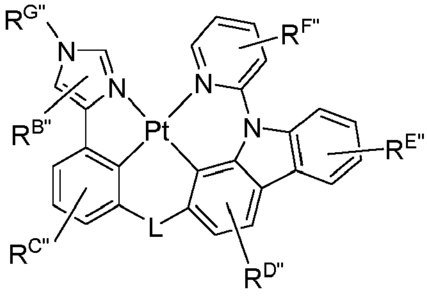

,

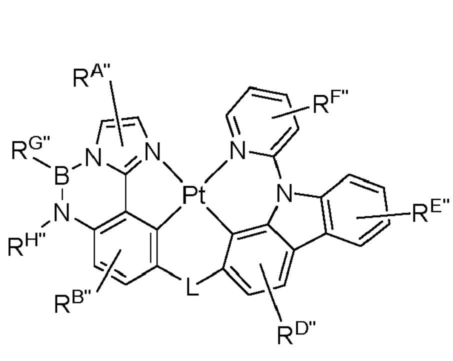

,

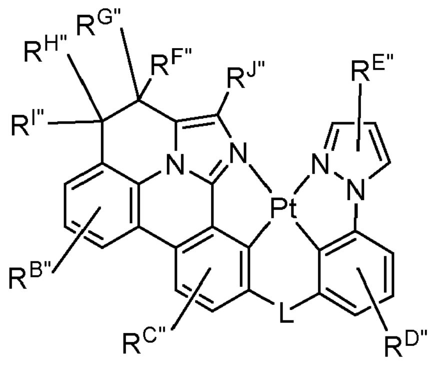

,

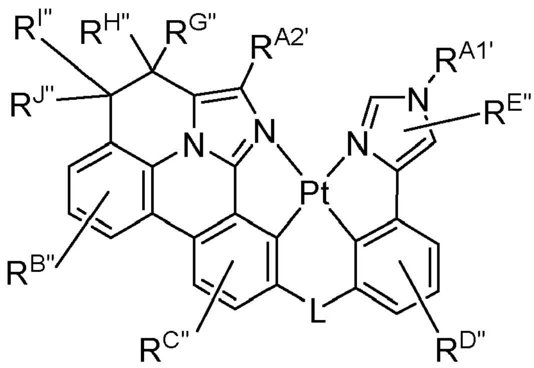
,
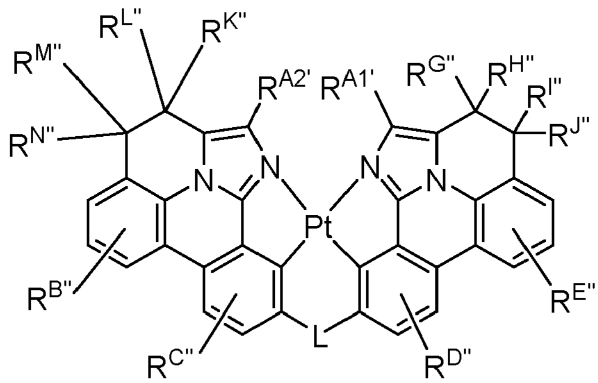
,

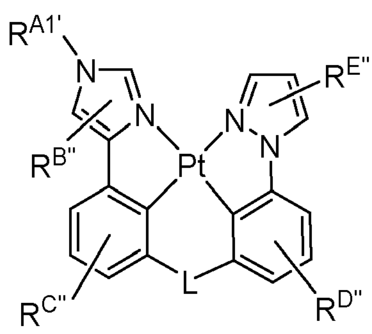
,
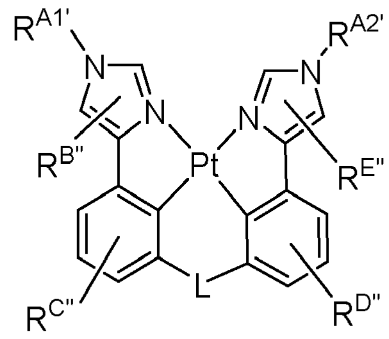
,
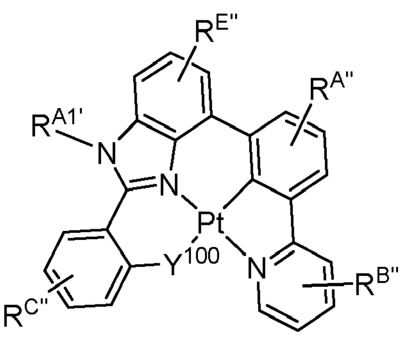
,

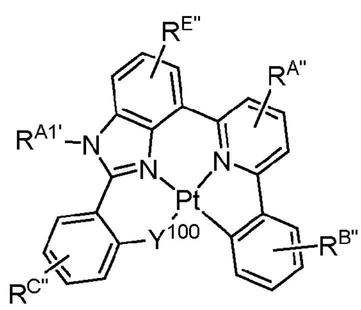
,
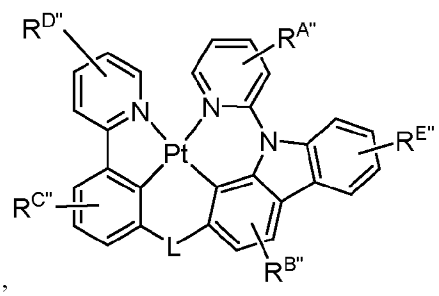
,
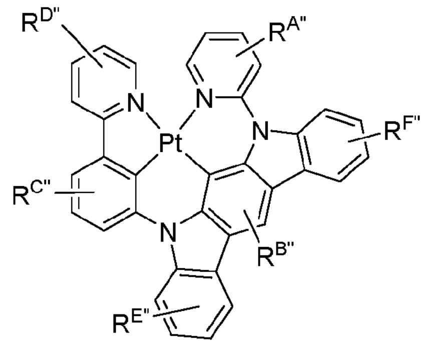
,

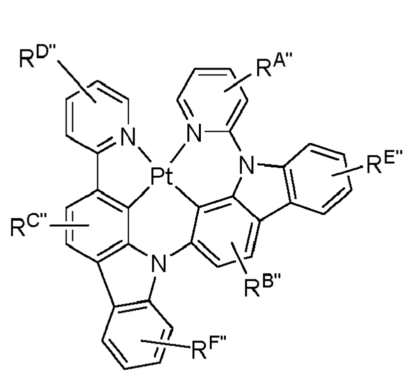
,
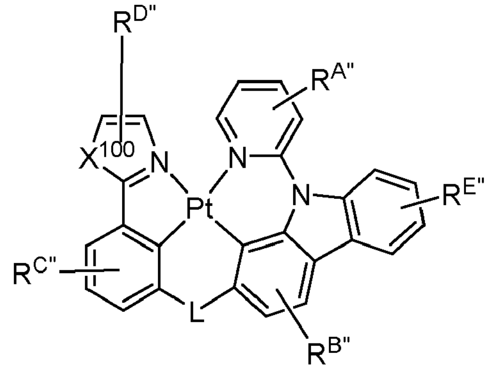
,

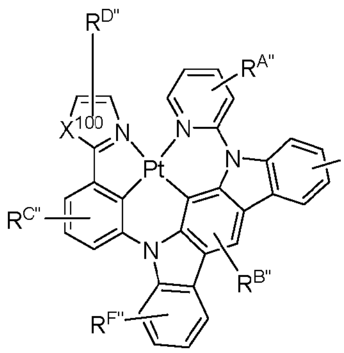
,
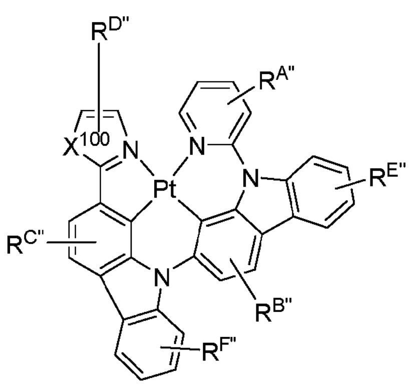
,
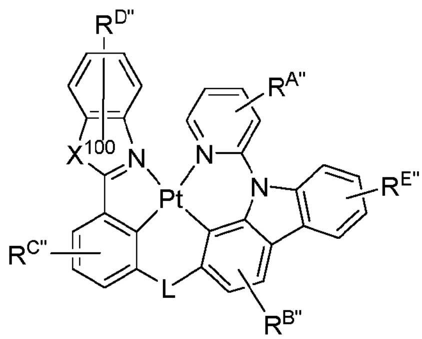
,

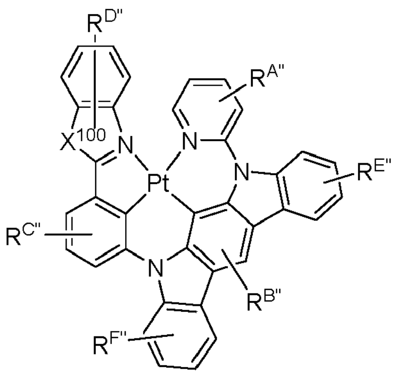
,
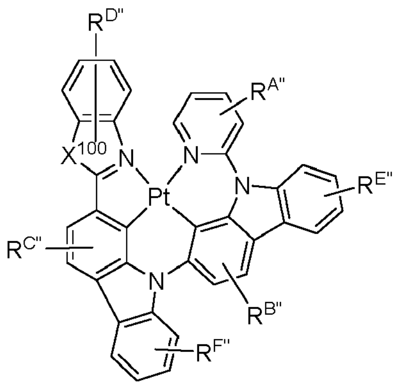
,
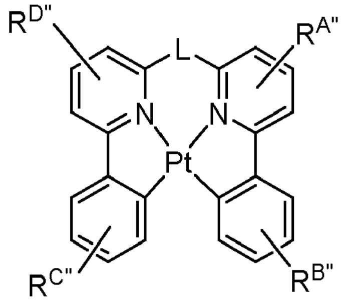
,

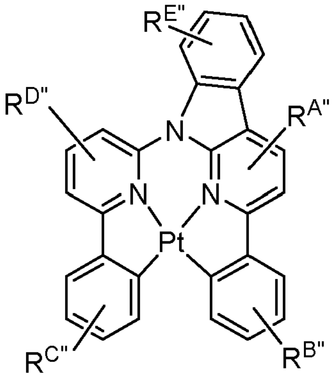
,
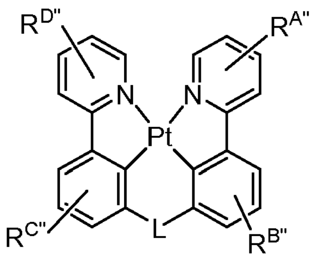
,
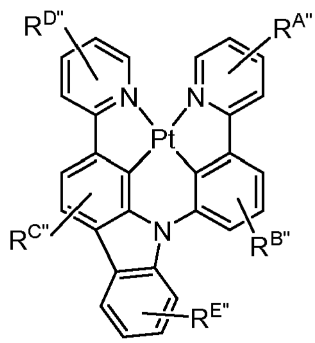
,

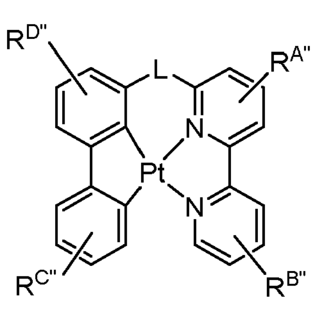
,
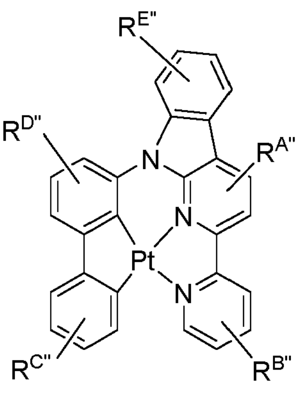
,
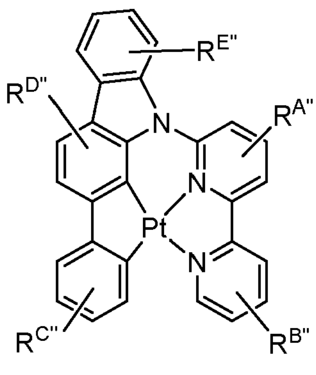
,

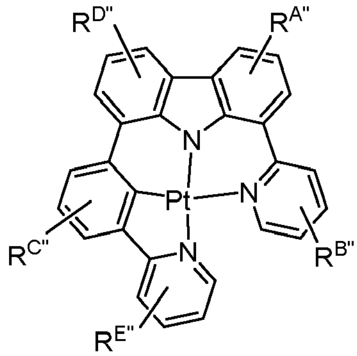,
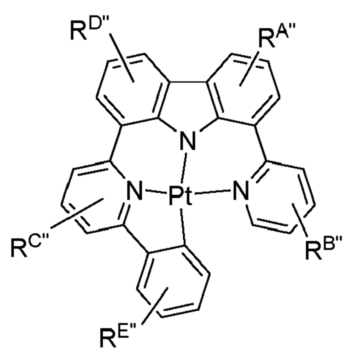,
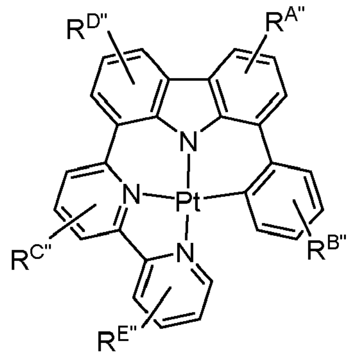,

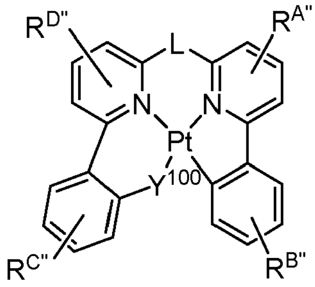,
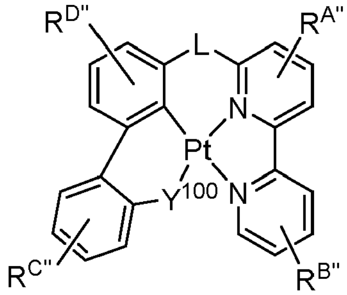,
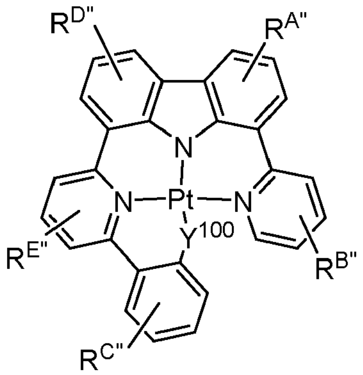,

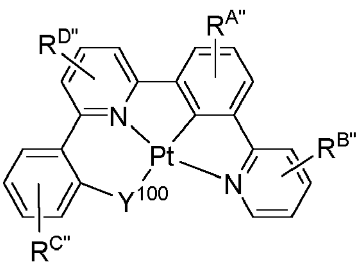,
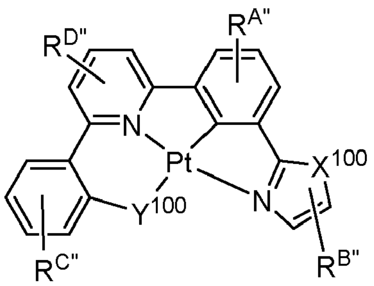,
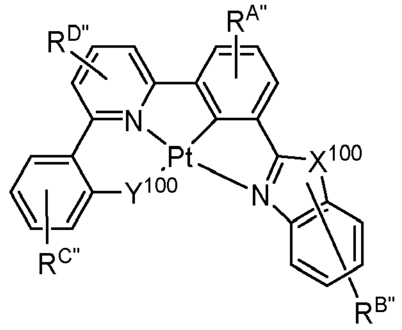,

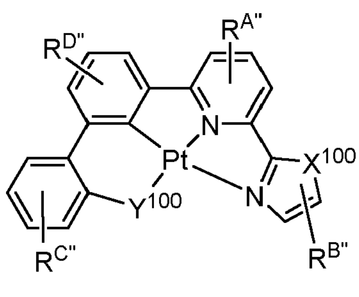,
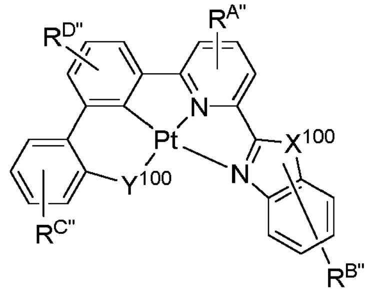,
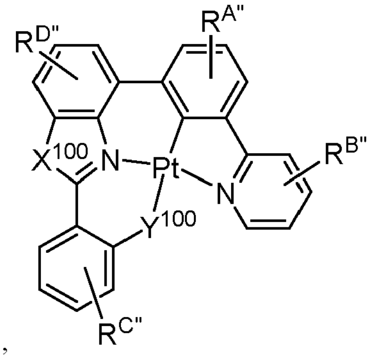,

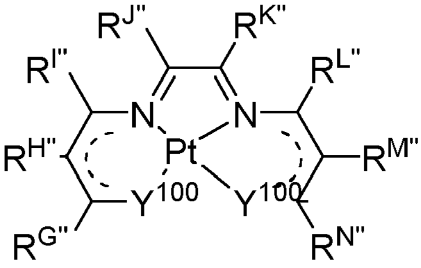,

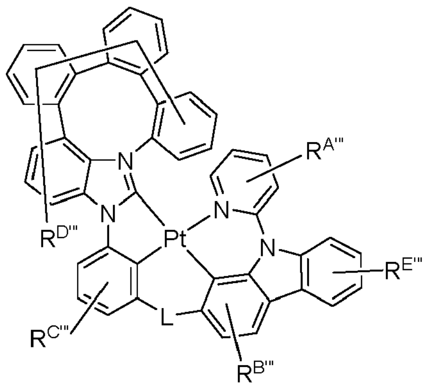,

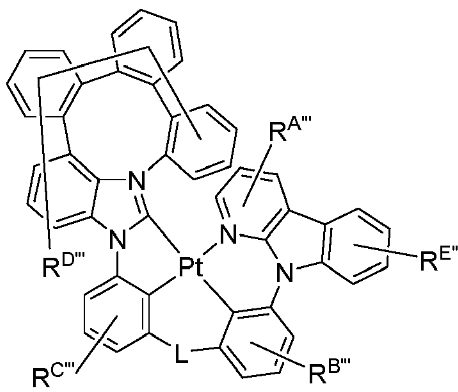,

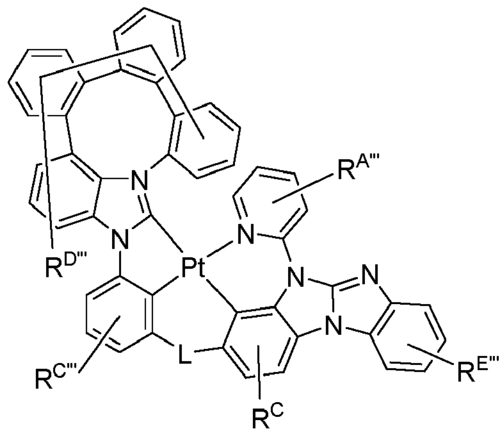,

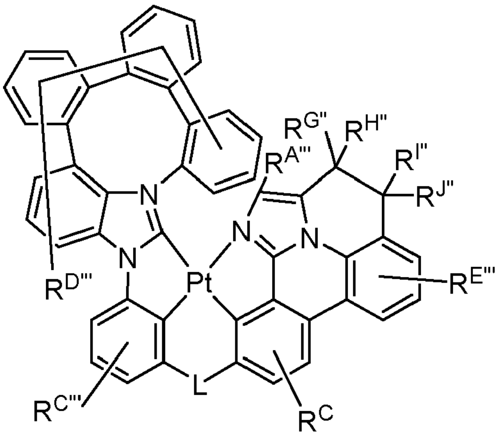,

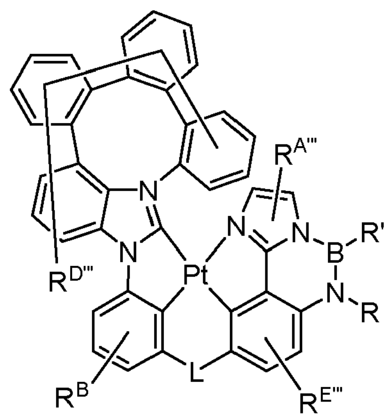,

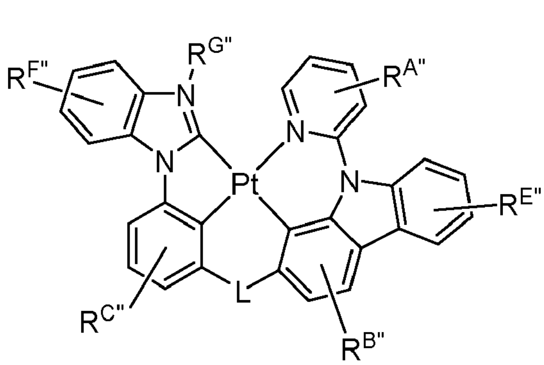,

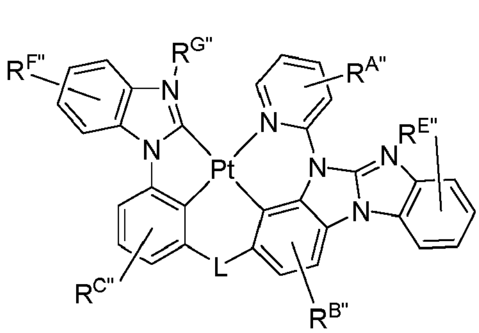,

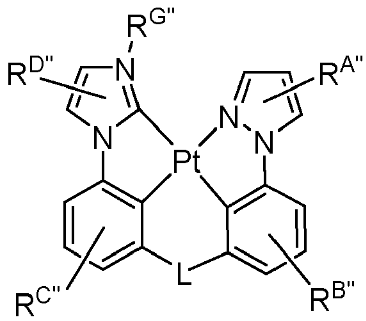
,
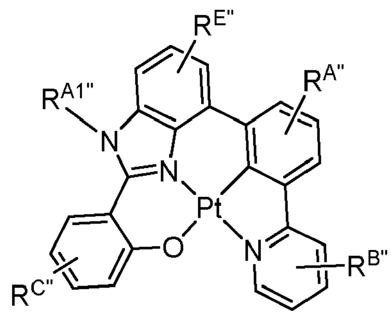
, and
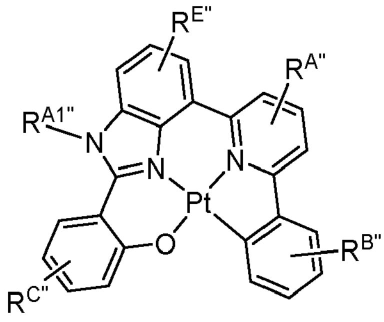
,

wherein:

each of $X^{96}$ to $X^{99}$ is independently C or N;
each $Y^{100}$ is independently selected from the group consisting of a NR", O, S, and Se;
L is independently selected from the group consisting of a direct bond, BR", BR"R‴, NR", PR", O, S, Se, C=O, C=S, C=Se, C=NR", C=CR"R‴, S=O, $SO_2$, CR", CR"R‴, SiR"R‴, GeR"R‴, alkyl, cycloalkyl, aryl, heteroaryl, and combinations thereof;
$X^{100}$ for each occurrence is selected from the group consisting of O, S, Se, NR", and CR"R‴;
each $R^{10a}$, $R^{20a}$, $R^{30a}$, $R^{40a}$, and $R^{50a}$, $R^{A''}$, $R^{B''}$, $R^{C''}$, $R^{D''}$, $R^{E''}$, and $R^{F''}$ independently represents mono-, up to the maximum substitutions, or no substitutions;
each of R, R', R", R‴, $R^{10a}$, $R^{11a}$, $R^{12a}$, $R^{13a}$, $R^{20a}$, $R^{30a}$, $R^{40a}$, $R^{50a}$, $R^{60}$, $R^{70}$, $R^{97}$, $R^{98}$, $R^{99}$, $R^{A1'}$, $R^{A2'}$, $R^{A''}$, $R^{B''}$, $R^{C''}$, $R^{D''}$, $R^{E''}$, $R^{F''}$, $R^{G''}$, $R^{H''}$, $R^{I''}$, $R^{J''}$, $R^{K''}$, $R^{L''}$, $R^{M''}$, and $R^{N''}$ is independently a hydrogen or a substituent selected from the group consisting of deuterium, halide, alkyl, cycloalkyl, heteroalkyl, arylalkyl, alkoxy, aryloxy, amino, silyl, germyl, boryl, selenyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, combinations thereof.

In the first dopant, at least one of $R^{A''}$, $R^{B''}$, $R^{C''}$, $R^{D''}$, $R^{E''}$, $R^{F''}$, $R^{10a}$, $R^{20a}$, $R^{30a}$, $R^{40a}$, and $R^{50a}$ is an electron-withdrawing group from LIST EWG 1 as defined herein. In some embodiments of the first dopant, at least one of $R^{A''}$, $R^{B''}$, $R^{C''}$, $R^{D''}$, $R^{E''}$, $R^{F''}$, $R^{10a}$, $R^{20a}$, $R^{30a}$, $R^{40a}$, and $R^{50a}$ is an electron-withdrawing group from LIST EWG 2 as defined herein. In some embodiments of the first dopant, at least one of $R^{A''}$, $R^{B''}$, $R^{C''}$, $R^{D''}$, $R^{E''}$, $R^{F''}$, $R^{10a}$, $R^{20a}$, $R^{30a}$, $R^{40a}$, and $R^{50a}$ is an electron-withdrawing group from LIST EWG 3 as defined herein. In some embodiments of the first dopant, at least one of $R^{A''}$, $R^{B''}$, $R^{C''}$, $R^{D''}$, $R^{E''}$, $R^{F''}$, $R^{10a}$, $R^{20a}$, $R^{30a}$, $R^{40a}$, and $R^{50a}$ is an electron-withdrawing group from LIST EWG 4 as defined herein. In some embodiments of the first dopant, at least one of $R^{A''}$, $R^{B''}$, $R^{C''}$, $R^{D''}$, $R^{E''}$, $R^{F''}$, $R^{10a}$, $R^{20a}$, $R^{30a}$, $R^{40a}$, and $R^{50a}$ is an electron-withdrawing group from LIST Pi-EWG as defined herein.

In some embodiments of the first dopant, one $R^{A''}$ is an electron-withdrawing group from LIST EWG 1 as defined herein. In some embodiments of the compound, one of $R^{A''}$ is an electron-withdrawing group from LIST EWG 2 as defined herein. In some embodiments of the compound, one of $R^{A''}$ is an electron-withdrawing group from LIST EWG 3 as defined herein. In some embodiments of the compound, one of $R^{A''}$ is an electron-withdrawing group from LIST EWG 4 as defined herein. In some embodiments of the compound, one of $R^{A''}$ is an electron-withdrawing group from LIST Pi-EWG as defined herein.

In some embodiments of the compound, one $R^{B''}$ is an electron-withdrawing group from LIST EWG 1 as defined herein. In some embodiments of the compound, one of $R^{B''}$ is an electron-withdrawing group from LIST EWG 2 as defined herein. In some embodiments of the compound, one of $R^{B''}$ is an electron-withdrawing group from LIST EWG 3 as defined herein. In some embodiments of the compound, one of $R^{B''}$ is an electron-withdrawing group from LIST EWG 4 as defined herein. In some embodiments of the compound, one of $R^{B''}$ is an electron-withdrawing group from LIST Pi-EWG as defined herein.

In some embodiments of the compound, one $R^{C''}$ is an electron-withdrawing group from LIST EWG 1 as defined herein. In some embodiments of the compound, one of $R^{C''}$ is an electron-withdrawing group from LIST EWG 2 as defined herein. In some embodiments of the compound, one of $R^{C''}$ is an electron-withdrawing group from LIST EWG 3 as defined herein. In some embodiments of the compound, one of $R^{C''}$ is an electron-withdrawing group from LIST EWG 4 as defined herein. In some embodiments of the compound, one of $R^{C''}$ is an electron-withdrawing group from LIST Pi-EWG as defined herein.

In some embodiments of the compound, one $R^{D''}$ is an electron-withdrawing group from LIST EWG 1 as defined herein. In some embodiments of the compound, one of $R^{D''}$ is an electron-withdrawing group from LIST EWG 2 as defined herein. In some embodiments of the compound, one of $R^{D''}$ is an electron-withdrawing group from LIST EWG 3 as defined herein. In some embodiments of the compound, one of $R^{D''}$ is an electron-withdrawing group from LIST EWG 4 as defined

herein. In some embodiments of the compound, one of $R^{D''}$ is an electron-withdrawing group from LIST Pi-EWG as defined herein.

In some embodiments of the compound, one $R^{E''}$ is an electron-withdrawing group from LIST EWG 1 as defined herein. In some embodiments of the compound, one of $R^{E''}$ is an electron-withdrawing group from LIST EWG 2 as defined herein. In some embodiments of the compound, one of $R^{E''}$ is an electron-withdrawing group from LIST EWG 3 as defined herein. In some embodiments of the compound, one of $R^{E''}$ is an electron-withdrawing group from LIST EWG 4 as defined herein. In some embodiments of the compound, one of $R^{E''}$ is an electron-withdrawing group from LIST Pi-EWG as defined herein.

In some embodiments of the compound, one $R^{F''}$ is an electron-withdrawing group from LIST EWG 1 as defined herein. In some embodiments of the compound, one of $R^{F''}$ is an electron-withdrawing group from LIST EWG 2 as defined herein. In some embodiments of the compound, one of $R^{F''}$ is an electron-withdrawing group from LIST EWG 3 as defined herein. In some embodiments of the compound, one of $R^{F''}$ is an electron-withdrawing group from LIST EWG 4 as defined herein. In some embodiments of the compound, one of $R^{F''}$ is an electron-withdrawing group from LIST Pi-EWG as defined herein.

In some embodiments of the compound, one $R^{10a}$ is an electron-withdrawing group from LIST EWG 1 as defined herein. In some embodiments of the compound, one of $R^{10a}$ is an electron-withdrawing group from LIST EWG 2 as defined herein. In some embodiments of the compound, one of $R^{10a}$ is an electron-withdrawing group from LIST EWG 3 as defined herein. In some embodiments of the compound, one of $R^{10a}$ is an electron-withdrawing group from LIST EWG 4 as defined herein. In some embodiments of the compound, one of $R^{10a}$ is an electron-withdrawing group from LIST Pi-EWG as defined herein.

In some embodiments of the compound, one $R^{20a}$ is an electron-withdrawing group from LIST EWG 1 as defined herein. In some embodiments of the compound, one of $R^{20a}$ is an electron-withdrawing group from LIST EWG 2 as defined herein. In some embodiments of the compound, one of $R^{20a}$ is an electron-withdrawing group from LIST EWG 3 as defined herein. In some embodiments of the compound, one of $R^{20a}$ is an electron-withdrawing group from LIST EWG 4 as defined herein. In some embodiments of the compound, one of $R^{20a}$ is an electron-withdrawing group from LIST Pi-EWG as defined herein.

In some embodiments of the compound, one $R^{30a}$ is an electron-withdrawing group from LIST EWG 1 as defined herein. In some embodiments of the compound, one of $R^{30a}$ is an electron-withdrawing group from LIST EWG 2 as defined herein. In some embodiments of the compound, one of $R^{30a}$ is an electron-withdrawing group from LIST EWG 3 as defined herein. In some embodiments of the compound, one of $R^{30a}$ is an electron-withdrawing group from LIST EWG 4 as defined herein. In some embodiments of the compound, one of $R^{30a}$ is an electron-withdrawing group from LIST Pi-EWG as defined herein.

In some embodiments of the compound, one $R^{40a}$ is an electron-withdrawing group from LIST EWG 1 as defined herein. In some embodiments of the compound, one of $R^{40a}$ is an electron-withdrawing group from LIST EWG 2 as defined herein. In some embodiments of the compound, one of $R^{40a}$ is an electron-withdrawing group from LIST EWG 3 as defined herein. In some embodiments of the compound, one of $R^{40a}$ is an electron-withdrawing group from LIST EWG 4 as defined herein. In some embodiments of the compound, one of $R^{40a}$ is an electron-withdrawing group from LIST Pi-EWG as defined herein.

In some embodiments of the compound, one $R^{50a}$ is an electron-withdrawing group from LIST EWG 1 as defined herein. In some embodiments of the compound, one of $R^{50a}$ is an electron-withdrawing group from LIST EWG 2 as defined herein. In some embodiments of the compound, one of $R^{50a}$ is an electron-withdrawing group from LIST EWG 3 as defined herein. In some embodiments of the compound, one of $R^{50a}$ is an electron-withdrawing group from LIST EWG 4 as defined herein. In some embodiments of the compound, one of $R^{50a}$ is an electron-withdrawing group from LIST Pi-EWG as defined herein.

In some embodiments, the electron-withdrawing groups commonly comprise one or more highly electronegative elements including but not limited to fluorine, oxygen, sulfur, nitrogen, chlorine, and bromine.

In some embodiments of the first dopant, the electron-withdrawing group has a Hammett constant larger than 0. In some embodiments, the electron-withdrawing group has a Hammett constant equal or larger than 0.1, 0.2, 0.3, 0.4, 0.5, 0.6, 0.7, 0.8, 0.9, 1.0, or 1.1.

In some embodiments, the electron-withdrawn group is selected from the group consisting of the structures in the following LIST EWG 1: F, $CF_3$, CN, $COCH_3$, CHO, $COCF_3$, COOMe, $COOCF_3$, $NO_2$, $SF_3$, $SiF_3$, $PF_4$, $SF_5$, $OCF_3$, $SCF_3$, $SeCF_3$, $SOCF_3$, $SeOCF_3$, $SO_2F$, $SO_2CF_3$, $SeO_2CF_3$, $OSeO_2CF_3$, OCN, SCN, SeCN, NC, $^+N(R^{k2})_3$, $(R^{k2})_2CCN$, $(R^{k2})_2CCF_3$, $CNC(CF_3)_2$, $BR^{k3}R^{k2}$, substituted or unsubstituted dibenzoborole, 1-substituted carbazole, 1,9-substituted carbazole, substituted or unsubstituted carbazole, substituted or unsubstituted pyridine, substituted or unsubstituted pyrimidine, substituted or unsubstituted pyrazine, substituted or unsubstituted pyridoxine, substituted or unsubstituted triazine, substituted or unsubstituted oxazole, substituted or unsubstituted benzoxazole, substituted or unsubstituted thiazole, substituted or unsubstituted benzothiazole, substituted or unsubstituted imidazole, substituted or unsubstituted benzimidazole, ketone, carboxylic acid, ester, nitrile, isonitrile, sulfinyl, sulfonyl, partially and fully fluorinated alkyl, partially

and fully fluorinated aryl, partially and fully fluorinated heteroaryl, cyano-containing alkyl, cyano-containing aryl, cyano-containing heteroaryl, isocyanate,

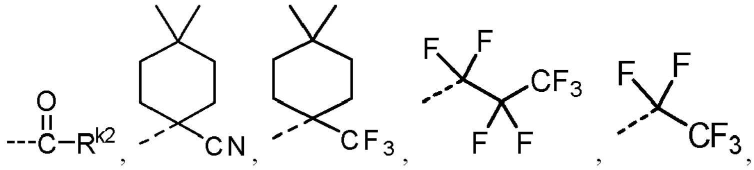,

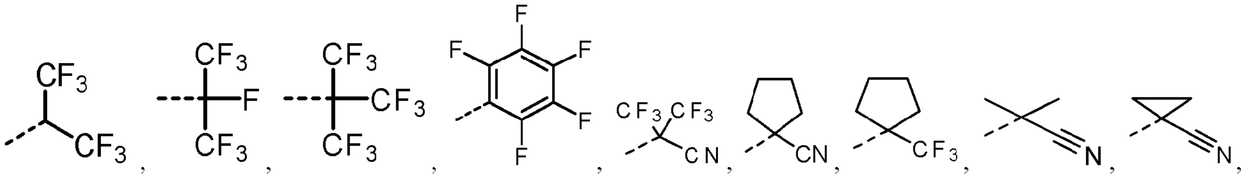,

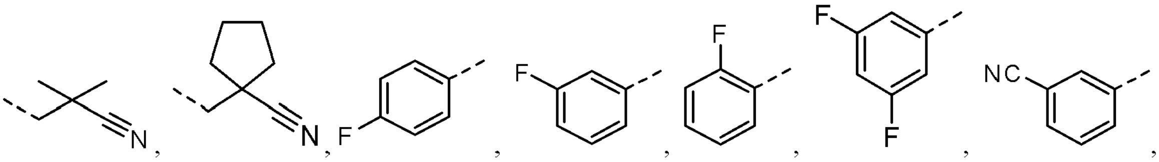,

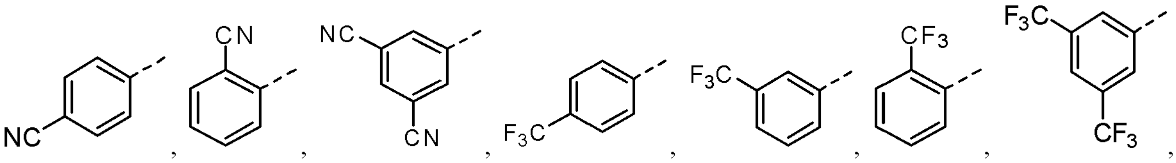,

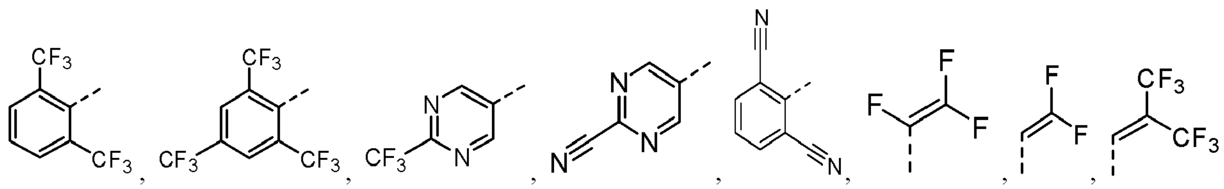,

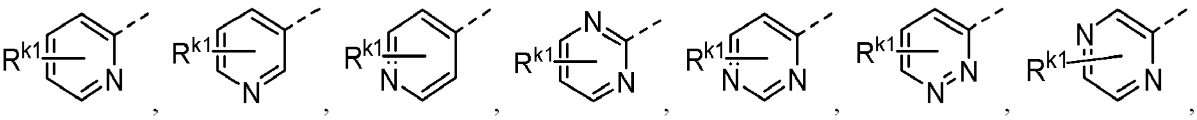,

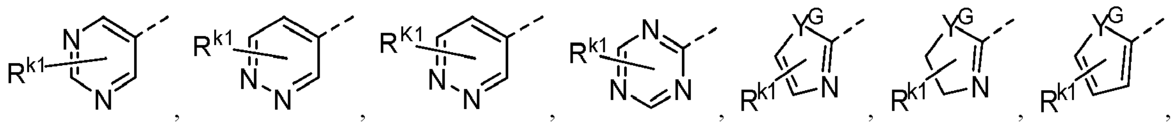,

and

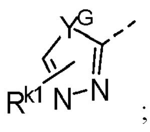;

wherein each $R^{k1}$ represents mono to the maximum allowable substitution, or no substitutions;

wherein $Y^G$ is selected from the group consisting of $BR_e$, $NR_e$, $PR_e$, O, S, Se, C=O, S=O, $SO_2$, $CR_eR_f$, $SiR_eR_f$, and $GeR_eR_f$; and

wherein each of $R^{k1}$, $R^{k2}$, $R^{k3}$, $R_e$, and $R_f$ is independently a hydrogen, or a substituent selected from the group consisting of the General Substituents defined herein.

In some embodiments, the electron-withdrawing group is selected from the group consisting of the structures in the following LIST EWG 2:

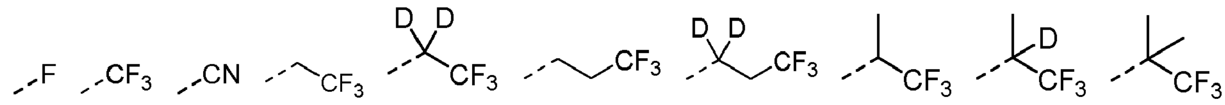

E1, E2, E3, E4, E5, E6, E7, E8, E9, E10,

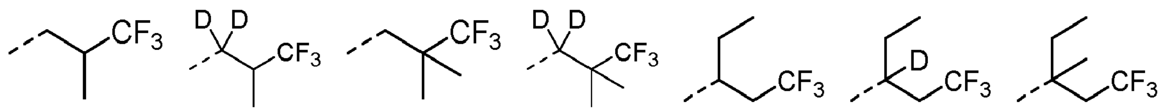

E11, E12, E13, E14, E15, E16, E17,

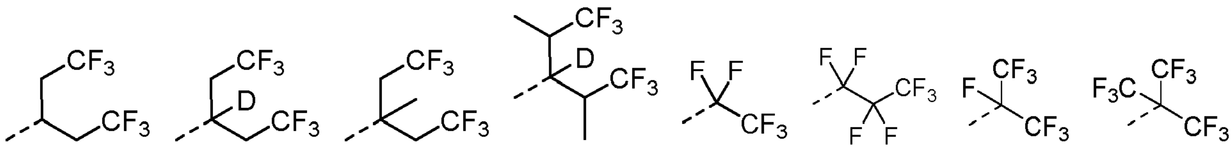

E18, E19, E20, E21, E22, E23, E24, E25,

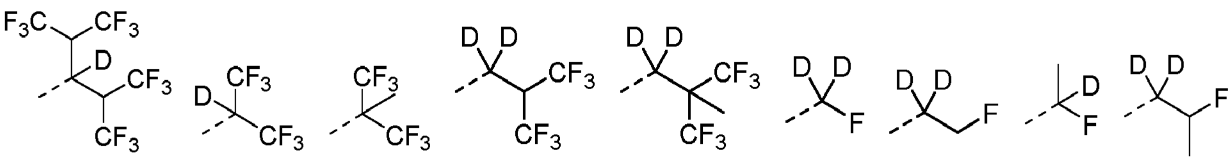

E26, E27, E28, E29, E30, E31, E32, E33, E34,

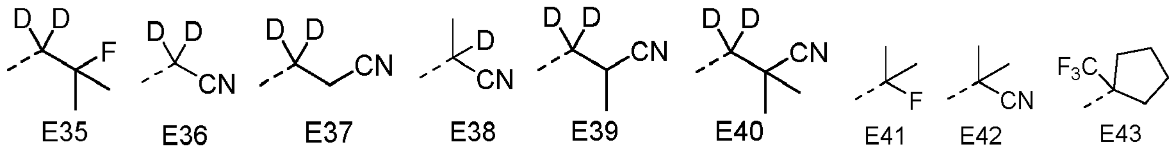

E35, E36, E37, E38, E39, E40, E41, E42, E43,

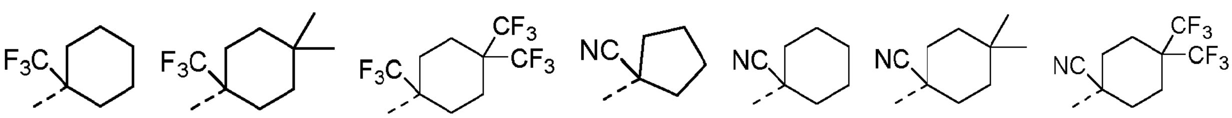

E44, E45, E46, E47, E48, E49, E50,

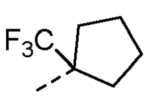
E51,
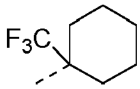
E52,
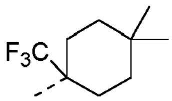
E53,
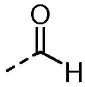
E54,
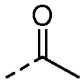
E55,
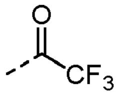
E56,
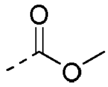
E57,
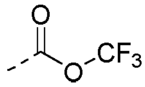
E58,
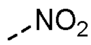
E59,

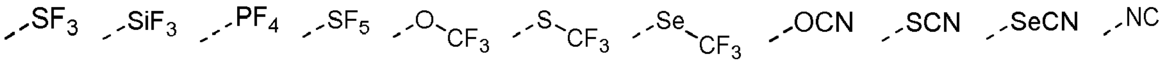
E60, E61, E62, E63, E64, E65, E66, E67, E68, E69, E70,

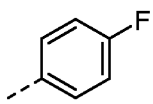
E71,
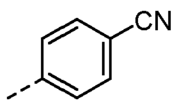
E72,
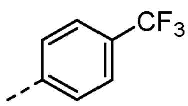
E73,
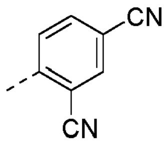
E74,
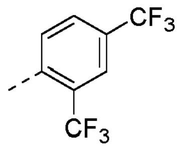
E75,
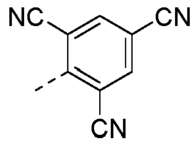
E76,

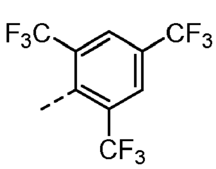
E77,
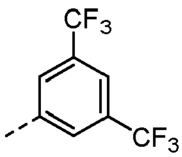
E78,
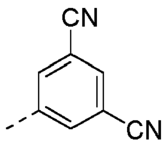
E79,
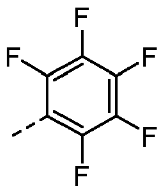
E80,
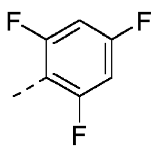
E81,
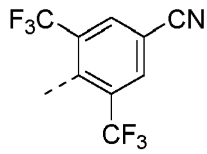
E82,

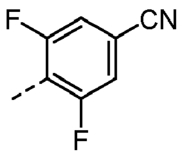
E83,
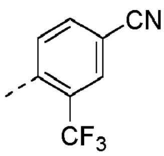
E84,
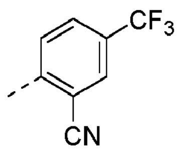
E85,
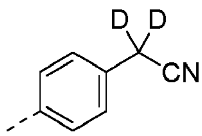
E86,
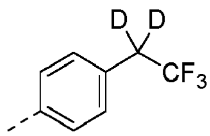
E87,
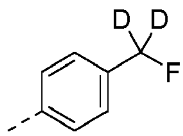
E88,

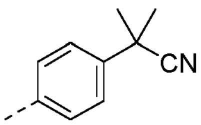
E89,
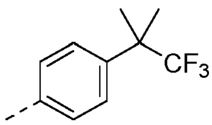
E90,
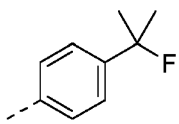
E91,
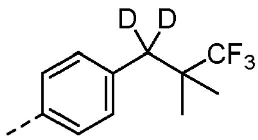
E92,
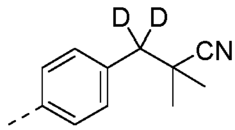
E93,

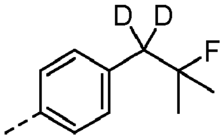
E94,
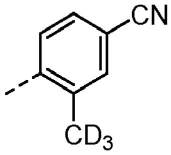
E95,
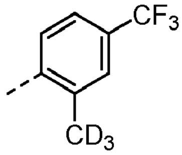
E96,
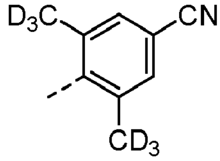
E97,
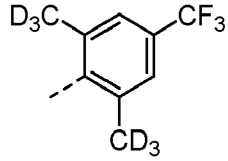
E98,

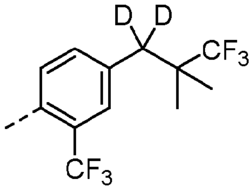
E99 ,
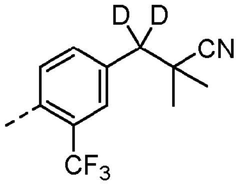
E100 ,
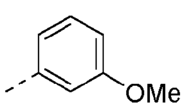
E101 ,
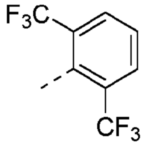
E102 ,
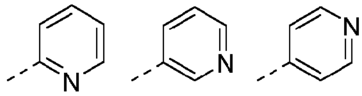
E103 , E104 , E105

,
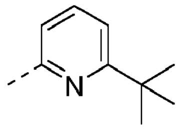
E106 ,
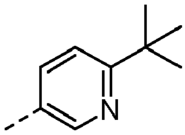
E107 ,
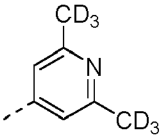
E108 ,
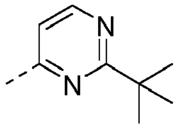
E109 ,
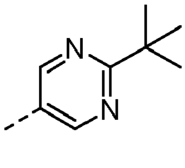
E110 ,
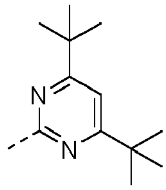
E111 ,

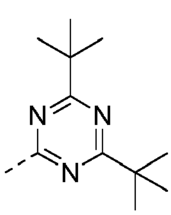
E112 ,
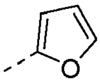
E113 ,
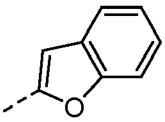
E114 ,
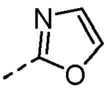
E115 ,
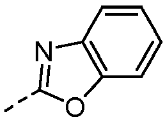
E116 ,
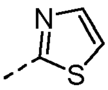
E117 ,
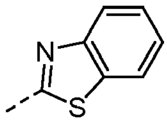
E118 ,
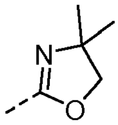
E119 ,

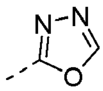
E120 ,
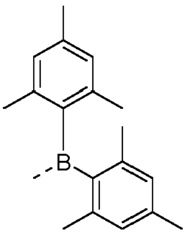
E121 ,
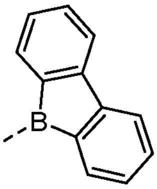
E122 ,
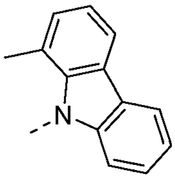
E123 ,
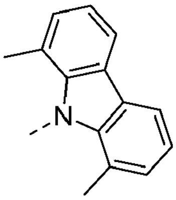
E124 , and
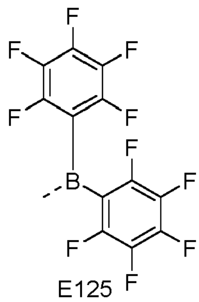
E125 .

In some embodiments, the electron-withdrawing group is selected from the group consisting of the structures in the following LIST EWG 3:

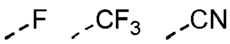
E1 , E2 , E3 ,
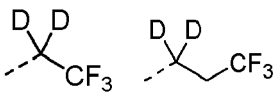
E5 , E7 ,
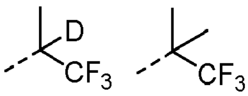
E9 , E10 ,
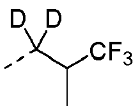
E12 ,
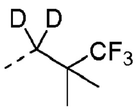
E14 ,
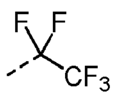
E22 ,

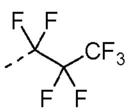
E23 ,
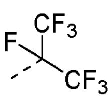
E24 ,
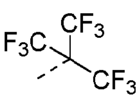
E25 ,
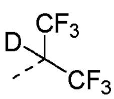
E27 ,
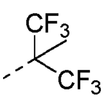
E28 ,
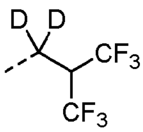
E29 ,
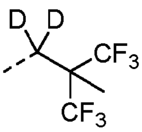
E30 ,
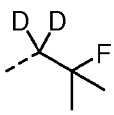
E35 ,
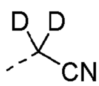
E36 ,

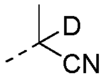
E38 ,
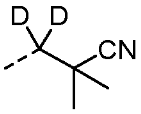
E40 ,
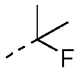
E41 ,
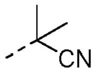
E42 ,
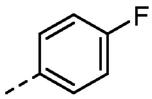
E71 ,
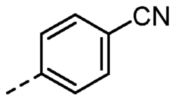
E72 ,
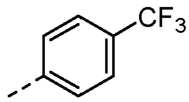
E73 ,
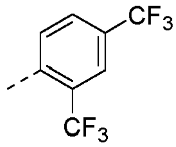
E75 ,

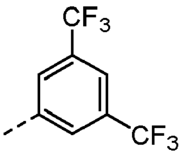
E78 ,
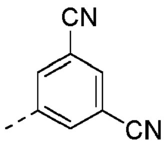
E79 ,
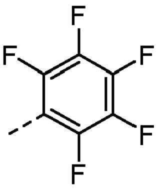
E80 ,
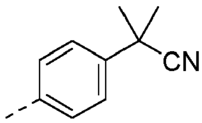
E89 ,
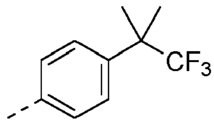
E90 ,
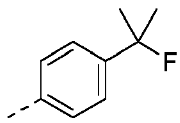
E91 ,

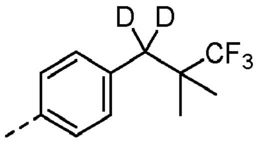
E92 ,
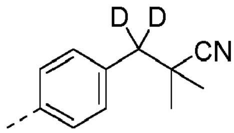
E93 ,
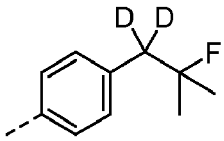
E94 ,
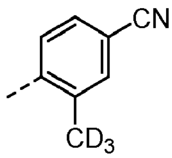
E95 ,
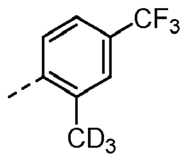
E96 ,

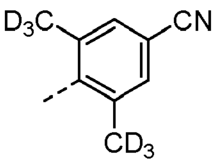
E97 ,
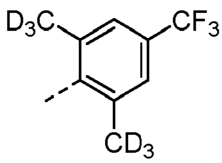
E98 ,
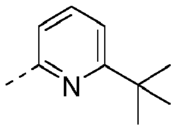
E106 ,
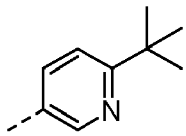
E107 ,
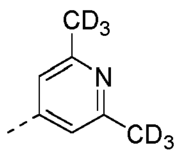
E108 ,
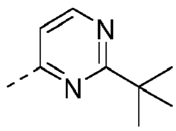
E109 ,

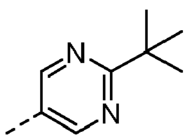
E110 ,
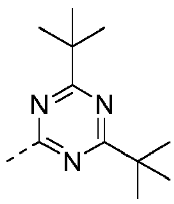
E112 ,
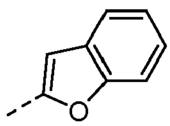
E114 ,
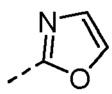
E115 ,
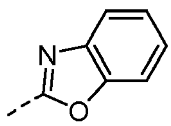
E116 , and
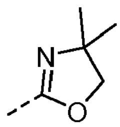
E119 .

In some embodiments, the electron-withdrawing group is selected from the group consisting of the structures in the following LIST EWG 4:

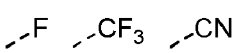
E1 , E2 , E3 ,
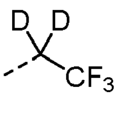
E5 ,
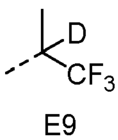
E9 ,
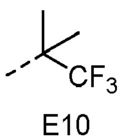
E10 ,
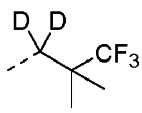
E14 ,
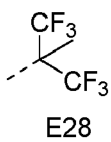
E28 ,
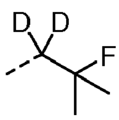
E35 ,
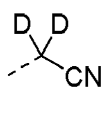
E36 ,

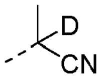 E38 , 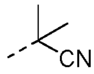 E42 , 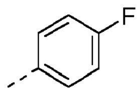 E71 , 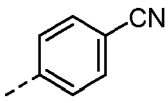 E72 , 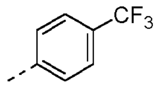 E73 , 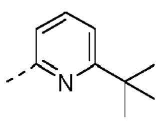 E106 , 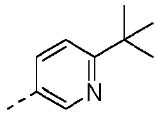 E107 , 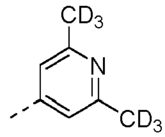 E108 ,

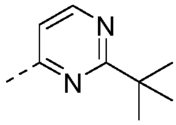 E109 , 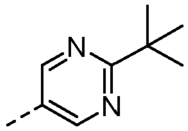 E110 , 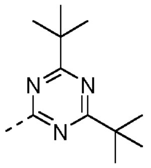 E112 , 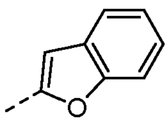 E114 , 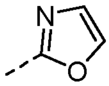 E115 , 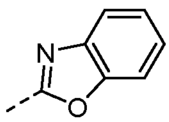 E116 , and 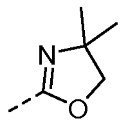 E119 .

In some embodiments, the electron-withdrawing group is a $\pi$-electron deficient electron-withdrawing group. In some embodiments, the $\pi$-electron deficient electron-withdrawing group is selected from the group consisting of the structures in the following LIST Pi-EWG: CN, $COCH_3$, CHO, $COCF_3$, COOMe, $COOCF_3$, $NO_2$, $SF_3$, $SiF_3$, $PF_4$, $SF_5$, $OCF_3$, $SCF_3$, $SeCF_3$, $SOCF_3$, $SeOCF_3$, $SO_2F$, $SO_2CF_3$, $SeO_2CF_3$, $OSeO_2CF_3$, OCN, SCN, SeCN, NC, $^+N(R^{k2})_3$, $BR^{k2}R^{k3}$, substituted or unsubstituted dibenzoborole, 1-substituted carbazole, 1,9-substituted carbazole, substituted or unsubstituted carbazole, substituted or unsubstituted pyridine, substituted or unsubstituted pyrimidine, substituted or unsubstituted pyrazine, substituted or unsubstituted pyridazine, substituted or unsubstituted triazine, substituted or unsubstituted oxazole, substituted or unsubstituted benzoxazole, substituted or unsubstituted thiazole, substituted or unsubstituted benzothiazole, substituted or unsubstituted imidazole, substituted or unsubstituted benzimidazole, ketone, carboxylic acid, ester, nitrile, isonitrile, sulfinyl, sulfonyl, partially and fully fluorinated aryl, partially and fully fluorinated heteroaryl, cyano-containing aryl, cyano-containing heteroaryl, isocyanate,

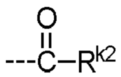 , 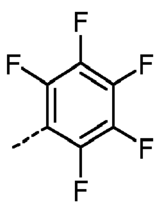 ,

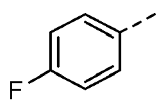 , 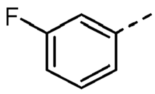 , 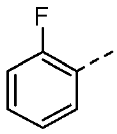 , 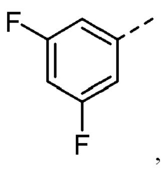 , 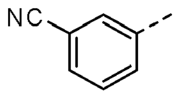 , 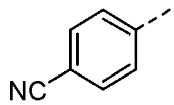 , 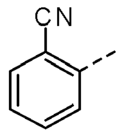 ,

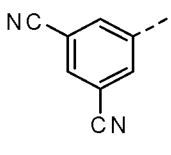 , 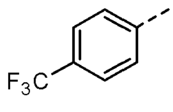 , 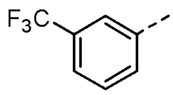 , 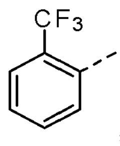 , 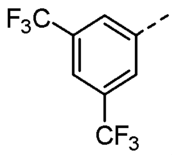 , 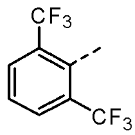 , 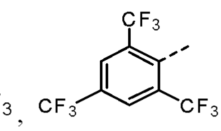 ,

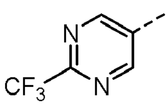 , 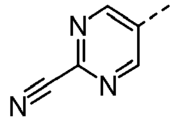 , 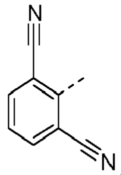 , 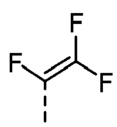 , 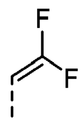 , 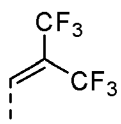 , 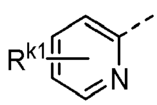 , 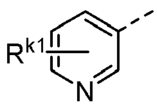 ,

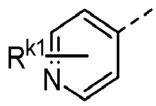, 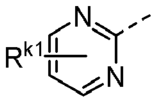, 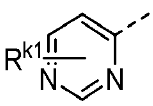, 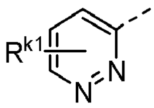, 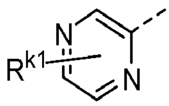, 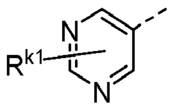, 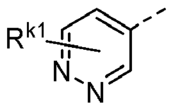,

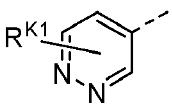, 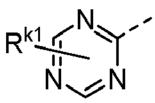, 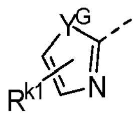, 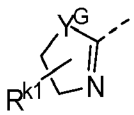, 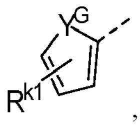, and 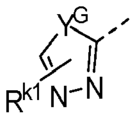;

wherein the variables are the same as previously defined.

In some embodiments, the composition A described herein can be at least 30% deuterated, at least 40% deuterated, at least 50% deuterated, at least 60% deuterated, at least 70% deuterated, at least 80% deuterated, at least 90% deuterated, at least 95% deuterated, at least 99% deuterated, or 100% deuterated. As used herein, percent deuteration has its ordinary meaning and includes the percent of possible hydrogen atoms (e.g., positions that are hydrogen or deuterium) that are replaced by deuterium atoms.

In some embodiments of heteroleptic compound having the formula of $M(L^1)_x(L^2)_y(L^3)_z$ as defined above, the ligand L' has a first substituent $R^I$, where the first substituent $R^I$ has a first atom a-I that is the farthest away from the metal M among all atoms in the ligand $L^1$. Additionally, the ligand $L^2$, if present, has a second substituent $R^{II}$, where the second substituent $R^{II}$ has a first atom a-II that is the farthest away from the metal M among all atoms in the ligand $L^2$. Furthermore, the ligand $L^3$, if present, has a third substituent $R^{III}$, where the third substituent $R^{III}$ has a first atom a-III that is the farthest away from the metal M among all atoms in the ligand $L^3$.

In such heteroleptic compounds, vectors $V_{D1}$, $V_{D2}$, and $V_{D3}$ can be defined that are defined as follows. $V_{D1}$ represents the direction from the metal M to the first atom a-I and the vector $V_{D1}$ has a value $D^1$ that represents the straight line distance between the metal M and the first atom a-I in the first substituent $R^I$. $V_{D2}$ represents the direction from the metal M to the first atom a-II and the vector $V_{D2}$ has a value $D^2$ that represents the straight line distance between the metal M and the first atom a-II in the second substituent $R^{II}$. $V_{D3}$ represents the direction from the metal M to the first atom a-III and the vector $V_{D3}$ has a value $D^3$ that represents the straight line distance between the metal M and the first atom a-III in the third substituent $R^{III}$.

In such heteroleptic compounds, a sphere having a radius r is defined whose center is the metal M and the radius r is the smallest radius that will allow the sphere to enclose all atoms in the compound that are not part of the substituents $R^I$, $R^{II}$ and $R^{III}$; and where at least one of $D^1$, $D^2$, and $D^3$ is greater than the radius r by at least 1.5 Å. In some embodiments, at least one of $D^1$, $D^2$, and $D^3$ is greater than the radius r by at least 2.9, 3.0, 4.3, 4.4, 5.2, 5.9, 7.3, 8.8, 10.3, 13.1, 17.6, or 19.1 Å.

In some embodiments of such heteroleptic compound, the compound has a transition dipole moment axis, and angles are defined between the transition dipole moment axis and the vectors $V_{D1}$, $V_{D2}$, and $V_{D3}$, where at least one of the angles between the transition dipole moment axis and the vectors $V_{D1}$, $V_{D2}$, and $V_{D3}$ is less than 40°. In some embodiments, at least one of the angles between the transition dipole moment axis and the vectors $V_{D1}$, $V_{D2}$, and $V_{D3}$ is less than 30°. In some embodiments, at least one of the angles between the transition dipole moment axis and the vectors $V_{D1}$, $V_{D2}$, and $V_{D3}$ is less than 20°. In some embodiments, at least one of the angles between the transition dipole moment axis and the vectors $V_{D1}$, $V_{D2}$, and $V_{D3}$ is less than 15°. In some embodiments, at least one of the angles between the transition dipole moment axis and the vectors $V_{D1}$, $V_{D2}$, and $V_{D3}$ is less than 10°. In some embodiments, at least two of the angles between the transition dipole moment axis and the vectors $V_{D1}$, $V_{D2}$, and $V_{D3}$ are less than 20°. In some embodiments, at least two of the angles between the transition dipole moment axis and the vectors $V_{D1}$, $V_{D2}$, and $V_{D3}$ are less than 15°. In some embodiments, at least two of the angles between the transition dipole moment axis and the vectors $V_{D1}$, $V_{D2}$, and $V_{D3}$ are less than 10°.

In some embodiments, all three angles between the transition dipole moment axis and the vectors $V_{D1}$, $V_{D2}$, and $V_{D3}$ are less than 20°. In some embodiments, all three angles between the transition dipole moment axis and the vectors $V_{D1}$, $V_{D2}$, and $V_{D3}$ are less than 15°. In some embodiments, all three angles between the transition dipole moment axis and the vectors $V_{D1}$, $V_{D2}$, and $V_{D3}$ are less than 10°.

To reduce the amount of Dexter energy transfer between the sensitizer compound and the acceptor compound, it would be preferable to have a large distance between the center of mass of the sensitizer compound and the center of mass of the closest neighboring acceptor compound in the emissive region. Therefore, in some embodiments, the distance between the center of mass of the acceptor compound and the center of mass of the sensitizer compound is at least 2, 1.5, 1.0, or 0.75 nm.

Preferred acceptor/sensitizer VDR combination (A): In some embodiments, it is preferable for the VDR of the acceptor to be less than 0.33 in order to reduce the coupling of the transition dipole moment of the emitting acceptor to

the plasmon modes, compared to an isotropic emitter, in order to achieve a higher outcoupling efficiency. In some cases, when the VDR of the acceptor is less than 0.33, it would be preferable for the VDR of the sensitizer to be less than 0.33 in order to improve the coupling of the transition dipole moments of the sensitizer and acceptor to optimize the Forster energy transfer rate. Accordingly, in some embodiments of the inventive OLED, the acceptor compound in the inventive OLED exhibits a VDR value equal to or less than 0.33, 0.30, 0.25, 0.2, 0.15, 0.10, 0.08, or 0.05 when the VDR is measured with an emissive thin film test sample that has the acceptor compound as the only emitter; and the sensitizer compound in the inventive OLED exhibits a VDR value equal to or less than 0.33, 0.30, 0.25, 0.2, 0.15, 0.10, 0.08, or 0.05 when the VDR is measured with an emissive thin film test sample that has the sensitizer compound as the only emitter.

Preferred acceptor/sensitizer VDR combination (B): In some embodiments, it is preferable for the VDR of the acceptor to be less than 0.33 in order to reduce the coupling of the transition dipole moment of the emitting acceptor to the plasmon modes compared to an isotropic emitter in order to achieve a higher outcoupling efficiency. In some cases, when the VDR of the acceptor is less than 0.33, it would be preferable to minimize the intermolecular interactions between the sensitizer and acceptor to decrease the degree of Dexter quenching. By changing the molecular geometry of the sensitizer to reduce the intermolecular interactions, it may be preferable to have a sensitizer with a VDR greater than 0.33. Accordingly, in some embodiments of the inventive OLED, the acceptor compound in the inventive OLED exhibits a VDR value equal to or less than 0.33, 0.30, 0.25, 0.2, 0.15, 0.10, 0.08, or 0.05 when the VDR is measured with an emissive thin film test sample that has the acceptor compound as the only emitter; and the sensitizer compound in the inventive OLED exhibits a VDR value larger than 0.33, 0.4, 0.5, 0.6, or 0.7 when the VDR is measured with an emissive thin film test sample that has the sensitizer compound as the only emitter.

Preferred acceptor/sensitizer VDR combination (C): In some embodiments, it is preferable for the VDR of the acceptor to be greater than 0.33 in order to increase the coupling of the transition dipole moment of the acceptor to the plasmon modes compared to an isotropic emitter in order to decrease the transient lifetime of the excited states in the emissive layer. In some cases, the increased coupling to the plasmon modes can be paired with an enhancement layer in a plasmonic OLED device to improve efficiency and extend operational lifetime. In some cases, when the VDR of the acceptor is greater than 0.33, it would be preferable to minimize the intermolecular interactions between the sensitizer and acceptor to decrease the degree of Dexter quenching. By changing the molecular geometry of the sensitizer to reduce the intermolecular interactions, it may be preferable to have a sensitizer with a VDR less than 0.33. Accordingly, in some embodiments of the inventive OLED, the acceptor compound in the inventive OLED exhibits a VDR value larger than 0.33, 0.4, 0.5, 0.6, or 0.7 when the VDR is measured with an emissive thin film test sample that has the acceptor compound as the only emitter; and the sensitizer compound in the inventive OLED exhibits a VDR value equal to or less than 0.33, 0.30, 0.25, 0.2, 0.15, 0.10, 0.08, or 0.05 when the VDR is measured with an emissive thin film test sample that has the sensitizer compound as the only emitter.

Preferred acceptor/sensitizer VDR combination (D): In some embodiments, it is preferable for the VDR of the acceptor to be greater than 0.33 in order to increase the coupling of the transition dipole moment of the acceptor to the plasmon modes compared to an isotropic emitter in order to decrease the transient lifetime of the excited states in the emissive layer. In some cases, the increased coupling to the plasmon modes can be paired with an enhancement layer in a plasmonic OLED device to improve efficiency and extend operational lifetime. In some cases, when the VDR of the acceptor is greater than 0.33, it would be preferable for the VDR of the sensitizer to be greater than 0.33 in order to improve the coupling of the transition dipole moments of the sensitizer and acceptor to optimize the Forster energy transfer rate. Accordingly, in some embodiments of the inventive OLED, the acceptor compound in the inventive OLED exhibits a VDR value larger than 0.33, 0.4, 0.5, 0.6, or 0.7 when the VDR is measured with an emissive thin film test sample that has the acceptor compound as the only emitter; and the sensitizer compound in the inventive OLED exhibits a VDR value larger than 0.33, 0.4, 0.5, 0.6, or 0.7 when the VDR is measured with an emissive thin film test sample that has the sensitizer compound as the only emitter.

VDR is the ensemble average fraction of vertically oriented molecular dipoles of the light-emitting compound in a thin film sample of an emissive layer, where the orientation "vertical" is relative to the plane of the surface of the substrate (i.e., normal to the surface of the substrate plane) on which the thin film sample is formed. A similar concept is horizontal dipole ratio (HDR) which is the ensemble average fraction of horizontally oriented molecular dipoles of the light-emitting compound in a thin film sample of an emissive layer, where the orientation "horizontal" is relative to the plane of the surface of the substrate (i.e. parallel to the surface of the substrate plane) on which the thin film sample is formed. By definition, VDR+HDR = 1. VDR can be measured by angle dependent, polarization dependent, photoluminescence measurements. By comparing the measured emission pattern of a photo-excited thin film test sample, as a function of polarization, to the computationally modeled pattern, one can determine VDR of the thin film test sample emission layer. For example, a modelled data of p-polarized emission is shown in FIG. 3. The modelled p-polarized angle photoluminescence (PL) is plotted for emitters with different VDRs. A peak in the modelled PL is observed in the p-polarized PL around the angle of 45 degrees with the peak PL being greater when the VDR of the emitter is higher.

To measure VDR values of the thin film test samples, a thin film test sample can be formed with the acceptor compound or the sensitizer compound (depending on whether the VDR of the acceptor compound or the sensitizer

compound is being measured) as the only emitter in the thin film and a Reference Host Compound A as the host. Preferably, the Reference Host Compound A is

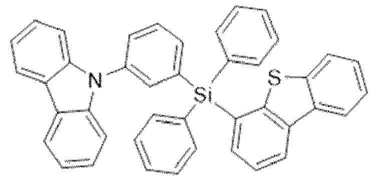

.

The thin film test sample is formed by thermally evaporating the emitter compound and the host compound on a substrate. For example, the emitter compound and the host compound can be co-evaporated. In some embodiments, the doping level of the emitter compounds in the host can be from 0.1 wt. % to 50 wt. %. In some embodiments, the doping level of the emitter compounds in the host can be from 3 wt. % to 20 wt. % for blue emitters. In some embodiments, the doping level of the emitter compounds in the host can be from 1 wt. % to 15 wt. % for red and green emitters. The thickness of the thermally evaporated thin film test sample can have a thickness of from 50 to 1000 Å.

In some embodiments, the OLED of the present disclosure can comprise a sensitizer, an acceptor, and one or more hosts in the emissive region, and the preferred acceptor/sensitizer VDR combinations (A) - (D) mentioned above are still applicable. In these embodiments, the VDR values for the acceptor compound can be measured with a thin film test sample formed of the one or more hosts and the acceptor, where the acceptor is the only emitter in the thin film test sample. Similarly, the VDR values for the sensitizer compound can be measured with a thin film test sample formed of the one or more hosts and the sensitizer, where the sensitizer is the only emitter in the thin film test sample.

In the example used to generate FIG. 3, a 30 nm thick film of material with a refractive index of 1.75 and the emission is monitored in a semi-infinite medium with a refractive index of 1.75. Each curve is normalized to a photoluminescence intensity of 1 at an angle of zero degrees, which is perpendicular to the surface of the film. As the VDR of the emitter is varied, the peak around 45 degrees increases greatly. When using a software to fit the VDR of experimental data, the modeled VDR would be varied until the difference between the modeled data and the experimental data is minimized.

Because the VDR represents the average dipole orientation of the light-emitting compound in the thin film sample, even if there are additional emission capable compounds in the emissive layer, if they are not contributing to the light emission, the VDR measurement does not reflect their VDR. Further, by inclusion of a host material that interacts with the light-emitting compound, the VDR of the light-emitting compound can be modified. Thus, a light-emitting compound in a thin film sample with host material A will exhibit one measured VDR value and that same light-emitting compound in a thin film sample with host material B will exhibit a different measured VDR value. Further, in some embodiments, exciplex or excimers are desirable which form emissive states between two neighboring molecules. These emissive states may have a VDR that is different than that if only one of the components of the exciplex or excimer were emitting or present in the sample.

In some embodiments, the OLED is a plasmonic OLED. In some embodiments, the OLED is a wave-guided OLED.

In some embodiments, the emissive region can further include a second host. In some embodiments, the second host comprises a moiety selected from the group consisting of biscarbazole, indolocarbazole, triazine, pyrimidine, pyridine, and boryl. In some embodiments, the second host has a HOMO level that is shallower than that of the acceptor compound.

In some embodiments, the OLED emits a white light at room temperature when a voltage is applied across the device.

In some embodiments, the OLED emits a luminescent radiation at room temperature when a voltage is applied across the device; wherein the luminescent first radiation component contributed from the acceptor compound with an emission $\lambda_{max1}$ being independently selected from the group consisting of larger than 340 nm to equal or less than 500 nm, larger than 500 nm to equal or less than 600 nm, and larger than 600 nm to equal or less than 900 nm. In some embodiments, the first radiation component has FWHM of 50, 40, 35, 30, 25, 20, 15, 10, or 5 nm or less. In some embodiments, the first radiation component has a 10% onset of the emission peak is less than 465, 460, 455, or 450 nm.

In some embodiments, the sensitizer compound is partially or fully deuterated. In some embodiments, the acceptor compound is partially or fully deuterated. In some embodiments, the first host is partially or fully deuterated. In some embodiments, the second host is partially or fully deuterated.

One of ordinary skill in the art would readily understand the meaning of the terms transition dipole moment axis of a compound and vertical dipole ratio of a compound. Nevertheless, the meaning of these terms can be found in U.S. pat. No. 10,672,997 whose disclosure is incorporated herein by reference in its entirety. In U.S. pat. No. 10,672,997, horizontal dipole ratio (HDR) of a compound, rather than VDR, is discussed. However, one skilled in the art readily

understands that VDR = 1 - HDR.

In yet another aspect, the present disclosure also provides a consumer product comprising an organic light-emitting device (OLED) having an anode; a cathode; and an organic layer disposed between the anode and the cathode, wherein the organic layer may comprise the composition A as disclosed in the above compounds section of the present disclosure.

In some embodiments, the consumer product comprises an OLED having an anode; a cathode; and an organic layer disposed between the anode and the cathode, wherein the organic layer comprises the composition A described herein.

Some examples of such consumer products include flat panel displays, curved displays, computer monitors, medical monitors, televisions, billboards, lights for interior or exterior illumination and/or signaling, heads-up displays, fully or partially transparent displays, flexible displays, rollable displays, foldable displays, stretchable displays, laser printers, telephones, mobile phones, tablets, phablets, personal digital assistants (PDAs), wearable devices, laptop computers, digital cameras, camcorders, viewfinders, micro-displays (displays that are less than 2 inches diagonal), 3-D displays, virtual reality or augmented reality displays, vehicles, video walls comprising multiple displays tiled together, theater or stadium screen, a light therapy device, and a sign. Various control mechanisms may be used to control devices fabricated in accordance with the present disclosure, including passive matrix and active matrix. Many of the devices are intended for use in a temperature range comfortable to humans, such as 18 degrees C. to 30 degrees C., and more preferably at room temperature (20-25 °C), but could be used outside this temperature range, for example, from -40 degree C to + 80 °C..

Generally, an OLED comprises at least one organic layer disposed between and electrically connected to an anode and a cathode. When a current is applied, the anode injects holes, and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

FIG. 1 shows an organic light emitting device 100. The figures are not necessarily drawn to scale. Device 100 may include a substrate 110, an anode 115, a hole injection layer (HIL) 120, a hole transport layer (HTL) 125, an electron blocking layer (EBL) 130, an emissive layer (EML) 135, a hole blocking layer (HBL) 140, an electron transport layer (ETL) 145, an electron injection layer (EIL) 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10, which are incorporated by reference.

More examples for each of these layers are available. For example, a flexible and transparent substrate-anode combination is disclosed in U.S. Pat. No. 5,844,363, which is incorporated by reference in its entirety. An example of a p-doped hole transport layer is m-MTDATA doped with $F_4$-TCNQ at a molar ratio of 50:1, as disclosed in U.S. Patent Application Publication No. 2003/0230980, which is incorporated by reference in its entirety. Examples of emissive and host materials are disclosed in U.S. Pat. No. 6,303,238 to Thompson et al., which is incorporated by reference in its entirety. An example of an n-doped electron transport layer is BPhen doped with Li at a molar ratio of 1:1, as disclosed in U.S. Patent Application Publication No. 2003/0230980, which is incorporated by reference in its entirety. U.S. Pat. Nos. 5,703,436 and 5,707,745, which are incorporated by reference in their entireties, disclose examples of cathodes including compound cathodes having a thin layer of metal such as Mg:Ag with an overlying transparent, electrically-conductive, sputter-deposited ITO layer. The theory and use of blocking layers is described in more detail in U. S. Pat. No. 6,097,147 and U.S. Patent Application Publication No. 2003/0230980, which are incorporated by reference in their entireties. Examples of injection layers are provided in U. S. Patent Application Publication No. 2004/0174116, which is incorporated by reference in its entirety. A description of protective layers may be found in U. S. Patent Application Publication No. 2004/0174116, which is incorporated by reference in its entirety.

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the present disclosure may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also

be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al., which is incorporated by reference in its entirety. By way of further example, OLEDs having a single organic layer may be used. OLEDs may be stacked, for example as described in U.S. Pat. No. 5,707,745 to Forrest et al, which is incorporated by reference in its entirety. The OLED structure may deviate from the simple layered structure illustrated in FIGS. 1 and 2. For example, the substrate may include an angled reflective surface to improve out-coupling, such as a mesa structure as described in U. S. Pat. No. 6,091,195 to Forrest et al., and/or a pit structure as described in U.S. Pat. No. 5,834,893 to Bulovic et al., which are incorporated by reference in their entireties.

Unless otherwise specified, any of the layers of the various embodiments may be deposited by any suitable method. For the organic layers, preferred methods include thermal evaporation, ink-jet, such as described in U. S. Pat. Nos. 6,013,982 and 6,087,196, which are incorporated by reference in their entireties, organic vapor phase deposition (OVPD), such as described in U.S. Pat. No. 6,337,102 to Forrest et al., which is incorporated by reference in its entirety, and deposition by organic vapor jet printing (OVJP, also referred to as organic vapor jet deposition (OVJD)), such as described in U.S. Pat. No. 7,431,968, which is incorporated by reference in its entirety. Other suitable deposition methods include spin coating and other solution based processes. Solution based processes are preferably carried out in nitrogen or an inert atmosphere. For the other layers, preferred methods include thermal evaporation, sputtering, chemical vapor deposition, atomic layer deposition, and electron beam deposition. Preferred patterning methods include deposition through a mask, photolithography, and cold welding such as described in U.S. Pat. Nos. 6,294,398 and 6,468,819, which are incorporated by reference in their entireties, and patterning associated with some of the deposition methods such as ink-jet and organic vapor jet printing (OVJP). Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons are a preferred range. Materials with asymmetric structures may have better solution processability than those having symmetric structures, because asymmetric materials may have a lower tendency to recrystallize. Dendrimer substituents may be used to enhance the ability of small molecules to undergo solution processing.

Devices fabricated in accordance with embodiments of the present disclosure may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a plurality of alternative layers of polymeric material and non-polymeric material; organic material and inorganic material; or a mixture of a polymeric material and a non-polymeric material as one example described in U.S. Pat. No. 7,968,146, PCT Pat. Application Nos. PCT/US2007/023098 and PCT/US2009/042829, which are herein incorporated by reference in their entireties.

Devices fabricated in accordance with embodiments of the present disclosure can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the present disclosure can be incorporated into a wide variety of consumer products that have one or more of the electronic component modules (or units) incorporated therein. A consumer product comprising an OLED that includes the compound of the present disclosure in the organic layer in the OLED is disclosed. Such consumer products would include any kind of products that include one or more light source(s) and/or one or more of some type of visual displays. Some examples of such consumer products include flat panel displays, curved displays, computer monitors, medical monitors, televisions, billboards, lights for interior or exterior illumination and/or signaling, heads-up displays, fully or partially transparent displays, flexible displays, rollable displays,

foldable displays, stretchable displays, laser printers, telephones, mobile phones, tablets, phablets, personal digital assistants (PDAs), wearable devices, laptop computers, digital cameras, camcorders, viewfinders, micro-displays (displays that are less than 2 inches diagonal), 3-D displays, virtual reality or augmented reality displays, vehicles, video walls comprising multiple displays tiled together, theater or stadium screen, a light therapy device, and a sign. Various control mechanisms may be used to control devices fabricated in accordance with the present disclosure, including passive matrix and active matrix. Many of the devices are intended for use in a temperature range comfortable to humans, such as 18 degrees C. to 30 degrees C., and more preferably at room temperature (20-25 °C), but could be used outside this temperature range, for example, from -40 degree C to + 80 °C.

More details on OLEDs, and the definitions described above, can be found in U.S. Pat. No. 7,279,704, which is incorporated herein by reference in its entirety.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

In some embodiments, the OLED has one or more characteristics selected from the group consisting of being flexible, being rollable, being foldable, being stretchable, and being curved. In some embodiments, the OLED is transparent or semi-transparent. In some embodiments, the OLED further comprises a layer comprising carbon nanotubes. In some embodiments, the OLED further comprises one or more quantum dots. Such quantum dots can be in the emissive layer, or in other functional layers, such as a down conversion layer.

In some embodiments, the OLED comprises a RGB pixel arrangement or white plus color filter pixel arrangement. In some embodiments, the OLED is a mobile device, a handheld device, or a wearable device. In some embodiments, the OLED is a display panel having less than 10 inch diagonal or 50 square inch area. In some embodiments, the OLED is a display panel having at least 10 inch diagonal or 50 square inch area. In some embodiments, the OLED is a lighting panel.

In some embodiments, the composition A can include an emissive dopant. In some embodiments, the composition can produce emissions via phosphorescence, fluorescence, thermally activated delayed fluorescence, i.e., TADF (also referred to as E-type delayed fluorescence; *see, e.g.,* U.S. Application No. 15/700,352, which is hereby incorporated by reference in its entirety), triplet-triplet annihilation, or combinations of these processes. In some embodiments, the emissive dopant can be a racemic mixture, or can be enriched in one enantiomer. In some embodiments, the emissive dopant can be homoleptic (each ligand is the same). In some embodiments, the emissive dopant can be heteroleptic (at least one ligand is different from others). When there are more than one ligand coordinated to a metal, the ligands can all be the same in some embodiments. In some other embodiments, at least one ligand is different from the other ligands. In some embodiments, every ligand can be different from each other. This is also true in embodiments where a ligand being coordinated to a metal can be linked with other ligands being coordinated to that metal to form a tridentate, tetradentate, pentadentate, or hexadentate ligands. Thus, where the coordinating ligands are being linked together, all of the ligands can be the same in some embodiments, and at least one of the ligands being linked can be different from the other ligand(s) in some other embodiments.

In some embodiments, the composition A can be used as a phosphorescent sensitizer in an OLED where one or multiple layers in the OLED contains an acceptor in the form of one or more fluorescent and/or delayed fluorescence emitters. In some embodiments, the composition A can be used as one component of an exciplex to be used as a sensitizer. As a phosphorescent sensitizer, the composition A must be capable of energy transfer to the acceptor and the acceptor will emit the energy or further transfer energy to a final emitter. The acceptor concentrations can range from 0.001% to 100%. The acceptor could be in either the same layer as the phosphorescent sensitizer or in one or more different layers. In some embodiments, the acceptor is a TADF emitter. In some embodiments, the acceptor is a fluorescent emitter. In some embodiments, the emission can arise from any or all of the sensitizer, acceptor, and final emitter.

According to another aspect, a formulation comprising the composition A described herein is also disclosed.

The OLED disclosed herein can be incorporated into one or more of a consumer product, an electronic component module, and a lighting panel. The organic layer can be an emissive layer and the composition A can include an emissive dopant in some embodiments, while the composition A can include a non-emissive dopant in other embodiments.

In yet another aspect of the present disclosure, a formulation that comprises the composition A disclosed herein is described. The formulation can include one or more components selected from the group consisting of a solvent, a host, a hole injection material, hole transport material, electron blocking material, hole blocking material, and an electron transport material, disclosed herein.

The present disclosure encompasses any chemical structure comprising the composition A of the present disclosure, or a monovalent or polyvalent variant thereof. In other words, the inventive compound, or a monovalent or polyvalent variant thereof, can be a part of a larger chemical structure. Such chemical structure can be selected from the group consisting of a monomer, a polymer, a macromolecule, and a supramolecule (also known as supermolecule). As used herein, a "monovalent variant of a compound" refers to a moiety that is identical to the compound except that

one hydrogen has been removed and replaced with a bond to the rest of the chemical structure. As used herein, a "polyvalent variant of a compound" refers to a moiety that is identical to the compound except that more than one hydrogen has been removed and replaced with a bond or bonds to the rest of the chemical structure. In the instance of a supramolecule, the inventive compound can also be incorporated into the supramolecule complex without covalent bonds.

### D. Combination of the Compounds of the Present Disclosure with Other Materials

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

#### a) Conductivity Dopants:

A charge transport layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer. In some embodiments, conductivity dopants comprise at least one chemical moiety selected from the group consisting of cyano, fluorinated aryl or heteroaryl, fluorinated alkyl or cycloalkyl, alkylene, heteroaryl, amide, benzodithiophene, and highly conjugated heteroaryl groups extended by non-ring double bonds.

#### b) HIL/HTL:

A hole injecting/transporting material to be used in the present disclosure is not particularly limited, and any compound may be used as long as the compound is typically used as a hole injecting/transporting material. Examples of the material include, but are not limited to: a phthalocyanine or porphyrin derivative; an aromatic amine derivative; an indolocarbazole derivative; a polymer containing fluorohydrocarbon; a polymer with conductivity dopants; a conducting polymer, such as PEDOT/PSS; a self-assembly monomer derived from compounds such as phosphonic acid and silane derivatives; a metal oxide derivative, such as $MoO_x$; a p-type semiconducting organic compound, such as 1,4,5,8,9,12-Hexaazatriphenylenehexacarbonitrile; a metal complex, and a cross-linkable compounds.

Examples of aromatic amine derivatives used in HIL or HTL include, but not limit to the following general structures:

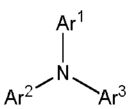, 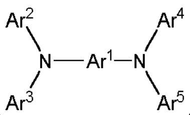, 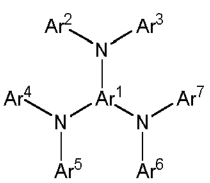, 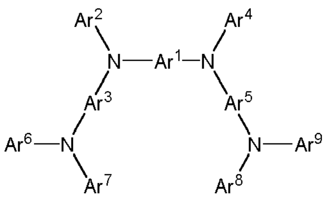, and 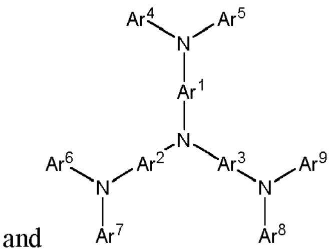.

Each of $Ar^1$ to $Ar^9$ is selected from the group consisting of aromatic hydrocarbon cyclic compounds such as benzene, biphenyl, triphenyl, triphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each

other directly or via at least one of oxygen atom, nitrogen atom, sulfur atom, silicon atom, phosphorus atom, boron atom, chain structural unit and the aliphatic cyclic group. Each of $Ar^1$ to $Ar^9$ may be unsubstituted or may be substituted by a general substituent as described above, any two substituents can be joined or fused into a ring.

In some embodiments, each $Ar^1$ to $Ar^9$ independently comprises a moiety selected from the group consisting of:

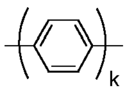, 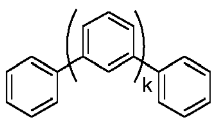, 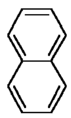, 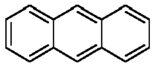, 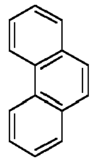, 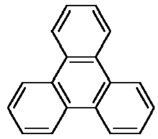, and 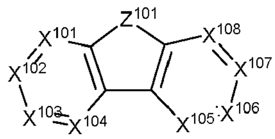

wherein k is an integer from 1 to 20; $X^{101}$ to $X^{108}$ is C or N; $Z^{101}$ is C, N, O, or S.

Examples of metal complexes used in HIL or HTL include, but are not limited to the following general formula:

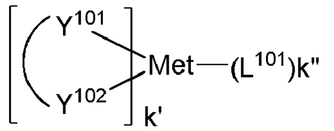,

wherein Met is a metal, which can have an atomic weight greater than 40; ($Y^{101}$-$Y^{102}$) is a bidentate ligand, the coordinating atoms of $Y^{101}$ and $Y^{102}$ are independently selected from C, N, O, P, and S; $L^{101}$ is an another ligand; k' is an integer value from 1 to the maximum number of ligands that may be attached to the metal; and k'+k" is the maximum number of ligands that may be attached to the metal.

In some embodiments, ($Y^{101}$-$Y^{102}$) is a 2-phenylpyridine or 2-phenylimidazole derivative. In some embodiments, ($Y^{101}$ -$Y^{102}$) is a carbene ligand. In some embodiments, Met is selected from Ir, Pt, Pd, Os, Cu, and Zn. In some embodiments, the metal complex has a smallest oxidation potential in solution vs. $Fc^+$/Fc couple less than about 0.6 V.

In some embodiments, the HIL/HTL material is selected from the group consisting of phthalocyanine and porphyrin compounds, starburst triarylamines, $CF_x$ fluorohydrocarbon polymer, conducting polymers (e.g., PEDOTPSS, polyaniline, polythiophene), phosphonic acid and silane SAMs, triarylamine or polythiophene polymers with conductivity dopants, Organic compounds with conductive inorganic compounds (such as molybdenum and tungsten oxides), n-type semiconducting organic complexes, metal organometallic complexes, cross-linkable compounds, polythiophene based polymers and copolymers, triarylamines, triarylamine with spirofluorene core, arylamine carbazole compounds, triarylamine with (di)benzothiophene/(di)benzofuran, indolocarbazoles, isoindole compounds, and metal carbene complexes.

### c) EBL:

An electron blocking layer (EBL) may be used to reduce the number of electrons and/or excitons that leave the emissive layer. The presence of such a blocking layer in a device may result in substantially higher efficiencies, and/or longer lifetime, as compared to a similar device lacking a blocking layer. Also, a blocking layer may be used to confine emission to a desired region of an OLED. In some embodiments, the EBL material has a higher LUMO (closer to the vacuum level) and/or higher triplet energy than one or more emitters closest to the EBL interface. In some embodiments, the compound used in EBL contains at least one carbazole group and/or at least one arylamine group. In some embodiments the HOMO level of the compound used in the EBL is shallower than the HOMO level of one or more of the hosts in the EML. In some embodiments, the compound used in EBL contains the same molecule or the same functional groups used as one of the hosts described herein.

### d) Hosts:

The light emitting layer of the organic EL device of the present disclosure preferably contains at least a light emitting material as the dopant, and a host material. Examples of the host material are not particularly limited, and any metal complexes or organic compounds may be used as long as the host won't fully quench the emission of the dopant.

Examples of metal complexes used as host are preferred to have the following general formula:

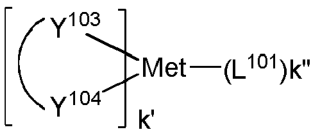

wherein Met is a metal; ($Y^{103}$-$Y^{104}$) is a bidentate ligand, the coordinating atoms of $Y^{103}$ and $Y^{104}$ are independently selected from C, N, O, P, and S; $L^{101}$ is an another ligand; k' is an integer value from 1 to the maximum number of ligands that may be attached to the metal; and k'+k" is the maximum number of ligands that may be attached to the metal.

In some embodiments, the metal complexes are:

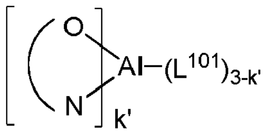 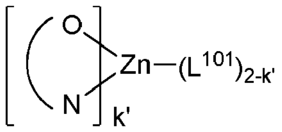

wherein (O-N) is a bidentate ligand, having metal coordinated to atoms O and N.

In some embodiments, Met is selected from Ir and Pt. In a further embodiments, ($Y^{103}$-$Y^{104}$) is a carbene ligand.

In some embodiments, the host compound contains at least one of the following groups selected from the group consisting of aromatic hydrocarbon cyclic compounds such as benzene, biphenyl, triphenyl, triphenylene, tetraphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, aza-dibenzothiophene, aza-dibenzofuran, aza-dibenzoselenophene, aza-carbazole, aza-indolocarbazole, aza-triphenylene, aza-tetraphenylene, 5$\lambda^2$-benzo[d]benzo[4,5]imidazo[3,2-a]imidazole, 5,9-dioxa-13b-boranaphtho[3,2, 1-de]anthracene,; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each option within each group may be unsubstituted or may be substituted by the General Substituents as described herein or may be further fused.

In some embodiments, the host compound comprises at least one of the moieties selected from the group consisting of:

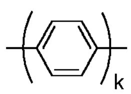, 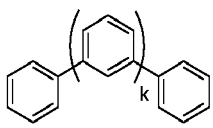, 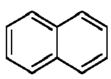, 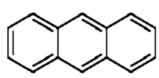, 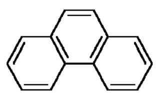, 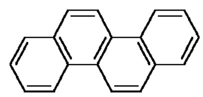,

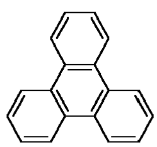, 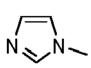, 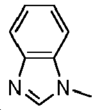, 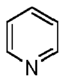, 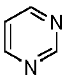, 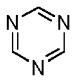, 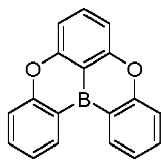, 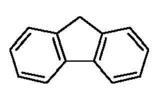, 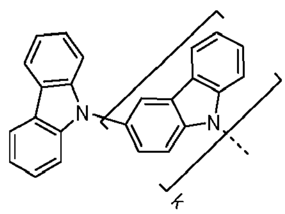,

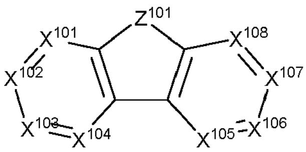,
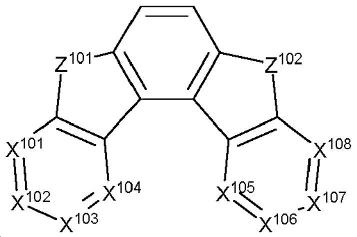,
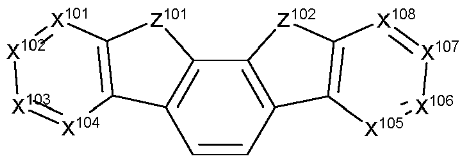,
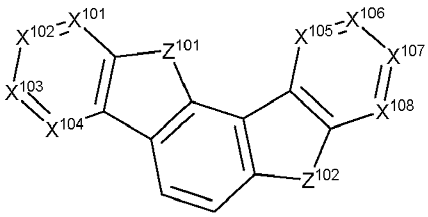,
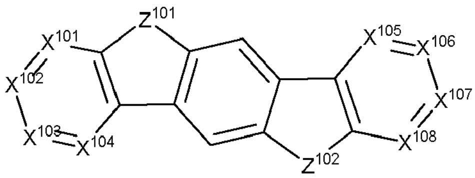,

and

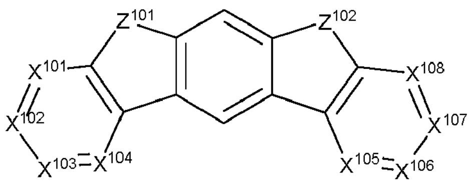,

wherein k is an integer from 0 to 20 or 1 to 20. $X^{101}$ to $X^{108}$ are independently selected from C or N. $Z^{101}$ and $Z^{102}$ are independently selected from C, N, O, or S.

In some embodiments, the host material is selected from the group consisting of arylcarbazoles, metal 8-hydroxyquinolates, (e.g., alq3, balq), metal phenoxybenzothiazole compounds, conjugated oligomers and polymers (e.g., polyfluorene), aromatic fused rings, zinc complexes, chrysene based compounds, aryltriphenylene compounds, poly-fused heteroaryl compounds, donor acceptor type molecules, dibenzofuran/dibenzothiophene compounds, polymers (e.g., pvk), spirofluorene compounds, spirofluorene-carbazole compounds, indolocarbazoles, 5-member ring electron deficient heterocycles (e.g., triazole, oxadiazole), tetraphenylene complexes, metal phenoxypyridine compounds, metal coordination complexes (e.g., Zn, Al with N^N ligands), dibenzothiophene/dibenzofuran-carbazole compounds, silicon/germanium aryl compounds, aryl benzoyl esters, carbazole linked by non-conjugated groups, aza-carbazole/dibenzofuran/dibenzothiophene compounds, and high triplet metal organometallic complexes (e.g., metal-carbene complexes).

e) Emitter Materials in EML:

One or more emitter materials may be used in conjunction with the compound or device of the present disclosure. The emitter material can be emissive or non-emissive in the current device as described herein. Examples of the emitter materials are not particularly limited, and any compounds may be used as long as the compounds are capable of producing emissions in a regular OLED device. Examples of suitable emitter materials include, but are not limited to, compounds which are capable of producing emissions via phosphorescence, non-delayed fluorescence, delayed fluorescence, especially the thermally activated delayed fluorescence, i.e., TADF (also referred to as E-type delayed fluorescence), triplet-triplet annihilation, or combinations of these processes.

In some embodiments, the emitter material has the formula of $M(L^1)_x(L^2)_y(L^3)_z$;

wherein $L^1$, $L^2$, and $L^3$ can be the same or different;
wherein x is 1, 2, or 3;
wherein y is 0, 1, or 2;
wherein z is 0, 1, or 2;
wherein x+y+z is the oxidation state of the metal M;
wherein $L^1$ is selected from the group consisting of the structures of LIGAND LIST B as defined herein;

wherein each $L^2$ and $L^3$ are independently selected from the group consisting of

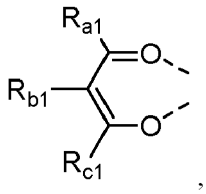

,

and the structures of LIGAND LIST B; wherein:

M is selected from the group consisting of Ir, Rh, Re, Ru, Os, Pt, Pd, Zn, Au, Ag, and Cu;
T is selected from the group consisting of B, Al, Ga, and In;
$K^{1'}$ is a direct bond or is selected from the group consisting of $NR_e$, $PR_e$, O, S, and Se;
each $Y^1$ to $Y^{15}$ are independently selected from the group consisting of carbon and nitrogen;
Y' is selected from the group consisting of $BR_e$, $NR_e$, $PR_e$, O, S, Se, C=O, S=O, $SO_2$, $CR_eR_f$, $SiR_eR_f$, and $GeR_eR_f$;
each $R_a$, $R_b$, $R_c$, and $R_d$ can independently represent from mono to the maximum possible number of substitutions, or no substitution;
each $R_{a1}$, $R_{b1}$, $R_{c1}$, $R_{d1}$, $R_a$, $R_b$, $R_c$, $R_d$, $R_e$, and $R_f$ is independently a hydrogen or a substituent selected from the group consisting of the General Substituents as defined herein; and

wherein any two substituents can be fused or joined to form a ring or form a multidentate ligand.

In some embodiments, the emitter material is selected from the group consisting of the LIST C as defined herein. In some embodiments of the above LIST C, each unsubstituted aromatic carbon atom can be replaced with N to form an aza-ring. In some embodiments, the maximum number of N atom in one ring is 1 or 2. In some embodiments of LIST C, Pt atom in each formula with Pt can be replaced by Pd atom.

In some embodiments of the OLED, the delayed fluorescence material comprises at least one donor group and at least one acceptor group. In some embodiments, the delayed fluorescence material is a metal complex. In some embodiments, the delayed fluorescence material is a non-metal complex. In some embodiments, the delayed fluorescence material is a Zn, Cu, Ag, or Au complex.

In some embodiments of the OLED, the delayed fluorescence material has the formula of $M(L^5)(L^6)$, wherein M is Cu, Ag, or Au, $L^5$ and $L^6$ are different, and $L^5$ and $L^6$ are independently selected from the group consisting of:

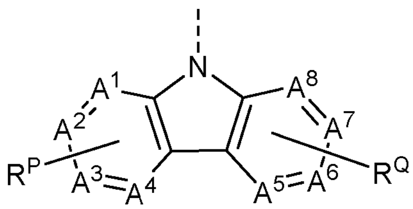

,

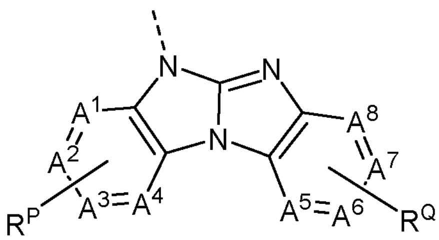

,

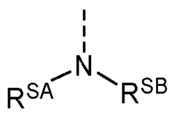

,

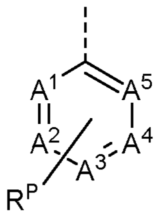

,

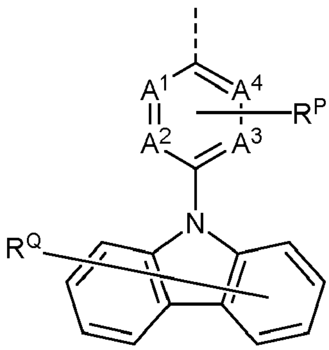

,

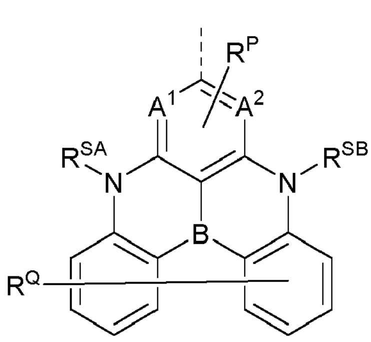

,

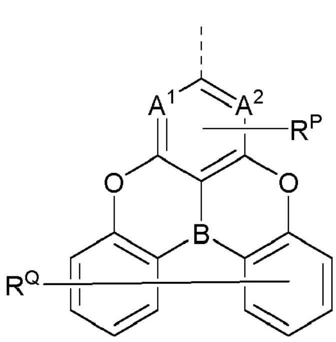

,

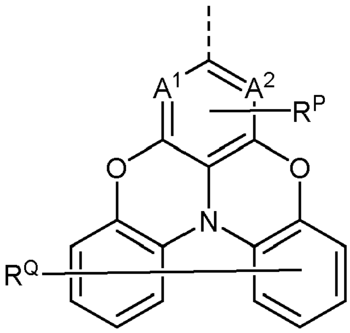,
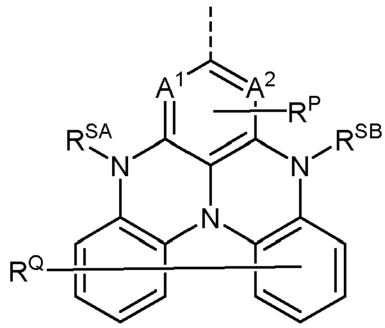,
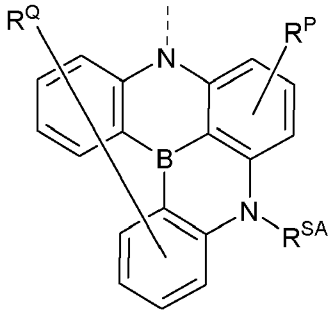,

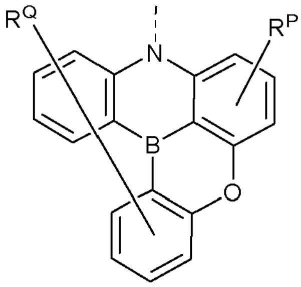,
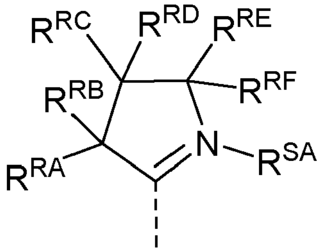,
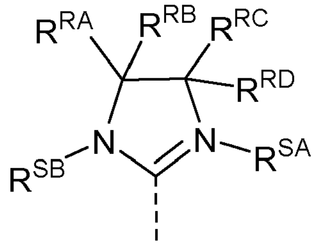,

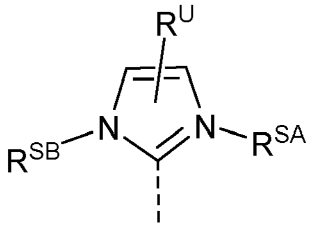,
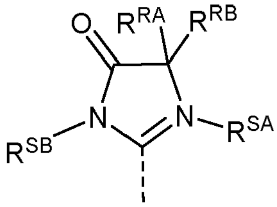,
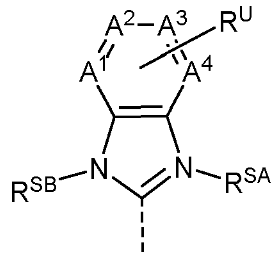,

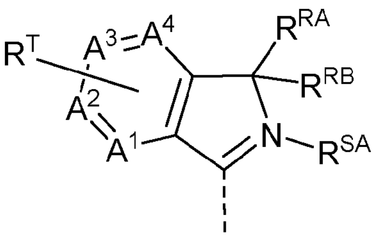,
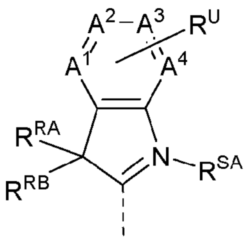,
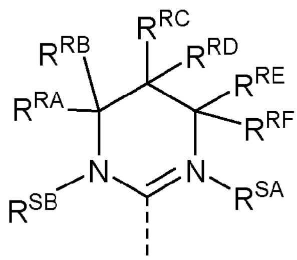,
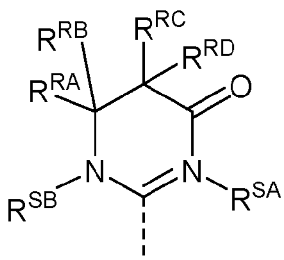,

,
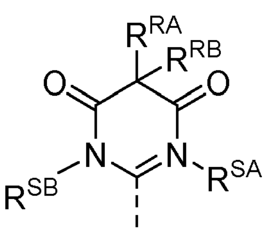,
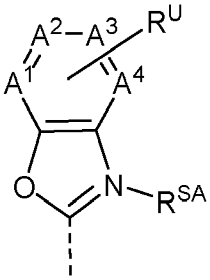,
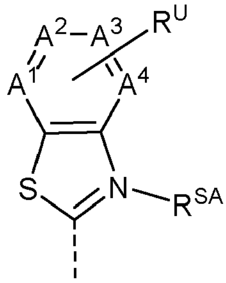,
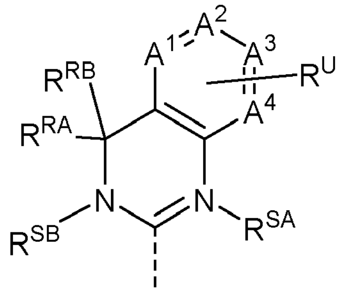,

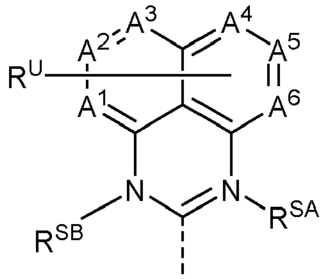, and 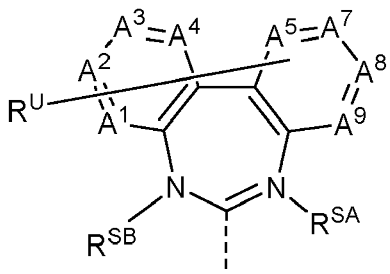;

wherein $A^1$ - $A^9$ are each independently selected from C or N;
each $R^P$, $R^Q$, and $R^U$ independently represents mono-, up to the maximum substitutions, or no substitutions;
wherein each $R^P$, $R^P$, $R^u$, $R^{SA}$, $R^{SB}$, $R^{RA}$, $R^{RB}$, $R^{RC}$, $R^{RD}$, $R^{RE}$, and $R^{RF}$ is independently a hydrogen or a substituent selected from the group consisting of the General Substituents as defined herein; any two substituents can be joined or fused to form a ring.

In some embodiments of the OLED, the delayed fluorescence material comprises at least one of the donor moieties selected from the group consisting of:

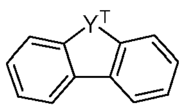, 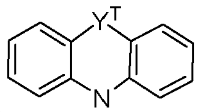, 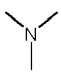, 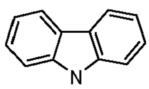, 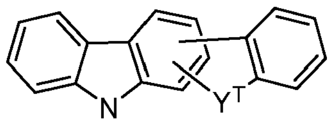,

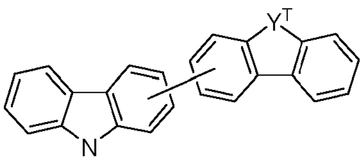, 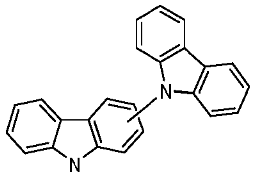, 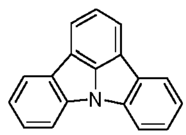, 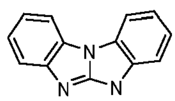, 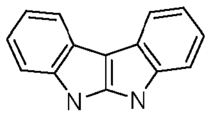,

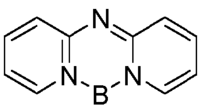, 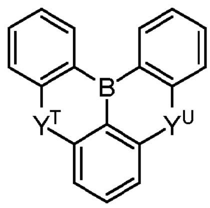, 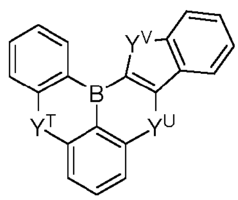, 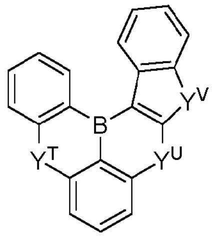, 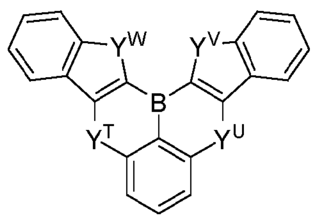,

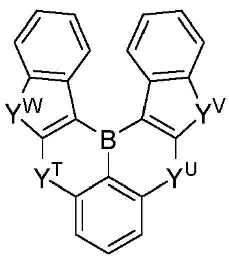, 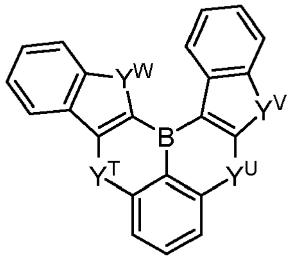, 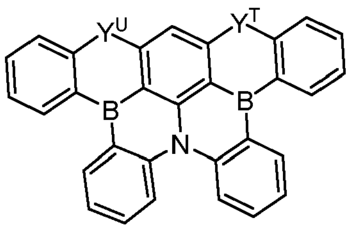, 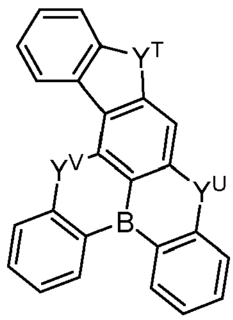,

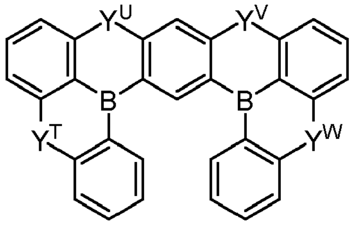, and 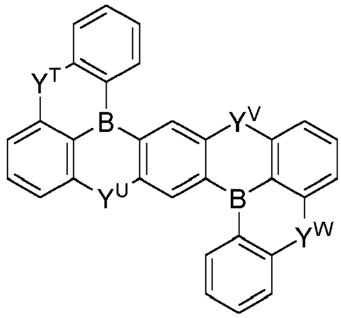;

wherein $Y^T$, $Y^U$, $Y^V$, and $Y^W$ are each independently selected from the group consisting of B, C, Si, Ge, N, P, O, S, Se, C=O, S=O, and $SO_2$.

In some of the above embodiments, any carbon ring atoms up to maximum of a total number of three, together with their substituents, in each phenyl ring of any of above structures can be replaced with N.

In some embodiments, the delayed fluorescence material comprises at least one of the acceptor moieties selected from the group consisting of nitrile, isonitrile, borane, fluoride, pyridine, pyrimidine, pyrazine, triazine, aza-carbazole, aza-dibenzothiophene, aza-dibenzofuran, aza-dibenzoselenophene, aza-triphenylene, imidazole, pyrazole, oxazole, thiazole, isoxazole, isothiazole, triazole, thiadiazole, and oxadiazole. In some embodiments, the acceptor moieties and the donor moieties as described herein can be connected directly, through a conjugated linker, or a non-conjugated linker, such as a $sp^3$ carbon or silicon atom.

In some embodiments, the fluorescent material comprises at least one of the chemical moieties selected from the group consisting of:

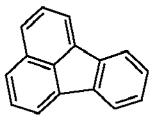, 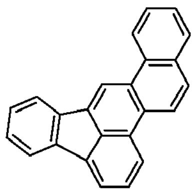, 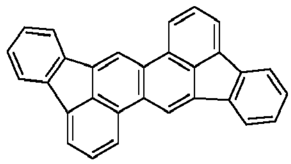, 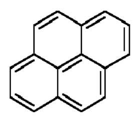, 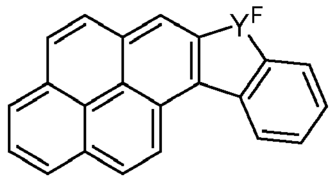,

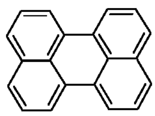, 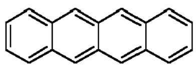, 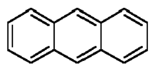, 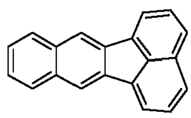, 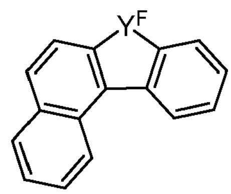, 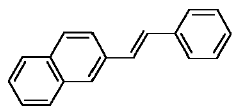,

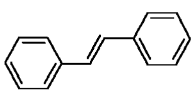, 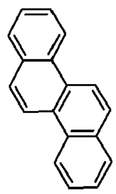, 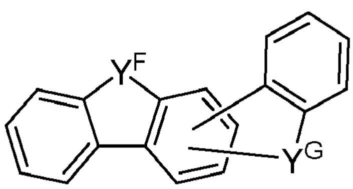, 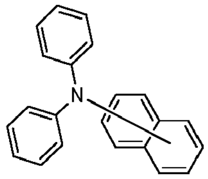, 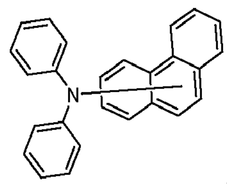,

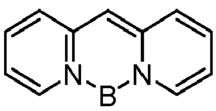, 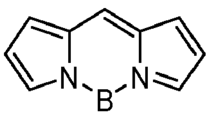, 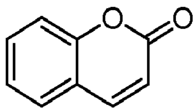, 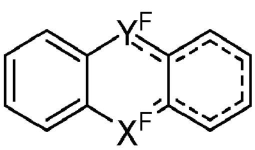, 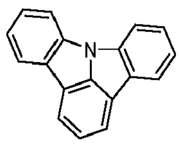,

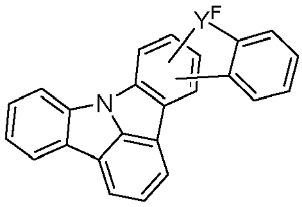,
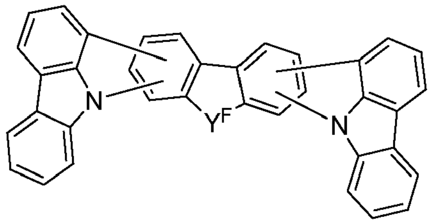,
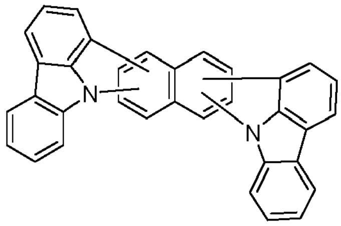,

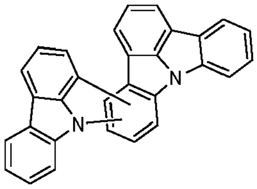,
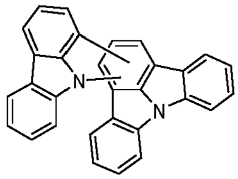,
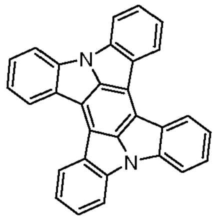,
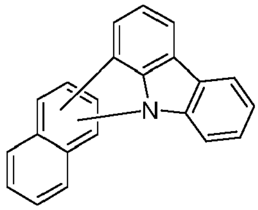,

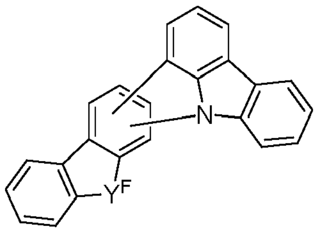,
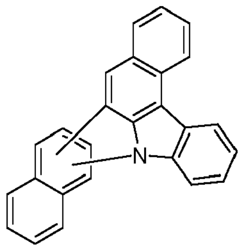,
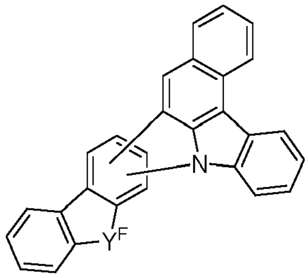,
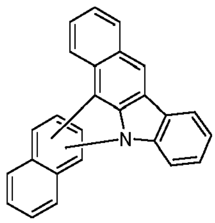,

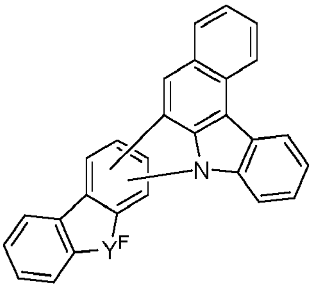,
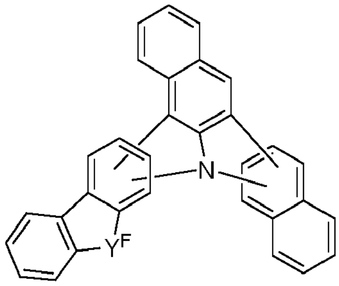,
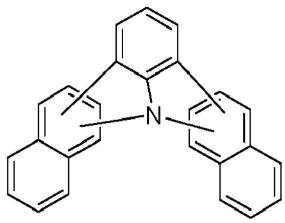,

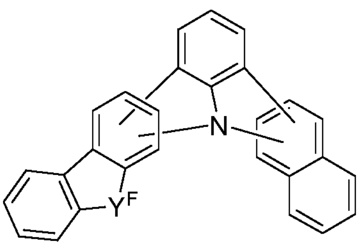,
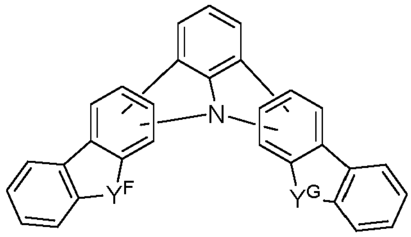,
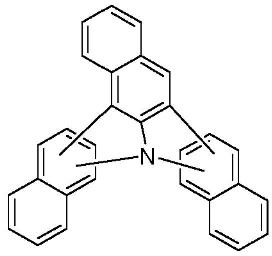,

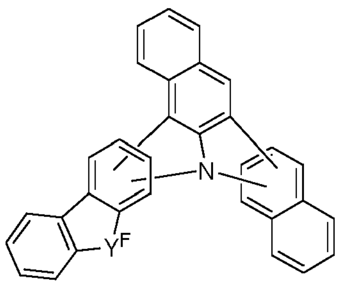
,
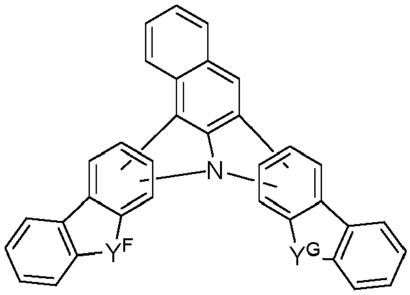
,
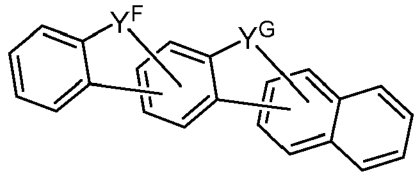
,
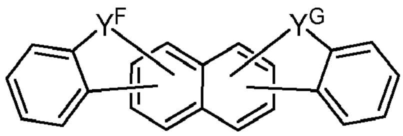
,
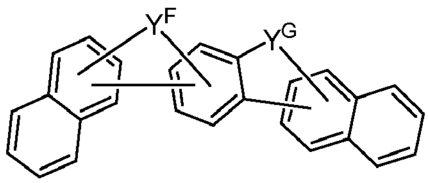
,
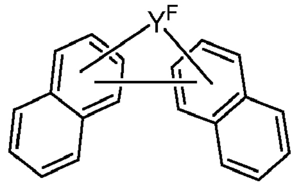
,
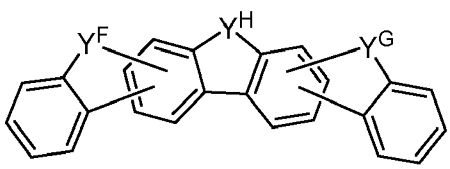
,
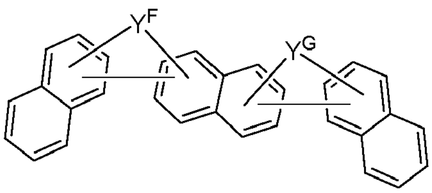
,
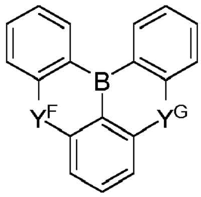
,
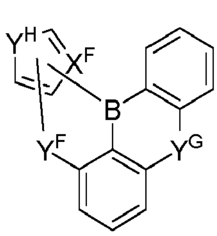
and
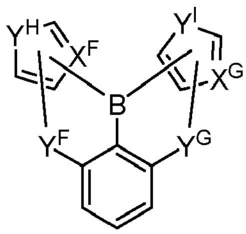
;

wherein $Y^F$, $Y^G$, $Y^H$, and $Y^I$ are each independently selected from the group consisting of B, C, Si, Ge, N, P, O, S, Se, C=O, S=O, and $SO_2$;
wherein $X^F$ and $X^G$ are each independently selected from the group consisting of C and N.

In some of the above embodiments, any carbon ring atoms up to maximum of a total number of three, together with their substituents, in each phenyl ring of any of above structures can be replaced with N.

f) HBL:

A hole blocking layer (HBL) may be used to reduce the number of holes and/or excitons that leave the emissive layer. The presence of such a blocking layer in a device may result in substantially higher efficiencies and/or longer lifetime as compared to a similar device lacking a blocking layer. Also, a blocking layer may be used to confine emission to a desired region of an OLED. In some embodiments, the HBL material has a lower HOMO (further away from the vacuum level) and/or higher triplet energy than one or more of the emitters closest to the HBL interface.
In some embodiments, compound used in HBL contains the same molecule or the same functional groups used as host described above.
In some embodiments, compound used in HBL comprises at least one of the following moieties selected from the group consisting of:

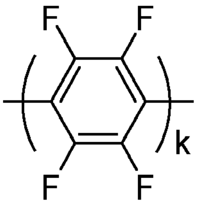, 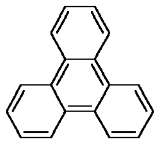, 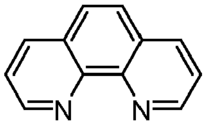, 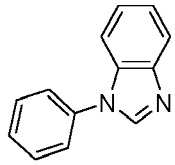, 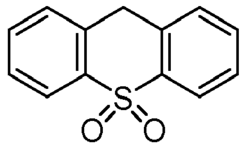,

and

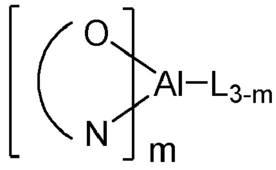;

wherein k is an integer from 1 to 20; $L^{101}$ is another ligand, k' is an integer from 1 to 3.

g) ETL:

Electron transport layer (ETL) may include a material capable of transporting electrons. Electron transport layer may be intrinsic (undoped), or doped. Doping may be used to enhance conductivity. Examples of the ETL material are not particularly limited, and any metal complexes or organic compounds may be used as long as they are typically used to transport electrons.

In some embodiments, compound used in ETL comprises at least one of the following moieties in the molecule:

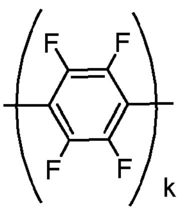, 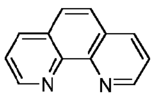, 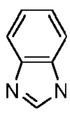, 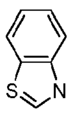, 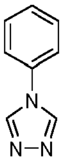, 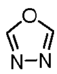, 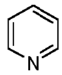, 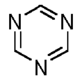. 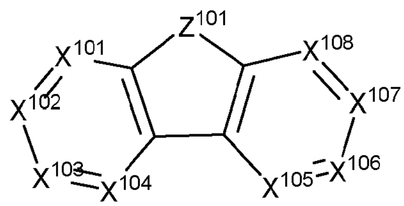,

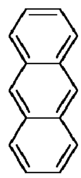,

and fullerenes; wherein k is an integer from 1 to 20, $X^{101}$ to $X^{108}$ is selected from C or N; $Z^{101}$ is selected from the group consisting of C, N, O, and S.

In some embodiments, the metal complexes used in ETL contains, but not limit to the following general formula:

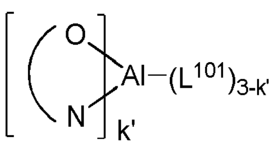 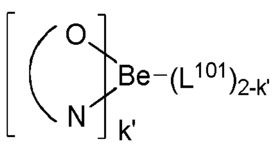 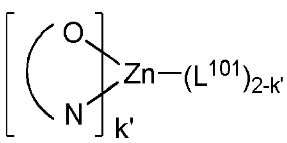 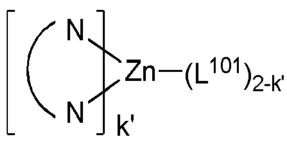

wherein (O-N) or (N-N) is a bidentate ligand, having metal coordinated to atoms O, N or N, N; $L^{101}$ is another ligand; k' is an integer value from 1 to the maximum number of ligands that may be attached to the metal.

In some embodiments, the ETL material is selected from the group consisting of anthracene-benzoimidazole compounds, aza triphenylene derivatives, anthracene-benzothiazole compounds, metal 8-hydroxyquinolates, metal hydroxybenzoquinolates, bathocuprine compounds, 5-member ring electron deficient heterocycles (e.g., triazole, oxadiazole, imidazole, benzoimidazole), silole compounds, arylborane compounds, fluorinated aromatic compounds, fullerene

(e.g., C60), triazine complexes, and Zn (N^N) complexes.

**h) Charge generation layer (CGL)**

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials include n and p conductivity dopants used in the transport layers.

In any of the above-mentioned compounds used in each layer of the OLED device, the hydrogen atoms can be partially or fully deuterated. The minimum amount of hydrogen of the compound being deuterated is selected from the group consisting of 30%, 40%, 50%, 60%, 70%, 80%, 90%, 95%, 99%, and 100%. As used herein, percent deuteration has its ordinary meaning and includes the percent of all possible hydrogen and deuterium atoms that are replaced by deuterium atoms. In some embodiments, the deuterium atoms are attached to an aromatic ring. In some embodiments, the deuterium atoms are attached to a saturated carbon atom, such as an alkyl or cycloalkyl carbon atom. In some other embodiments, the deuterium atoms are attached to a heteroatom, such as Si, or Ge atom.

It is understood that the various embodiments described herein are by way of example only and are not intended to limit the scope of the invention. For example, many of the materials and structures described herein may be substituted with other materials and structures without deviating from the spirit of the invention. The present invention as claimed may therefore include variations from the particular examples and preferred embodiments described herein, as will be apparent to one of skill in the art. It is understood that various theories as to why the invention works are not intended to be limiting.

**E. Experimental Data**

Films for angle dependent photoluminescence are fabricated by vacuum thermal evaporation of 400Å of H doped with 5% of the emitter on UV-ozone pretreated glass substrates. The polarized angle dependent photoluminescence is then measured using a Fluxim Phelos system with a 340 nm or 405 nm excitation source and fit with Setfos software yielding the VDR. The Phelos spectral intensity versus angle is obtained by integrating the wavelength regime over a range which excludes the excitation source scatter.

The fit routine within Setfos is as follows: the optical stack is set up identical to the experiment with a 0.7 mm glass substrate into which the emission is measured, a 40 nm EML film with the emitter, and air as the last layer. The emitter distribution is set as exponential with a position at the top air-EML interface and a width of 50 nm. The integrated p-polarized and s-polarized spectral intensities vs. angle are used as the input targets for the Setfos fit/optimization routine. The fit parameters of the optimization are the: emitter orientation (VDR), emission intensity, and EML refractive index. The resulting VDR from this fit is the reported value where VDR = vertical dipole ratio (0.33 is random, anything less than 0.33 is net horizontally aligned).

Table 1. The VDR values obtained each Host/Emitter combination are as follows:

| Host | Emitter | VDR |
|---|---|---|
| Inventive compound IH-1 | E-1 | 0.39 |
| Comparative compound CH-1 | E-1 | 0.23 |
| Inventive compound IH-2 | E-2 | 0.32 |
| Comparative compound CH-1 | E-2 | 0.13 |
| Inventive compound IH-3 | E-3 | 0.28 |
| Comparative compound CH-1 | E-3 | 0.19 |

The structures of the host and emitter compounds used are shown below:

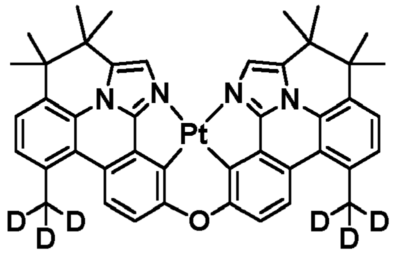

E-1

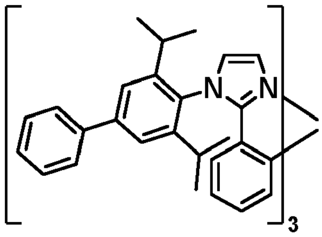

E-2

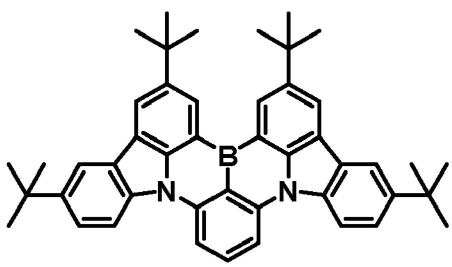

E-3

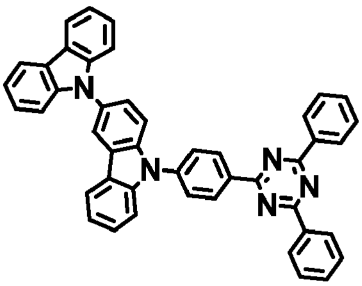

IH-1

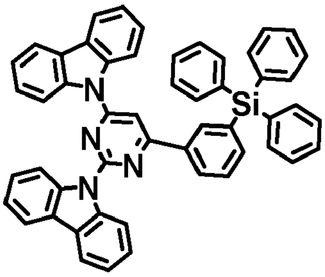

IH-2

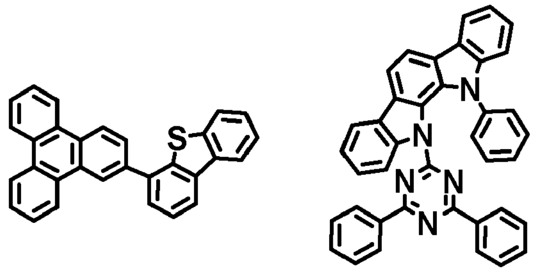

7 : 3

IH-3

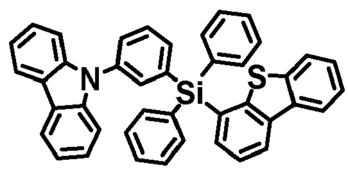

CH-1

The data in Table 1 shows that when the host was switched from comparative compound CH-1 to the inventive compounds IH-1, IH-2, or IH-3, there is an introduction of a novel excited state that allows for the increase in VDR. The overall increase ranges from 0.09 to 0.19 in the examples in Table 1. The overall increase in VDR is beneficial to the efficiency and lifetime of devices that take advantage of vertically aligned dipoles, such as plasmonic and some sensitized devices.

The raw photoluminescence (PL) spectra from these measurements are shown in FIGS. 4A-4C. FIG. 4A shows the PL spectra comparison between host compounds CH-1 and IH-1 for emitter E-1. FIG. 4B shows the PL spectra comparison between host compounds CH-1 and IH-2 for emitter E-2. FIG. 4C shows the PL spectra comparison between host compounds CH-1 and IH-3 for emitter E-3.

A red-shift can be easily spotted in the overall emission of the dopants in these figures when switching from CH-1 to IH-1, IH-2, or IH-3. This red-shift is indicative of an exciplex state forming, and illustrates the host choice leading to the novel excited state characteristics and ultimately the higher device VDR.

The invention is further described by the following numbered aspects:

1. A composition A comprising: a first dopant; and a first host; wherein: the first dopant has a HOMO energy $HOMO_{Dopant}$ and a LUMO energy $LUMO_{Dopant}$; the first host has a HOMO energy $HOMO_{Host}$ and a LUMO energy $LUMO_{Host}$; $|LUMO_{Host} - HOMO_{Dopant}| = X1$; $|LUMO_{Dopant} - HOMO_{Host}| = X2$; the first dopant has an optical bandgap energy, Y; at least one of X1 and X2 is less than or equal to Y + 0.026 eV; the composition A has a vertical dipole ratio VDR(A); composition B is a reference composition comprising the first dopant and a second host, wherein the second host is

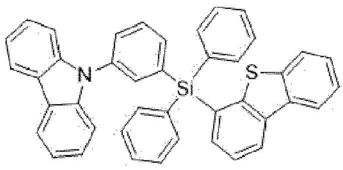

;

the composition B having a vertical dipole ratio VDR(B); the ratio of the first dopant and the first host in the composition A is identical to the ratio of the first dopant and second host in the composition B; and VDR(A) - VDR(B) is $\geq 0.05$.

2. The composition A of aspect 1, wherein the first dopant and the first host form an exciplex when the composition A is used as an emissive layer in an organic light emitting device.

3. The composition A of claim 1, wherein the first dopant is capable of fluorescence, TADF emission, or phosphorescence at room temperature in an organic light emitting device; and/or wherein VDR(A) > 0.33; and/or wherein VDR(B) < 0.33.

4. The composition A of aspect 1, wherein when the composition A is used as an emissive layer in an organic light emitting device, at least the first dopant or the first host of the composition A has an orientation order parameter (S) > 0.

5. The composition A of aspect 1, wherein the first dopant's optical LUMO is within $\pm$ 0.05 eV of the electrochemical LUMO of at least the first dopant or the first host of the composition A.

6. The composition A of aspect 1, wherein the first dopant's optical LUMO is at least 0.026 eV greater than electrochemical LUMO of at least the first dopant or the first host of the composition A.

7. The composition A of aspect 1, wherein at least the first dopant or the first host of the composition A has rod-like metric R > 0.3; and/or wherein at least the first dopant or the first host of the composition A has disk-like metric D > 0.3; and/or wherein at least the first dopant or the first host of the composition A has a sphericity < 0.5; and/or wherein the first host has steric factor SF > 0.5; and/or wherein the first dopant has SF > 0.5.

8. The composition A of aspect 3, wherein the first dopant capable of fluorescence at room temperature in an OLED comprises at least one of the chemical moieties selected from the group consisting of:

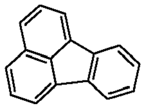, 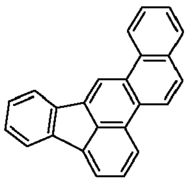, 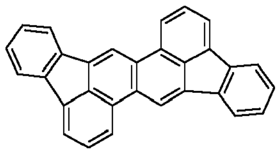, 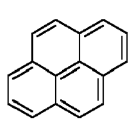, 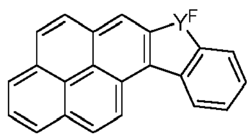, 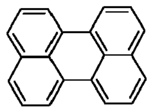,

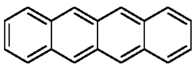, 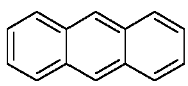, 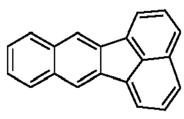, 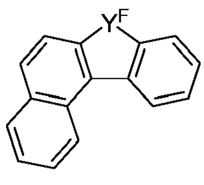, 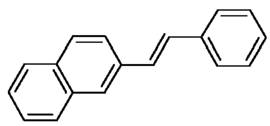,

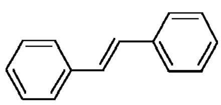, 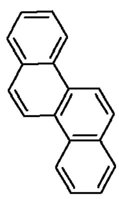, 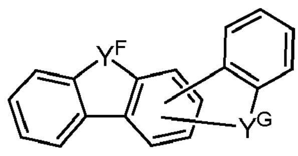, 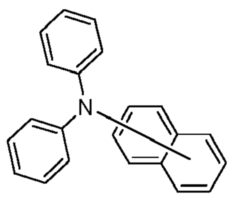, 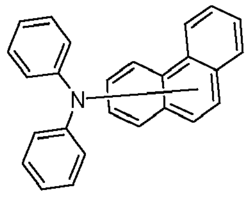,

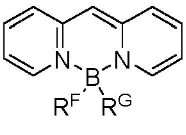 , 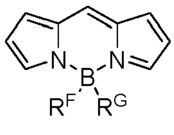 , 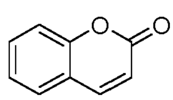 , 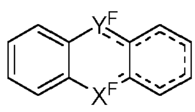 , 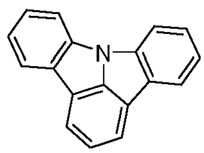 ,

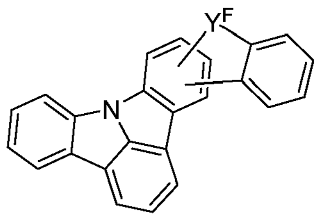 , 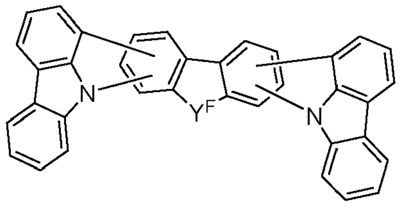 , 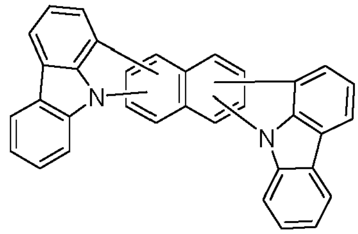 ,

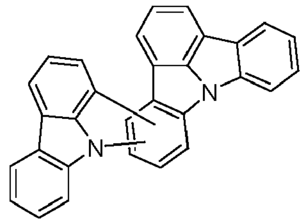 , 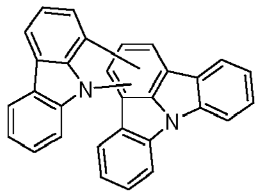 , 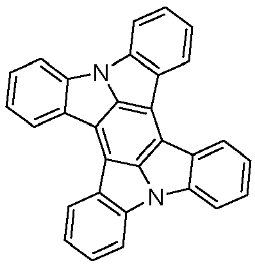 , 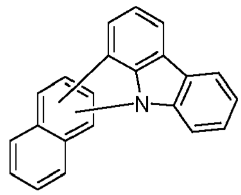 ,

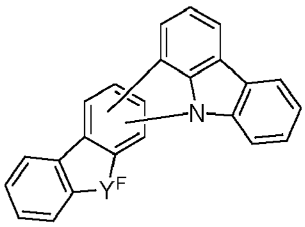 , 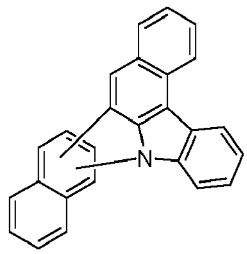 , 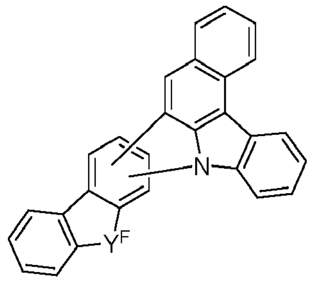 , 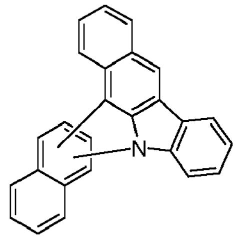 ,

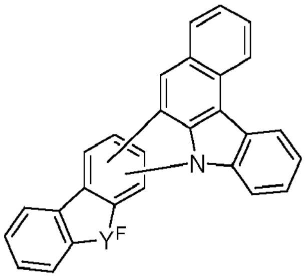 , 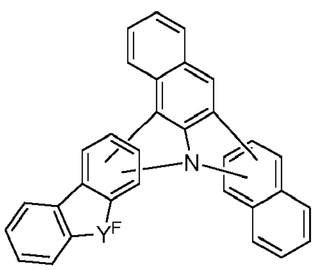 , 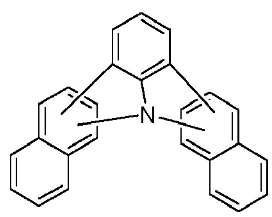 ,

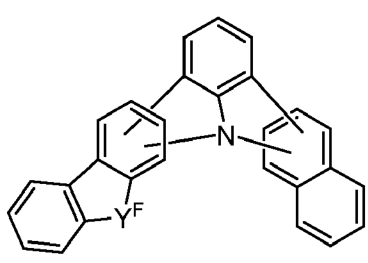 , 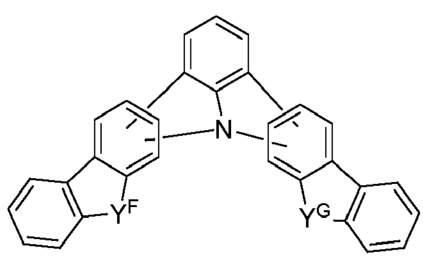 , 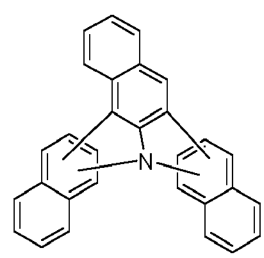 ,

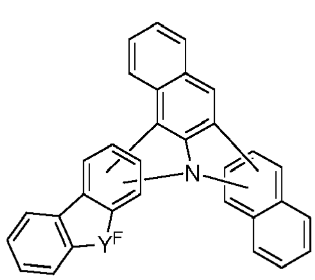,
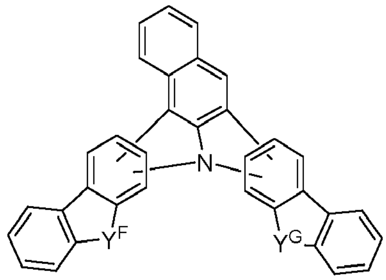,
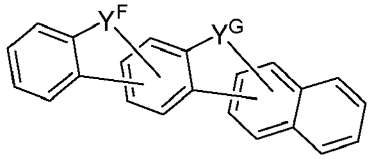,

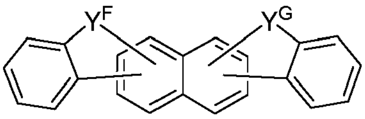,
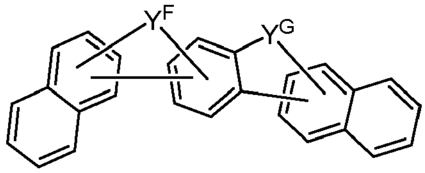,
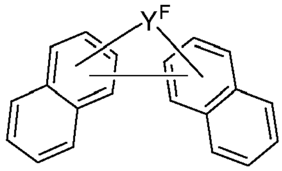,

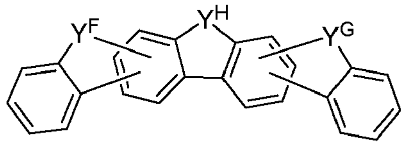,
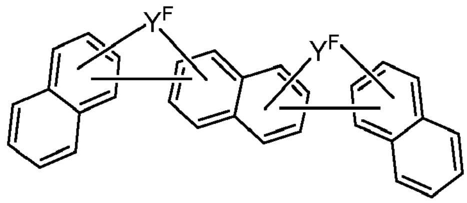,
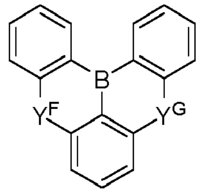,

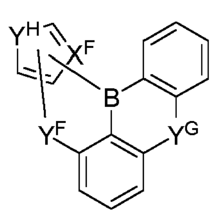
and
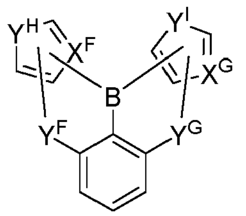

wherein $Y^F$, $Y^G$, $Y^H$, and $Y^I$ are each independently selected from the group consisting of BR, NR, PR, O, S, Se, C=O, S=O, $SO_2$, BRR', CRR', SiRR', and GeRR'; wherein $X^F$ and $Y^G$ are each independently selected from the group consisting of C and N; and wherein $R^F$, $R^G$, R, and R' are each independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, selenyl, sulfinyl, sulfonyl, phosphino, and combinations thereof.

9. The composition A of aspect 3, wherein the first dopant capable of fluorescence at room temperature in an organic light emitting device can be selected from the group consisting of the structures of LIST A as defined herein above; wherein $Y^{F1}$ to $Y^{F4}$ are each independently selected from O, S, and $NR^{F1}$; wherein $R^{F1}$ and $R^{1S}$ to $R^{9S}$ each independently represents from mono to maximum possible number of substitutions, or no substitution; and wherein $R^{F1}$ and $R^{1S}$ to $R^{9S}$ are each independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, selenyl, sulfinyl, sulfonyl, phosphino, and combinations thereof; and any two substituents can be joined or fused to form a ring.

10. The composition A of aspect 3, wherein the first dopant capable of TADF emission at room temperature in an organic light emitting device comprises at least one of the chemical moieties selected from the group consisting of:

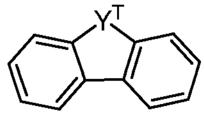, 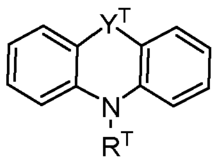, 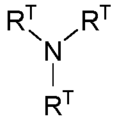, 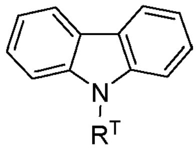, 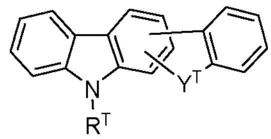,

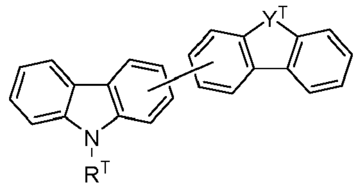, 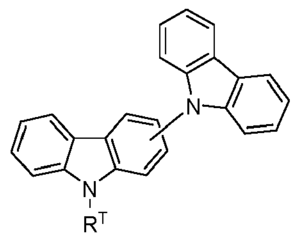, 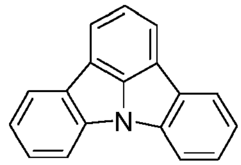, 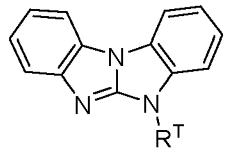,

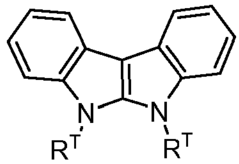, 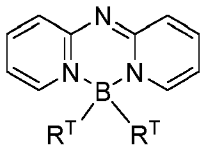, 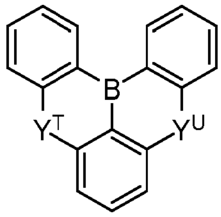, 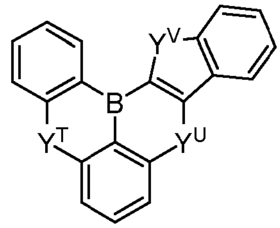, 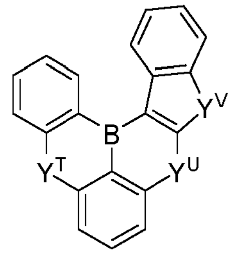,

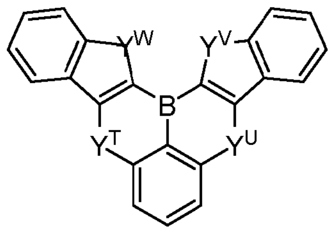, 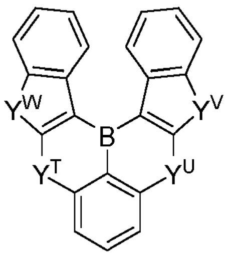, 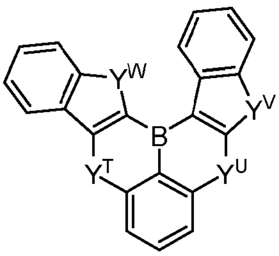, 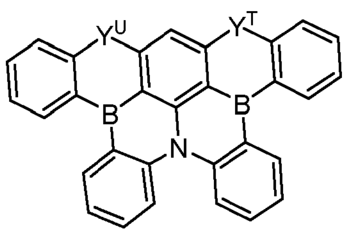,

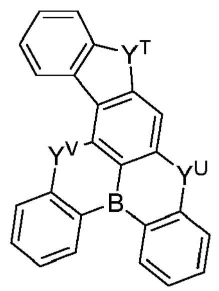, 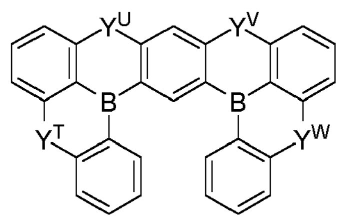, and 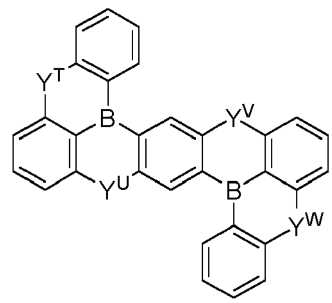;

wherein $Y^T$, $Y^U$, $Y^V$, and $Y^W$ are each independently selected from the group consisting of BR, NR, PR, O, S, Se, C=O, S=O, $SO_2$, BRR', CRR', SiRR', and GeRR'; wherein each $R^T$ can be the same or different and each $R^T$ is independently a donor, an acceptor group, an organic linker bonded to a donor, an organic linker bonded to an acceptor group, or a terminal group selected from the group consisting of alkyl, cycloalkyl, heteroalkyl, heterocycloalkyl, arylalkyl, aryl, heteroaryl, and combinations thereof; and R, and R' are each independently a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof.

11. The composition A of aspect 3, wherein the first dopant capable of phosphorescence at room temperature in an organic light emitting device has the formula of $M(L^1)_x(L^2)_y(L^3)_z$; wherein M is selected from the group consisting of Ir, Rh, Re, Ru, Os, Pt, Pd, Au, and Cu; wherein $L^1$, $L^2$, and $L^3$ can be the same or different; wherein x is 1, 2, or 3; wherein y is 0, 1, or 2; wherein z is 0, 1, or 2; wherein x+y+z is the oxidation state of the metal M; wherein $L^1$ is selected from the group consisting of the structures in LIGAND LIST B as defined herein above; wherein $L^2$ and $L^3$ are independently selected from the group consisting of

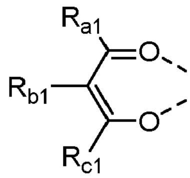

,

and the structures of the LIGAND LIST B; wherein: T is selected from the group consisting of B, Al, Ga, and In; $K^{1'}$ is a direct bond or is selected from the group consisting of $NR_e$, $PR_e$, O, S, and Se; each $Y^1$ to $Y^{13}$ are independently selected from the group consisting of carbon and nitrogen; Y' is selected from the group consisting of $BR_e$, $NR_e$, $PR_e$, O, S, Se, C=O, S=O, $SO_2$, $CR_eR_f$, $SiR_eR_f$, and $GeR_eR_f$; $R_e$ and $R\varepsilon$ can be fused or joined to form a ring; each $R_a$, $R_b$, $R_c$, and $R_d$ can independently represent from mono to the maximum possible number of substitutions, or no substitution; each $R_{a1}$, $R_{b1}$, $R_{c1}$, $R_{d1}$, $R_a$, $R_b$, $R_c$, $R_d$, $R_e$, and $R_f$ is independently a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; and wherein any two of $R_{a1}$, $R_{b1}$, $R_{c1}$, $R_{d1}$, $R_a$, $R_b$, $R_c$, and $R_d$ can be fused or joined to form a ring or form a multidentate ligand.

12. The composition A of aspect 3, wherein the first dopant capable of phosphorescence at room temperature in an organic light emitting device has the formula selected from the group consisting of the structures of LIST C as defined herein above, wherein: each of $X^{96}$ to $X^{99}$ is independently C or N; each $Y^{100}$ is independently selected from the group consisting of a NR", O, S, and Se; L is independently selected from the group consisting of a direct bond, BR", BR"R"', NR", PR", O, S, Se, C=O, C=S, C=Se, C=NR", C=CR"R"', S=O, $SO_2$, CR", CR"R"', SiR"R"', GeR"R"', alkyl, cycloalkyl, aryl, heteroaryl, and combinations thereof; $X^{100}$ for each occurrence is selected from the group consisting of O, S, Se, NR", and CR"R"'; each $R^{10a}$, $R^{20a}$, $R^{30a}$, $R^{40a}$, and $R^{50a}$, $R^{A"}$, $R^{B"}$, $R^{C"}$, $R^{D"}$, $R^{E"}$, and $R^{F"}$ independently represents mono-, up to the maximum substitutions, or no substitutions; each of R, R', R", R"', $R^{10a}$, $R^{11a}$ $R^{12a}$, $R^{13a}$, $R^{20a}$, $R^{30a}$, $R^{40a}$, $R^{50a}$, $R^{60}$, $R^{70}$, $R^{97}$, $R^{98}$, $R^{99}$, $R^{A1'}$, $R^{A2'}$, $R^{A"}$, $R^{B"}$, $R^{C"}$, $R^{D"}$ $R^{E"}$, $R^{F"}$, $R^{G"}$, $R^{H"}$, $R^{I"}$, $R^{J"}$, $R^{K"}$, $R^{L"}$, $R^{M"}$, and $R^{N"}$ is independently a hydrogen or a substituent selected from the group consisting of deuterium, halide, alkyl, cycloalkyl, heteroalkyl, arylalkyl, alkoxy, aryloxy, amino, silyl, germyl, boryl, selenyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, combinations thereof.

13. The composition A of aspect 1, wherein the first host can be selected from the group consisting of the structures of HOST Group 1 as defined herein above;
wherein: each of $J_1$ to $J_6$ is independently C or N; L' is a direct bond or an organic linker; each $Y^{AA}$, $Y^{BB}$, $Y^{CC}$, and $Y^{DD}$ is independently selected from the group consisting of absent a bond, direct bond, O, S, Se, CRR', SiRR', GeRR', NR, BR, BRR'; each of $R^{A'}$, $R^{B'}$, $R^{C'}$, $R^{D'}$, $R^{E'}$, $R^{F'}$, and $R^{G'}$ independently represents mono, up to the maximum substitutions, or no substitutions; each R, R', $R^{A'}$, $R^{B'}$, $R^{C'}$, $R^{D'}$, $R^{E'}$, $R^{F'}$, and $R^{G'}$ is independently a hydrogen or a substituent selected from the group consisting of the General Substituents as defined herein; any two substituents can be joined or fused to form a ring; and where possible, each unsubstituted aromatic carbon atom is optionally replaced with N to form an aza-substituted ring.

14. An organic light emitting device (OLED) comprising: an anode; a cathode; and an organic layer disposed between the anode and the cathode, wherein the organic layer comprises a composition according to aspect 1.

15. The OLED of aspect 14, wherein the organic layer further comprises an additional host, wherein the additional host comprises at least one chemical moiety selected from the group consisting of triphenylene, carbazole, indolocarbazole, dibenzothiophene, dibenzofuran, dibenzoselenophene, $5\lambda^2$-benzo [d]benzo[4,5]imidazo[3,2-a]imidazole, 5,9-dioxa-13b-boranaphtho[3,2,1-de]anthracene, azaborinine, oxaborinine, dihydroacridine, xanthene, dihydrobenzoazasiline, dibenzooxasiline, phenoxazine, phenoxathiine, phenothiazine, dihydrophenazine, fluorene, naphthalene, anthracene, phenanthrene, phenanthroline, benzoquinoline, quinoline, isoquinoline, quinazoline, pyrimidine, pyrazine, pyridine, triazine, boryl, silyl, aza-triphenylene, aza-carbazole, aza-indolocarbazole, aza-dibenzothiophene, aza-dibenzofuran, aza-dibenzoselenophene, aza-5$\lambda^2$-benzo[d]benzo[4,5]imidazo[3,2-a]imidazole, and aza-(5,9-dioxa-13b-boranaphtho[3,2,1-de] anthracene).

16. The OLED of aspect 14 or 15, wherein the organic layer further comprises an additional host, wherein the additional host is selected from the group consisting of the structures of the HOST Group 1 as defined herein above. wherein: each of $J_1$ to $J_6$ is independently C or N; L' is a direct bond or an organic linker; each $Y^{AA}$, $Y^{BB}$, $Y^{CC}$, and $Y^{DD}$ is independently selected from the group consisting of absent a bond, direct bond, O, S, Se, CRR', SiRR', GeRR', NR, BR, BRR'; each of $R^{A'}$, $R^{B'}$, $R^{C'}$, $R^{D'}$, $R^{E'}$, $R^{F'}$, and $R^{G'}$ independently represents mono, up to the maximum substitutions, or no substitutions; each R, R', $R^{A'}$, $R^{B'}$, $R^{C'}$, $R^{D'}$, $R^{E'}$, $R^{F'}$, and $R^{G'}$ is independently a hydrogen or a substituent selected from the group consisting of the General Substituents as defined herein; any two substituents can be joined or fused to form a ring; and where possible, each unsubstituted aromatic carbon atom is optionally replaced with N to form an aza-substituted ring.

17. The OLED of any one of aspects 14 to 16, wherein at least one of the anode, the cathode, or a new layer disposed over the organic layer functions as an enhancement layer, wherein the layer that functions as the enhancement layer comprises a plasmonic material exhibiting surface plasmon resonance that non-radiatively couples to the emitter material and transfers excited state energy from the first dopant to non-radiative mode of surface plasmon polariton.

18. The OLED of any one of aspects 14 to 17, further comprising an outcoupling layer that scatters the energy from the surface plasmon polaritons.

19. A consumer product comprising an organic light-emitting device comprising: an anode; a cathode; and an organic layer disposed between the anode and the cathode, wherein the organic layer comprises a composition according to any one of aspects 1 to 13.

20. A formulation comprising a composition according to any one of aspects 1 to 13.

## Claims

**1.** A composition A comprising:

a first dopant; and
a first host;
wherein: the first dopant has a HOMO energy $HOMO_{Dopant}$ and a LUMO energy $LUMO_{Dopant}$;
the first host has a HOMO energy $HOMO_{Host}$ and a LUMO energy $LUMO_{Host}$;
$|LUMO_{Host} - HOMO_{Dopant}| = X1$;
$|LUMO_{Dopant} - HOMO_{Host}| = X2$;
the first dopant has an optical bandgap energy, Y;
at least one of X1 and X2 is less than or equal to Y + 0.026 eV;
the composition A has a vertical dipole ratio VDR(A);
composition B is a reference composition comprising the first dopant and a second host, wherein the second host is

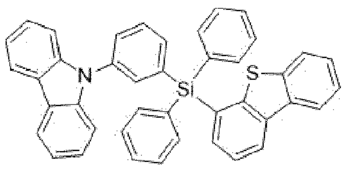

;

the composition B having a vertical dipole ratio VDR(B);
the ratio of the first dopant and the first host in the composition A is identical to the ratio of the first dopant and second host in the composition B; and
VDR(A) - VDR(B) is $\geq 0.05$.

2. The composition A of claim 1, wherein the first dopant and the first host form an exciplex when the composition A is used as an emissive layer in an organic light emitting device.

3. The composition A of claim 1, wherein the first dopant is capable of fluorescence, TADF emission, or phosphorescence at room temperature in an organic light emitting device; and/or

wherein VDR(A) > 0.33; and/or
wherein VDR(B) < 0.33.

4. The composition A of claim 1, wherein when the composition A is used as an emissive layer in an organic light emitting device, at least the first dopant or the first host of the composition A has an orientation order parameter (S) > 0.

5. The composition A of claim 1, wherein the first dopant's optical LUMO is within ± 0.05 eV of the electrochemical LUMO of at least the first dopant or the first host of the composition A.

6. The composition A of claim 1, wherein the first dopant's optical LUMO is at least 0.026 eV greater than electrochemical LUMO of at least the first dopant or the first host of the composition A.

7. The composition A of claim 1, wherein at least the first dopant or the first host of the composition A has rod-like metric R > 0.3; and/or

wherein at least the first dopant or the first host of the composition A has disk-like metric D > 0.3; and/or
wherein at least the first dopant or the first host of the composition A has a sphericity < 0.5; and/or
wherein the first host has steric factor SF > 0.5; and/or
wherein the first dopant has SF > 0.5.

8. The composition A of claim 3, wherein the first dopant capable of fluorescence at room temperature in an OLED comprises at least one of the chemical moieties selected from the group consisting of:

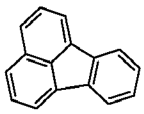 , 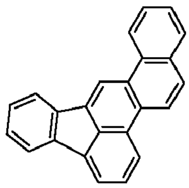 , 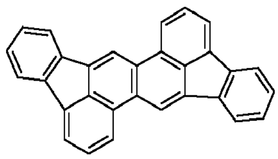 , 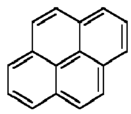 , 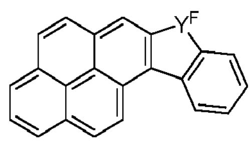 , 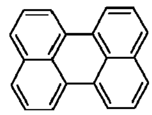 ,

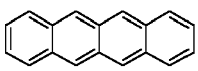 , 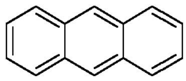 , 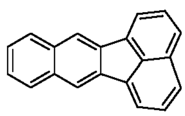 , 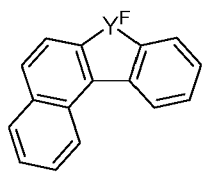 , 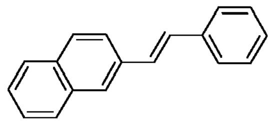 ,

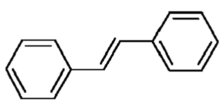 , 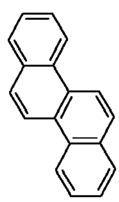 , 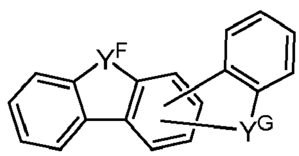 , 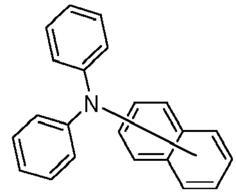 , 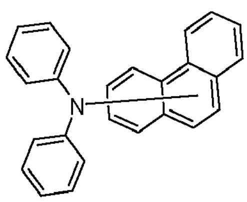 ,

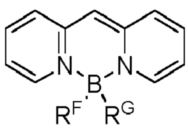 , 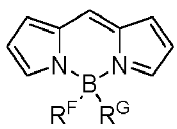 , 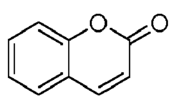 , 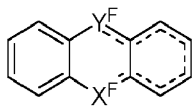 , 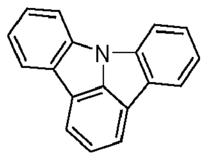 ,

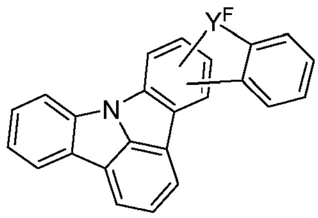,
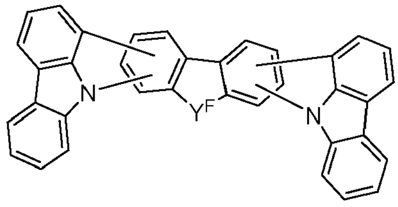,
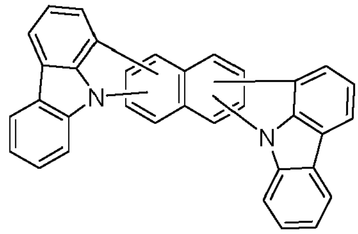,

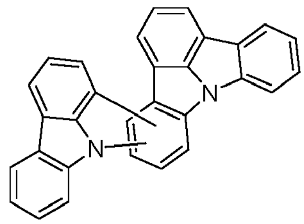,
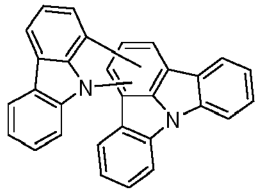,
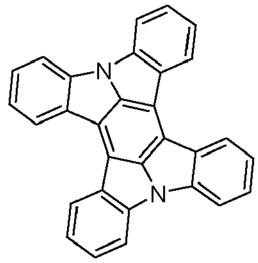,
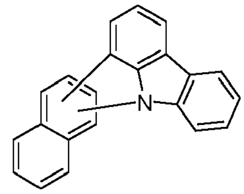,

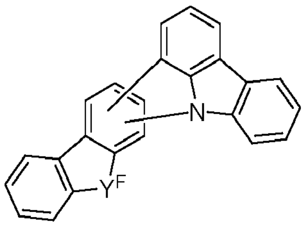,
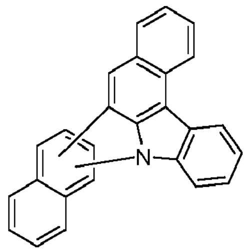,
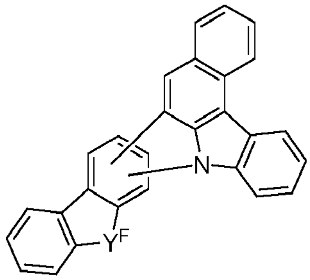,
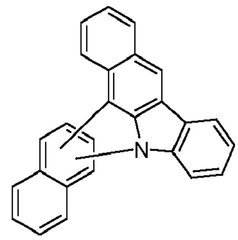,

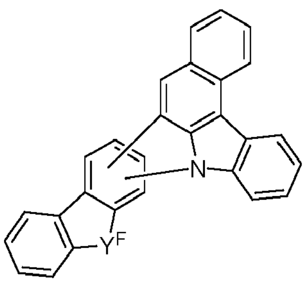,
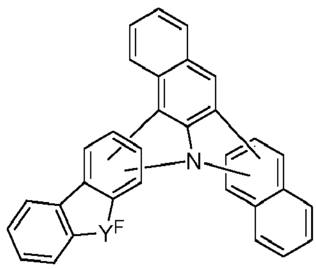,
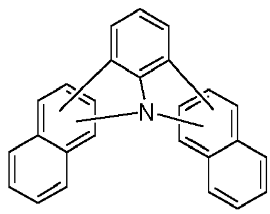,

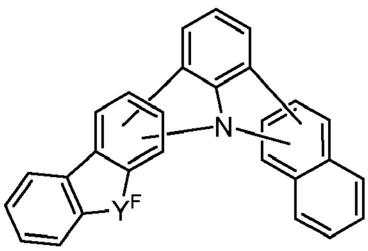,
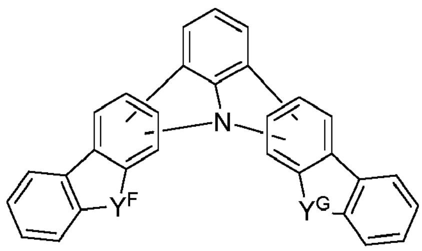,
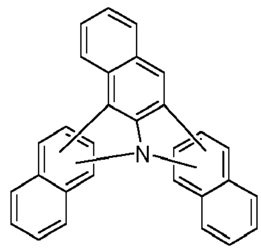,

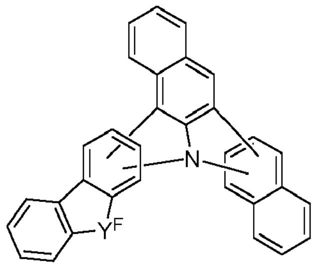 , 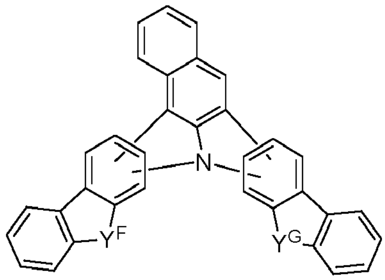 , 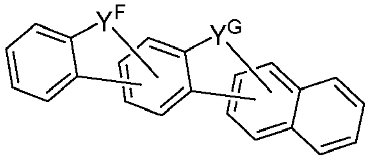 ,

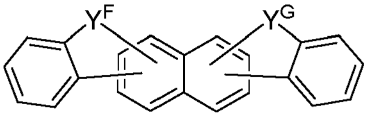 , 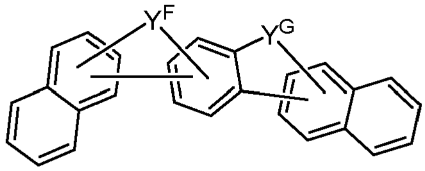 , 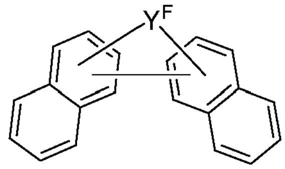 ,

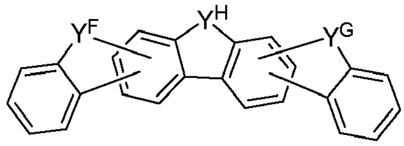 , 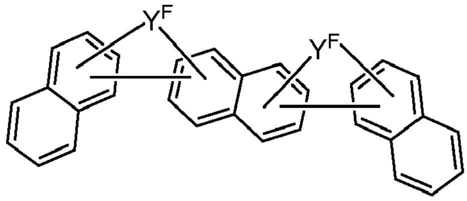 , 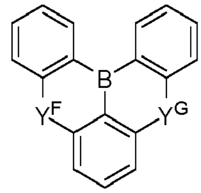 ,

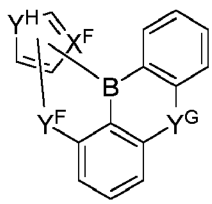 and 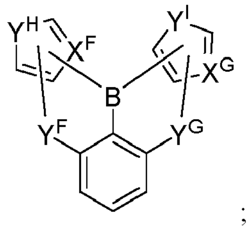 ;

wherein $Y^F$, $Y^G$, $Y^H$, and $Y^I$ are each independently selected from the group consisting of BR, NR, PR, O, S, Se, C=O, S=O, $SO_2$, BRR', CRR', SiRR', and GeRR';
wherein $X^F$ and $Y^G$ are each independently selected from the group consisting of C and N; and
wherein $R^F$, $R^G$, R, and R' are each independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, selenyl, sulfinyl, sulfonyl, phosphino, and combinations thereof.

**9.** The composition A of claim 3, wherein the first dopant capable of TADF emission at room temperature in an organic light emitting device comprises at least one of the chemical moieties selected from the group consisting of:

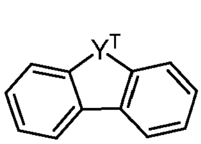 , 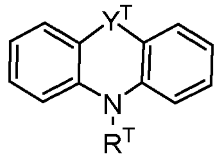 , 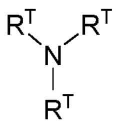 , 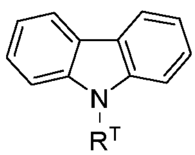 , 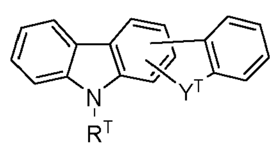 ,

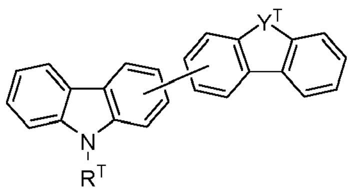 , 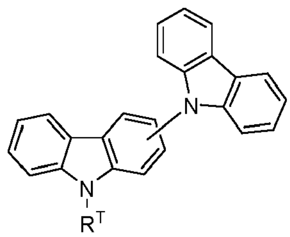 , 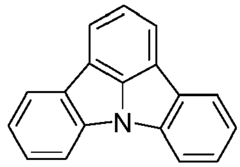 , 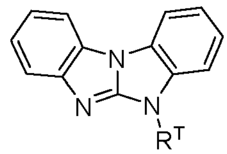 ,

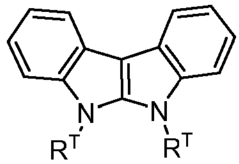 , 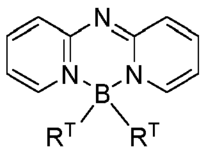 , 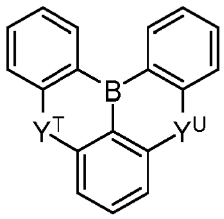 , 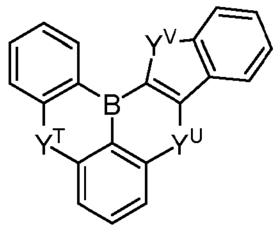 , 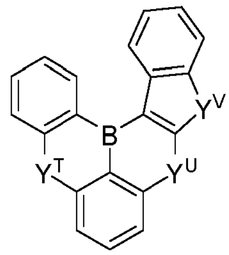 ,

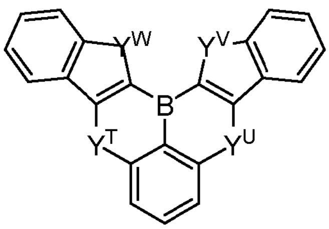 , 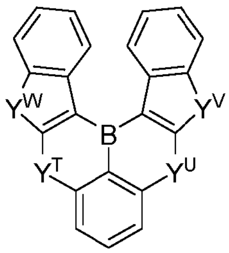 , 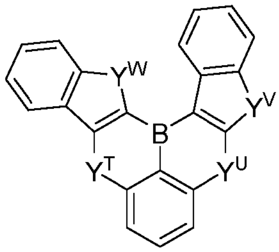 , 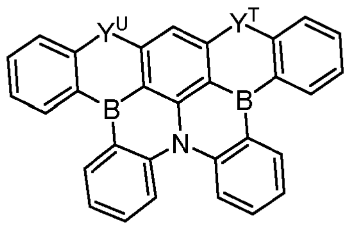 ,

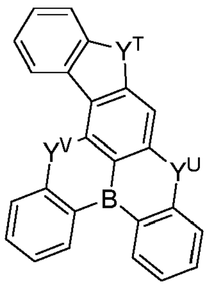 , 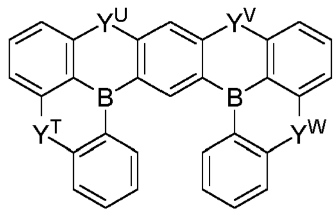 , and 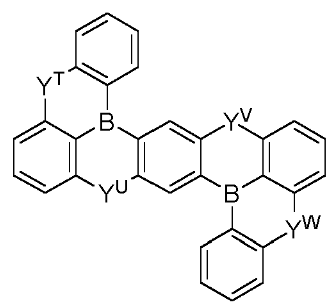 ;

wherein $Y^T$, $Y^U$, $Y^V$, and $Y^W$ are each independently selected from the group consisting of BR, NR, PR, O, S, Se, C=O, S=O, $SO_2$, BRR', CRR', SiRR', and GeRR';

wherein each $R^T$ can be the same or different and each $R^T$ is independently a donor, an acceptor group, an organic linker bonded to a donor, an organic linker bonded to an acceptor group, or a terminal group selected from the group consisting of alkyl, cycloalkyl, heteroalkyl, heterocycloalkyl, arylalkyl, aryl, heteroaryl, and combinations thereof; and

R, and R' are each independently a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof.

**10.** The composition A of claim 3, wherein the first dopant capable of phosphorescence at room temperature in an organic light emitting device has the formula of $M(L^1)_x(L^2)_y(L^3)_z$;

wherein M is selected from the group consisting of Ir, Rh, Re, Ru, Os, Pt, Pd, Au, and Cu;

wherein $L^1$, $L^2$, and $L^3$ can be the same or different;

wherein x is 1, 2, or 3;

wherein y is 0, 1, or 2;

wherein z is 0, 1, or 2;

wherein x+y+z is the oxidation state of the metal M;

wherein $L^1$ is selected from the group consisting of the structures in the following LIGAND LIST B:

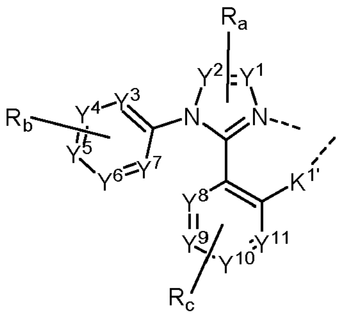,
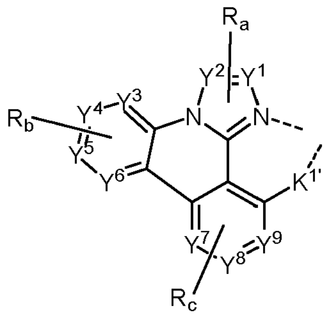,
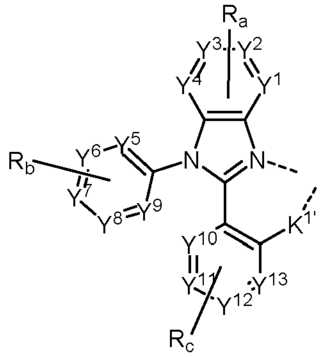,
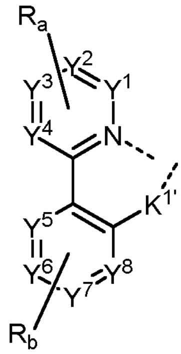,
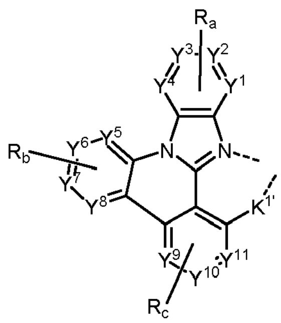,
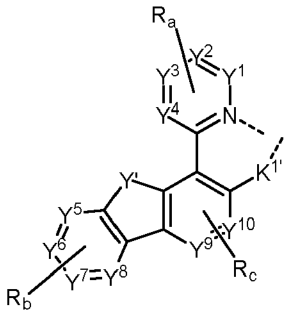,
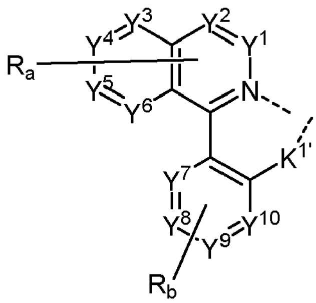,
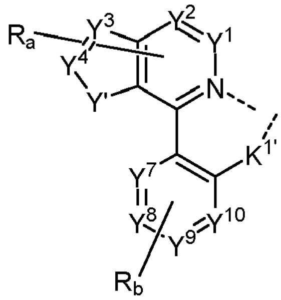,
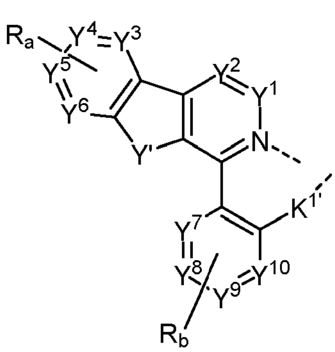,
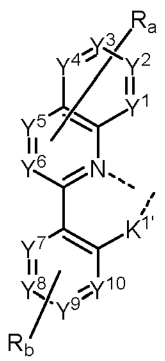,
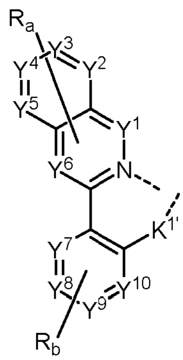,
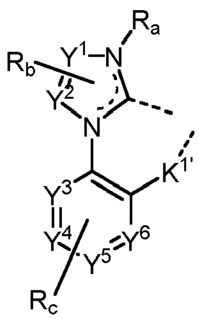,
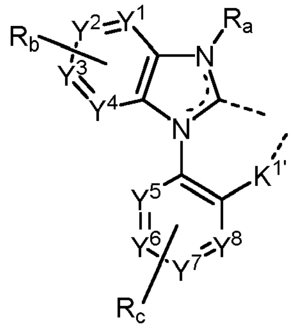,
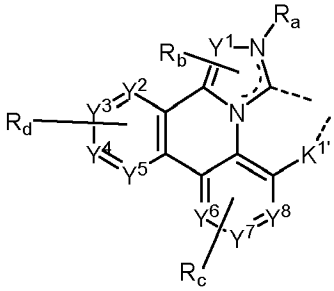,
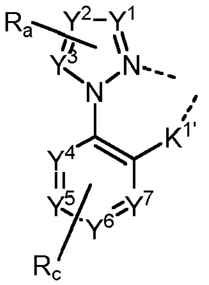,
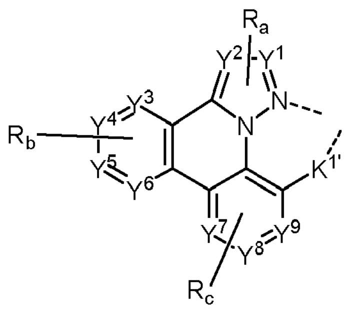,
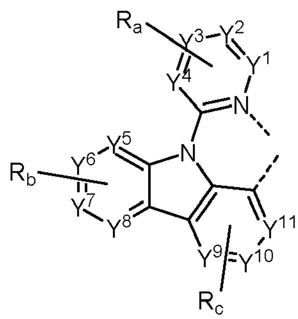,

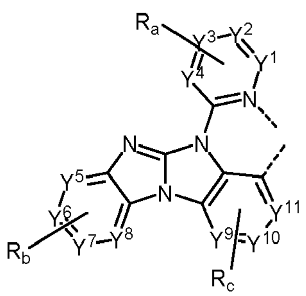, 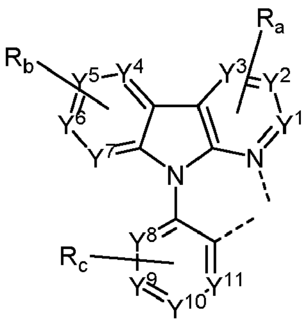, 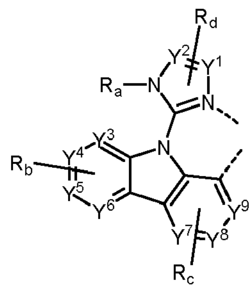, 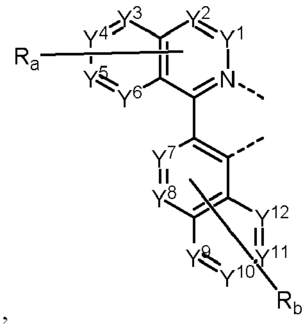,

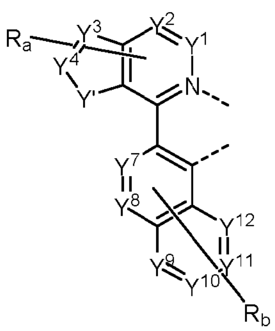, 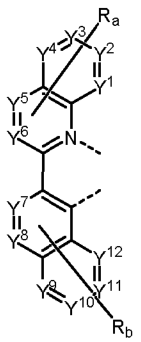, 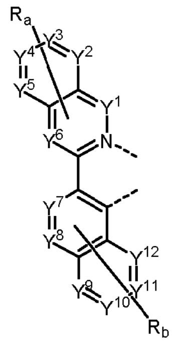, 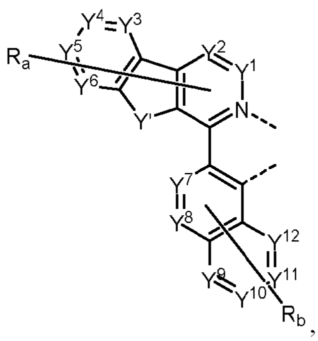, 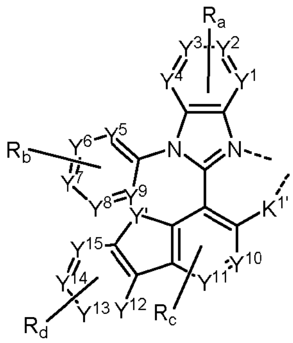,

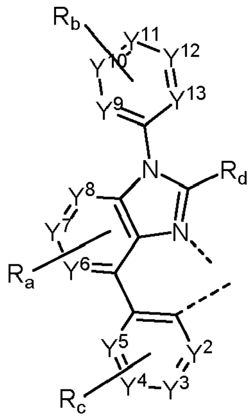, 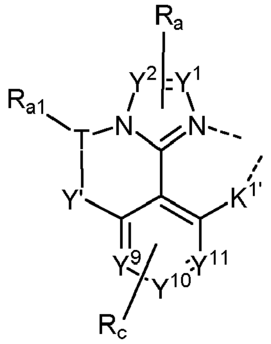, 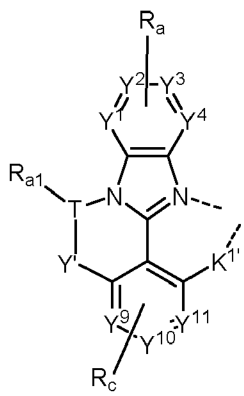, 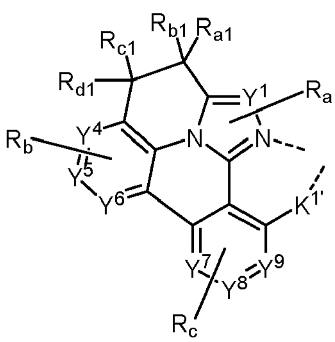,

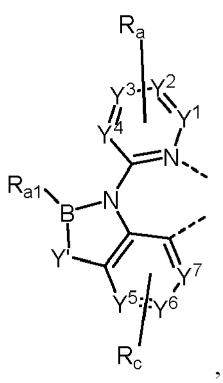, 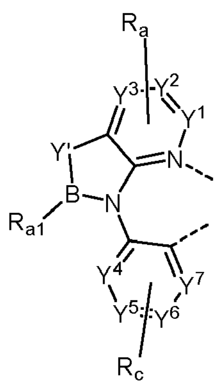, 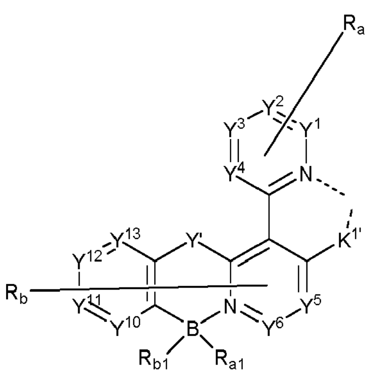, and 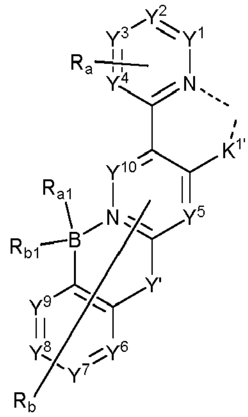;

wherein $L^2$ and $L^3$ are independently selected from the group consisting of

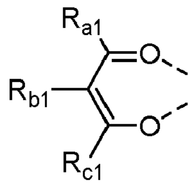

,

and the structures of the LIGAND LISTB; wherein:

T is selected from the group consisting of B, Al, Ga, and In;

$K^{1'}$ is a direct bond or is selected from the group consisting of $NR_e$, $PR_e$, O, S, and Se;

each $Y^1$ to $Y^{13}$ are independently selected from the group consisting of carbon and nitrogen;

Y' is selected from the group consisting of $BR_e$, $NR_e$, $PR_e$, O, S, Se, C=O, S=O, $SO_2$, $CR_eR_f$, $SiR_eR_f$, and $GeR_eR_f$;

$R_e$ and $R_f$ can be fused or joined to form a ring;

each $R_a$, $R_b$, $R_c$, and $R_d$ can independently represent from mono to the maximum possible number of substitutions, or no substitution;

each $R_{a1}$, $R_{b1}$, $R_{c1}$, $R_{d1}$, $R_a$, $R_b$, $R_c$, $R_d$, $R_e$, and $R_f$ is independently a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; and

wherein any two of $R_{a1}$, $R_{b1}$, $R_{c1}$, $R_{d1}$, $R_a$, $R_b$, $R_c$, and $R_d$ can be fused or joined to form a ring or form a multidentate ligand.

**11.** The composition A of claim 3, wherein the first dopant capable of phosphorescence at room temperature in an organic light emitting device has the formula selected from the group consisting of:

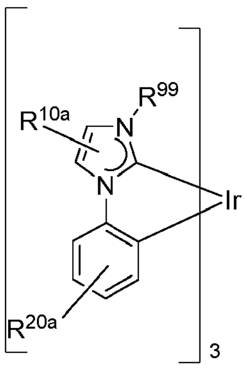

,

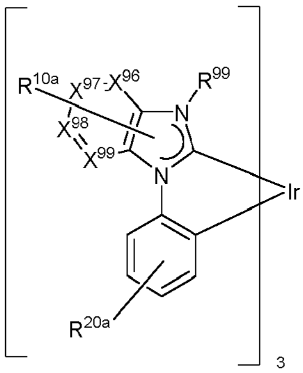

,

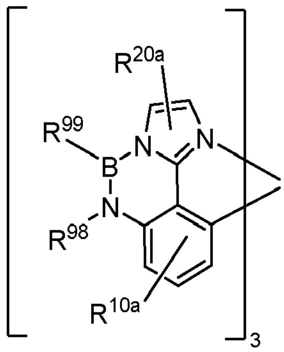

,

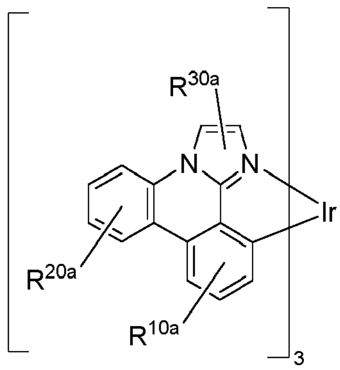

,

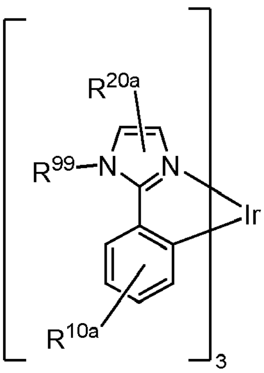

,

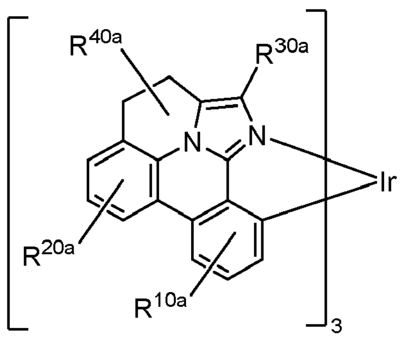

,

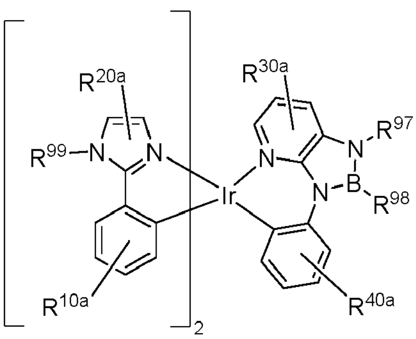

,

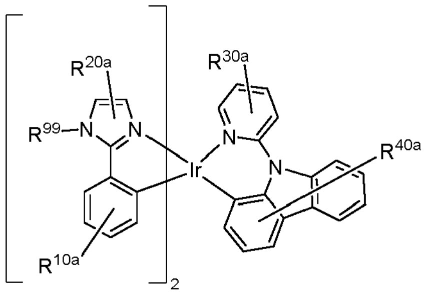,
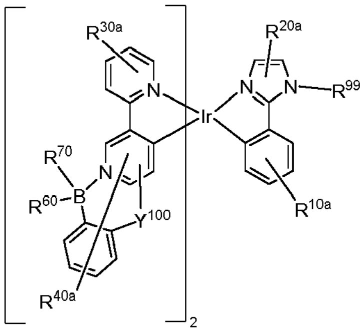,
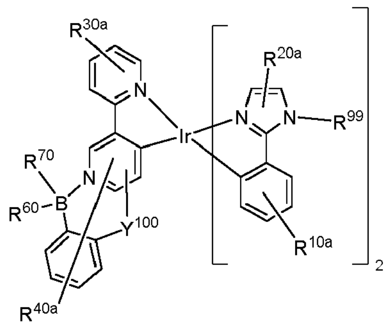,

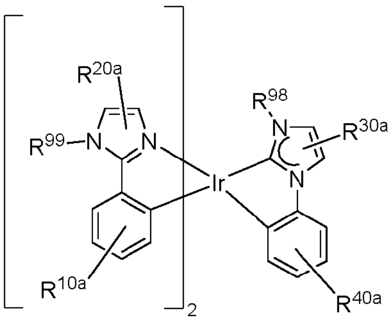,
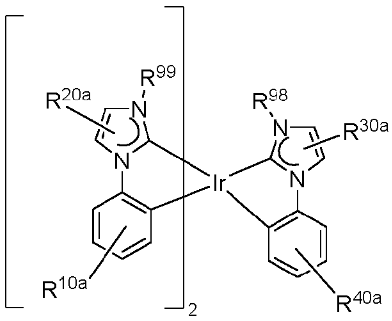,
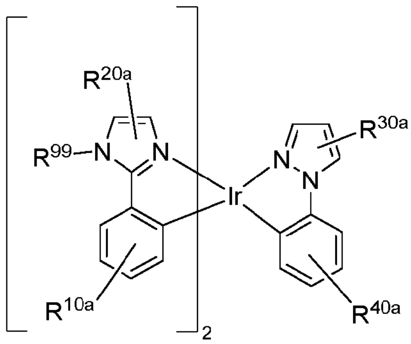,

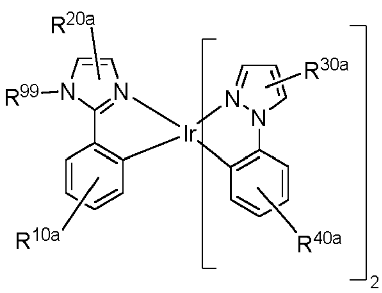,
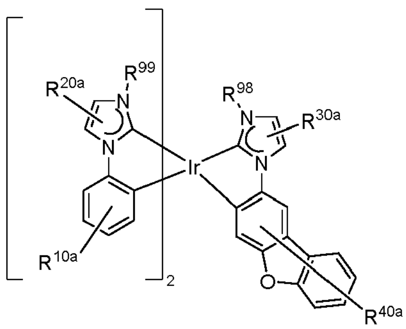,
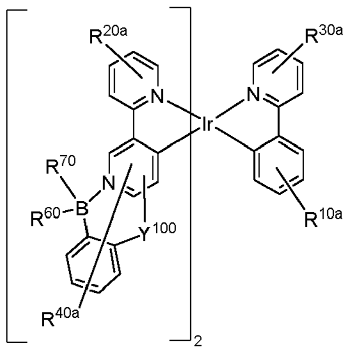,

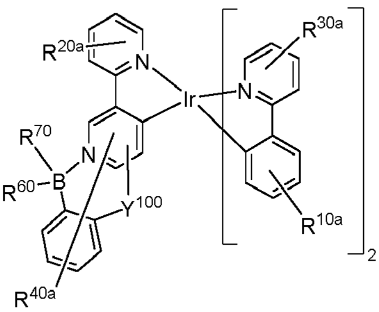,
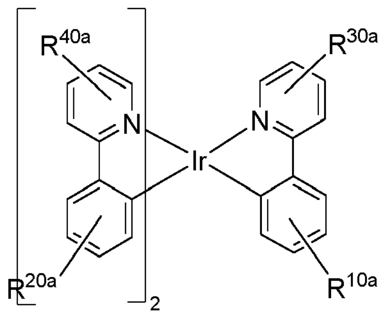,
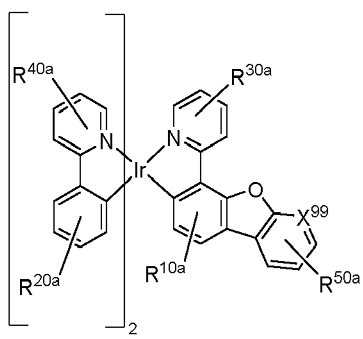,

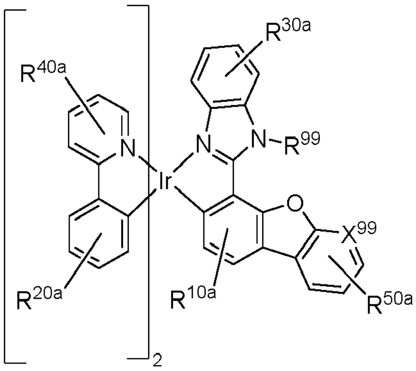
,
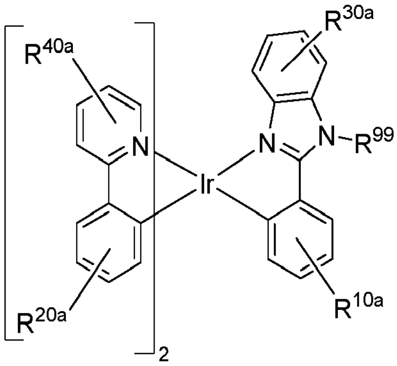
,
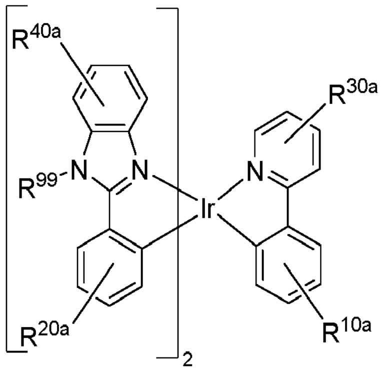
,

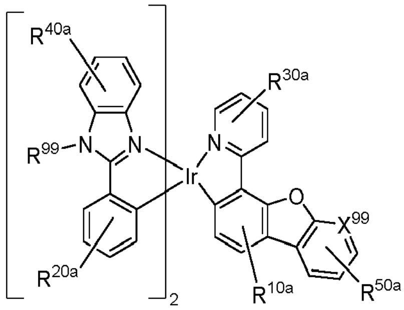
,
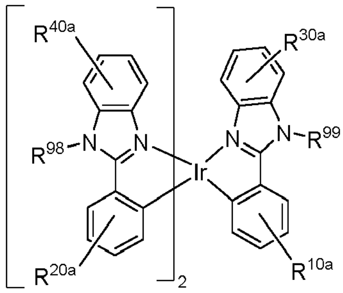
,
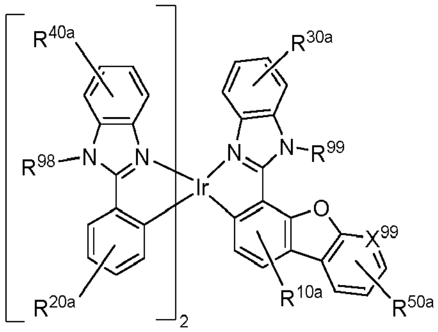
,

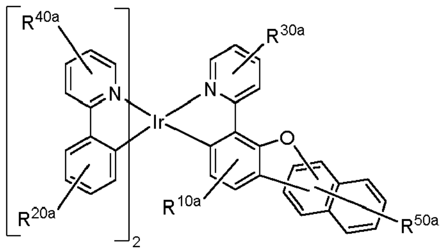
,
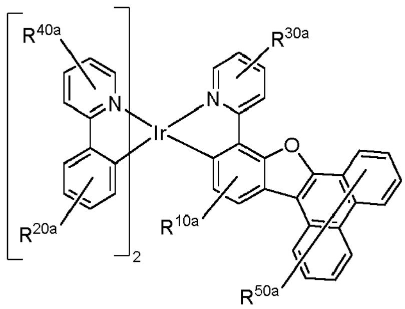
,

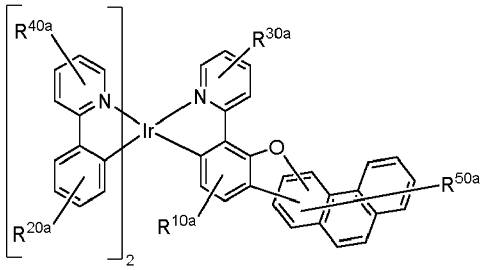
,
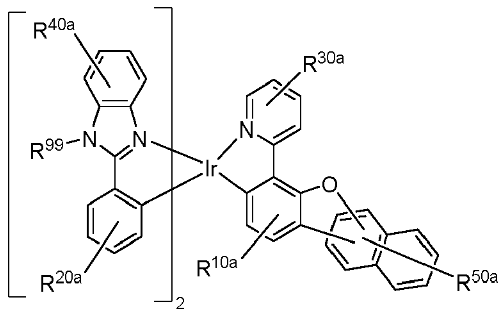
,

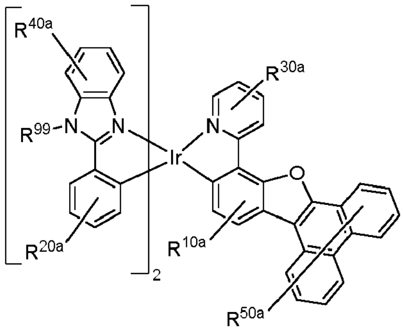
,
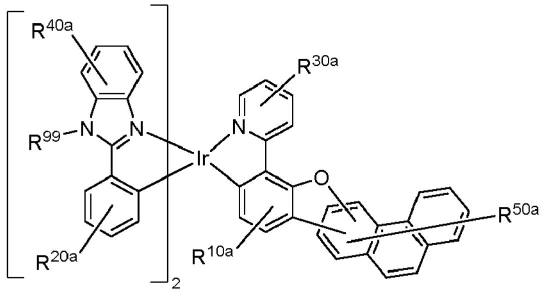
,
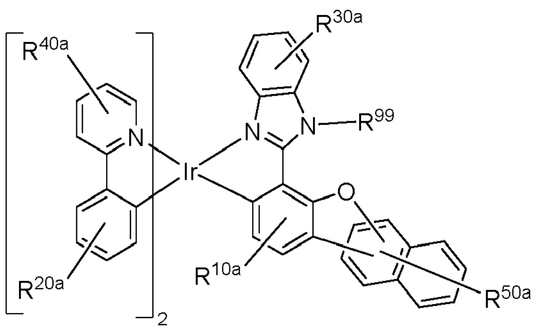
,
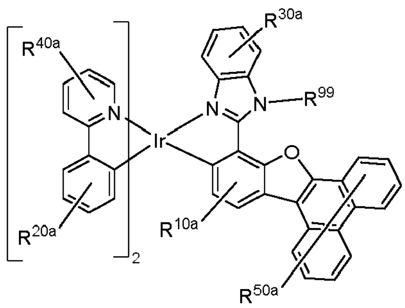
,
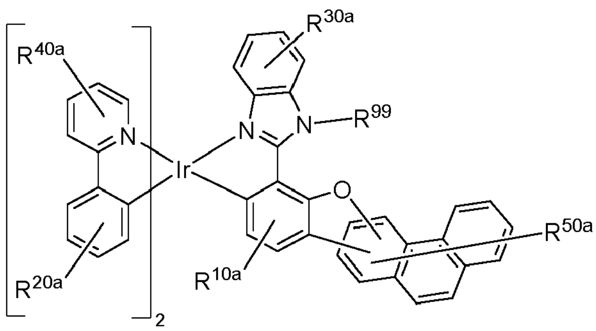
,
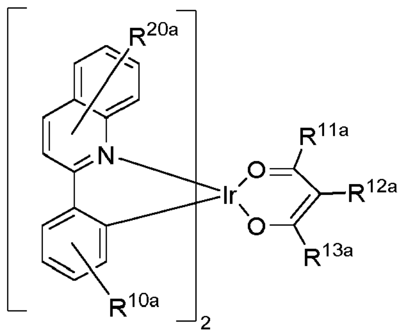
,
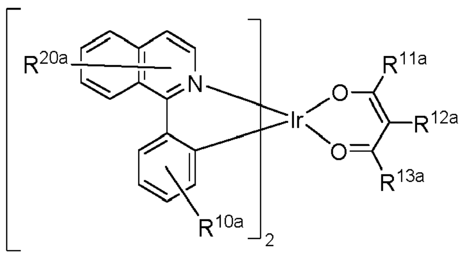
,
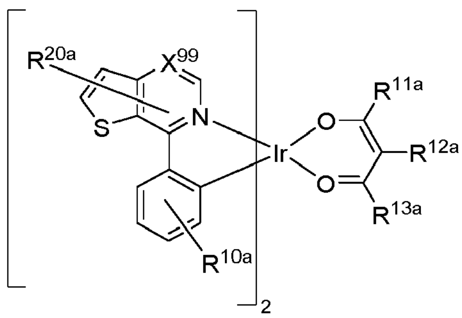
,

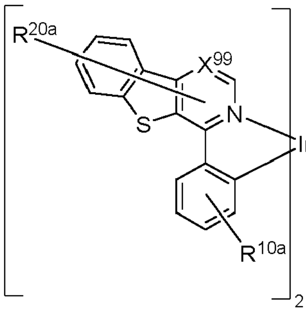
,
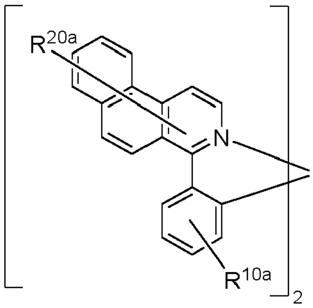

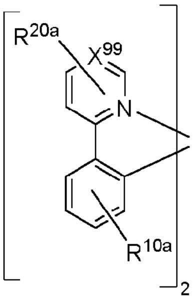
,
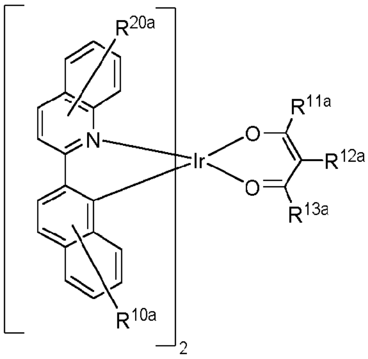
,
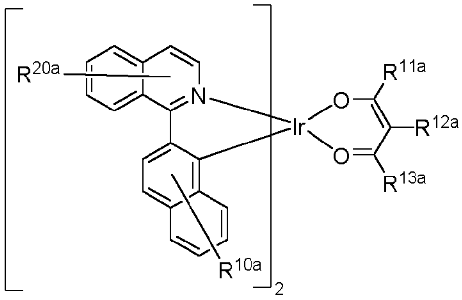
,

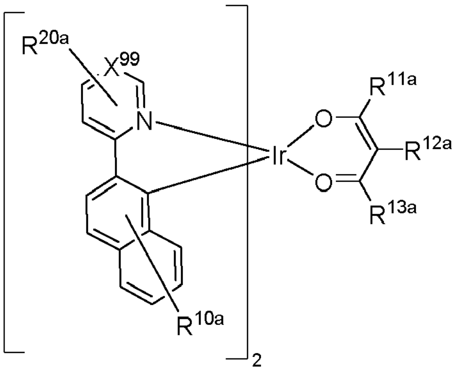
,
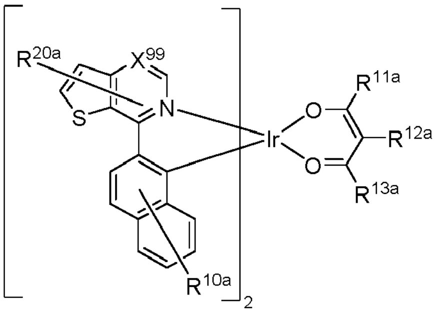
,

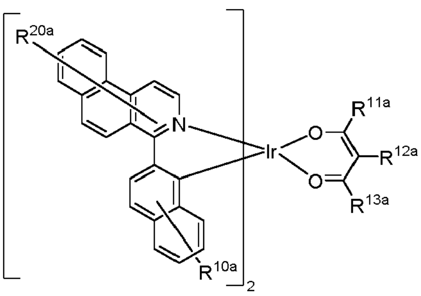
,
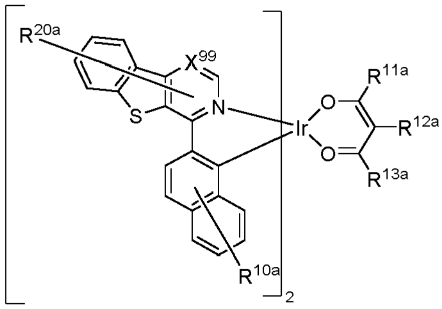
,

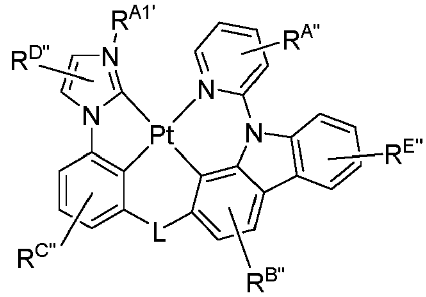,
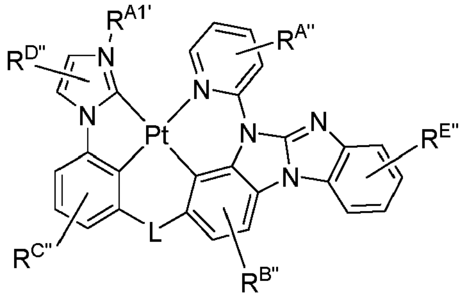,
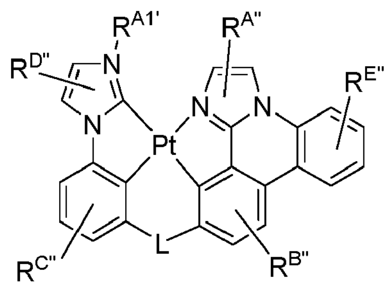,
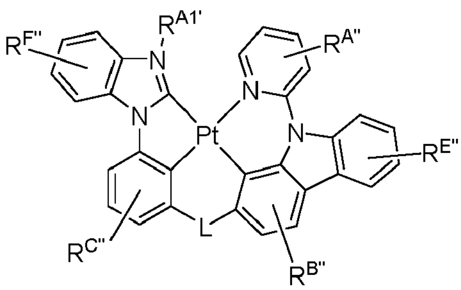,
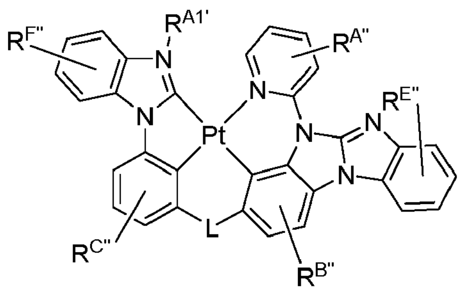,
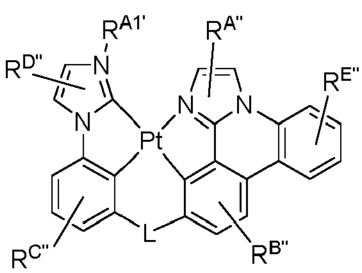,
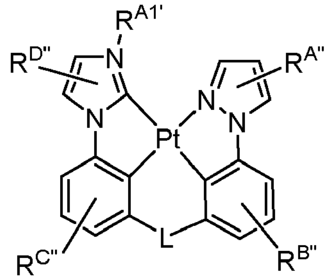,
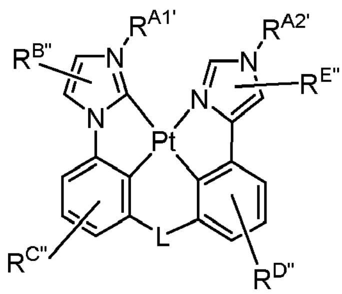,
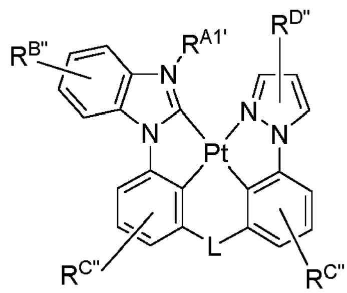,
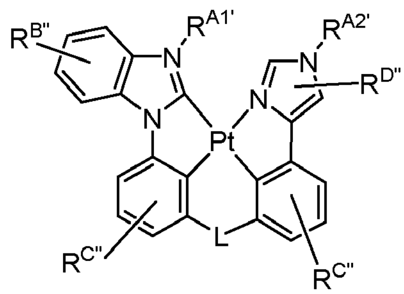,
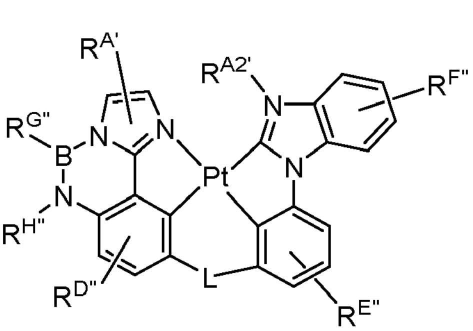,
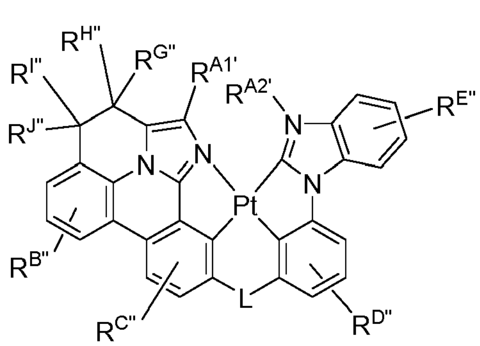,

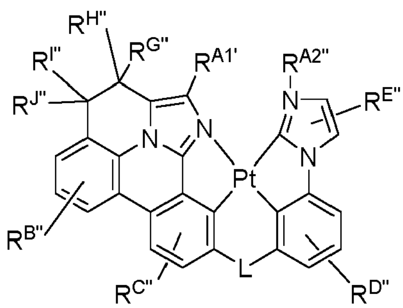
,
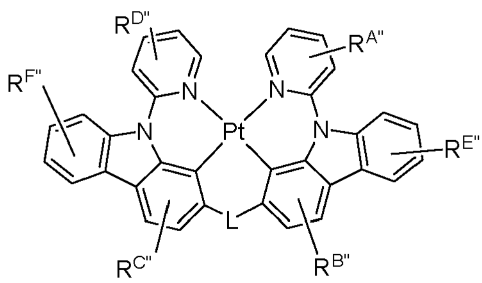
,

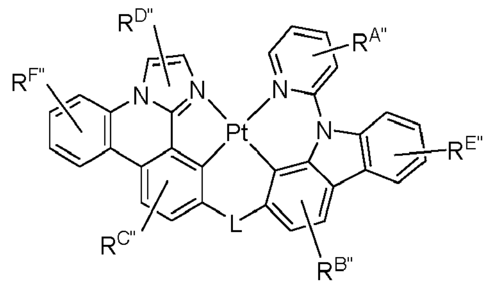
,
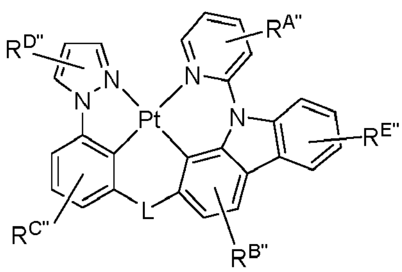
,

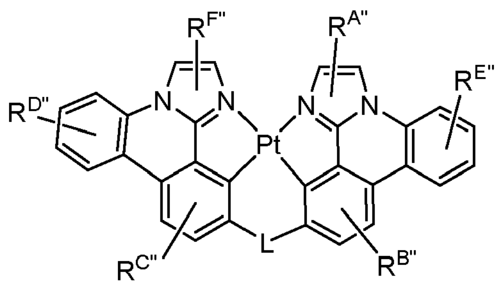
,
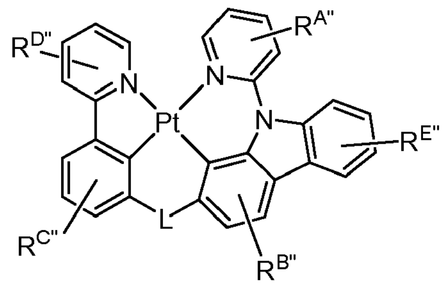
,

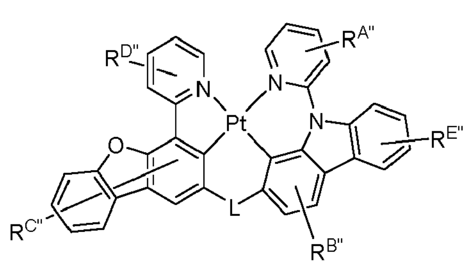
,
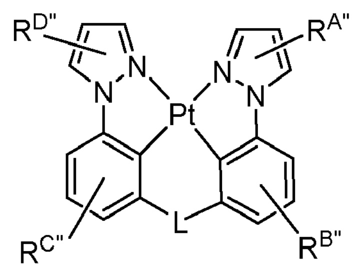
,

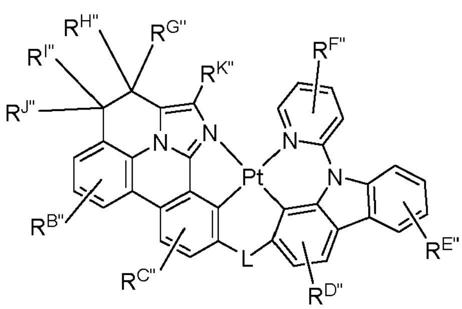
,
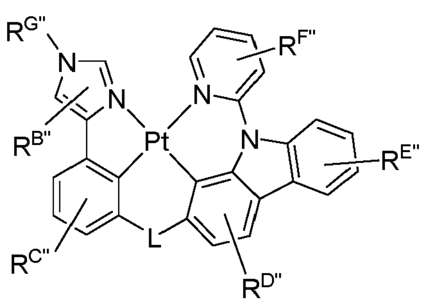
,

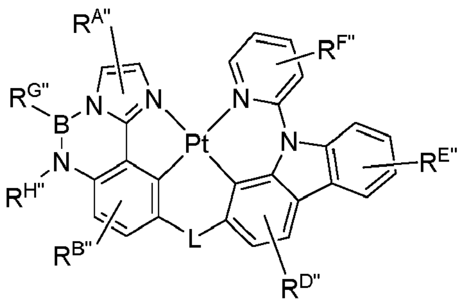 , 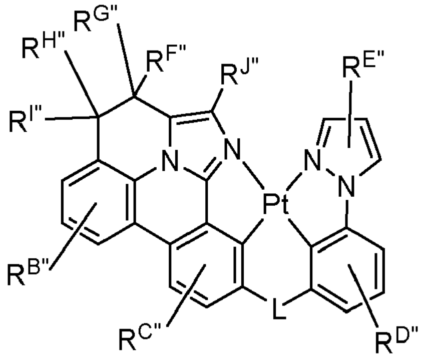 ,

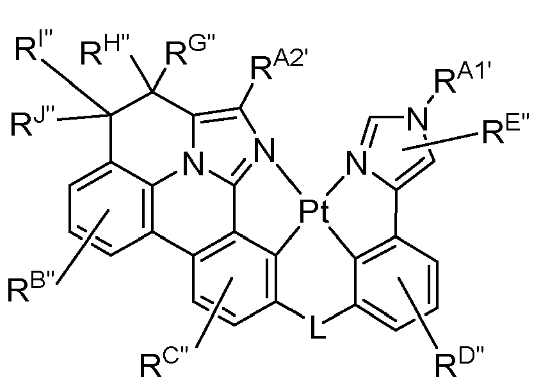 , 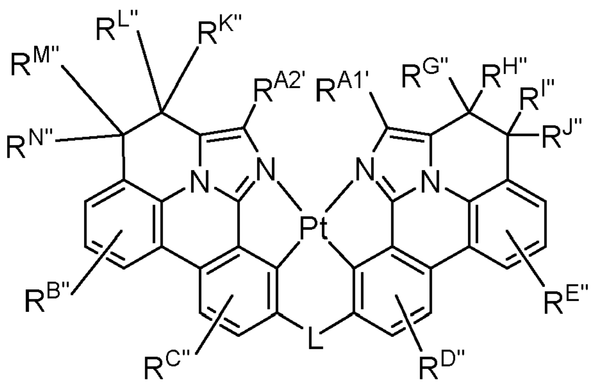 ,

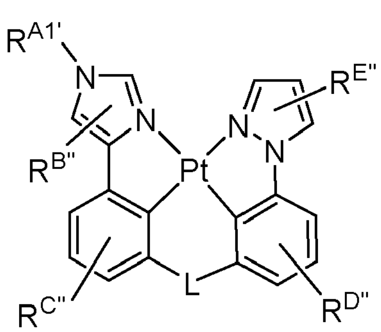 , 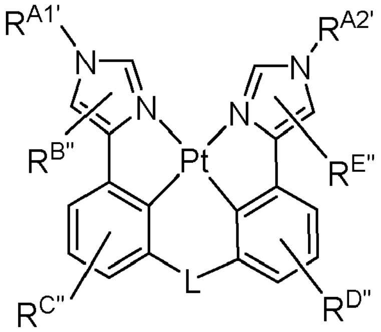 , 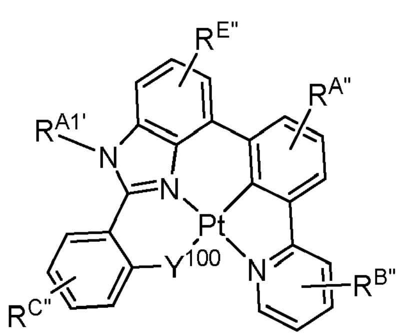 ,

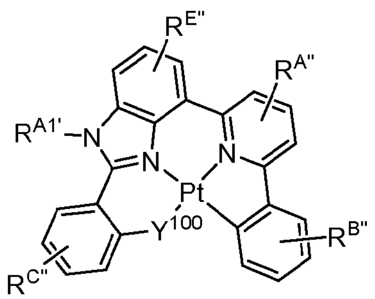 , 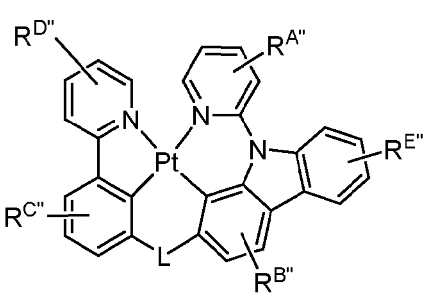 , 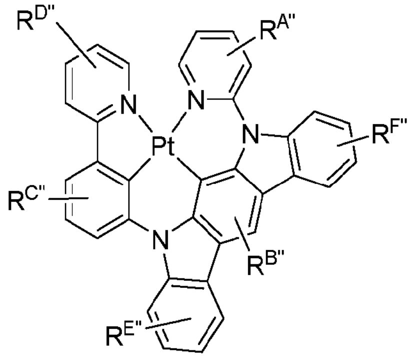 ,

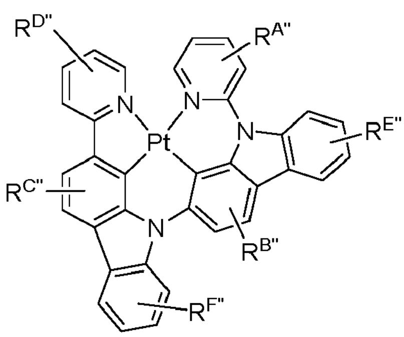
,
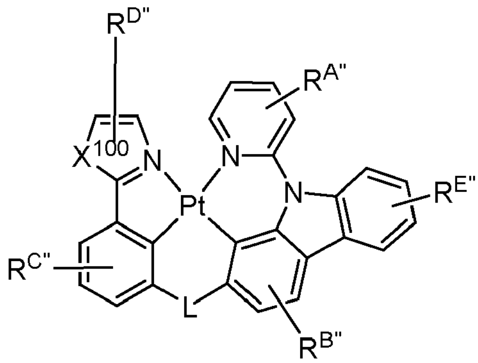
,

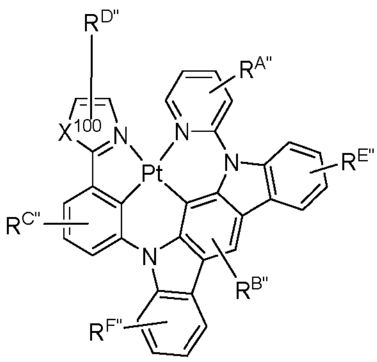
,
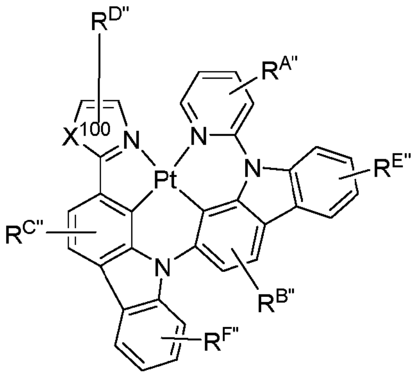
,
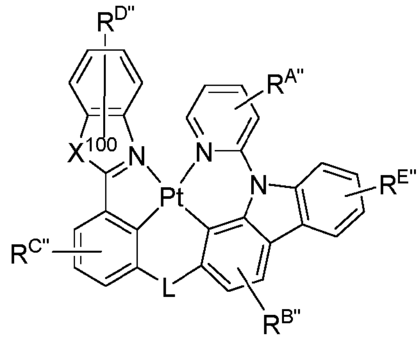
,

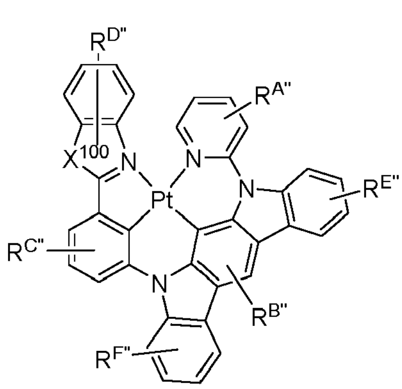
,
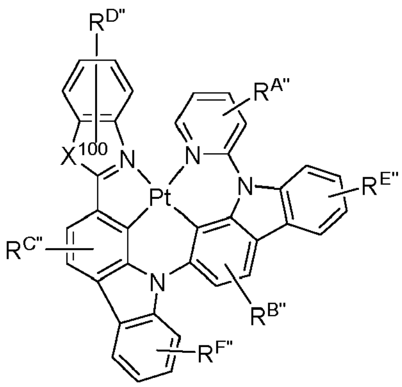
,
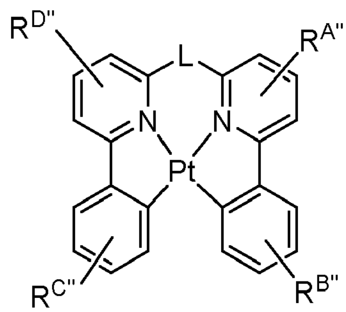
,

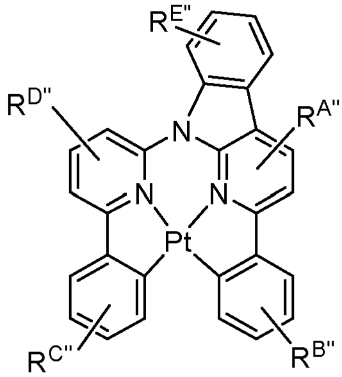
,
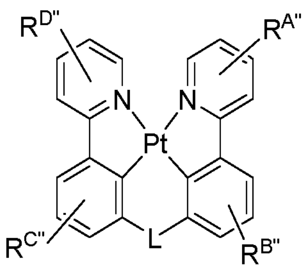
,
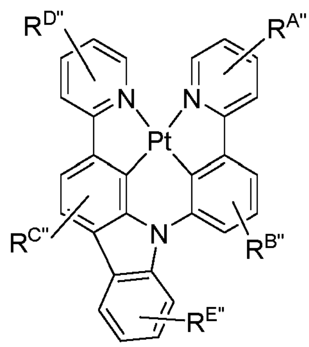
,

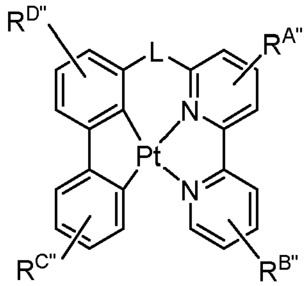 , 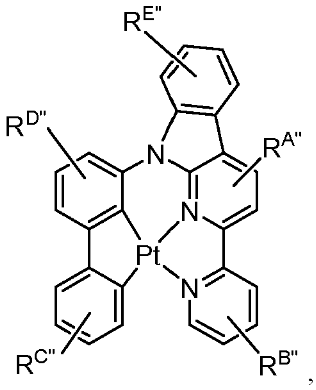 , 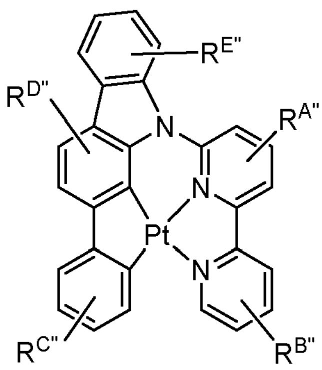 ,

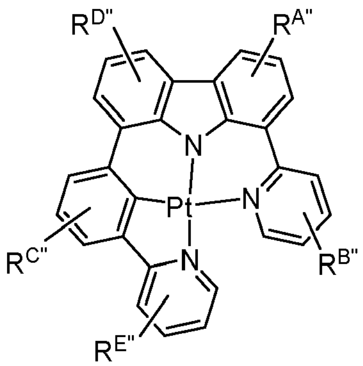 , 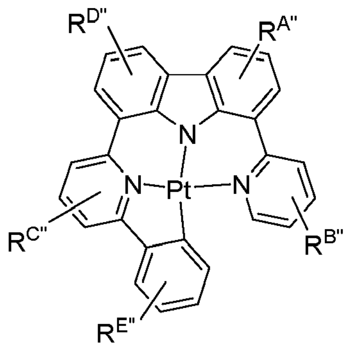 , 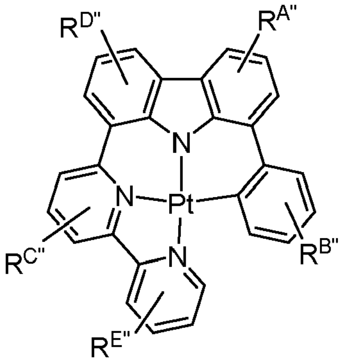 ,

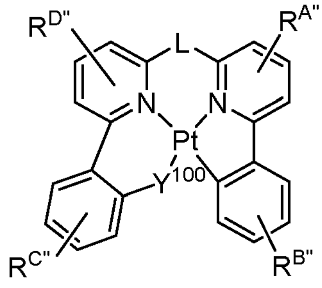 , 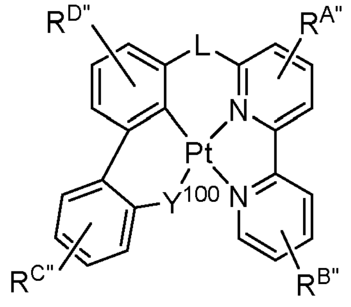 , 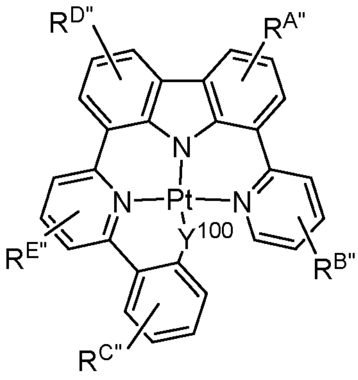 ,

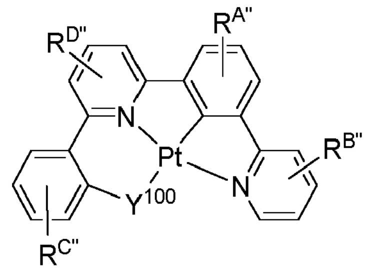 , 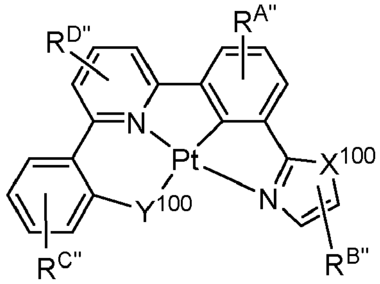 , 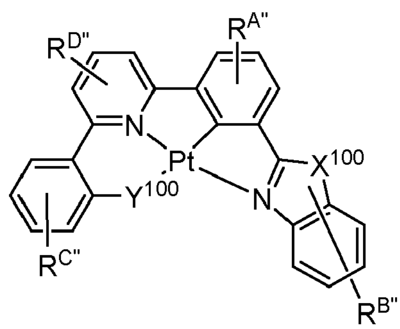 ,

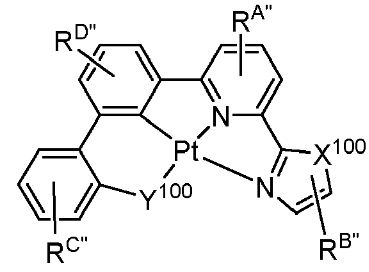,
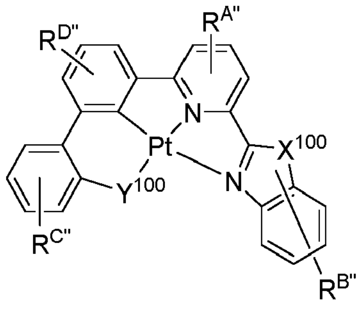,
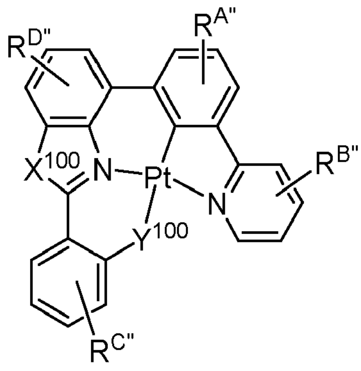,

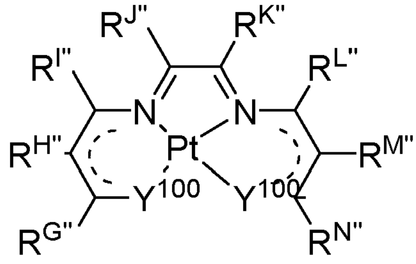,
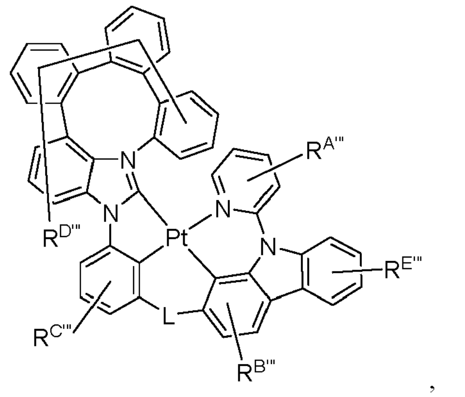,

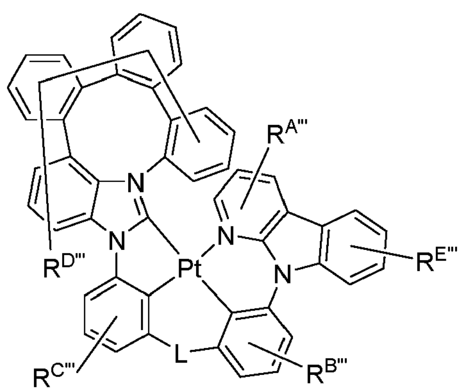,
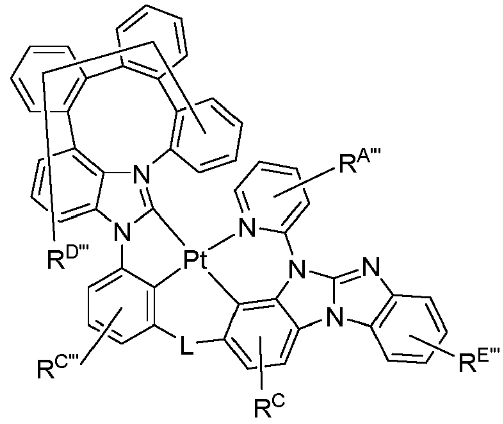,

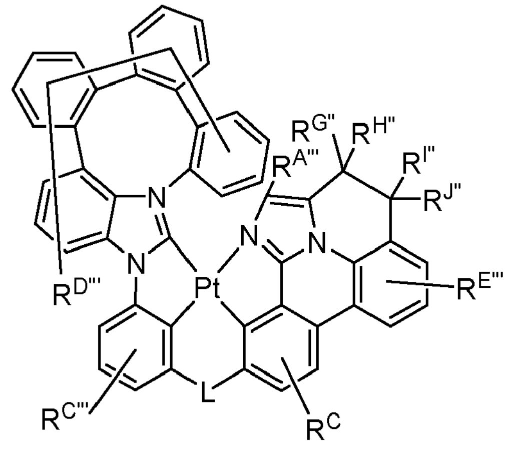,
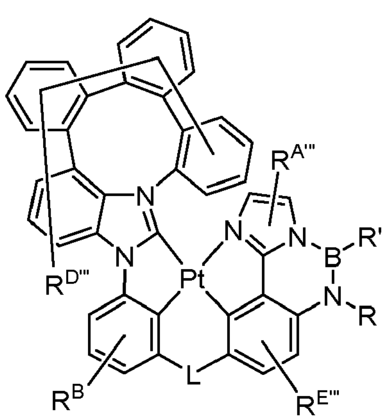,

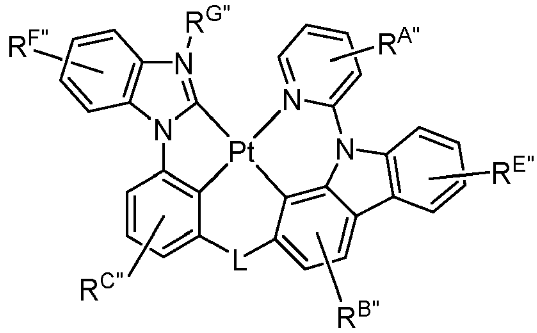

,

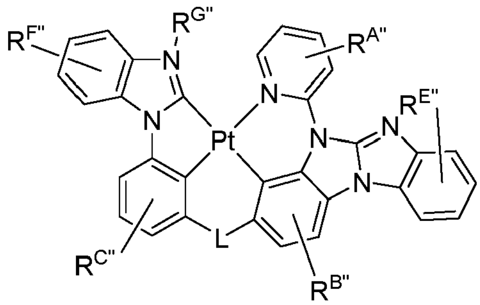

,

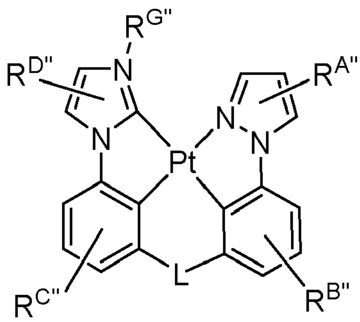

,

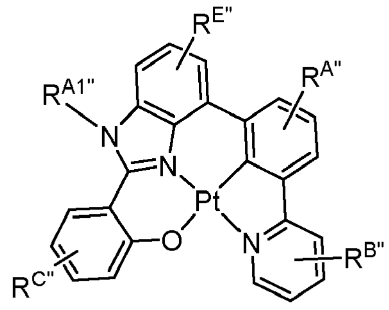

, and

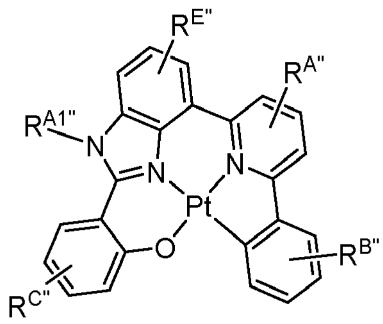

,

wherein:

each of $X^{96}$ to $X^{99}$ is independently C or N;
each $Y^{100}$ is independently selected from the group consisting of a NR", O, S, and Se;
L is independently selected from the group consisting of a direct bond, BR", BR"R‴, NR", PR", O, S, Se, C=O, C=S, C=Se, C=NR", C=CR"R‴, S=O, $SO_2$, CR", CR"R‴, SiR"R‴, GeR"R‴, alkyl, cycloalkyl, aryl, heteroaryl, and combinations thereof;
$X^{100}$ for each occurrence is selected from the group consisting of O, S, Se, NR", and CR"R‴;
each $R^{10a}$, $R^{20a}$, $R^{30a}$, $R^{40a}$, and $R^{50a}$, $R^{A"}$, $R^{B"}$, $R^{C"}$, $R^{D"}$, $R^{E"}$, and $R^{F"}$ independently represents mono-, up to the maximum substitutions, or no substitutions;
each of R, R', R", R‴, $R^{10a}$, $R^{11a}$, $R^{12a}$, $R^{13a}$, $R^{20a}$, $R^{30a}$, $R^{40a}$, $R^{50a}$, $R^{60}$, $R^{70}$, $R^{97}$, $R^{98}$, $R^{99}$, $R^{A1'}$, $R^{A2'}$, $R^{A"}$, $R^{B"}$, $R^{C"}$, $R^{D"}$, $R^{E"}$, $R^{F"}$, $R^{G"}$, $R^{H"}$, $R^{I"}$, $R^{J"}$, $R^{K"}$, $R^{L"}$, $R^{M"}$, and $R^{N"}$ is independently a hydrogen or a substituent selected from the group consisting of deuterium, halide, alkyl, cycloalkyl, heteroalkyl, arylalkyl, alkoxy, aryloxy, amino, silyl, germyl, boryl, selenyl, alkenyl, cycloalkenyl, heteroalkenyl, alkynyl, aryl, heteroaryl, acyl, carbonyl, carboxylic acid, ester, nitrile, isonitrile, sulfanyl, sulfinyl, sulfonyl, phosphino, combinations thereof.

**12.** The composition A of claim 1, wherein the first host can be selected from the group consisting of:

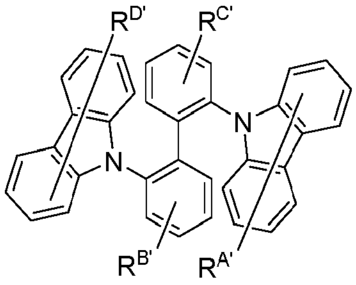

,

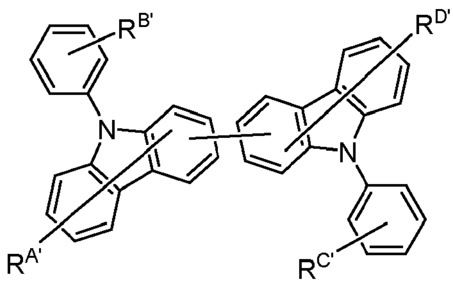

,

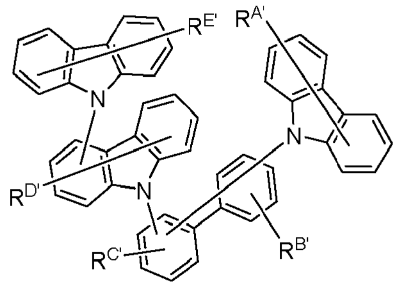

,

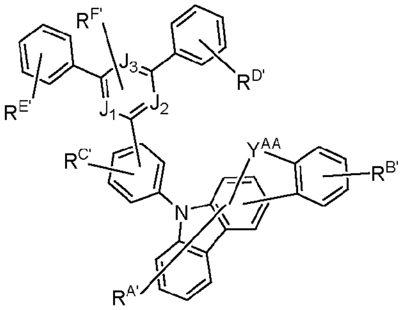
,
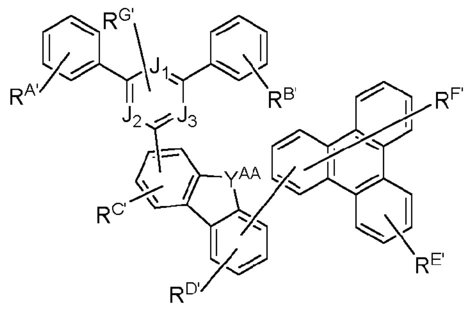
,
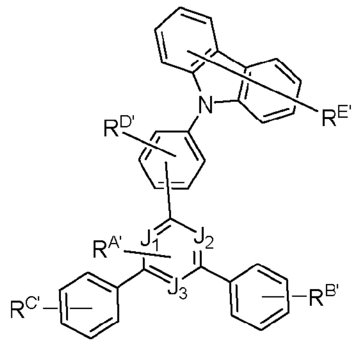

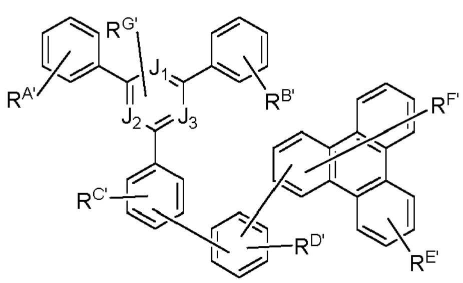
,
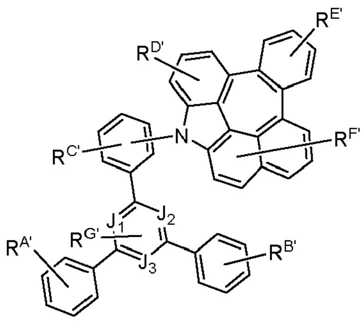
,

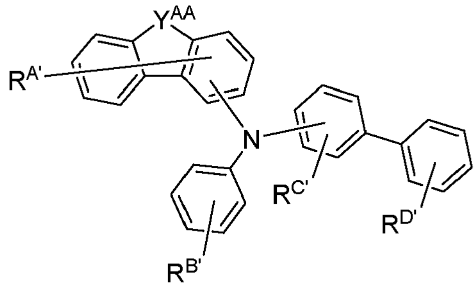
,
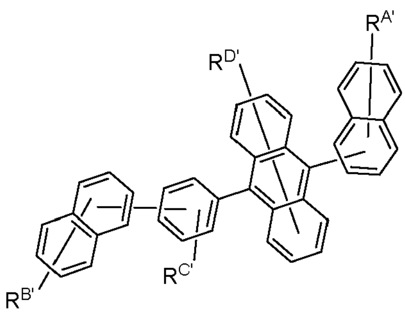
,

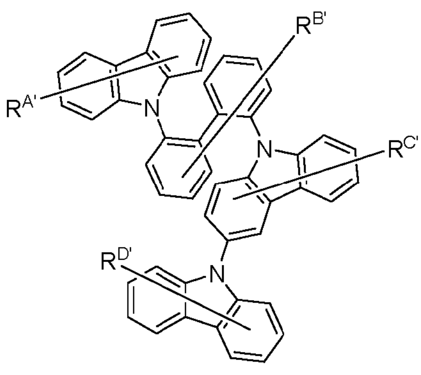
,
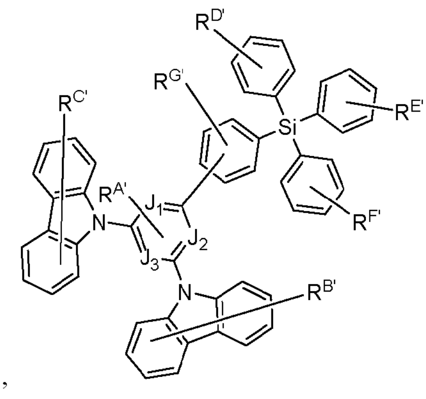
,
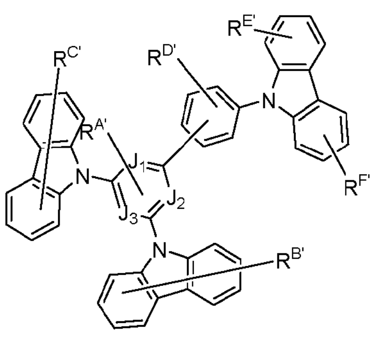
,

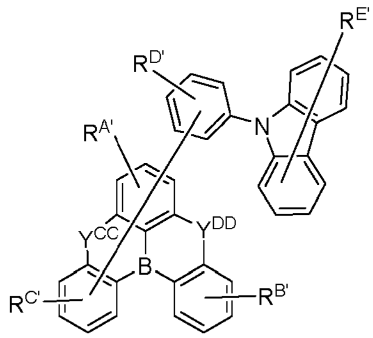
,
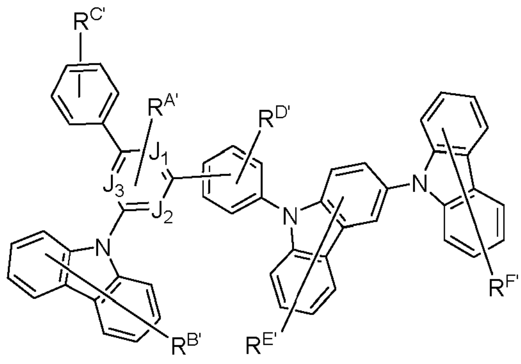
,
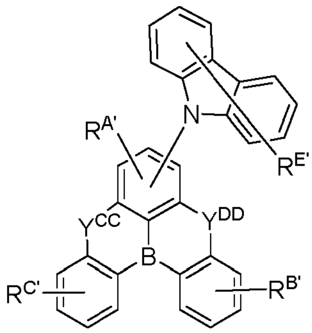
,

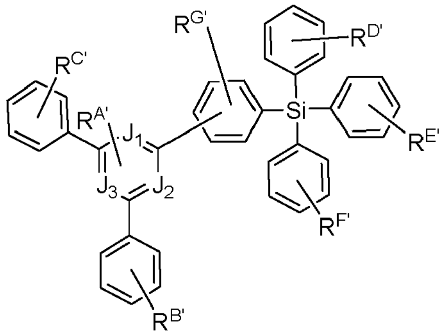
,
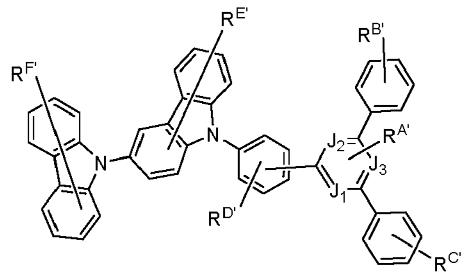
,

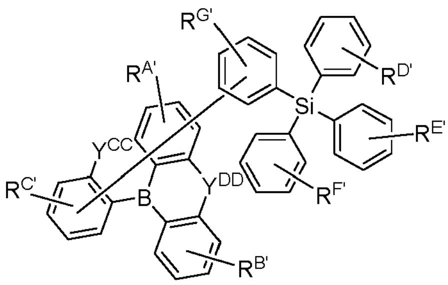
,
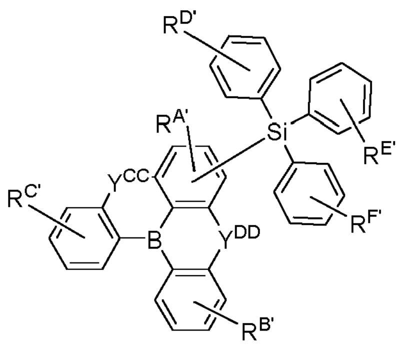
,

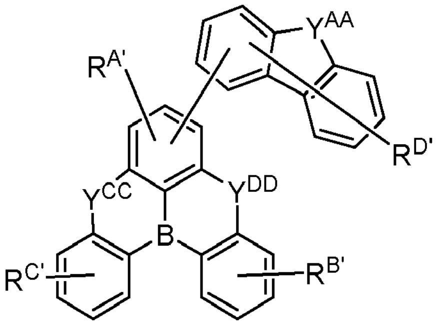
,
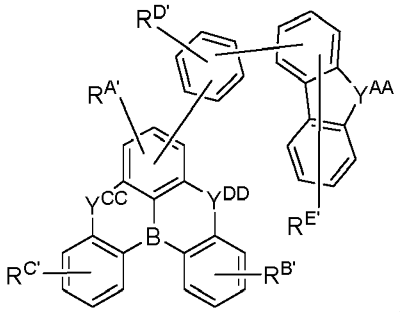
,

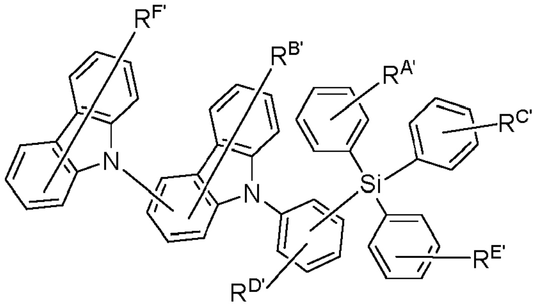
,
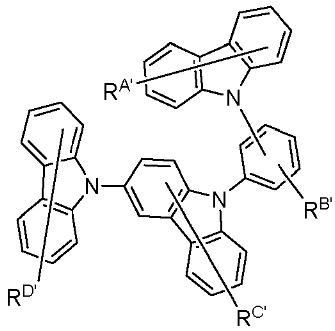
,
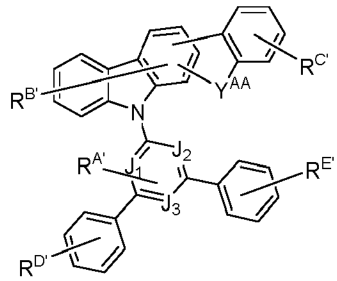
,

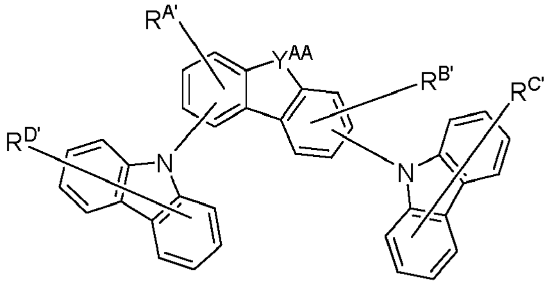
,
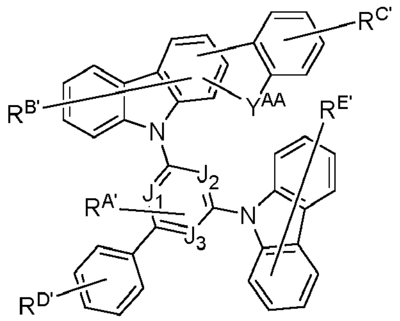
,

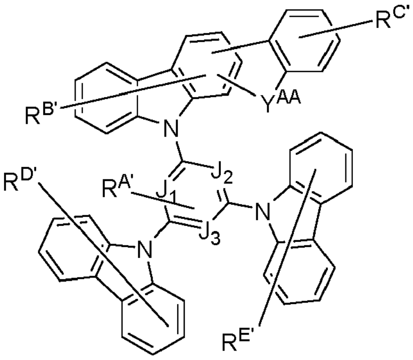
,
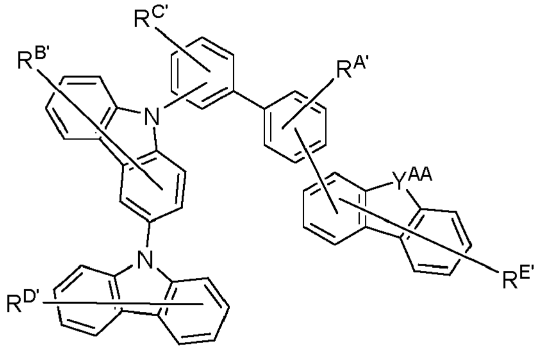
,

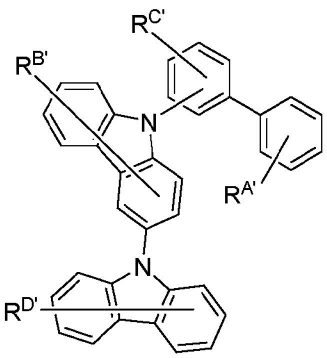
,
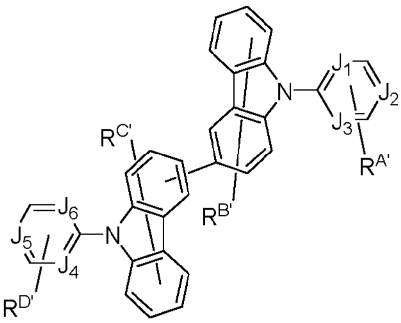
,
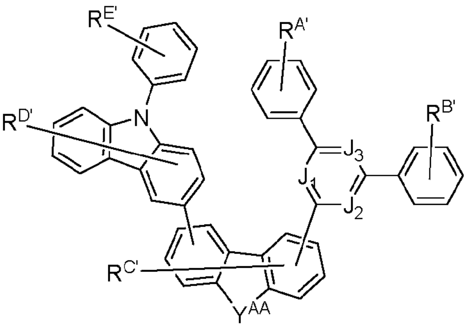
,

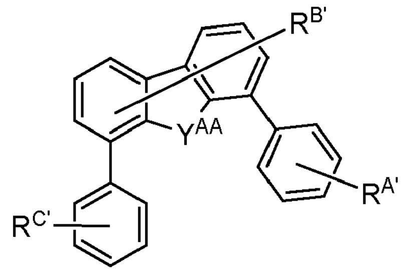 , 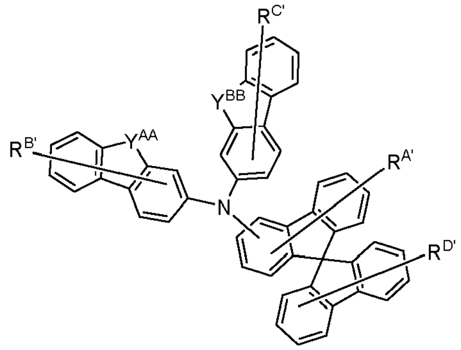 , 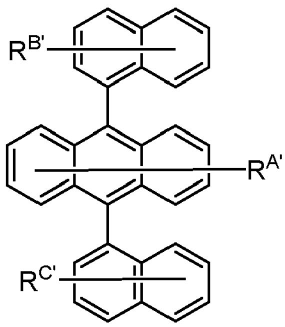 ,

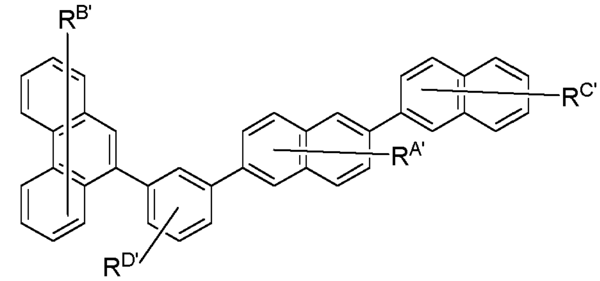 , 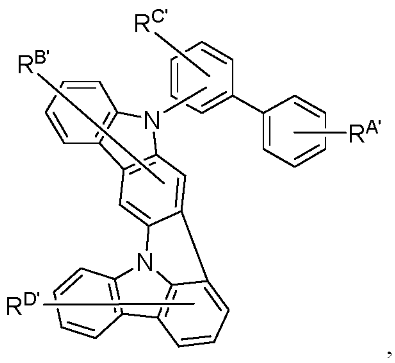 ,

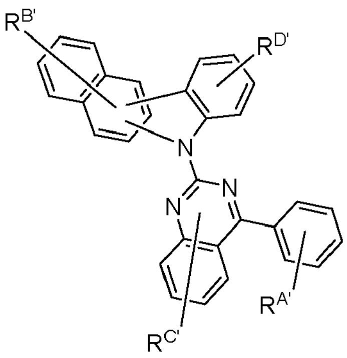 , 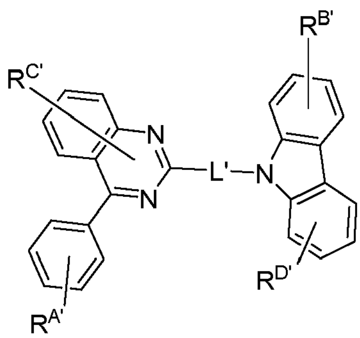 , 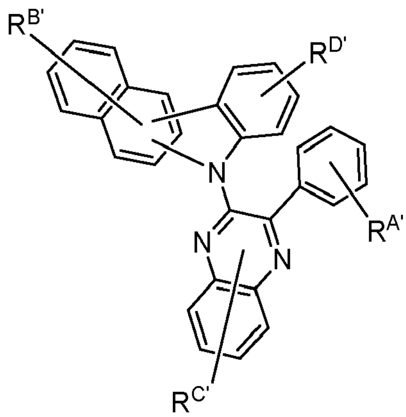 ,

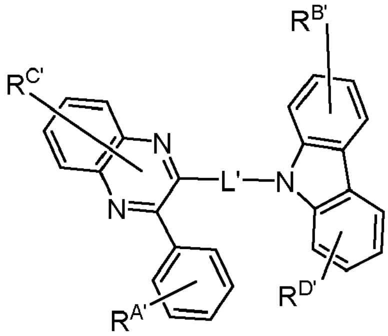 , 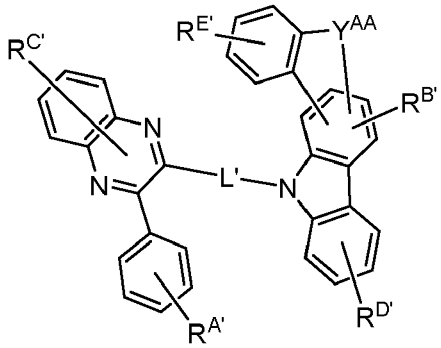 , 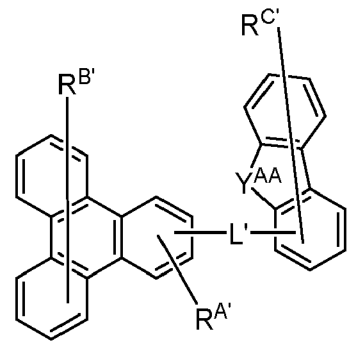 ,

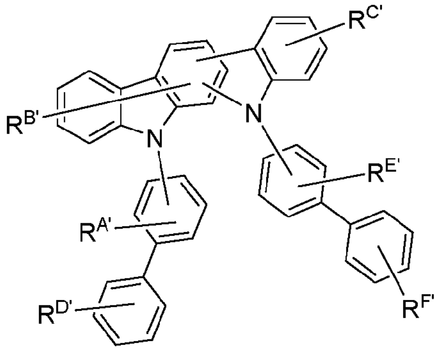,
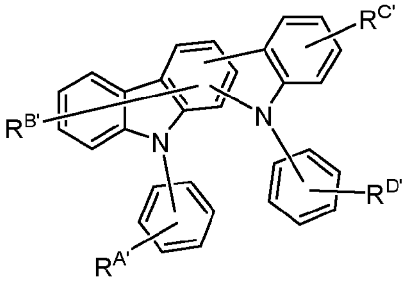,
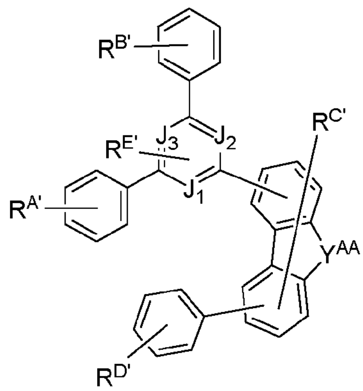,

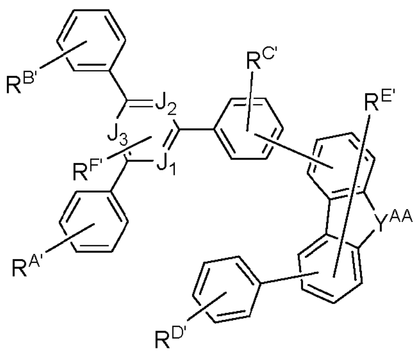,
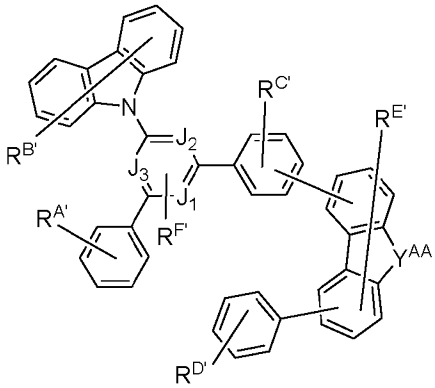,
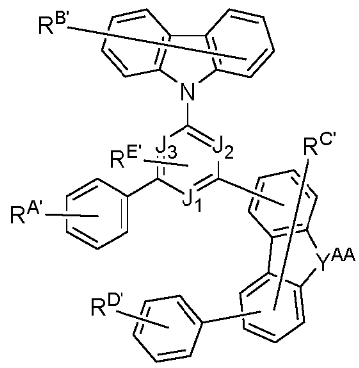,

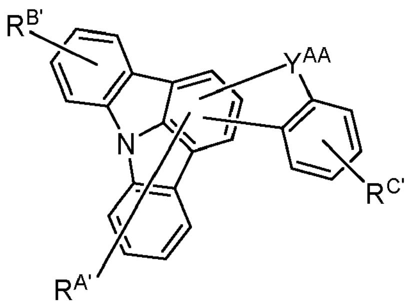,
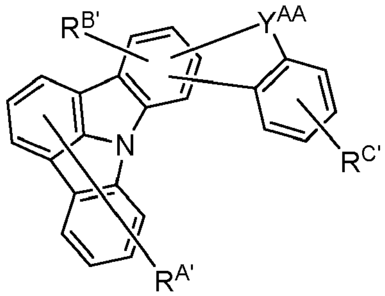,
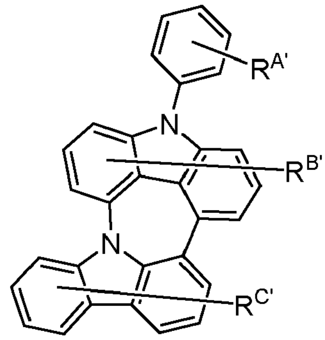,

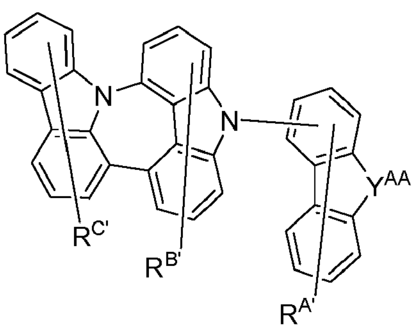,
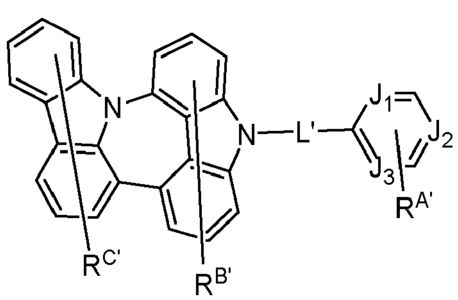,

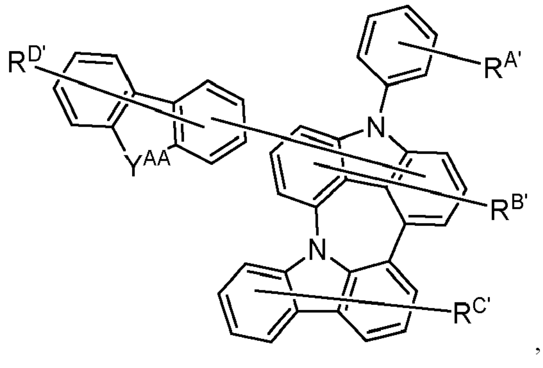
,
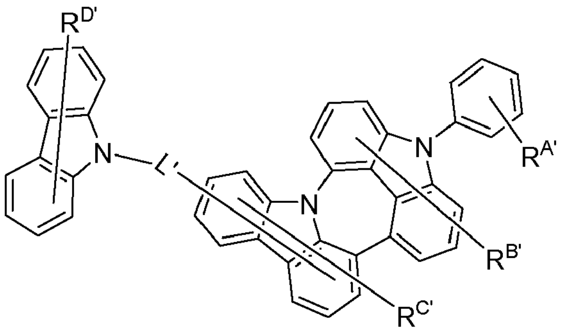
,

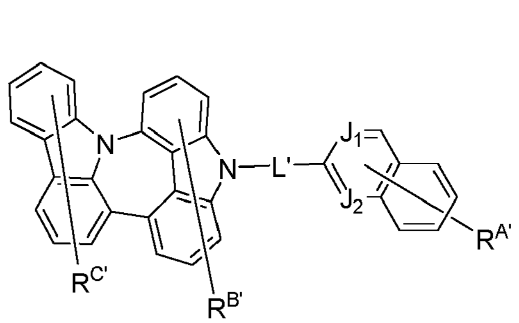
,
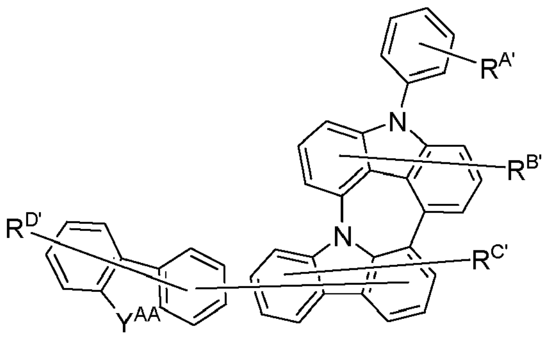
,

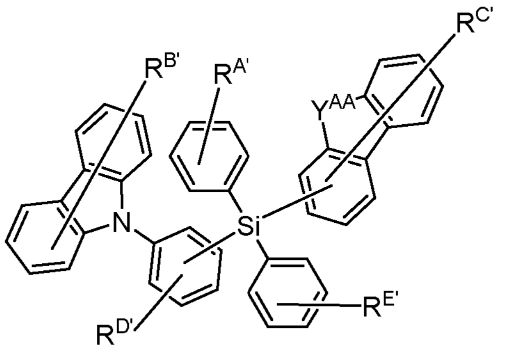
,
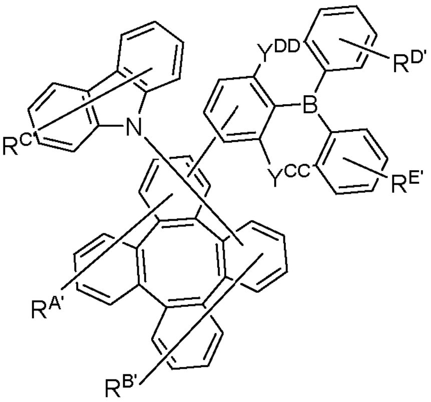
,
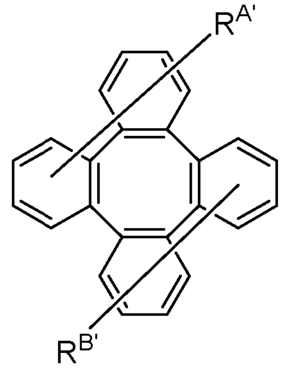
,

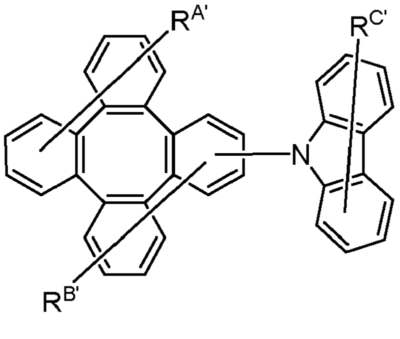
,
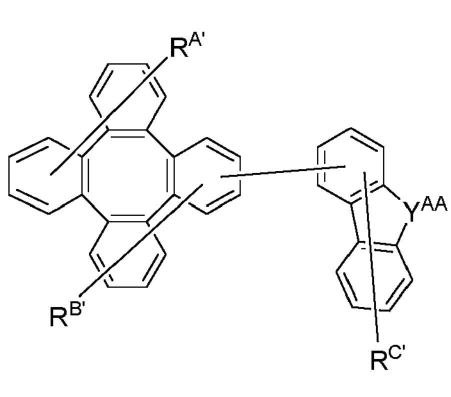
,

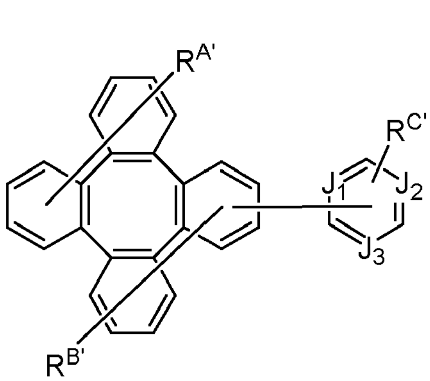,
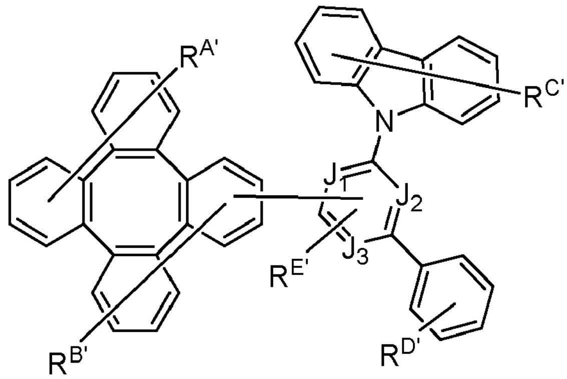,

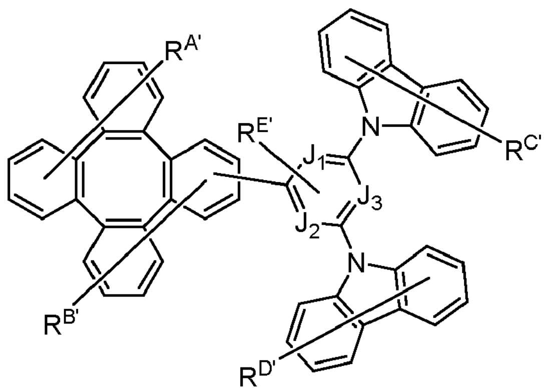,
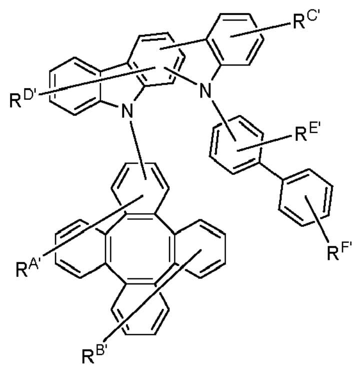,

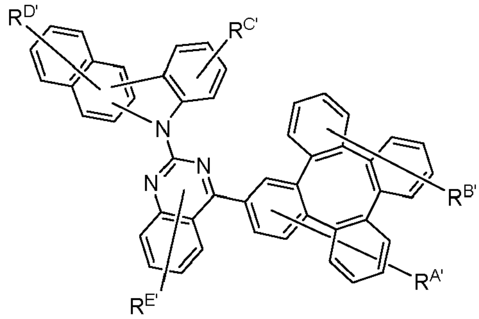,
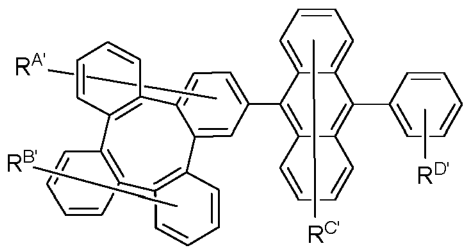,

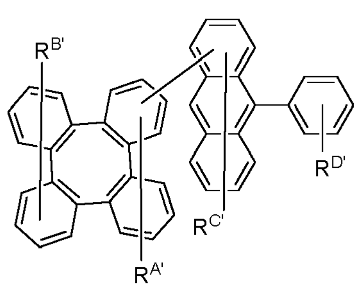,
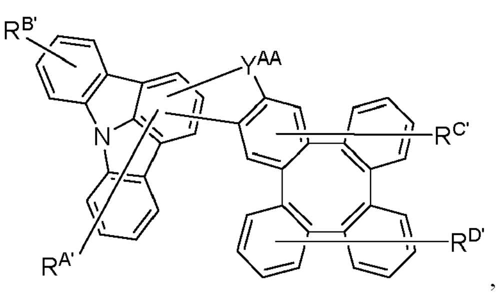, and

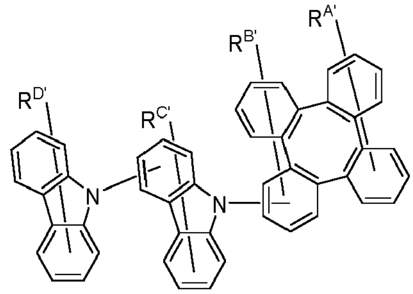

,

wherein:

each of $J_1$ to $J_6$ is independently C or N;
L' is a direct bond or an organic linker;
each $Y^{AA}$, $Y^{BB}$, $Y^{CC}$, and $Y^{DD}$ is independently selected from the group consisting of absent a bond, direct bond, O, S, Se, CRR', SiRR', GeRR', NR, BR, BRR';
each of $R^{A'}$, $R^{B'}$, $R^{C'}$, $R^{D'}$, $R^{E'}$, $R^{F'}$, and $R^{G'}$ independently represents mono, up to the maximum substitutions, or no substitutions;
each R, R', $R^{A'}$, $R^{B'}$, $R^{C'}$, $R^{D'}$, $R^{E'}$, $R^{F'}$, and $R^{G'}$ is independently a hydrogen or a substituent selected from the group consisting of the General Substituents as defined herein; any two substituents can be joined or fused to form a ring;

and where possible, each unsubstituted aromatic carbon atom is optionally replaced with N to form an aza-substituted ring.

**13.** An organic light emitting device (OLED) comprising:

an anode;
a cathode; and
an organic layer disposed between the anode and the cathode, wherein the organic layer comprises a composition according to any one of the previous claims.

**14.** The OLED of claim 13, wherein at least one of the anode, the cathode, or a new layer disposed over the organic layer functions as an enhancement layer, wherein the layer that functions as the enhancement layer comprises a plasmonic material exhibiting surface plasmon resonance that non-radiatively couples to the emitter material and transfers excited state energy from the first dopant to non-radiative mode of surface plasmon polariton.

**15.** A consumer product comprising an organic light-emitting device comprising:

an anode;
a cathode; and
an organic layer disposed between the anode and the cathode, wherein the organic layer comprises a composition or OLED according to any one of the previous claims.

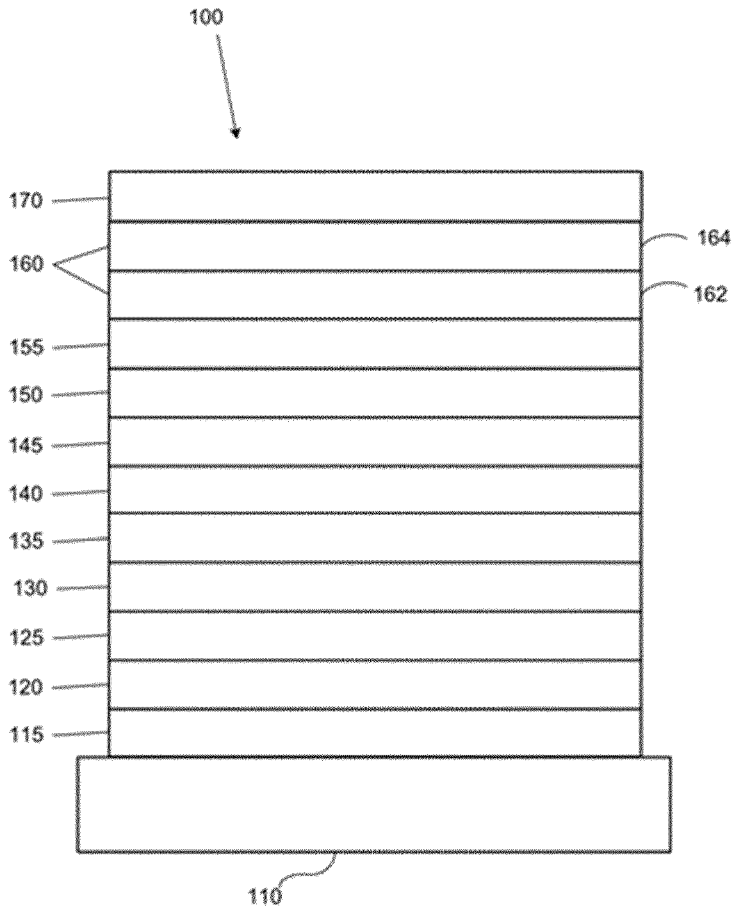
100
170
160
164
162
155
150
145
140
135
130
125
120
115
110

FIG. 1

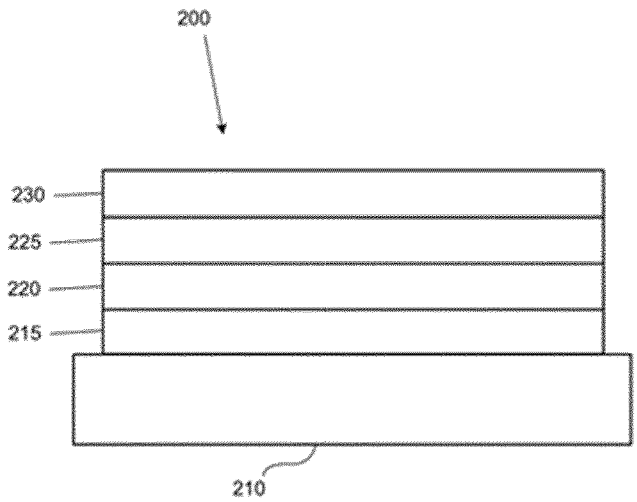
200
230
225
220
215
210

FIG. 2

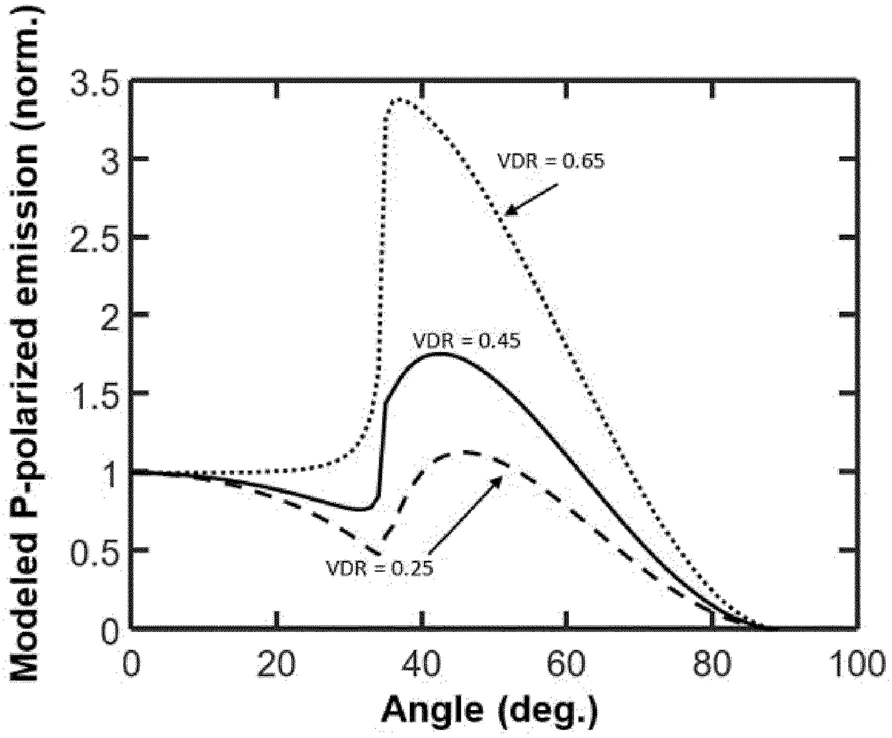
Modeled P-polarized emission (norm.)
3.5
3
2.5
2
1.5
1
0.5
0
0
20
40
60
80
100
Angle (deg.)
VDR = 0.65
VDR = 0.45
VDR = 0.25

FIG. 3

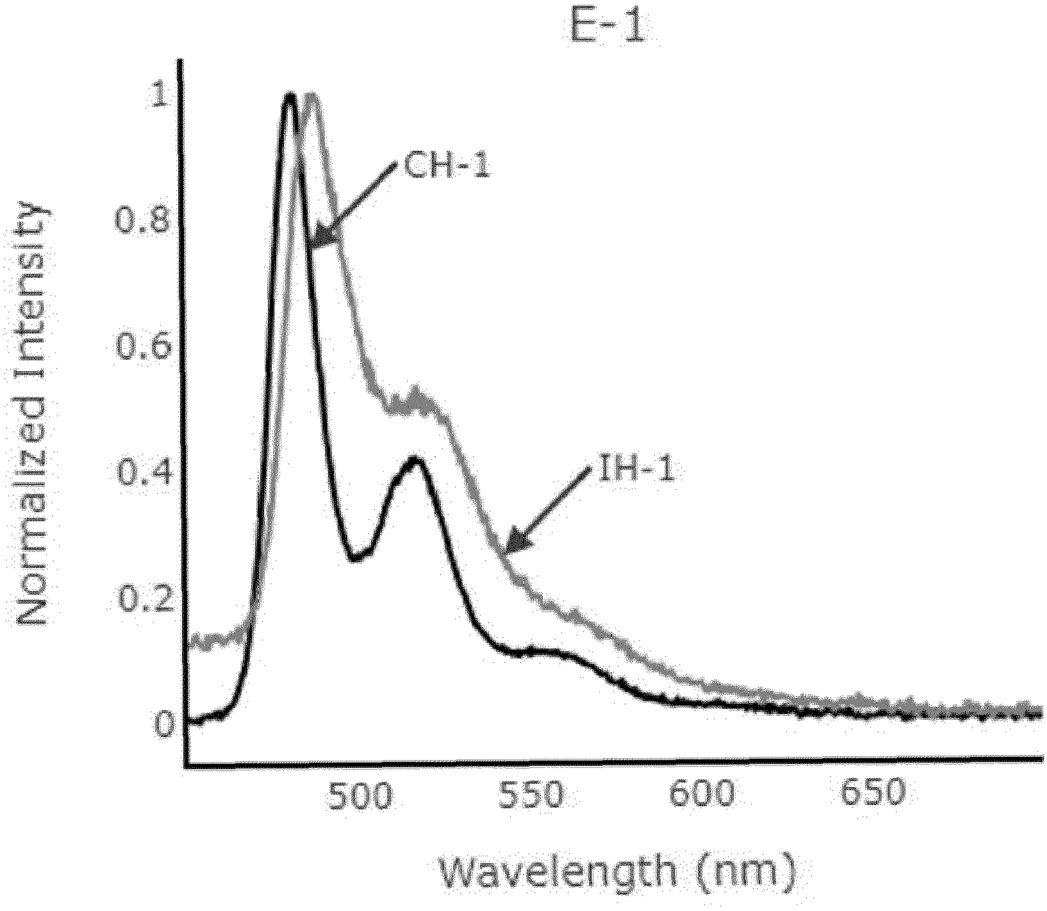
E-1
Normalized Intensity
1
0.8
0.6
0.4
0.2
0
CH-1
IH-1
500
550
600
650
Wavelength (nm)

FIG. 4A

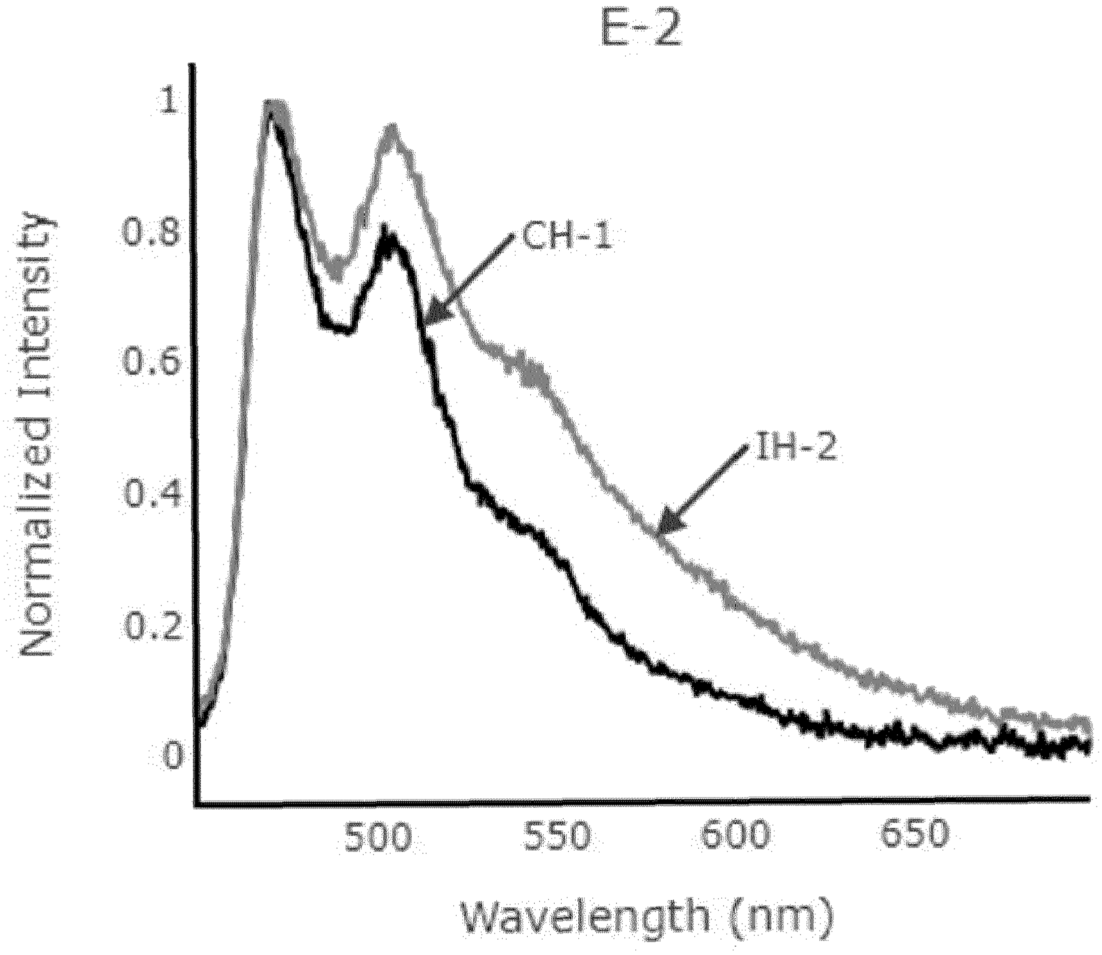
E-2
Normalized Intensity
1
0.8
0.6
0.4
0.2
0
500
550
600
650
Wavelength (nm)
CH-1
IH-2

FIG. 4B

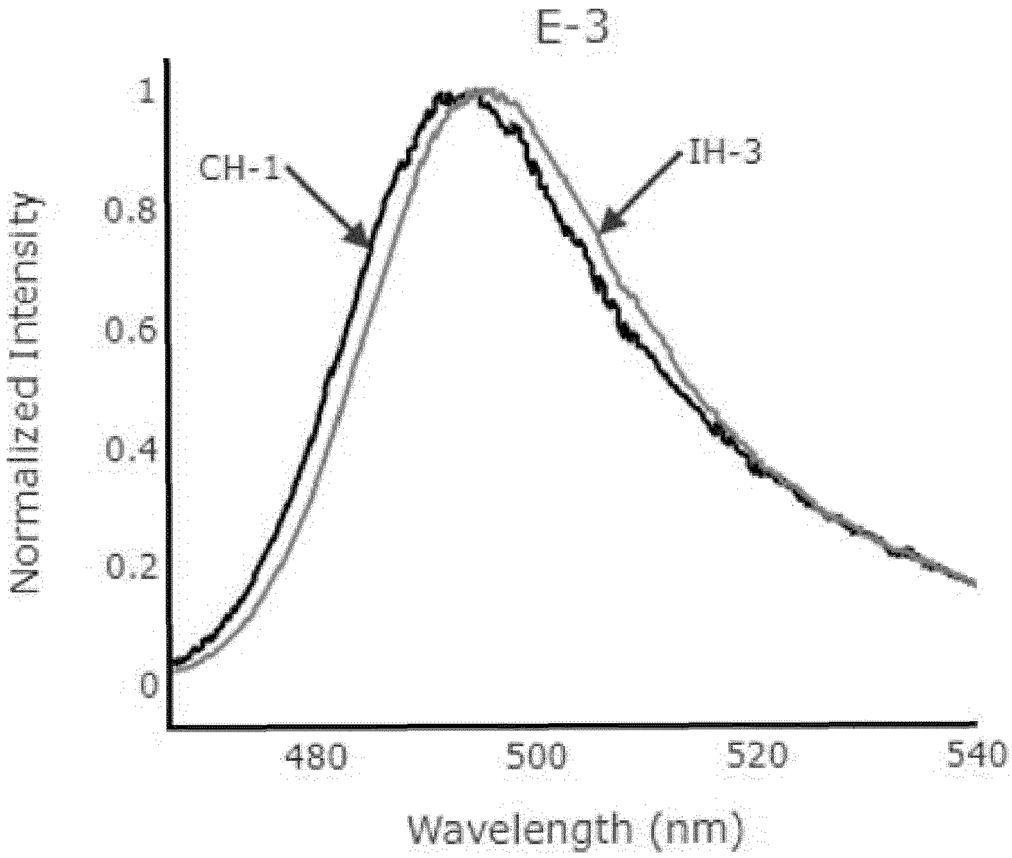
E-3
CH-1
IH-3
Normalized Intensity
0
0.2
0.4
0.6
0.8
1
480
500
520
540
Wavelength (nm)

FIG. 4C

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 63500964
- US 8557400 B
- WO 2006095951 A
- US 20110037057
- US 20230292605
- US 10672997 B
- US 7279704 B
- US 5844363 A
- US 20030230980
- US 6303238 B, Thompson
- US 5703436 A
- US 5707745 A
- US 6097147 A
- US 20040174116
- US 5247190 A, Friend
- US 6091195 A, Forrest
- US 5834893 A, Bulovic
- US 6013982 A
- US 6087196 A
- US 6337102 B, Forrest
- US 7431968 B
- US 6294398 B
- US 6468819 B
- US 7968146 B
- US 2007023098 W
- US 2009042829 W
- US 700352


### Non-patent literature cited in the description


- **MING YAN et al.** *Tetrahedron,* 2015, vol. 71, 1425-30
- **ATZRODT et al.** *Angew. Chem. Int. Ed. (Reviews),* 2007, vol. 46, 7744-65
- **FINK, R ; HEISCHKEL, Y ; THELAKKAT, M. ; SCHMIDT, H.-W.** *Chem. Mater.,* 1998, vol. 10, 3620-3625
- **POMMEREHNE, J. ; VESTWEBER, H ; GUSS, W ; MAHRT, R. F ; BASSLER, H ; PORSCH, M ; DAUB, J.** *Adv. Mater.,* 1995, vol. 7, 551
- **HONG et al.** *, Chem. Mater.,* 2016, vol. 28, 5791-98, 5792-93
- **TAVASLI et al.** *J. Mater. Chem.,* 2012, vol. 22, 6419-29
- **MORELLO, G.R.** *J. Mol. Model.,* 2017, vol. 23, 174
- **POMMEREHNE, J. ; VESTWEBER, H ; GUSS, W. ; MAHRT, R. F. ; BASSLER, H. ; PORSCH, M ; DAUB.** *J. Adv. Mater.,* 1995, vol. 7, 551